# EUROPEAN PATENT SPECIFICATION

(11) **EP 3 912 983 B1**
(45) Date of publication and mention of the grant of the patent: **15.11.2023**
(21) Application number: 21174468.5
(22) Date of filing: 18.05.2021
(51) Int. Cl.: C07F 15/00, H05B 33/14, C09K 11/06, H10K 85/30, H10K 101/10

(54) **ORGANOMETALLIC COMPOUND, ORGANIC LIGHT-EMITTING DEVICE INCLUDING ORGANOMETALLIC COMPOUND, AND ELECTRONIC APPARATUS INCLUDING ORGANIC LIGHT-EMITTING DEVICE**
ORGANOMETALLISCHE VERBINDUNG, ORGANISCHE LICHTEMITTIERENDE VORRICHTUNG MIT ORGANOMETALLISCHER VERBINDUNG UND ELEKTRONISCHE VORRICHTUNG MIT ORGANISCHER LICHTEMITTIERENDER VORRICHTUNG
COMPOSÉ ORGANOMÉTALLIQUE, DISPOSITIF ÉLECTROLUMINESCENT ORGANIQUE LE COMPRENANT ET APPAREIL ÉLECTRONIQUE COMPRENANT LE DISPOSITIF ÉLECTROLUMINESCENT ORGANIQUE

(30) Priority: 21.05.2020 KR 20200060898
(43) Date of publication of application: 24.11.2021
(73) Proprietor: Samsung Electronics Co., Ltd., Suwon-si 16677 (KR)
(72) Inventor: HWANG, Kyuyoung, 16678 Gyeonggi-do (KR); KANG, Byungjoon, 16678 Gyeonggi-do (KR); KWAK, Seungyeon, 16678 Gyeonggi-do (KR); KIM, Sangdong, 16678 Gyeonggi-do (KR); LEE, Banglin, 16678 Gyeonggi-do (KR); YI, Jeoungin, 16678 Gyeonggi-do (KR); CHOI, Byoungki, 16678 Gyeonggi-do (KR)
(74) Representative: Elkington and Fife LLP

(56) References cited:
- EP-A1- 3 705 483
- EP-A1- 3 825 320
- CN-A- 107 759 638
- KR-A- 20190 106 807
- US-A1- 2017 346 025

## Description

### FIELD OF THE INVENTION

The present disclosure relates to an organometallic compound, an organic light-emitting device including the organometallic compound, and an electronic apparatus including the organic light-emitting device.

### BACKGROUND OF THE INVENTION

Organic light-emitting devices (OLEDs) are self-emissive devices which produce full-color images. In addition, OLEDs have wide viewing angles and exhibit excellent driving voltage and response speed characteristics.

OLEDs include an anode, a cathode, and an organic layer between the anode and the cathode and including an emission layer. A hole transport region may be located between the anode and the emission layer, and an electron transport region may be located between the emission layer and the cathode. Holes provided from the anode may move toward the emission layer through the hole transport region, and electrons provided from the cathode may move toward the emission layer through the electron transport region. The holes and the electrons recombine in the emission layer to produce excitons. These excitons transit from an excited state to a ground state to thereby generate light.

Heteroleptic organometallic compounds similar to those claimed used in light-emitting devices are known from KR20190106807, EP3825320, EP3705483, US2017/346025, CN107759638.

### SUMMARY OF THE INVENTION

Provided are a novel organometallic compound, an organic light-emitting device including the organometallic compound, and an electronic apparatus including the organic light-emitting device.

Additional aspects will be set forth in part in the description which follows and, in part, will be apparent from the description, or may be learned by practice of the presented embodiments of the disclosure.

According an aspect of an embodiment, an organometallic compound may be represented by Formula 1:

Formula 1 M(L₁)ₙ₁(L₂)ₙ₂

wherein, in Formula 1,
M may be a transition metal,
L₁ may be a ligand represented by Formula 2A,
L₂ may be a ligand represented by Formula 2B,
n1 and n2 may each independently be 1 or 2, when n1 is 2, two L₁(s) may be identical to or different from each other, and when n2 is 2, two L₂(s) may be identical to or different from each other,
the sum of n1 and n2 may be 2 or 3,
L₁ may be different from L₂, 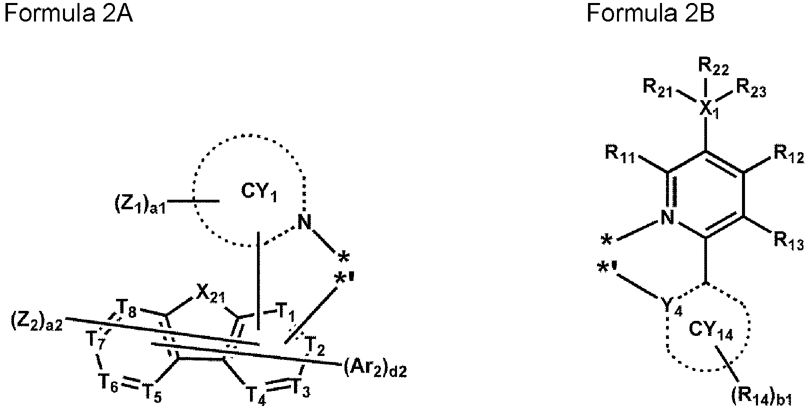
wherein, in Formulae 2A and 2B,
Y₄ may be C or N,
X₁ may be Si or Ge,
X₂₁ may be O, S, S(=O), N(Z₂₉), C(Z₂₉)(Z₃₀), or Si(Z₂₉)(Z₃₀),
T₁ to T₄ may each independently be C, N, a carbon atom bound to ring CY₁, or a carbon atom bound to M in Formula 1, one of T₁ to T₄ may be a carbon atom bound to M in Formula 1, another one of T₁ to T₄, which may not be bound to bound to M, may be a carbon atom bound to ring CY₁,
T₅ to T₈ may each independently be C or N,
the number of N(s) among T₁ to T₈ may be 0 or 1,
ring CY₁ and ring CY₁₄ may each independently be a C₅-C₃₀ carbocyclic group or a C₁-C₃₀ heterocyclic group,
Ar₂ may be ring CY₂ unsubstituted or substituted with at least one Z₀, and ring CY₂ may be an unsaturated C₅-C₃₀ carbocyclic group or an unsaturated C₁-C₃₀ heterocyclic group,
R₂₁ to R₂₃ may each independently be a C₁-C₆₀ alkyl group or a C₆-C₆₀ aryl group, each unsubstituted or substituted with deuterium, -F, -Cl, -Br, -I, -CD₃, -CD₂H, -CDH₂, -CF₃, -CF₂H, -CFH₂, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₂₀ alkyl group, a C₃-C₁₀ cycloalkyl group, a phenyl group, or any combination thereof,
Z₀, Z₁, Z₂, Z₂₉, Z₃₀, and R₁₁ to R₁₄ may each independently be hydrogen, deuterium, -F, -Cl, -Br, -I, -SF₅, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a substituted or unsubstituted C₁-C₆₀ alkyl group, a substituted or unsubstituted C₂-C₆₀ alkenyl group, a substituted or unsubstituted C₂-C₆₀ alkynyl group, a substituted or unsubstituted C₁-C₆₀ alkoxy group, a substituted or unsubstituted C₁-C₆₀ alkylthio group, a substituted or unsubstituted C₃-C₁₀ cycloalkyl group, a substituted or unsubstituted C₁-C₁₀ heterocycloalkyl group, a substituted or unsubstituted C₃-C₁₀ cycloalkenyl group, a substituted or unsubstituted C₁-C₁₀ heterocycloalkenyl group, a substituted or unsubstituted C₆-C₆₀ aryl group, a substituted or unsubstituted C₆-C₆₀ aryloxy group, a substituted or unsubstituted C₆-C₆₀ arylthio group, a substituted or unsubstituted C₁-C₆₀ heteroaryl group, a substituted or unsubstituted monovalent non-aromatic condensed polycyclic group, a substituted or unsubstituted monovalent non-aromatic condensed heteropolycyclic group, -N(Q₁)(Q₂), -Si(Q₃)(Q₄)(Q₅), -Ge(Q₃)(Q₄)(Q₅), -B(Q₆)(Q₇), -P(=O)(Q₈)(Q₉), or - P(Q₈)(Q₉),
d2 may be an integer from 1 to 6, and when d2 is 2 or greater, at least two Ar₂(s) may be identical to or different from each other,
a1 and b1 may each independently be an integer from 0 to 20, when a1 is 2 or greater, at least two Z₁(s) may be identical to or different from each other, and when b1 is 2 or greater, at least two R₁₄(s) may be identical to or different from each other,
a2 may be an integer from 0 to 5, and when a2 is 2 or greater, at least two Z₂(s) may be identical to or different from each other,
Condition 1 or Condition 2 may be satisfied:
   Condition 1
      wherein X₁ in Formula 2B may be Si,
      R₁₂ in Formula 2B may be neither hydrogen nor a methyl group, and
      the number of N(s) among T₁ to T₈ in Formula 2A may be 0, and
   Condition 2
      wherein, in Formula 2B, R₁₂ may be hydrogen, or the number of carbon atoms included in R₁₂ may be 1,
      at least two of R₂₁ to R₂₃ may optionally be bound to each other to form a C₅-C₃₀ carbocyclic group unsubstituted or substituted with at least one R₁₀ₐ or a C₁-C₃₀ heterocyclic group unsubstituted or substituted with at least one R₁₀ₐ,
      at least two of a plurality of Z₁(_{S}) may optionally be bound to each other to form a C₅-C₃₀ carbocyclic group unsubstituted or substituted with at least one R₁₀ₐ or a C₁-C₃₀ heterocyclic group unsubstituted or substituted with at least one R₁₀ₐ,
      at least two of a plurality of Z₂(s) may optionally be bound to each other to form a C₅-C₃₀ carbocyclic group unsubstituted or substituted with at least one R₁₀ₐ or a C₁-C₃₀ heterocyclic group unsubstituted or substituted with at least one R₁₀ₐ,
      R₁₂ and R₁₃ may optionally be bound to each other to form a C₅-C₃₀ carbocyclic group unsubstituted or substituted with at least one R₁₀ₐ or a C₁-C₃₀ heterocyclic group unsubstituted or substituted with at least one R₁₀ₐ,
      at least two of a plurality of R₁₄(s) may optionally be bound to each other to form a C₅-C₃₀ carbocyclic group unsubstituted or substituted with at least one R₁₀ₐ or a C₁-C₃₀ heterocyclic group unsubstituted or substituted with at least one R₁₀ₐ,
      at least two of Z₀, Z₁, Z₂, Z₂₉, Z₃₀, and R₁₁ to R₁₄ may optionally be bound to each other to form a C₅-C₃₀ carbocyclic group unsubstituted or substituted with at least one R₁₀ₐ or a C₁-C₃₀ heterocyclic group unsubstituted or substituted with at least one R₁₀ₐ,
      R₁₀ₐ may be understood by referring to the description of R₁₄ provided herein,
      * and *' in Formulae 2A and 2B each indicate a binding site to M in Formula 1, and
      a substituent of the substituted C₁-C₆₀ alkyl group, the substituted C₂-C₆₀ alkenyl group, the substituted C₂-C₆₀ alkynyl group, the substituted C₁-C₆₀ alkoxy group, the substituted C₁-C₆₀ alkylthio group, the substituted C₃-C₁₀ cycloalkyl group, the substituted C₁-C₁₀ heterocycloalkyl group, the substituted C₃-C₁₀ cycloalkenyl group, the substituted C₁-C₁₀ heterocycloalkenyl group, the substituted C₆-C₆₀ aryl group, the substituted C₆-C₆₀ aryloxy group, the substituted C₆-C₆₀ arylthio group, the substituted C₁-C₆₀ heteroaryl group, the substituted monovalent non-aromatic condensed polycyclic group, and the substituted monovalent non-aromatic condensed heteropolycyclic group may be:
         deuterium, -F, -Cl, -Br, -I, -CD₃, -CD₂H, -CDH₂, -CF₃, -CF₂H, -CFH₂, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₆₀ alkyl group, a C₂-C₆₀ alkenyl group, a C₂-C₆₀ alkynyl group, a C₁-C₆₀ alkoxy group, or a C₁-C₆₀ alkylthio group;
         a C₁-C₆₀ alkyl group, a C₂-C₆₀ alkenyl group, a C₂-C₆₀ alkynyl group, a C₁-C₆₀ alkoxy group, or a C₁-C₆₀ alkylthio group, each substituted with deuterium, -F, -Cl, -Br, -I, -CD₃, -CD₂H, -CDH₂, -CF₃, -CF₂H, -CFH₂, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₆-C₆₀ aryloxy group, a C₆-C₆₀ arylthio group, a C₁-C₆₀ heteroaryl group, a monovalent non-aromatic condensed polycyclic group, a monovalent non-aromatic condensed heteropolycyclic group, -N(Q₁₁)(Q₁₂), - Si(Q₁₃)(Q₁₄)(Q₁₅), -Ge(Q₁₃)(Q₁₄)(Q₁₅), -B(Q₁₆)(Q₁₇), -P(=O)(Q₁₈)(Q₁₉), -P(Q₁₈)(Q₁₉), or any combination thereof;
         a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₆-C₆₀ aryloxy group, a C₆-C₆₀ arylthio group, a C₁-C₆₀ heteroaryl group, a monovalent non-aromatic condensed polycyclic group, or a monovalent non-aromatic condensed heteropolycyclic group, each unsubstituted or substituted with deuterium, -F, -Cl, -Br, -I, -CD₃, -CD₂H, -CDH₂, -CF₃, -CF₂H, -CFH₂, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₆₀ alkyl group, a C₂-C₆₀ alkenyl group, a C₂-C₆₀ alkynyl group, a C₁-C₆₀ alkoxy group, a C₁-C₆₀ alkylthio group, a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₆-C₆₀ aryloxy group, a C₆-C₆₀ arylthio group, a C₁-C₆₀ heteroaryl group, a monovalent non-aromatic condensed polycyclic group, a monovalent non-aromatic condensed heteropolycyclic group, - N(Q₂₁)(Q₂₂), -Si(Q₂₃)(Q₂₄)(Q₂₅), -Ge(Q₂₃)(Q₂₄)(Q₂₅), -B(Q₂₆)(Q₂₇), -P(=O)(Q₂₈)(Q₂₉), - P(Q₂₈)(Q₂₉), or any combination thereof;
         -N(Q₃₁)(Q₃₂), -Si(Q₃₃)(Q₃₄)(Q₃₅), -Ge(Q₃₃)(Q₃₄)(Q₃₅), -B(Q₃₆)(Q₃₇), - P(=O)(Q₃₈)(Q₃₉), or -P(Q₃₈)(Q₃₉); or
         any combination thereof,
         wherein Q₁ to Q₉, Q₁₁ to Q₁₉, Q₂₁ to Q₂₉, and Q₃₁ to Q₃₉ may each independently be: hydrogen; deuterium; -F; -Cl; -Br; -I; a hydroxyl group; a cyano group; a nitro group; an amino group; an amidino group; a hydrazine group; a hydrazone group; a carboxylic acid group or a salt thereof; a sulfonic acid group or a salt thereof; a phosphoric acid group or a salt thereof; a C₁-C₆₀ alkyl group unsubstituted or substituted with deuterium, a C₁-C₆₀ alkyl group, a C₆-C₆₀ aryl group, or any combination thereof; a C₂-C₆₀ alkenyl group; a C₂-C₆₀ alkynyl group; a C₁-C₆₀ alkoxy group; a C₁-C₆₀ alkylthio group; a C₃-C₁₀ cycloalkyl group; a C₁-C₁₀ heterocycloalkyl group; a C₃-C₁₀ cycloalkenyl group; a C₁-C₁₀ heterocycloalkenyl group; a C₆-C₆₀ aryl group unsubstituted or substituted with deuterium, a C₁-C₆₀ alkyl group, a C₆-C₆₀ aryl group, or any combination thereof; a C₆-C₆₀ aryloxy group; a C₆-C₆₀ arylthio group; a C₁-C₆₀ heteroaryl group; a monovalent non-aromatic condensed polycyclic group; or a monovalent non-aromatic condensed heteropolycyclic group.

According to an aspect of another embodiment, an organic light-emitting device may include: a first electrode; a second electrode; and an organic layer located between the first electrode and the second electrode, wherein the organic layer may include an emission layer and at least one of the organometallic compound.

The organometallic compound may be included in the emission layer of the organic layer, and the organometallic compound included in the emission layer may serve as a dopant.

According to an aspect of another embodiment, an electronic apparatus may include the organic light-emitting device.

### BRIEF DESCRIPTION OF THE DRAWINGS

The above and other aspects, features, and advantages of certain embodiments of the disclosure will be more apparent from the following description taken in conjunction with the accompanying drawings, in which:

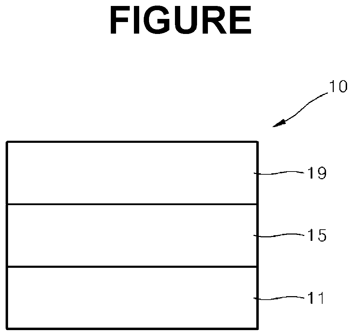

FIG. 1 is a schematic cross-sectional view of an organic light-emitting device according to an embodiment;

### DETAILED DESCRIPTION OF THE EMBODIMENTS

Reference will now be made in detail to embodiments, examples of which are illustrated in the accompanying drawings, wherein like reference numerals refer to like elements throughout. In this regard, the present embodiments may have different forms and should not be construed as being limited to the descriptions set forth herein. Accordingly, the embodiments are merely described below, by referring to the figures, to explain aspects. As used herein, the term "and/or" includes any and all combinations of one or more of the associated listed items. Expressions such as "at least one of," when preceding a list of elements, modify the entire list of elements and do not modify the individual elements of the list.

An organometallic compound may be represented by Formula 1:

Formula 1 M(L₁)ₙ₁(L₂)ₙ₂

wherein, in Formula 1, M may be a transition metal.

In some embodiments, M may be a first-row transition metal, a second-row transition metal, or a third-row transition metal.

In some embodiments, M may be iridium (Ir), platinum (Pt), osmium (Os), titanium (Ti), zirconium (Zr), hafnium (Hf), europium (Eu), terbium (Tb), thulium (Tm), or rhodium (Rh).

In an embodiment, M may be Ir, Pt, Os, or Rh.

In Formula 1, L₁ may be a ligand represented by Formula 2A, n1 in Formula 1 indicates the number of L₁(s) in Formula 1, and n1 may be 1 or 2. When n1 is 2, two L₁(s) may be identical to or different from each other.

In Formula 1, L₂ may be a ligand represented by Formula 2B, n2 in Formula 1 indicates the number of L₂(s) in Formula 1, and n2 may be 1 or 2. When n2 is 2, two L₂(s) may be identical to or different from each other.

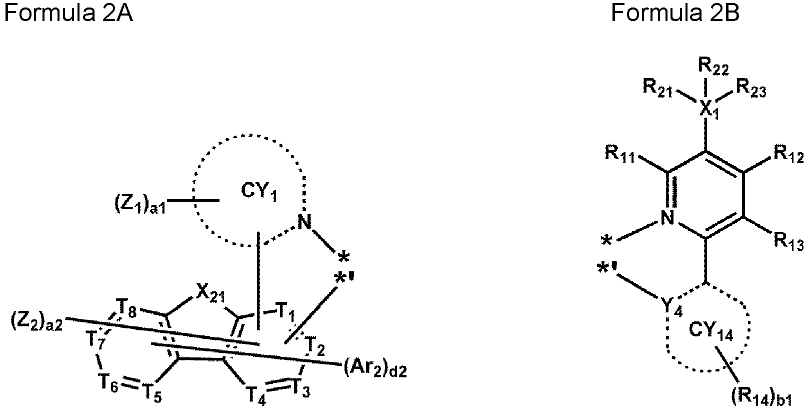

Formulae 2A and 2B may respectively be understood by referring to the descriptions of Formulae 2A and 2B provided herein.

L₁ and L₂ in Formula 1 may be different from each other. That is, the organometallic compound represented by Formula 1 may be a heteroleptic complex.

In some embodiments, M may be Ir, n1+n2=3; or M may be Pt, n1+n2=2.

In some embodiments, M may be Ir in Formula 1 and i) n1 may be 1 and n2 may be 2; or ii) n1 may be 2 and n2 may be 1.

In Formula 2B, Y₄ may be C or N.

In some embodiments, in Formula 2B, Y₄ may be C.

In Formula 2B, X₁ may be Si or Ge.

In Formula 2A, X₂₁ may be O, S, S(=O), N(Z₂₉), C(Z₂₉)(Z₃₀), or Si(Z₂₉)(Z₃₀). Z₂₉ and Z₃₀ may respectively be understood by referring to the descriptions of Z₂₉ and Z₃₀ provided herein.

In some embodiments, X₂₁ in Formula 2A may be O or S.

In Formula 2A, T₁ to T₄ may each independently be C, N, a carbon atom bound to ring CY₁, or a carbon atom bound to M in Formula 1, one of T₁ to T₄ may be a carbon atom bound to M in Formula 1, another one of T₁ to T₄, which may not be bound to bound to M, may be a carbon atom bound to ring CY₁, and T₅ to T₈ may each independently be C or N.

The number of N(s) among T₁ to T₈ in Formula 2A may be 0 or 1.

In Formulae 2A and 2B, ring CY₁ and ring CY₁₄ may each independently be a C₅-C₃₀ carbocyclic group or a C₁-C₃₀ heterocyclic group, Ar₂ in Formula 2A may be ring CY₂ unsubstituted or substituted with at least one Z₀, and ring CY₂ may be an unsaturated C₅-C₃₀ carbocyclic group or an unsaturated C₁-C₃₀ heterocyclic group. Z₀ may be understood by referring to the description of Z₀ provided herein.

In an embodiment, in Formulae 2A and 2B, ring CY₁ and ring CY₁₄ may each independently be a cyclopentane group, a cyclohexane group, a cycloheptane group, a cyclopentene group, a cyclohexene group, a cycloheptene group, a benzene group, a naphthalene group, an anthracene group, a phenanthrene group, a triphenylene group, a pyrene group, a chrysene group, a cyclopentadiene group, a 1,2,3,4-tetrahydronaphthalene group, a thiophene group, a furan group, a borole group, a phosphole group, a silole group, a germole group, a selenophene group, an indole group, a benzoborole group, a benzophosphole group, an indene group, a benzosilole group, a benzogermole group, a benzothiophene group, a benzoselenophene group, a benzofuran group, a carbazole group, a dibenzoborole group, a dibenzophosphole group, a fluorene group, a dibenzosilole group, a dibenzogermole group, a dibenzothiophene group, a dibenzoselenophenegroup, a dibenzofuran group, a dibenzothiophene 5-oxide group, a 9H-fluorene-9-one group, a dibenzothiophene 5,5-dioxide group, an azaindole group, an azabenzoborole group, an azabenzophosphole group, an azaindene group, an azabenzosilole group, an azabenzogermole group, an azabenzothiophene group, an azabenzoselenophene group, an azabenzofuran group, an azacarbazole group, an azadibenzoborole group, an azadibenzophosphole group, an azafluorene group, an azadibenzosilole group, an azadibenzogermole group, an azadibenzothiophene group, an azadibenzoselenophene group, an azadibenzofuran group, an azadibenzothiophene 5-oxide group, an aza-9H-fluoren-9-one group, an azadibenzothiophene 5,5-dioxide group, a pyridine group, a pyrimidine group, a pyrazine group, a pyridazine group, a triazine group, a quinoline group, an isoquinoline group, a quinoxaline group, a quinazoline group, a phenanthroline group, a pyrrole group, a pyrazole group, an imidazole group, a triazole group, an oxazole group, an isooxazole group, a thiazole group, an isothiazole group, an oxadiazole group, a thiadiazole group, a benzopyrazole group, a benzimidazole group, a benzoxazole group, a benzothiazole group, a benzoxadiazole group, a benzothiadiazole group, a 5,6,7,8-tetrahydroisoquinoline group, a 5,6,7,8-tetrahydroquinoline group, an adamantane group, a norbornane group, or a norbornene group.

In one or more embodiments, ring CY₁ and ring CY₁₄ may each independently be a benzene group, a naphthalene group, a 1,2,3,4-tetrahydronaphthalene group, a phenanthrene group, a pyridine group, a pyrimidine group, a pyrazine group, a triazine group, a benzofuran group, a benzothiophene group, a fluorene group, a carbazole group, a dibenzofuran group, a dibenzothiophene group, a dibenzosilole group, an azafluorene group, an azacarbazole group, an azadibenzofuran group, an azadibenzothiophene group, or an azadibenzosilole group.

In one or more embodiments, in Formula 2A, ring CY₁ may be a pyridine group, a 5,6,7,8-tetrahydroisoquinoline group, or a 5,6,7,8-tetrahydroquinoline.

In one or more embodiments, in Formula 2B, ring CY₁₄ may be a benzene group, a naphthalene group, a 1,2,3,4-tetrahydronaphthalene group, a phenanthrene group, a dibenzothiophene group, a dibenzofuran group, or a pyridine group.

In one or more embodiments, ring CY₂ may be a benzene group, a naphthalene group, an anthracene group, a phenanthrene group, a triphenylene group, a pyrene group, a chrysene group, a cyclopentadiene group, a 1,2,3,4-tetrahydronaphthalene group, a thiophene group, a furan group, a borole group, a phosphole group, a silole group, a germole group, a selenophene group, an indole group, a benzoborole group, a benzophosphole group, an indene group, a benzosilole group, a benzogermole group, a benzothiophene group, a benzoselenophene group, a benzofuran group, a carbazole group, a dibenzoborole group, a dibenzophosphole group, a fluorene group, a dibenzosilole group, a dibenzogermole group, a dibenzothiophene group, a dibenzoselenophenegroup, a dibenzofuran group, a dibenzothiophene 5-oxide group, a 9H-fluorene-9-one group, a dibenzothiophene 5,5-dioxide group, an azaindole group, an azabenzoborole group, an azabenzophosphole group, an azaindene group, an azabenzosilole group, an azabenzogermole group, an azabenzothiophene group, an azabenzoselenophene group, an azabenzofuran group, an azacarbazole group, an azadibenzoborole group, an azadibenzophosphole group, an azafluorene group, an azadibenzosilole group, an azadibenzogermole group, an azadibenzothiophene group, an azadibenzoselenophene group, an azadibenzofuran group, an azadibenzothiophene 5-oxide group, an aza-9H-fluoren-9-one group, an azadibenzothiophene 5,5-dioxide group, a pyridine group, a pyrimidine group, a pyrazine group, a pyridazine group, a triazine group, a quinoline group, an isoquinoline group, a quinoxaline group, a quinazoline group, a phenanthroline group, a pyrrole group, a pyrazole group, an imidazole group, a triazole group, an oxazole group, an isooxazole group, a thiazole group, an isothiazole group, an oxadiazole group, a thiadiazole group, a benzopyrazole group, a benzimidazole group, a benzoxazole group, a benzothiazole group, a benzoxadiazole group, a benzothiadiazole group, a 5,6,7,8-tetrahydroisoquinoline group, or a 5,6,7,8-tetrahydroquinoline group.

In Formula 2B, R₂₁ to R₂₃ may each independently be a C₁-C₆₀ alkyl group or a C₆-C₆₀ aryl group, each unsubstituted or substituted with deuterium, -F, -Cl, -Br, -I, - CD₃, -CD₂H, -CDH₂, -CF₃, -CF₂H, -CFH₂, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₂₀ alkyl group, a C₃-C₁₀ cycloalkyl group, a phenyl group, or any combination thereof.

In some embodiments, in Formula 2B, R₂₁ to R₂₃ may each independently be a methyl group, an ethyl group, *an n-propyl group,* an iso-propyl group, *an n-butyl group, a sec-butyl group,* an isobutyl group, *a tert-butyl group, an n-pentyl group, a tert-pentyl group,* a neopentyl group, an isopentyl group, *a see-pentyl group,* a 3-pentyl group, *a sec*-isopentyl group, *an n-hexyl group,* an iso-hexyl group, *a see-hexyl group, a tert-hexyl group, an n-heptyl group,* an iso-heptyl group, *a see-heptyl group, a tert-heptyl group, an n-octyl group,* an iso-octyl group, *a sec-octyl group, a tert-octyl group, an n-nonyl group,* an iso-nonyl group, a *sec-nonyl group, a tert-nonyl group, an n-decyl group,* an iso-decyl group, a *sec-decyl group, a tert-decyl group,* a phenyl group, a biphenyl group, or a naphthyl group, each unsubstituted or substituted with deuterium, -F, -Cl, -Br, -I, -CD₃, -CD₂H, -CDH₂, -CF₃, -CF₂H, -CFH₂, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₂₀ alkyl group, a C₃-C₁₀ cycloalkyl group, a phenyl group, or any combination thereof.

In an embodiment, in Formula 2B, R₂₁ to R₂₃ may each independently be -CH₃, -CH₂CH₃, -CD₃, -CD₂H, -CDH₂, -CH₂CD₃, or -CD₂CH₃.

In one or more embodiments, in Formula 2B, R₂₁ to R₂₃ may be identical to one another.

In one or more embodiments, in Formula 2B, at least two of R₂₁ to R₂₃ may be different from each other.

In Formulae 2A and 2B, Z₀, Z₁, Z₂, Z₂₉, Z₃₀, and R₁₁ to R₁₄ may each independently be hydrogen, deuterium, -F, -Cl, -Br, -I, -SF₅, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a substituted or unsubstituted C₁-C₆₀ alkyl group, a substituted or unsubstituted C₂-C₆₀ alkenyl group, a substituted or unsubstituted C₂-C₆₀ alkynyl group, a substituted or unsubstituted C₁-C₆₀ alkoxy group, a substituted or unsubstituted C₁-C₆₀ alkylthio group, a substituted or unsubstituted C₃-C₁₀ cycloalkyl group, a substituted or unsubstituted C₁-C₁₀ heterocycloalkyl group, a substituted or unsubstituted C₃-C₁₀ cycloalkenyl group, a substituted or unsubstituted C₁-C₁₀ heterocycloalkenyl group, a substituted or unsubstituted C₆-C₆₀ aryl group, a substituted or unsubstituted C₆-C₆₀ aryloxy group, a substituted or unsubstituted C₆-C₆₀ arylthio group, a substituted or unsubstituted C₁-C₆₀ heteroaryl group, a substituted or unsubstituted monovalent non-aromatic condensed polycyclic group, a substituted or unsubstituted monovalent non-aromatic condensed heteropolycyclic group, -N(Q₁)(Q₂), -Si(Q₃)(Q₄)(Q₅), -Ge(Q₃)(Q₄)(Q₅), - B(Q₆)(Q₇), -P(=O)(Q₈)(Q₉), or -P(Q₈)(Q₉), wherein Q₁ to Q₉ may respectively be understood by referring to the descriptions of Q₁ to Q₉ provided herein.

In Formula 2A, d2 indicates the number of Ar₂(s), and d2 may be an integer from 1 to 6. When d2 is 2 or greater, at least two Ar₂(s) may be identical to different from each other. In some embodiments, d2 may be 1, 2, or 3. In an embodiment, d2 may be 1 or 2.

In Formulae 2A and 2B, a1 and b1 may respectively indicate the number of Z₁(s) and R₁₄(s), and a1 and b1 may each independently be an integer from 0 to 20. When a1 is 2 or greater, at least two Z₁(s) may be identical to or different from each other. When b1 is 2 or greater, at least two R₁₄(s) may be identical to or different from each other. In some embodiments, a1 and b1 may each independently be an integer from 0 to 10.

In Formula 2A, a2 indicates the number of Z₂(s), and a2 may be an integer from 0 to 5. When a2 is 2 or greater, at least two Z₂(s) may be identical to different from each other. In some embodiments, a2 may be 0, 1, 2, or 3.

In some embodiments, Z₁ in Formula 2A and R₁₁ to R₁₃ in Formula 2B may each independently be:
hydrogen, deuterium, -F, or a cyano group;
a C₁-C₂₀ alkyl group unsubstituted or substituted with deuterium, -F, a cyano group, a C₃-C₁₀ cycloalkyl group, a deuterated C₃-C₁₀ cycloalkyl group, a fluorinated C₃-C₁₀ cycloalkyl group, a (C₁-C₂₀ alkyl)C₃-C₁₀ cycloalkyl group, a C₁-C₁₀ heterocycloalkyl group, a deuterated C₁-C₁₀ heterocycloalkyl group, a fluorinated C₁-C₁₀ heterocycloalkyl group, a (C₁-C₂₀ alkyl)C₁-C₁₀ heterocycloalkyl group, a phenyl group, a deuterated phenyl group, a fluorinated a phenyl group, a (C₁-C₂₀ alkyl)phenyl group, a biphenyl group, a deuterated biphenyl group, a fluorinated biphenyl group, a (C₁-C₂₀ alkyl)biphenyl group, or any combination thereof; or
a C₃-C₁₀ cycloalkyl group, a C₁-C₁₀ heterocycloalkyl group, a phenyl group, or a biphenyl group, each unsubstituted or substituted with deuterium, -F, a cyano group, a C₁-C₂₀ alkyl group, a deuterated C₁-C₂₀ alkyl group, a fluorinated C₁-C₂₀ alkyl group, a C₁-C₂₀ alkoxy group, a deuterated C₁-C₂₀ alkoxy group, a fluorinated C₁-C₂₀ alkoxy group, a C₃-C₁₀ cycloalkyl group, a deuterated C₃-C₁₀ cycloalkyl group, a fluorinated C₃-C₁₀ cycloalkyl group, a (C₁-C₂₀ alkyl)C₃-C₁₀ cycloalkyl group, a C₁-C₁₀ heterocycloalkyl group, a deuterated C₁-C₁₀ heterocycloalkyl group, a fluorinated C₁-C₁₀ heterocycloalkyl group, a (C₁-C₂₀ alkyl)C₁-C₁₀ heterocycloalkyl group, a phenyl group, a deuterated phenyl group, a fluorinated a phenyl group, a (C₁-C₂₀ alkyl)phenyl group, a biphenyl group, a deuterated biphenyl group, a fluorinated a biphenyl group, a (C₁-C₂₀ alkyl)biphenyl group, or any combination thereof.

In some embodiments, Z₁ in Formula 2A and R₁₁ to R₁₃ in Formula 2B may each independently be:
hydrogen or deuterium;
a C₁-C₂₀ alkyl group unsubstituted or substituted with deuterium, a C₃-C₁₀ cycloalkyl group, a deuterated C₃-C₁₀ cycloalkyl group, a (C₁-C₂₀ alkyl)C₃-C₁₀ cycloalkyl group, a C₁-C₁₀ heterocycloalkyl group, a deuterated C₁-C₁₀ heterocycloalkyl group, a (C₁-C₂₀ alkyl)C₁-C₁₀ heterocycloalkyl group, a phenyl group, a deuterated phenyl group, a (C₁-C₂₀ alkyl)phenyl group, a biphenyl group, a deuterated biphenyl group, a (C₁-C₂₀ alkyl)biphenyl group, or any combination thereof; or
a C₃-C₁₀ cycloalkyl group, a C₁-C₁₀ heterocycloalkyl group, a phenyl group, or a biphenyl group, each unsubstituted or substituted with deuterium, -F, a cyano group, a C₁-C₂₀ alkyl group, a deuterated C₁-C₂₀ alkyl group, a C₁-C₂₀ alkoxy group, a deuterated C₁-C₂₀ alkoxy group, a C₃-C₁₀ cycloalkyl group, a deuterated C₃-C₁₀ cycloalkyl group, a (C₁-C₂₀ alkyl)C₃-C₁₀ cycloalkyl group, a C₁-C₁₀ heterocycloalkyl group, a deuterated C₁-C₁₀ heterocycloalkyl group, a (C₁-C₂₀ alkyl)C₁-C₁₀ heterocycloalkyl group, a phenyl group, a deuterated phenyl group, a (C₁-C₂₀ alkyl)phenyl group, a biphenyl group, a deuterated biphenyl group, a (C₁-C₂₀ alkyl)biphenyl group, or any combination thereof.

In one or more embodiments, Z₀ and Z₂ in Formula 2A and R₁₄ in Formula 2B may each independently be:
hydrogen, deuterium, -F, or a cyano group;
a C₁-C₂₀ alkyl group unsubstituted or substituted with deuterium, -F, a cyano group, a C₃-C₁₀ cycloalkyl group, a deuterated C₃-C₁₀ cycloalkyl group, a fluorinated C₃-C₁₀ cycloalkyl group, a (C₁-C₂₀ alkyl)C₃-C₁₀ cycloalkyl group, a C₁-C₁₀ heterocycloalkyl group, a deuterated C₁-C₁₀ heterocycloalkyl group, a fluorinated C₁-C₁₀ heterocycloalkyl group, a (C₁-C₂₀ alkyl)C₁-C₁₀ heterocycloalkyl group, a phenyl group, a deuterated phenyl group, a fluorinated a phenyl group, a (C₁-C₂₀ alkyl)phenyl group, a biphenyl group, a deuterated biphenyl group, a fluorinated biphenyl group, a (C₁-C₂₀ alkyl)biphenyl group, or any combination thereof;
a C₃-C₁₀ cycloalkyl group, a C₁-C₁₀ heterocycloalkyl group, a phenyl group, or a biphenyl group, each unsubstituted or substituted with deuterium, -F, a cyano group, a C₁-C₂₀ alkyl group, a deuterated C₁-C₂₀ alkyl group, a fluorinated C₁-C₂₀ alkyl group, a C₁-C₂₀ alkoxy group, a deuterated C₁-C₂₀ alkoxy group, a fluorinated C₁-C₂₀ alkoxy group, a C₃-C₁₀ cycloalkyl group, a deuterated C₃-C₁₀ cycloalkyl group, a fluorinated C₃-C₁₀ cycloalkyl group, a (C₁-C₂₀ alkyl)C₃-C₁₀ cycloalkyl group, a C₁-C₁₀ heterocycloalkyl group, a deuterated C₁-C₁₀ heterocycloalkyl group, a fluorinated C₁-C₁₀ heterocycloalkyl group, a (C₁-C₂₀ alkyl)C₁-C₁₀ heterocycloalkyl group, a phenyl group, a deuterated phenyl group, a fluorinated a phenyl group, a (C₁-C₂₀ alkyl)phenyl group, a biphenyl group, a deuterated biphenyl group, a fluorinated a biphenyl group, a (C₁-C₂₀ alkyl)biphenyl group, or any combination thereof; or
-Si(Q₃)(Q₄)(Q₅), or -Ge(Q₃)(Q₄)(Q₅).

In one or more embodiments, in Formulae 2A and 2B, Z₀, Z₁, Z₂, Z₂₉, Z₃₀, and R₁₁ to R₁₄ may each independently be:
hydrogen, deuterium, -F, -Cl, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, -SF₅, a C₁-C₂₀ alkyl group, a C₁-C₂₀ alkoxy group, or a C₁-C₂₀ alkylthio group;
a C₁-C₂₀ alkyl group, a C₁-C₂₀ alkoxy group, or a C₁-C₂₀ alkylthio group, each substituted with deuterium, -F, -Cl, -Br, -I, -CD₃, -CD₂H, -CDH₂, -CF₃, -CF₂H, -CFH₂, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₁₀ alkyl group, a cyclopentyl group, a cyclohexyl group, a cycloheptyl group, a cyclooctyl group, an adamantanyl group, a norbornanyl group, a norbornenyl group, a cyclopentenyl group, a cyclohexenyl group, a cycloheptenyl group, a bicyclo[1.1.1]pentyl group, a bicyclo[2.1.1]hexyl group, a bicyclo[2.2.2]octyl group, a (C₁-C₂₀ alkyl)cyclopentyl group, a (C₁-C₂₀ alkyl)cyclohexyl group, a (C₁-C₂₀ alkyl)cycloheptyl group, a (C₁-C₂₀ alkyl)cyclooctyl group, a (C₁-C₂₀ alkyl)adamantanyl group, a (C₁-C₂₀ alkyl)norbornanyl group, a (C₁-C₂₀ alkyl)norbornenyl group, a (C₁-C₂₀ alkyl)cyclopentenyl group, a (C₁-C₂₀ alkyl)cyclohexenyl group, a (C₁-C₂₀ alkyl)cycloheptenyl group, a (C₁-C₂₀ alkyl)bicyclo[1.1.1]pentyl group, a (C₁-C₂₀ alkyl)bicyclo[2.1.1]hexyl group, a (C₁-C₂₀ alkyl)bicyclo[2.2.2]octyl group, a phenyl group, a (C₁-C₂₀ alkyl)phenyl group, a biphenyl group, a terphenyl group, a naphthyl group, a pyridinyl group, a pyrimidinyl group, or any combination thereof;
a cyclopentyl group, a cyclohexyl group, a cycloheptyl group, a cyclooctyl group, an adamantanyl group, a norbornanyl group, a norbornenyl group, a cyclopentenyl group, a cyclohexenyl group, a cycloheptenyl group, a bicyclo[1.1.1]pentyl group, a bicyclo[2.1.1]hexyl group, a bicyclo[2.2.2]octyl group, a phenyl group, a (C₁-C₂₀ alkyl)phenyl group, a biphenyl group, a terphenyl group, a naphthyl group, a fluorenyl group, a phenanthrenyl group, an anthracenyl group, a fluoranthenyl group, a triphenylenyl group, a pyrenyl group, a chrysenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a quinoxalinyl group, a quinazolinyl group, a cinnolinyl group, a carbazolyl group, a phenanthrolinyl group, a benzimidazolyl group, a benzofuranyl group, a benzothiophenyl group, a benzoisothiazolyl group, a benzoxazolyl group, a benzoisoxazolyl group, a triazolyl group, a tetrazolyl group, an oxadiazolyl group, a triazinyl group, a dibenzofuranyl group, a dibenzothiophenyl group, a benzocarbazolyl group, a dibenzocarbazolyl group, an imidazopyridinyl group, an imidazopyrimidinyl group, an azacarbazolyl group, an azadibenzofuranyl group, or an azadibenzothiophenyl group, each unsubstituted or substituted with deuterium, -F, -Cl, -Br, -I, -CD₃, -CD₂H, -CDH₂, -CF₃, -CF₂H, -CFH₂, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₂₀ alkyl group, a (phenyl)C₁-C₁₀ alkyl group, a C₁-C₂₀ alkoxy group, a cyclopentyl group, a cyclohexyl group, a cycloheptyl group, a cyclooctyl group, an adamantanyl group, a norbornanyl group, a norbornenyl group, a cyclopentenyl group, a cyclohexenyl group, a cycloheptenyl group, a bicyclo[1.1.1]pentyl group, a bicyclo[2.1.1]hexyl group, a bicyclo[2.2.2]octyl group, a (C₁-C₂₀ alkyl)cyclopentyl group, a (C₁-C₂₀ alkyl)cyclohexyl group, a (C₁-C₂₀ alkyl)cycloheptyl group, a (C₁-C₂₀ alkyl)cyclooctyl group, a (C₁-C₂₀ alkyl)adamantanyl group, a (C₁-C₂₀ alkyl)norbornanyl group, a (C₁-C₂₀ alkyl)norbornenyl group, a (C₁-C₂₀ alkyl)cyclopentenyl group, a (C₁-C₂₀ alkyl)cyclohexenyl group, a (C₁-C₂₀ alkyl)cycloheptenyl group, a (C₁-C₂₀ alkyl)bicyclo[1.1.1]pentyl group, a (C₁-C₂₀ alkyl)bicyclo[2.1.1]hexyl group, a (C₁-C₂₀ alkyl)bicyclo[2.2.2]octyl group, a phenyl group, a (C₁-C₂₀ alkyl)phenyl group, a biphenyl group, a terphenyl group, a naphthyl group, a fluorenyl group, a phenanthrenyl group, an anthracenyl group, a fluoranthenyl group, a triphenylenyl group, a pyrenyl group, a chrysenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a quinoxalinyl group, a quinazolinyl group, a cinnolinyl group, a carbazolyl group, a phenanthrolinyl group, a benzimidazolyl group, a benzofuranyl group, a benzothiophenyl group, a benzoisothiazolyl group, a benzoxazolyl group, a benzoisoxazolyl group, a triazolyl group, a tetrazolyl group, an oxadiazolyl group, a triazinyl group, a dibenzofuranyl group, a dibenzothiophenyl group, a benzocarbazolyl group, a dibenzocarbazolyl group, an imidazopyridinyl group, an imidazopyrimidinyl group, an azacarbazolyl group, an azadibenzofuranyl group, an azadibenzothiophenyl group, or any combination thereof; or
-N(Q₁)(Q₂), -Si(Q₃)(Q₄)(Q₅), -Ge(Q₃)(Q₄)(Q₅), -B(Q₆)(Q₇), -P(=O)(Q₈)(Q₉), or - P(Q₈)(Q₉),
wherein Q₁ to Q₉ may each independently be:

   -CH₃, -CD₃, -CD₂H, -CDH₂, -CH₂CH₃, -CH₂CD₃, -CH₂CD₂H, -CH₂CDH₂, - CHDCH₃, -CHDCD₂H, -CHDCDH₂, -CHDCD₃, -CD₂CD₃, -CD₂CD₂H, or -CD₂CDH₂;
an *n*-propyl group, an *iso*-propyl group, an *n*-butyl group, a *sec*-butyl group, an isobutyl group, a *tert*-butyl group, an *n*-pentyl group, a *tert*-pentyl group, a neopentyl group, an isopentyl group, a see-pentyl group, a 3-pentyl group, a see-isopentyl group, a phenyl group, a biphenyl group, or a naphthyl group, each unsubstituted or substituted with deuterium, a C₁-C₁₀ alkyl group, a phenyl group, or any combination thereof.

In one or more embodiments, R₂₁ to R₂₃, Z₁, Z₂, and R₁₁ to R₁₄ in Formulae 2A and 2B may not include silicon (Si). Accordingly, an electronic device, e.g., an organic light-emitting device, including the organometallic compound represented by Formula 1 may have improved out-coupling characteristics.

In one or more embodiments, the organometallic compound represented by Formula 1 may satisfy at least one of Conditions A, B, and C:
Condition A
   wherein, Z₁ in Formula 2A may not be hydrogen, and a1 may not be 0,
Condition B
   wherein, Z₂ in Formula 2A may not be hydrogen, and a2 may not be 0, and
Condition C
   R₁₄ in Formula 2B may not be hydrogen, and b1 may not be 0.

The organometallic compound represented by Formula 1 may satisfy Condition 1 or Condition 2:
Condition 1
   wherein X₁ in Formula 2B may be Si,
   R₁₂ in Formula 2B may not be hydrogen and a methyl group, and
   the number of N(s) among T₁ to T₈ in Formula 2A may be 0, and
Condition 2
   wherein, in Formula 2B, R₁₂ may be hydrogen, or the number of carbon atoms included in R₁₂ may be 1 (for example, R₁₂ in Formula 2B may be hydrogen, a methyl group, or a deuterated methyl group (for example, -CH₂D, -CHD₂ or -CD₃)).

In an embodiment, the organometallic compound represented by Formula 1 may satisfy Condition 1.

In one or more embodiments, the organometallic compound represented by Formula 1 may satisfy Condition 1 and the number of carbon atoms included in R₁₂ of Formula 2B may be 2 or higher.

In one or more embodiments, the organometallic compound represented by Formula 1 may satisfy Condition 1 and R₁₂ in Formula 2B may be:
a C₂-C₂₀ alkyl group or a C₂-C₂₀ alkoxy group;
a methyl group or a methoxy group, each substituted with a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₁₄ aryl group, a C₁-C₁₄ heteroaryl group, a monovalent non-aromatic condensed polycyclic group, a monovalent non-aromatic condensed heteropolycyclic group, or any combination thereof;
a C₂-C₂₀ alkyl group or a C₂-C₂₀ alkoxy group, each substituted with deuterium, -F, -Cl, -Br, -I, -CD₃, -CD₂H, -CDH₂, -CF₃, -CF₂H, -CFH₂, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₁₀ alkyl group, a C₁-C₁₀ alkoxy group, a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₁₄ aryl group, a C₁-C₁₄ heteroaryl group, a monovalent non-aromatic condensed polycyclic group, a monovalent non-aromatic condensed heteropolycyclic group, or any combination thereof; or
a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₁₄ aryl group, a C₁-C₁₄ heteroaryl group, a monovalent non-aromatic condensed polycyclic group, or a monovalent non-aromatic condensed heteropolycyclic group, each unsubstituted or substituted with deuterium, -F, -Cl, -Br, -I, -CD₃, -CD₂H, -CDH₂, -CF₃, -CF₂H, -CFH₂, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₂₀ alkyl group, a C₁-C₂₀ alkoxy group, a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₁₄ aryl group, a C₁-C₁₄ heteroaryl group, a monovalent non-aromatic condensed polycyclic group, a monovalent non-aromatic condensed heteropolycyclic group, or any combination thereof.

In one or more embodiments, the organometallic compound represented by Formula 1 may satisfy Condition 1 and R₁₂ in Formula 2B may be:
a methyl group or a methoxy group, substituted with a cyclopentyl group, a cyclohexyl group, a cycloheptyl group, a cyclooctyl group, an adamantanyl group, a norbornanyl group, a norbornenyl group, a cyclopentenyl group, a cyclohexenyl group, a cycloheptenyl group, a bicyclo[1.1.1]pentyl group, a bicyclo[2.1.1]hexyl group, a bicyclo[2.2.2]octyl group, a (C₁-C₂₀ alkyl)cyclopentyl group, a (C₁-C₂₀ alkyl)cyclohexyl group, a (C₁-C₂₀ alkyl)cycloheptyl group, a (C₁-C₂₀ alkyl)cyclooctyl group, a (C₁-C₂₀ alkyl)adamantanyl group, a (C₁-C₂₀ alkyl)norbornanyl group, a (C₁-C₂₀ alkyl)norbornenyl group, a (C₁-C₂₀ alkyl)cyclopentenyl group, a (C₁-C₂₀ alkyl)cyclohexenyl group, a (C₁-C₂₀ alkyl)cycloheptenyl group, a (C₁-C₂₀ alkyl)bicyclo[1.1.1]pentyl group, a (C₁-C₂₀ alkyl)bicyclo[2.1.1]hexyl group, a (C₁-C₂₀ alkyl)bicyclo[2.2.2]octyl group, a phenyl group, a (C₁-C₂₀ alkyl)phenyl group, a naphthyl group, a pyridinyl group, a pyrimidinyl group, or any combination thereof;
a methyl group or a methoxy group, substituted with i) a cyclopentyl group, a cyclohexyl group, a cycloheptyl group, a cyclooctyl group, an adamantanyl group, a norbornanyl group, a norbornenyl group, a cyclopentenyl group, a cyclohexenyl group, a cycloheptenyl group, a bicyclo[1.1.1]pentyl group, a bicyclo[2.1.1]hexyl group, a bicyclo[2.2.2]octyl group, a (C₁-C₂₀ alkyl)cyclopentyl group, a (C₁-C₂₀ alkyl)cyclohexyl group, a (C₁-C₂₀ alkyl)cycloheptyl group, a (C₁-C₂₀ alkyl)cyclooctyl group, a (C₁-C₂₀ alkyl)adamantanyl group, a (C₁-C₂₀ alkyl)norbornanyl group, a (C₁-C₂₀ alkyl)norbornenyl group, a (C₁-C₂₀ alkyl)cyclopentenyl group, a (C₁-C₂₀ alkyl)cyclohexenyl group, a (C₁-C₂₀ alkyl)cycloheptenyl group, a (C₁-C₂₀ alkyl)bicyclo[1.1.1]pentyl group, a (C₁-C₂₀ alkyl)bicyclo[2.1.1]hexyl group, a (C₁-C₂₀ alkyl)bicyclo[2.2.2]octyl group, a phenyl group, a (C₁-C₂₀ alkyl)phenyl group, a naphthyl group, a pyridinyl group, a pyrimidinyl group, or any combination thereof and ii) at least one deuterium;
a C₂-C₂₀ alkyl group or a C₂-C₂₀ alkoxy group, unsubstituted or substituted with deuterium, -F, -Cl, -Br, -I, -CD₃, -CD₂H, -CDH₂, -CF₃, -CF₂H, -CFH₂, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₂₀ alkyl group, a cyclopentyl group, a cyclohexyl group, a cycloheptyl group, a cyclooctyl group, an adamantanyl group, a norbornanyl group, a norbornenyl group, a cyclopentenyl group, a cyclohexenyl group, a cycloheptenyl group, a bicyclo[1.1.1]pentyl group, a bicyclo[2.1.1]hexyl group, a bicyclo[2.2.2]octyl group, a (C₁-C₂₀ alkyl)cyclopentyl group, a (C₁-C₂₀ alkyl)cyclohexyl group, a (C₁-C₂₀ alkyl)cycloheptyl group, a (C₁-C₂₀ alkyl)cyclooctyl group, a (C₁-C₂₀ alkyl)adamantanyl group, a (C₁-C₂₀ alkyl)norbornanyl group, a (C₁-C₂₀ alkyl)norbornenyl group, a (C₁-C₂₀ alkyl)cyclopentenyl group, a (C₁-C₂₀ alkyl)cyclohexenyl group, a (C₁-C₂₀ alkyl)cycloheptenyl group, a (C₁-C₂₀ alkyl)bicyclo[1.1.1]pentyl group, a (C₁-C₂₀ alkyl)bicyclo[2.1.1]hexyl group, a (C₁-C₂₀ alkyl)bicyclo[2.2.2]octyl group, a phenyl group, a (C₁-C₂₀ alkyl)phenyl group, a naphthyl group, a pyridinyl group, a pyrimidinyl group, or any combination thereof; or
a cyclopentyl group, a cyclohexyl group, a cycloheptyl group, a cyclooctyl group, an adamantanyl group, a norbornanyl group, a norbornenyl group, a cyclopentenyl group, a cyclohexenyl group, a cycloheptenyl group, a bicyclo[1.1.1]pentyl group, a bicyclo[2.1.1]hexyl group, a bicyclo[2.2.2]octyl group, a phenyl group, a (C₁-C₂₀ alkyl)phenyl group, a biphenyl group, a terphenyl group, a naphthyl group, a fluorenyl group, a phenanthrenyl group, an anthracenyl group, a fluoranthenyl group, a triphenylenyl group, a pyrenyl group, a chrysenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a quinoxalinyl group, a quinazolinyl group, a cinnolinyl group, a carbazolyl group, a phenanthrolinyl group, a benzimidazolyl group, a benzofuranyl group, a benzothiophenyl group, a benzoisothiazolyl group, a benzoxazolyl group, a benzoisoxazolyl group, a triazolyl group, a tetrazolyl group, an oxadiazolyl group, a triazinyl group, a dibenzofuranyl group, a dibenzothiophenyl group, a benzocarbazolyl group, a dibenzocarbazolyl group, an imidazopyridinyl group, an imidazopyrimidinyl group, an azacarbazolyl group, an azadibenzofuranyl group or an azadibenzothiophenyl group, each unsubstituted or substituted with deuterium, -F, -Cl, -Br, -I, -CD₃, -CD₂H, -CDH₂, -CF₃, -CF₂H, -CFH₂, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₂₀ alkyl group, a C₁-C₂₀ alkoxy group, a cyclopentyl group, a cyclohexyl group, a cycloheptyl group, a cyclooctyl group, an adamantanyl group, a norbornanyl group, a norbornenyl group, a cyclopentenyl group, a cyclohexenyl group, a cycloheptenyl group, a bicyclo[1.1.1]pentyl group, a bicyclo[2.1.1]hexyl group, a bicyclo[2.2.2]octyl group, a (C₁-C₂₀ alkyl)cyclopentyl group, a (C₁-C₂₀ alkyl)cyclohexyl group, a (C₁-C₂₀ alkyl)cycloheptyl group, a (C₁-C₂₀ alkyl)cyclooctyl group, a (C₁-C₂₀ alkyl)adamantanyl group, a (C₁-C₂₀ alkyl)norbornanyl group, a (C₁-C₂₀ alkyl)norbornenyl group, a (C₁-C₂₀ alkyl)cyclopentenyl group, a (C₁-C₂₀ alkyl)cyclohexenyl group, a (C₁-C₂₀ alkyl)cycloheptenyl group, a (C₁-C₂₀ alkyl)bicyclo[1.1.1]pentyl group, a (C₁-C₂₀ alkyl)bicyclo[2.1.1]hexyl group, a (C₁-C₂₀ alkyl)bicyclo[2.2.2]octyl group, a phenyl group, a (C₁-C₂₀ alkyl)phenyl group, a biphenyl group, a terphenyl group, a naphthyl group, a fluorenyl group, a phenanthrenyl group, an anthracenyl group, a fluoranthenyl group, a triphenylenyl group, a pyrenyl group, a chrysenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a quinoxalinyl group, a quinazolinyl group, a cinnolinyl group, a carbazolyl group, a phenanthrolinyl group, a benzimidazolyl group, a benzofuranyl group, a benzothiophenyl group, a benzoisothiazolyl group, a benzoxazolyl group, a benzoisoxazolyl group, a triazolyl group, a tetrazolyl group, an oxadiazolyl group, a triazinyl group, a dibenzofuranyl group, a dibenzothiophenyl group, a benzocarbazolyl group, a dibenzocarbazolyl group, an imidazopyridinyl group, an imidazopyrimidinyl group, an azacarbazolyl group, an azadibenzofuranyl group, an azadibenzothiophenyl group, or any combination thereof.

In one or more embodiments, the organometallic compound represented by Formula 1 may satisfy Condition 2.

In one or more embodiments, the organometallic compound represented by Formula 1 may satisfy Condition 2, X₁ in Formula 2B may be Si, and the number of N(s) among T₁ to T₈ in Formula 2A may be 0.

In one or more embodiments, the organometallic compound represented by Formula 1 may satisfy Condition 2, X₁ in Formula 2B may be Ge, and the number of N(s) among T₁ to T₈ in Formula 2A may be 0.

In one or more embodiments, the organometallic compound represented by Formula 1 may satisfy Condition 2, X₁ in Formula 2B may be Si, and the number of N(s) among T₁ to T₈ in Formula 2A may be 1.

In one or more embodiments, the organometallic compound represented by Formula 1 may satisfy Condition 2, X₁ in Formula 2B may be Ge, and the number of N(s) among T₁ to T₈ in Formula 2A may be 1.

In one or more embodiments, the organometallic compound represented by Formula 1 may satisfy Condition 2, R₁₂ in Formula 2B may include at least one deuterium.

In one or more embodiments, the organometallic compound represented by Formula 1 may include at least one deuterium, at least one fluoro group (-F), at least one cyano group (-CN), or any combination thereof.

In one or more embodiments, the organometallic compound represented by Formula 1 may include at least one deuterium.

In one or more embodiments, the organometallic compound represented by Formula 1 may satisfy at least one of Conditions (1) to (6); or the organometallic compound represented by Formula 1 may satisfy Condition (7):
Condition (1)
   wherein, in Formula 2A, a1 may not be 0, and at least one of Z₁(s) in the number of a1 may include deuterium,
Condition (2)
   wherein, in Formula 2A, a2 may not be 0, at least one of Z₂(s) in the number of a2 may include deuterium, a fluoro group (-F), a cyano group, or any combination thereof,
Condition (3)
   wherein, in Formula 2A, at least one of Ar₂(s) in the number of d2 may include deuterium, a fluoro group (-F), a cyano group, or any combination thereof,
Condition (4)
   wherein, in Formula 2B, at least one of R₂₁ to R₂₃ may include deuterium,
Condition (5)
   wherein, in Formula 2B, R₁₂ may include at least one deuterium,
Condition (6)
   wherein, in Formula 2B, b1 may not be 0, at least one of R₁₄(s) in the number of b1 may include deuterium, a fluoro group (-F), a cyano group, or any combination thereof, and
Condition (7)
   wherein, Z₁, Z₂, and Ar₂ in Formula 2A and R₁₁ to R₁₄ and R₂₁ to R₂₃ in Formula 2B may each consist of carbon and hydrogen.

In one or more embodiments, in Formulae 2A and 2B, Z₀, Z₁, Z₂, Z₂₉, Z₃₀, and R₁₁ to R₁₄ may each independently be hydrogen, deuterium, -F, a cyano group, a nitro group, -SF₅, -CH₃, -CD₃, -CD₂H, -CDH₂, -CF₃, -CF₂H, -CFH₂, -OCH₃, -OCDH₂, - OCD₂H, -OCD₃, -SCH₃, -SCDH₂, -SCD₂H, -SCD₃, a group represented by one of Formulae 9-1 to 9-39, a group represented by one of Formulae 9-1 to 9-39 in which at least one hydrogen is substituted with deuterium, a group represented by one of Formulae 9-1 to 9-39 in which at least one hydrogen is substituted with -F, a group represented by one of Formulae 9-201 to 9-230, a group represented by one of Formulae 9-201 to 9-230 in which at least one hydrogen is substituted with deuterium, a group represented by one of Formulae 9-201 to 9-230 in which at least one hydrogen is substituted with -F, a group represented by one of Formulae 10-1 to 10-145, a group represented by one of Formulae 10-1 to 10-145 in which at least one hydrogen is substituted with deuterium, a group represented by one of Formulae 10-1 to 10-145 in which at least one hydrogen is substituted with -F, a group represented by one of Formulae 10-201 to 10-354, a group represented by one of Formulae 10-201 to 10-354 in which at least one hydrogen is substituted with deuterium, a group represented by one of Formulae 10-201 to 10-354 in which at least one hydrogen is substituted with -F, -Si(Q₃)(Q₄)(Q₅), or -Ge(Q₃)(Q₄)(Q₅), wherein Q₁ to Q₅ may respectively be understood by referring to the descriptions of Q₁ to Q₅ provided herein.

In one or more embodiments, Z₁ in Formula 2A and R₁₁ to R₁₃ in Formula 2B may each independently be hydrogen, deuterium, -CH₃, -CD₃, -CD₂H, -CDH₂, -OCH₃, -OCDH₂, -OCD₂H, -OCD₃, -SCH₃, -SCDH₂, -SCD₂H, -SCD₃, a group represented by one of Formulae 9-1 to 9-39, a group represented by one of Formulae 9-1 to 9-39 in which at least one hydrogen is substituted with deuterium, a group represented by one of Formulae 9-201 to 9-230, a group represented by one of Formulae 9-201 to 9-230 in which at least one hydrogen is substituted with deuterium, a group represented by one of Formulae 10-1 to 10-138 and 10-145, or a group represented by one of Formulae 10-1 to 10-138 and 10-145 in which at least one hydrogen is substituted with deuterium.

In one or more embodiments, Ar₂ in Formula 2A may be a group represented by one of Formulae 10-12 to 10-145, a group represented by one of Formulae 10-12 to 10-145 in which at least hone hydrogen is substituted with deuterium, a group represented by one of Formulae 10-12 to 10-145 in which at least one hydrogen is substituted with -F, a group represented by one of Formulae 10-201 to 10-354, a group represented by one of Formulae 10-201 to 10-354 in which at least one hydrogen is substituted with deuterium, or a group represented by one of Formulae 10-201 to 10-354 in which at least one hydrogen is substituted with -F.

In one or more embodiments, R₁₂ in Formula 2B may be hydrogen, -CH₃, - CH₂D, -CHD₂ or -CD₃.

In one or more embodiments, R₁₂ in Formula 2B may be hydrogen or a methyl group (-CH₃).

In one or more embodiments, R₁₂ in Formula 2B may be -CH₂D, -CHD₂ or - CD₃.

In one or more embodiments, R₁₂ in Formula 2B may be a group represented by one of Formulae 9-1 to 9-39, a group represented by one of Formulae 9-1 to 9-39 in which at least one hydrogen is substituted with deuterium, a group represented by one of Formulae 9-1 to 9-39 in which at least one hydrogen is substituted with -F, a group represented by one of Formulae 9-201 to 9-230, a group represented by one of Formulae 9-201 to 9-230 in which at least one hydrogen is substituted with deuterium, a group represented by one of Formulae 9-201 to 9-230 in which at least one hydrogen is substituted with -F, a group represented by one of Formulae 10-1 to 10-145, a group represented by one of Formulae 10-1 to 10-145 in which at least one hydrogen is substituted with deuterium, a group represented by one of Formulae 10-1 to 10-145 in which at least one hydrogen is substituted with -F, a group represented by one of Formulae 10-201 to 10-354, a group represented by one of Formulae 10-201 to 10-354 in which at least one hydrogen is substituted with deuterium, or a group represented by one of Formulae 10-201 to 10-354 in which at least one hydrogen is substituted with -F.

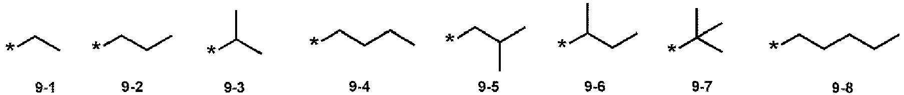

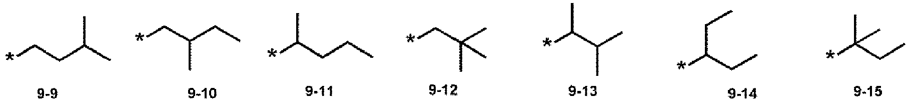

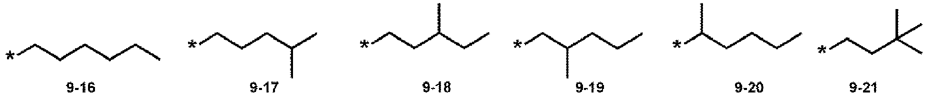

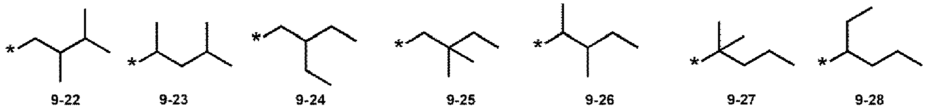

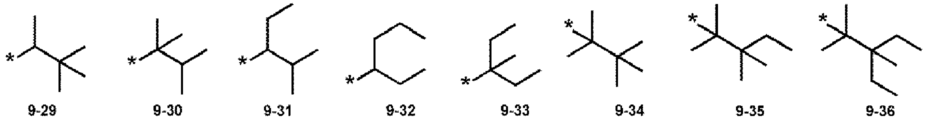

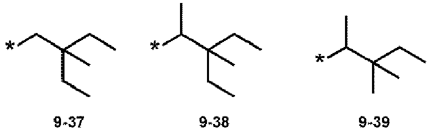

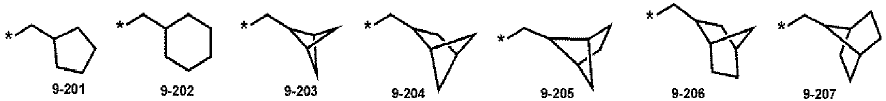

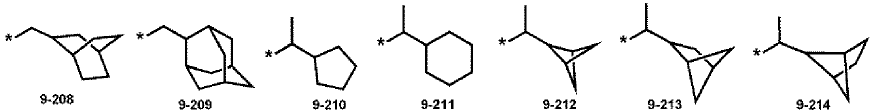

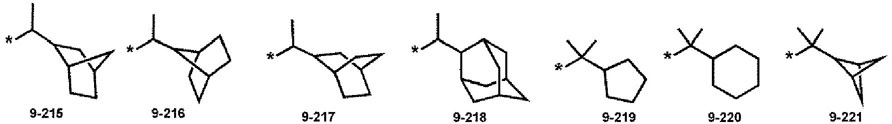

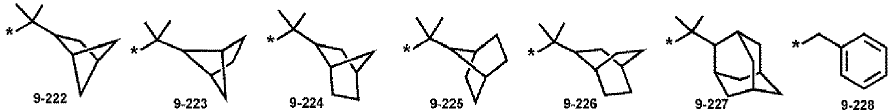

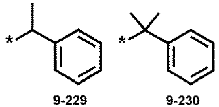

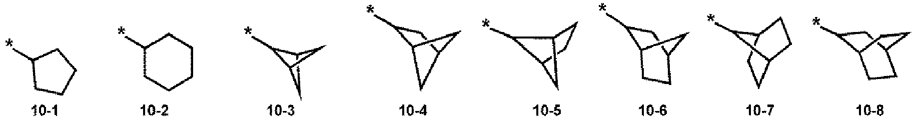

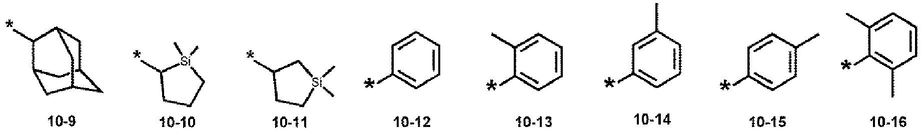

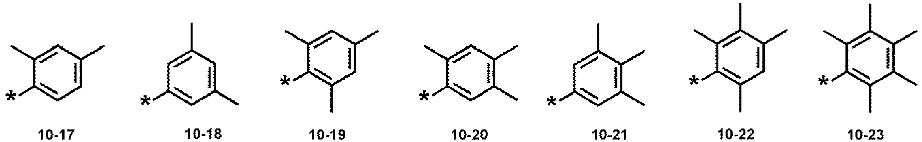

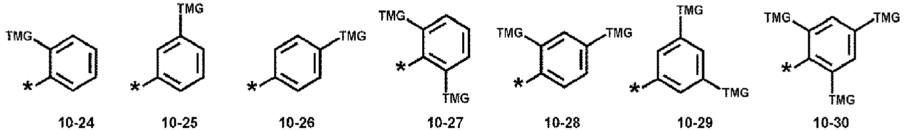

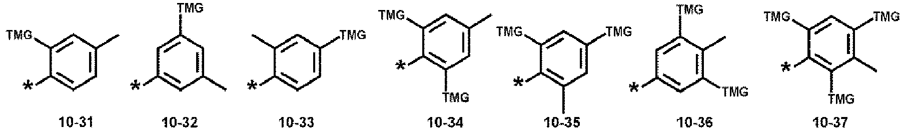

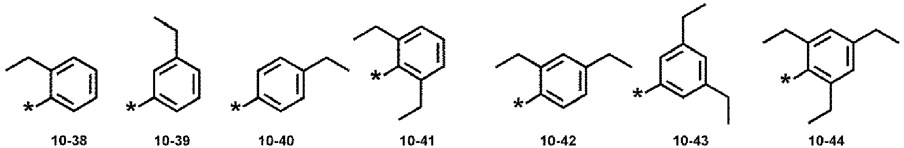

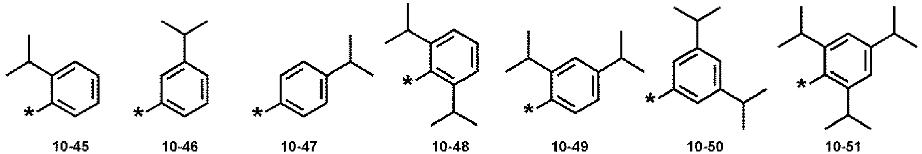

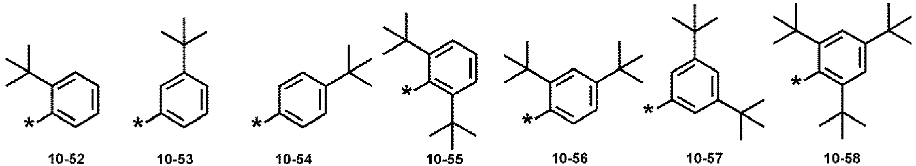

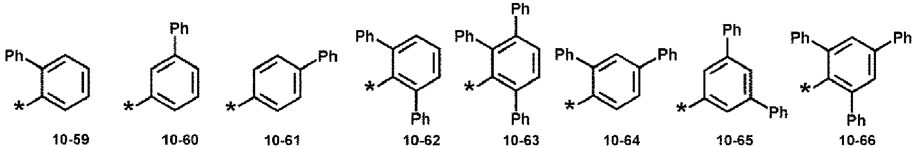

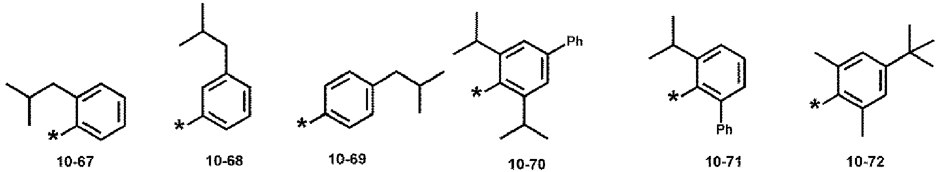

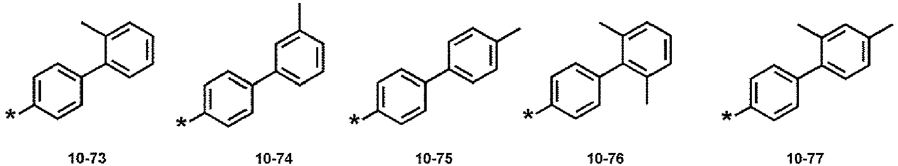

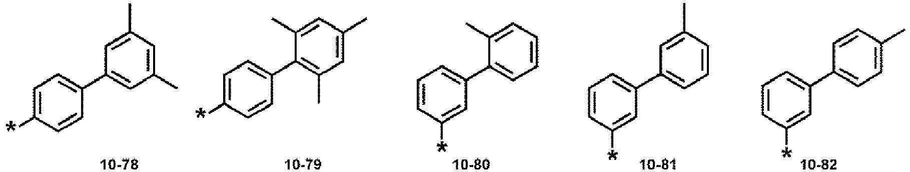

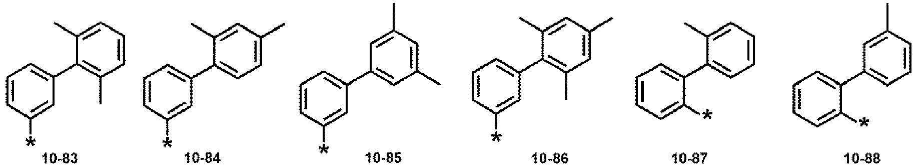

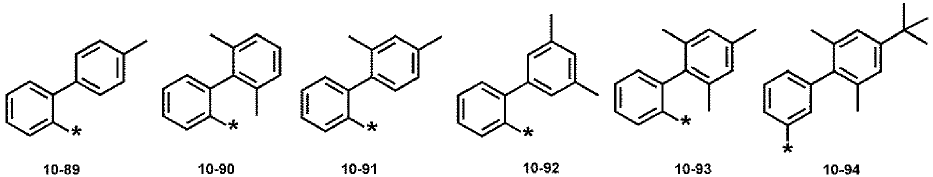

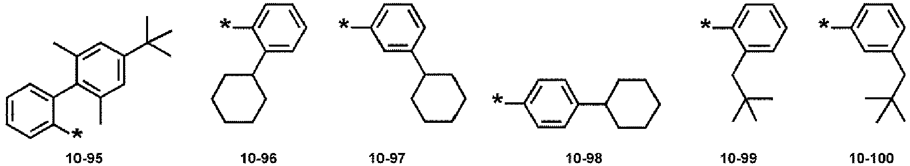

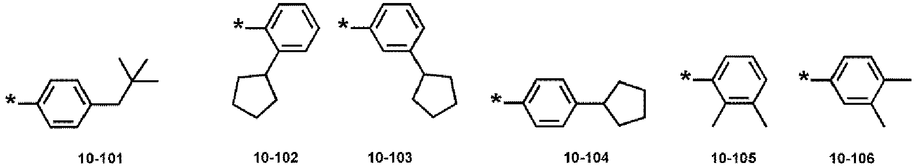

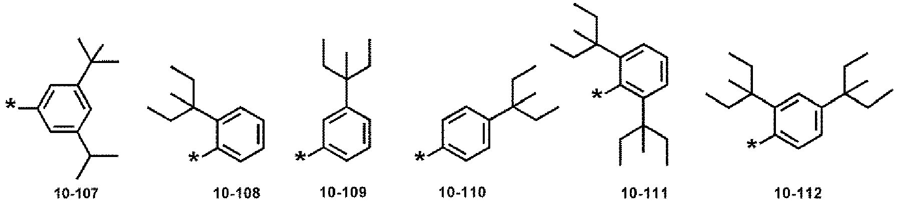

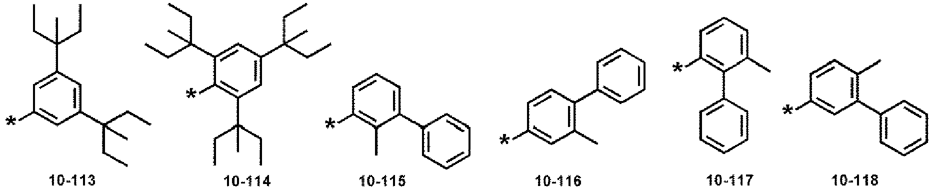

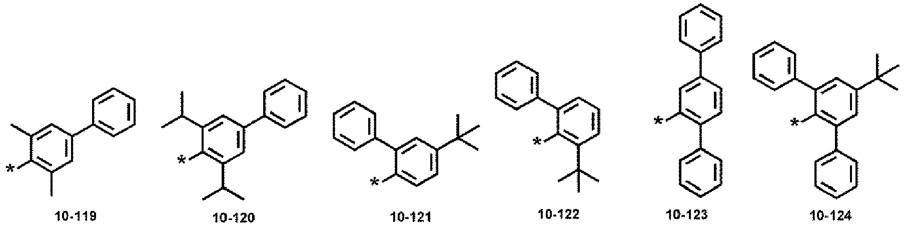

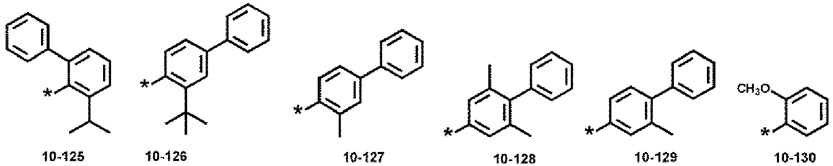

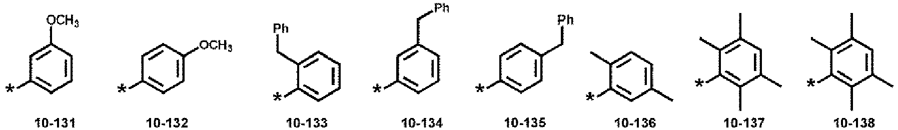

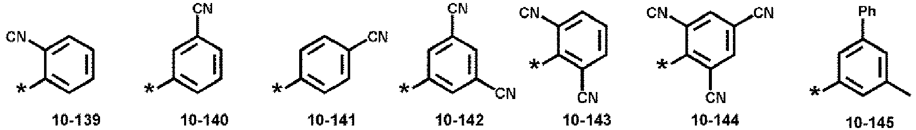

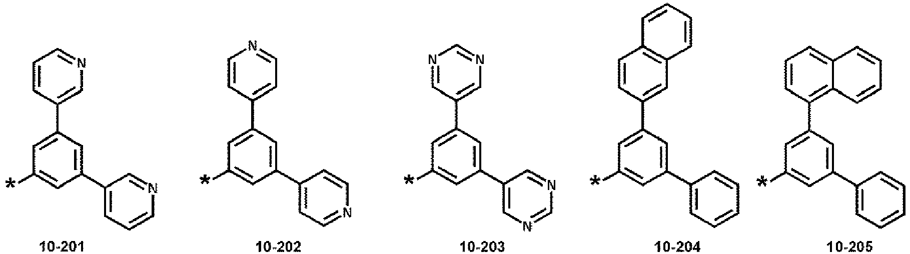

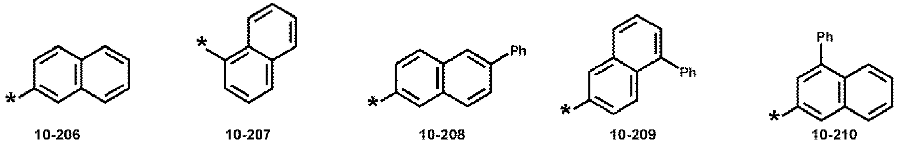

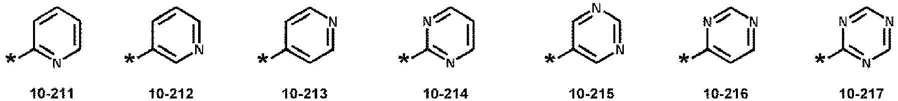

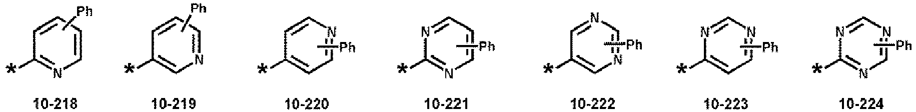

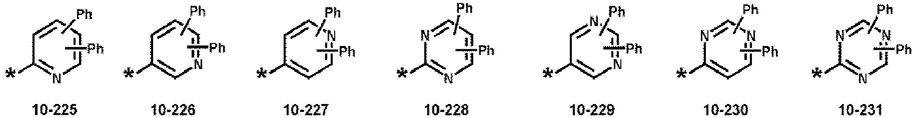

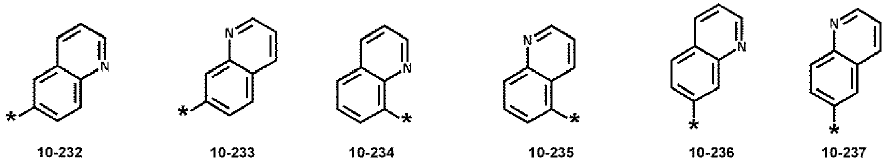

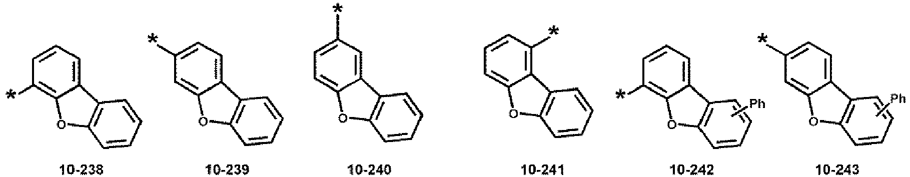

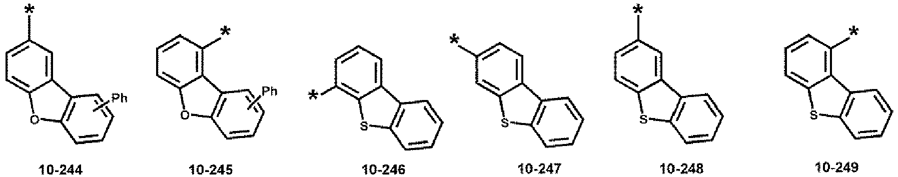

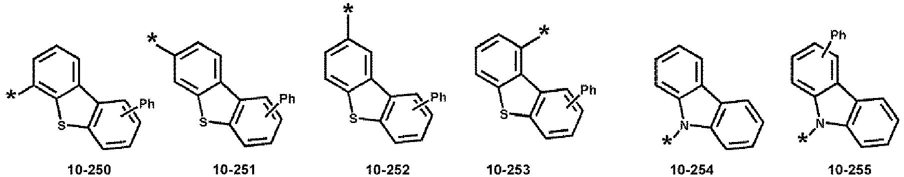

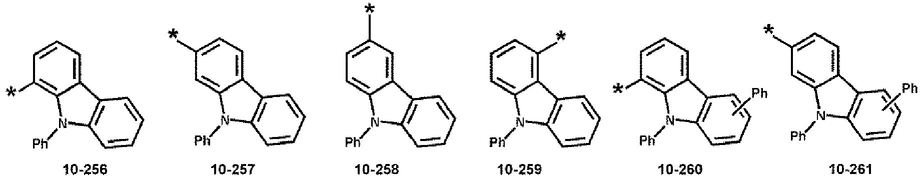

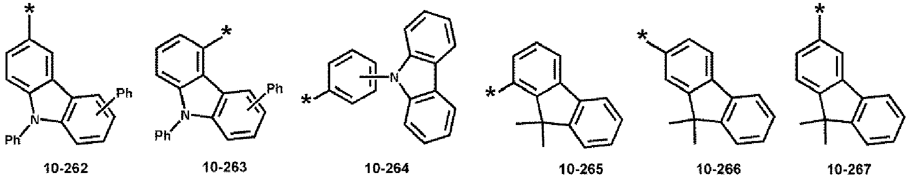

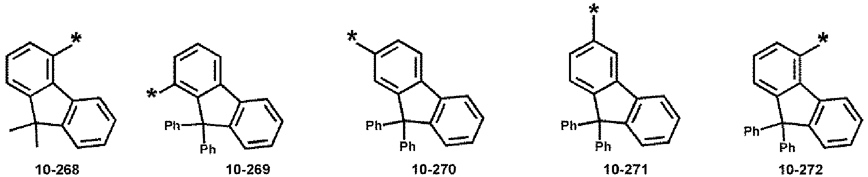

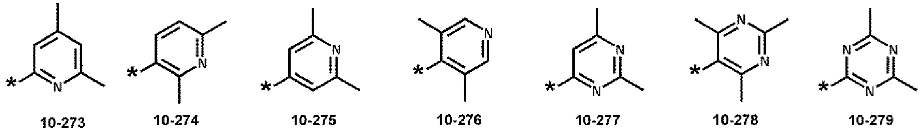

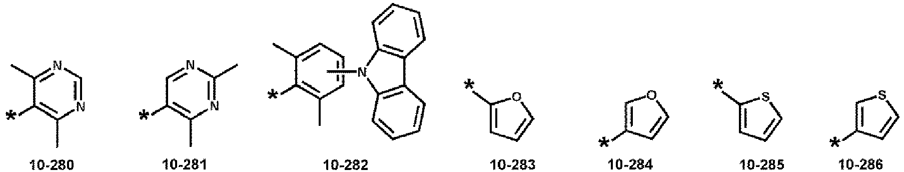

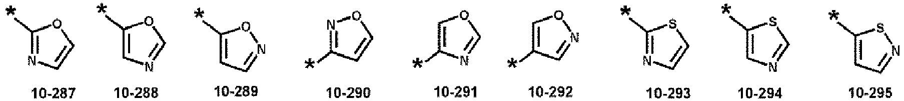

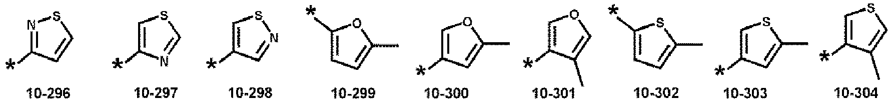

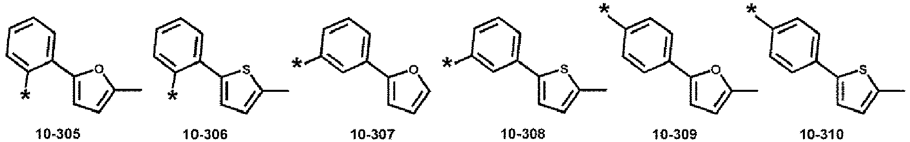

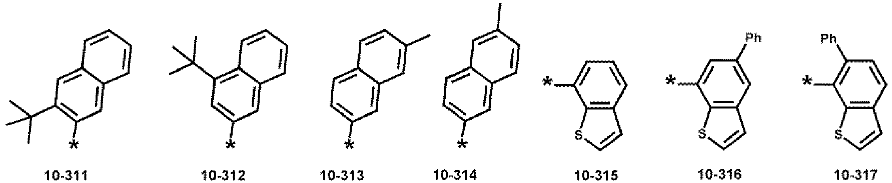

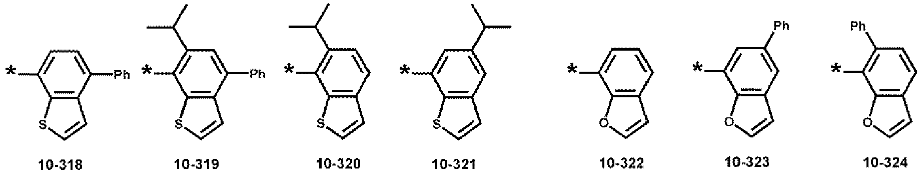

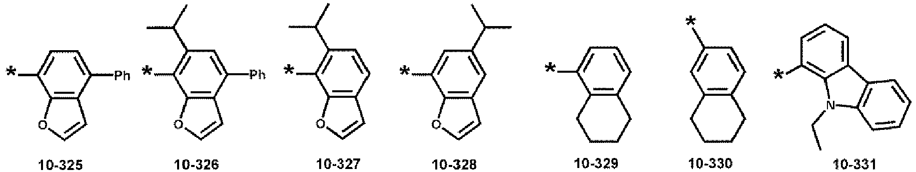

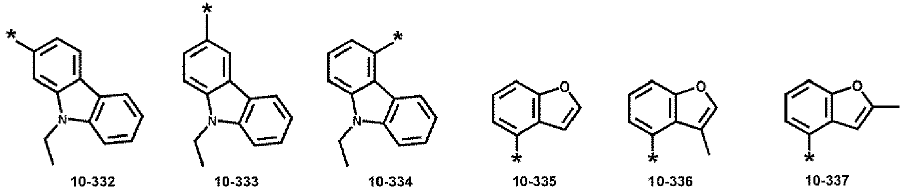

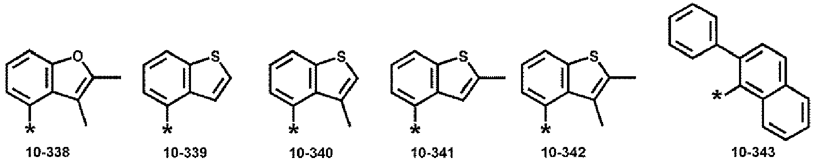

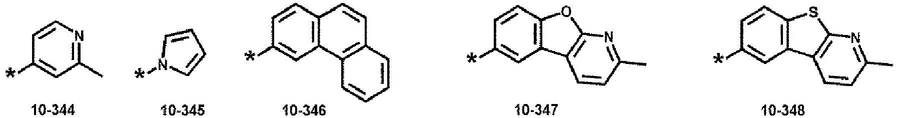

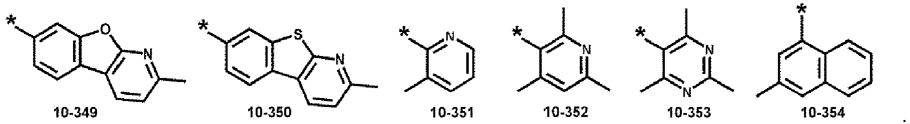

In Formulae 9-1 to 9-39, 9-201 to 9-230, 10-1 to 10-145, and 10-201 to 10-354, * indicates a binding site to an adjacent atom, "Ph" represents a phenyl group, "TMS" represents a trimethylsilyl group, "TMG" represents a trimethylgermyl group, and "OMe" represents a methoxy group.

The "group represented by one of Formulae 9-1 to 9-39 in which at least one hydrogen is substituted with deuterium" and the "group represented by one of Formulae 9-201 to 9-230 in which at least one hydrogen is substituted with deuterium" may each be, for example, a group represented by one of Formulae 9-501 to 9-514 and 9-601 to 9-637:

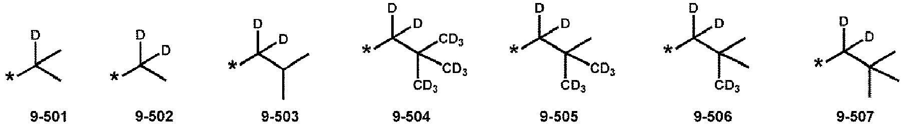

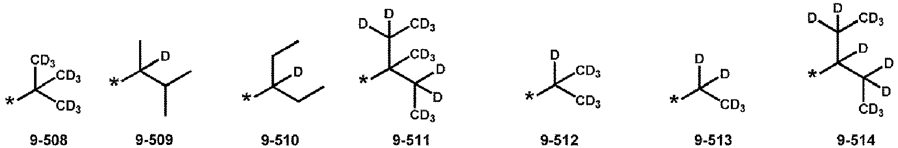

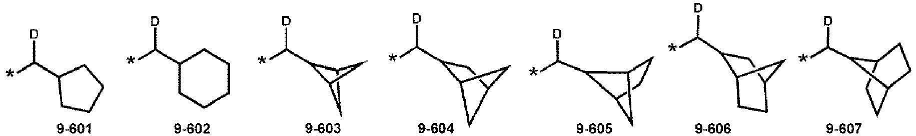

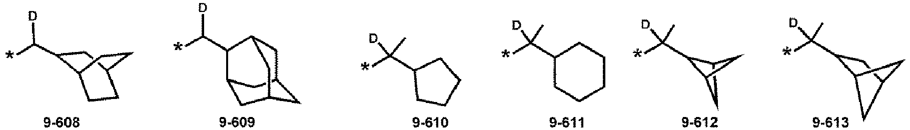

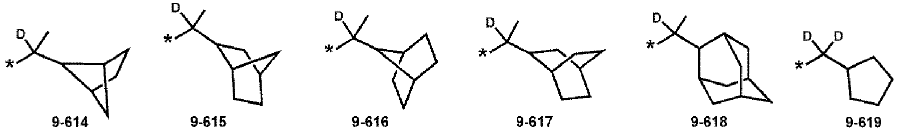

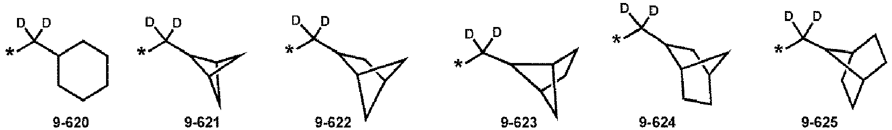

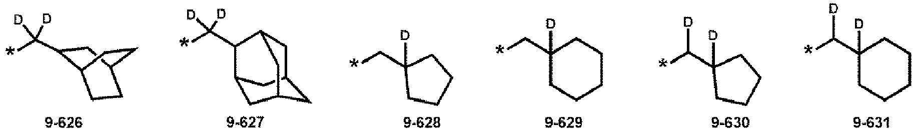

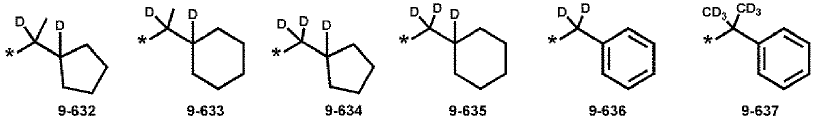

The "group represented by one of Formulae 9-1 to 9-39 in which at least one hydrogen is substituted with -F" and the "group represented by one of Formulae 9-201 to 9-230 in which at least one hydrogen is substituted with -F" may each be, for example, a group represented by one of Formulae 9-701 to 9-710:

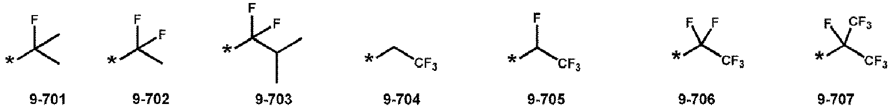

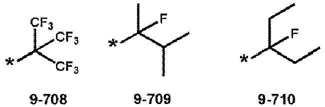

The "group represented by one of Formulae 10-1 to 10-145 in which at least one hydrogen is substituted with a deuterium" and the "group represented by one of Formulae 10-201 to 10-354 in which at least one hydrogen is substituted with deuterium" may each be, for example, a group represented by one of Formulae 10-501 to 10-553:

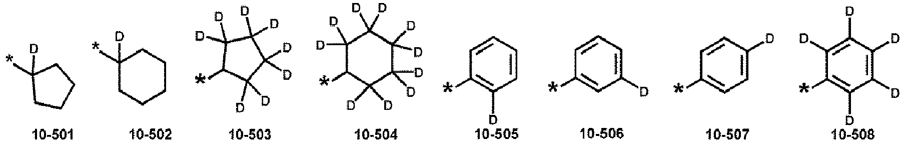

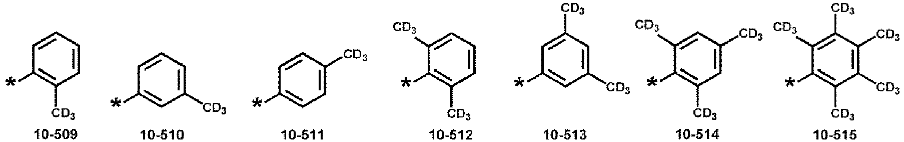

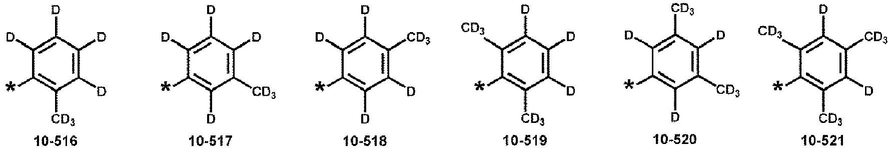

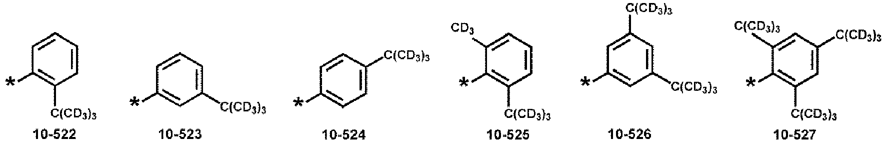

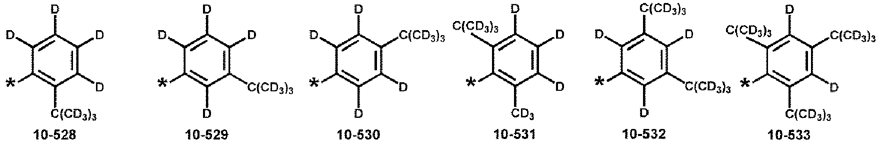

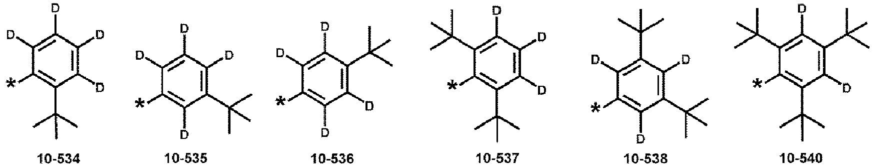

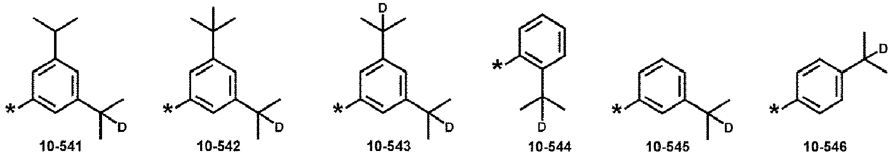

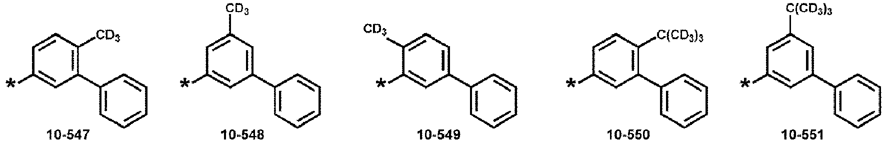

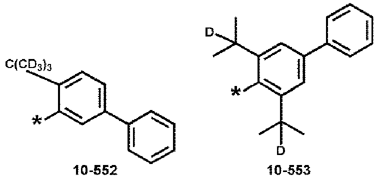

The "group represented by one of Formulae 10-1 to 10-145 in which at least one hydrogen is substituted with -F" and the "group represented by one of Formulae 10-201 to 10-354 in which at least one hydrogen is substituted with -F" may each be, for example, a group represented by one of Formulae 10-601 to 10-636:

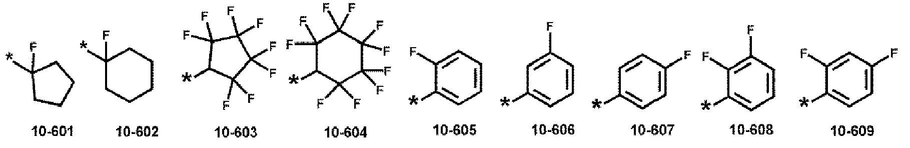

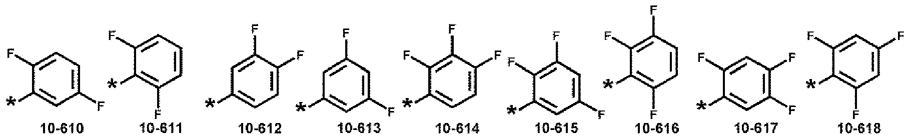

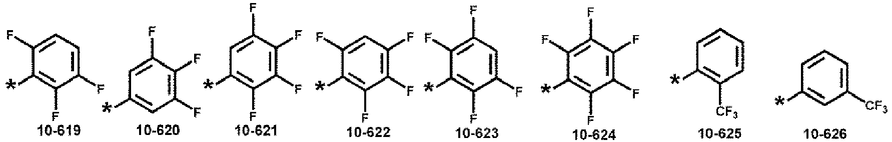

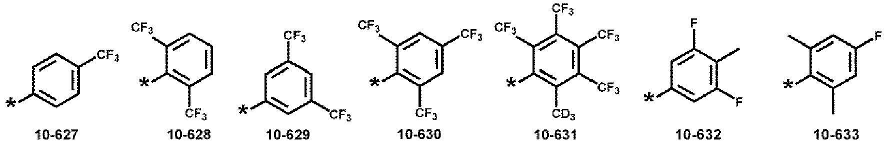

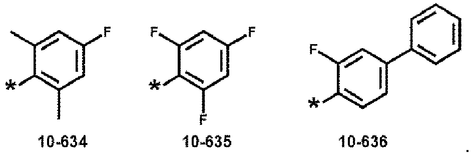

In Formulae 2A and 2B, i) at least two of R₂₁ to R₂₃ may optionally be bound to each other to form a C₅-C₃₀ carbocyclic group unsubstituted or substituted with at least one R₁₀ₐ or a C₁-C₃₀ heterocyclic group unsubstituted or substituted with at least one R₁₀ₐ, ii) at least two of a plurality of Z₁(s) may optionally be bound to each other to form a C₅-C₃₀ carbocyclic group unsubstituted or substituted with at least one R₁₀ₐ or a C₁-C₃₀ heterocyclic group unsubstituted or substituted with at least one R₁₀ₐ, iii) at least two of a plurality of Z₂(s) may optionally be bound to each other to form a C₅-C₃₀ carbocyclic group unsubstituted or substituted with at least one R₁₀ₐ or a C₁-C₃₀ heterocyclic group unsubstituted or substituted with at least one R₁₀ₐ, iv) R₁₂ and R₁₃ may optionally be bound to each other to form a C₅-C₃₀ carbocyclic group unsubstituted or substituted with at least one R₁₀ₐ or a C₁-C₃₀ heterocyclic group unsubstituted or substituted with at least one R₁₀ₐ, v) at least two of a plurality of R₁₄(s) may optionally be bound to each other to form a C₅-C₃₀ carbocyclic group unsubstituted or substituted with at least one R₁₀ₐ or a C₁-C₃₀ heterocyclic group unsubstituted or substituted with at least one R₁₀ₐ, vi) at least two of Z₀, Z₁, Z₂, Z₂₉, Z₃₀, and R₁₁ to R₁₄ may optionally be bound to each other to form a C₅-C₃₀ carbocyclic group unsubstituted or substituted with at least one R₁₀ₐ or a C₁-C₃₀ heterocyclic group unsubstituted or substituted with at least one R₁₀ₐ.

R₁₀ₐ as used herein may be understood by referring to the description of R₁₄ provided herein.
* and *' in Formulae 2A and 2B each indicate a binding site to M in Formula 1.

In an embodiment, in Formula 2A, a group represented by 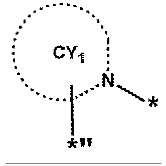 may be a group represented by one of Formulae CY1(1) to CY1(16): 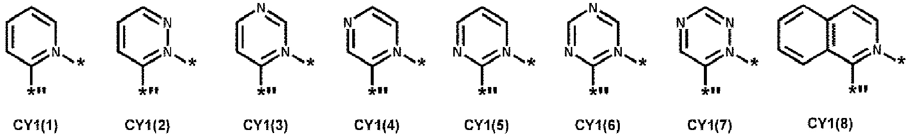 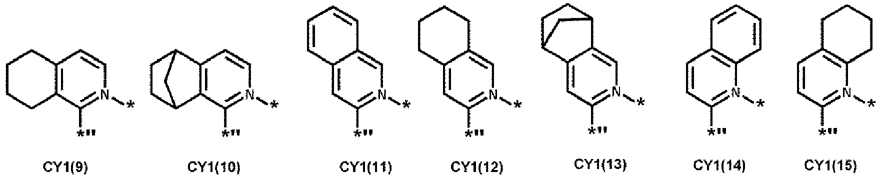 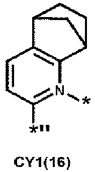 wherein, in Formulae CY1(1) to CY1(16),
* indicates a binding site to M in Formula 1, and
*" indicates a binding site to one of T₁ to T₄ in Formula 2A.

In one or more embodiments, in Formula 2A, a group represented by 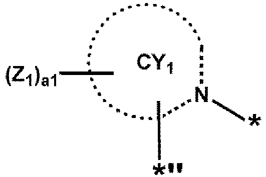 may be a group represented by one of Formulae CY1-1 to CY1-28: 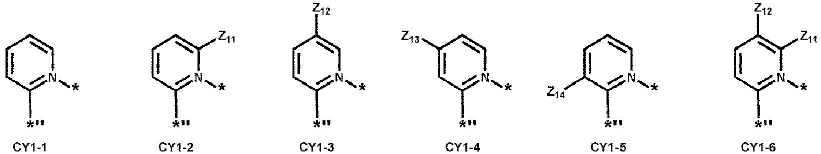 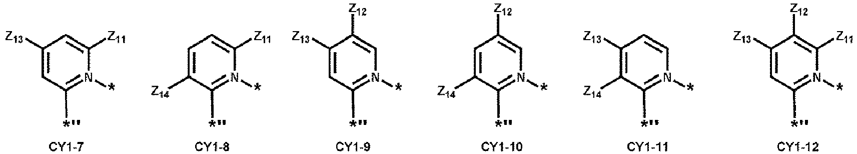 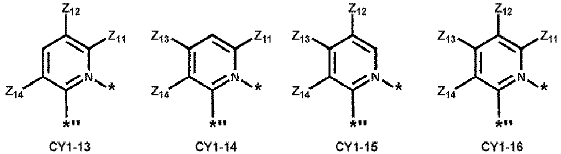 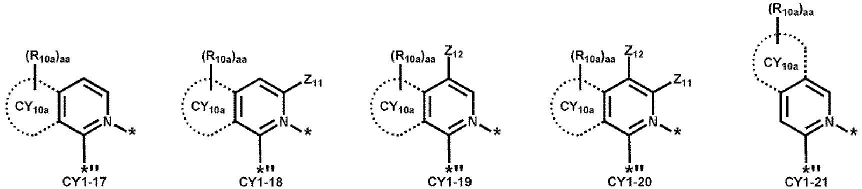 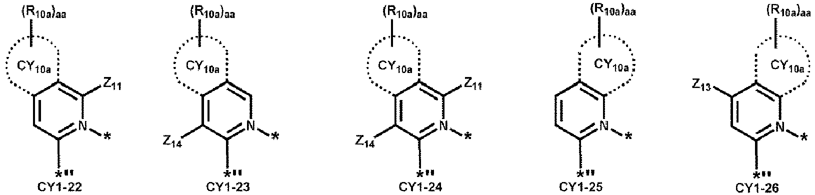 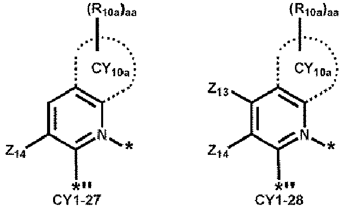
wherein, in Formulae CY1-1 to CY1-28,
Z₁₁ to Z₁₄ may each be the same as described in connection with Z₁ provided herein, wherein Z₁₁ to Z₁₄ may not each be hydrogen,
ring CY₁₀ₐ may be a C₅-C₃₀ carbocyclic group or a C₁-C₃₀ heterocyclic group,
R₁₀ₐ may be the same as described herein,
aa may be an integer from 0 to 10,
* indicates a binding site to M in Formula 1, and
*" indicates a binding site to one of T₁ to T₄ in Formula 2A.

In some embodiments, ring CY₁₀ₐ may be a cyclohexane group, a norbornane group, a benzene group, or a naphthalene group.

In one or more embodiments, in Formula 2A, a group represented by 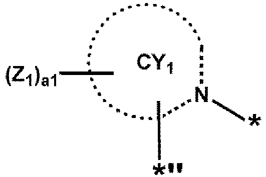 may be a group represented by one of Formulae CY1-1, CY1-4, CY1-7, CY1-9, CY1-11, CY1-12, and CY1-14 to CY1-24.

In one or more embodiments, in Formula 2A, a group represented by 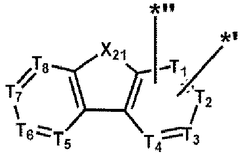 may be a group represented by one of Formulae CY2-1 to CY2-6: 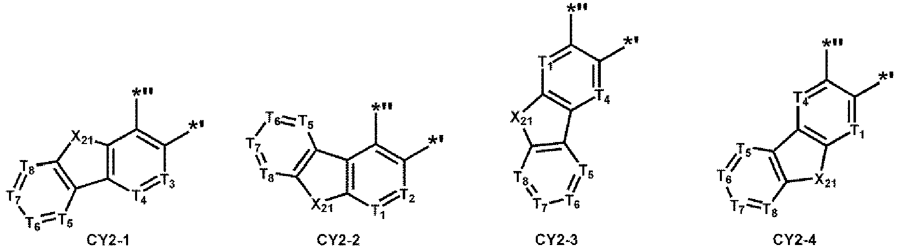 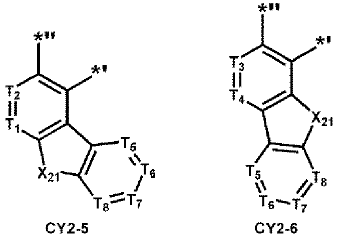
wherein, in Formulae CY2-1 to CY2-6,
T₁ to T₈ may each independently be C or N, the number of N(s) among T₃ to T₈ in Formulae CY2-1 and CY2-6 may be 0 or 1, the number of N(s) among T₁, T₂, T₅, T₆, T₇, and T₈ in Formulae CY2-2 and CY2-5 may be 0 or 1, the number of N(s) among T₁, T₄, T₅, T₆, T₇, and T₈ in Formulae CY2-3 and CY2-4 may be 0 or 1,
X₂₁ may be the same as described herein,
*" indicates a binding site to ring CY₁ in Formula 2A, and
"indicates a binding site to M in Formula 1.

In some embodiments, a group represented by 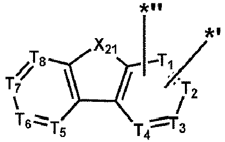 in Formula 2A in the organometallic compound represented by Formula 1 may be a group represented by one of Formulae CY2-1 to CY2-6,
a) X₁ in Formula 2B may be Si, R₁₂ in Formula 2B may not be hydrogen and a methyl group, and the number of N(s) among T₁ to T₈ in Formulae CY2-1 to CY2-6 may be 0,
b) X₁ in Formula 2B may be Si or Ge, R₁₂ in Formula 2B may be hydrogen, a methyl group, or a deuterated methyl group, and the number of N(s) among T₁ to T₈ in Formulae CY2-1 to CY2-6 may be 0,
c) X₁ in Formula 2B may be Si or Ge, R₁₂ in Formula 2B may be hydrogen, a methyl group, or a deuterated methyl group, and the number of N(s) among T₃ to T₈ in Formulae CY2-1 and CY2-6 may be 1,
d) X₁ in Formula 2B may be Si or Ge, R₁₂ in Formula 2B may be hydrogen, a methyl group, or a deuterated methyl group, and the number of N(s) among T₁, T₂, T₅, T₆, T₇ and T₈ in Formulae CY2-2 and CY2-5 may be 1, or
e) X₁ in Formula 2B may be Si or Ge, R₁₂ in Formula 2B may be hydrogen, a methyl group, or a deuterated methyl group, and the number of N(s) among T₁, T₄, T₅, T₆, T₇ and T₈ in Formulae CY2-3 and CY2-4 may be 1.

In one or more embodiments, in Formula 2A, a group represented by 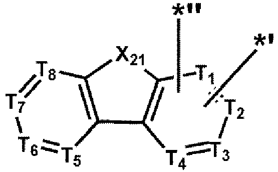 may be a group represented by one of Formulae CY2(1) to CY2(6): 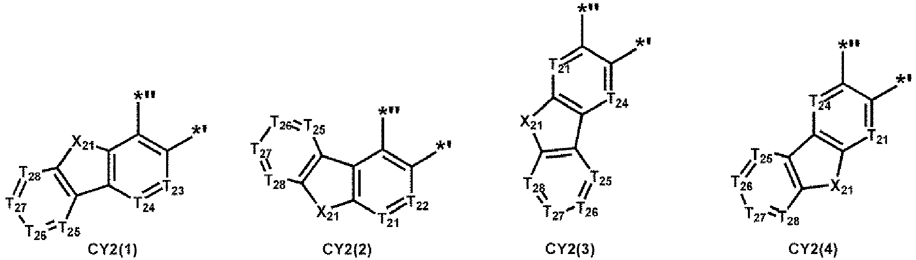 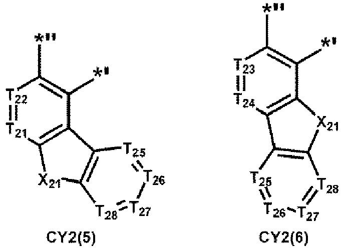
wherein, in Formulae CY2(1) to CY2(6),
T₂₁ may be N, C(Z₂₁), or C(Ar₂₁), T₂₂ may be N, C(Z₂₂), or C(Ar₂₂), T₂₃ may be N, C(Z₂₃), or C(Ar₂₃), T₂₄ may be N, C(Z₂₄), or C(Ar₂₄), T₂₅ may be N, C(Z₂₅), or C(Ar₂₅), T₂₆ may be N, C(Z₂₆), or C(Ar₂₆), T₂₇ may be N, C(Z₂₇), or C(Ar₂₇), and T₂₈ may be N, C(Z₂₈), or C(Ar₂₈),
the number of N(s) among T₃ to T₈ in Formulae CY2-1 and CY2-6 may be 0 or 1, the number of N(s) among T₁, T₂, T₅, T₆, T₇, and T₈ in Formulae CY2-2 and CY2-5 may be 0 or 1, the number of N(s) among T₁, T₄, T₅, T₆, T₇, and T₈ in Formulae CY2-3 and CY2-4 may be 0 or 1,
X₂₁ may be the same as described herein,
Z₂₁ to Z₂₈ may each be the same as described in connection with Z₂ provided herein,
Ar₂₁ to Ar₂₈ may each be the same as described in connection with Ar₂ provided herein,
Formulae CY2-1 and CY2-6 may include at least one of Ar₂₃ to Ar₂₈, Formulae CY2-2 and CY2-5 may include at least one of Ar₂₁, Ar₂₂, Ar₂₅, Ar₂₆, Ar₂₇, and Ar₂₈, and Formulae CY2-3 and CY2-4 may include at least one of Ar₂₁, Ar₂₄, Ar₂₅, Ar₂₆, Ar₂₇, and Ar₂₈,
*" indicates a binding site to ring CY₁ in Formula 2A, and
"indicates a binding site to M in Formula 1.

In one or more embodiments, in Formula 2A, a group represented by 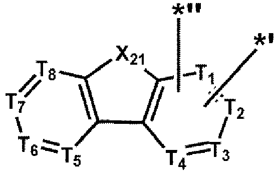 may be a group represented by one of Formulae CY2(1) to CY2(6), and at least one of Conditions 1-1 to 1-8 may be satisfied:
Condition 1-1
   wherein, T₂₈ in Formulae CY2(1) to CY2(6) may be C(Ar₂₈),
Condition 1-2
   wherein, T₂₇ in Formulae CY2(1) to CY2(6) may be C(Ar₂₇),
Condition 1-3
   wherein, T₂₆ in Formulae CY2(1) to CY2(6) may be C(Ar₂₆),
Condition 1-4
   wherein, T₂₅ in Formulae CY2(1) to CY2(6) may be C(Ar₂₅),
Condition 1-5
   wherein, T₂₄ in Formulae CY2(1), CY2(3), CY2(4), and CY2(6) may be C(Ar₂₄),
Condition 1-6
   wherein, T₂₃ in Formulae CY2(1) and CY2(6) may be C(Ar₂₃),
Condition 1-7
   wherein, T₂₂ in Formulae CY2(2) and CY2(5) may be C(Ar₂₂), and
Condition 1-8
   wherein, T₂₁ in Formulae CY2(2) to CY2(5) may be C(Ar₂₁).

In one or more embodiments, in Formula 2A, a group represented by 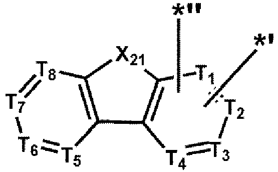 may be a group represented by one of Formulae CY2(1) to CY2(6), and at least one of Conditions 2-1 to 2-8 may be satisfied:
Condition 2-1
   wherein, T₂₈ in Formulae CY2(1) to CY2(6) may be C(Z₂₈), and Z₂₈ may not be hydrogen,
Condition 2-2
   wherein, T₂₇ in Formulae CY2(1) to CY2(6) may be C(Z₂₇), and Z₂₇ may not be hydrogen,
Condition 2-3
   wherein, T₂₆ in Formulae CY2(1) to CY2(6) may be C(Z₂₆), and Z₂₆ may not be hydrogen,
Condition 2-4
   wherein, T₂₅ in Formulae CY2(1) to CY2(6) may be C(Z₂₅), and Z₂₅ may not be hydrogen,
Condition 2-5
   wherein, T₂₄ in Formulae CY2(1), CY2(3), CY2(4), and CY2(6) may be C(Z₂₄), and Z₂₄ may not be hydrogen,
Condition 2-6
   wherein, T₂₃ in Formulae CY2(1) and CY2(6) may be C(Z₂₃), and Z₂₃ may not be hydrogen,
Condition 2-7
   wherein, T₂₂ in Formulae CY2(2) and CY2(5) may be C(Z₂₂), and Z₂₂ may not be hydrogen, and
Condition 2-8
   wherein, T₂₁ in Formulae CY2(2) to CY2(5) may be C(Z₂₁), and Z₂₁ may not be hydrogen.

In one or more embodiments, in Formula 2A, a group represented by 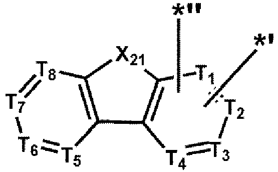 may be a group represented by one of Formulae CY2(1) to CY2(6), and one of Conditions 3-1 to 3-9 may be satisfied:
Condition 3-1
   T₂₁ to T₂₈ in Formulae CY2(1) to CY2(6) may not each be N,
Condition 3-2
   T₂₈ in Formulae CY2(1) to CY2(6) may be N,
Condition 3-3
   T₂₇ in Formulae CY2(1) to CY2(6) may be N,
Condition 3-4
   T₂₆ in Formulae CY2(1) to CY2(6) may be N,
Condition 3-5
   T₂₅ in Formulae CY2(1) to CY2(6) may be N,
Condition 3-6
   wherein, T₂₄ in Formulae CY2(1), CY2(3), CY2(4), and CY2(6) may be N,
Condition 3-7
   T₂₃ in Formulae CY2(1) and CY2(6) may be N,
Condition 3-8
   T₂₂ in Formulae CY2(2) and CY2(5) may be N, and
Condition 3-9
   T₂₁ in Formulae CY2(2) to CY2(5) may be N,

In one or more embodiments, a group represented by Formula CY2(1) may be a group represented by one of Formulae CY2(1)-1 to CY2(1)-4, a group represented by Formula CY2(2) may be a group represented by one of Formulae CY2(2)-1 to CY2(2)-4, a group represented by Formula CY2(3) may be a group represented by one of Formulae CY2(3)-1 to CY2(3)-3, a group represented by Formula CY2(4) may be a group represented by one of Formulae CY2(4)-1 to CY2(4)-3, a group represented by Formula CY2(5) may be a group represented by one of Formulae CY2(5)-1 to CY2(5)-4, and a group represented by Formula CY2(6) may be a group represented by one of Formulae CY2(6)-1 to CY2(6)-4: 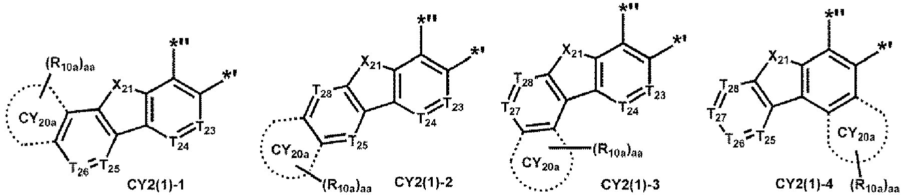 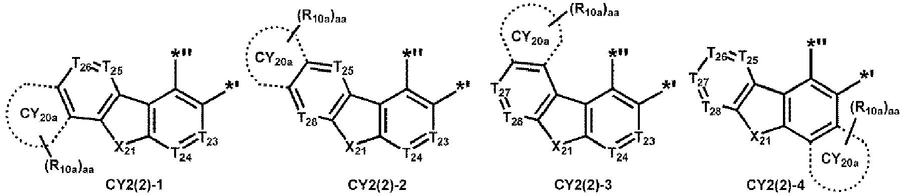 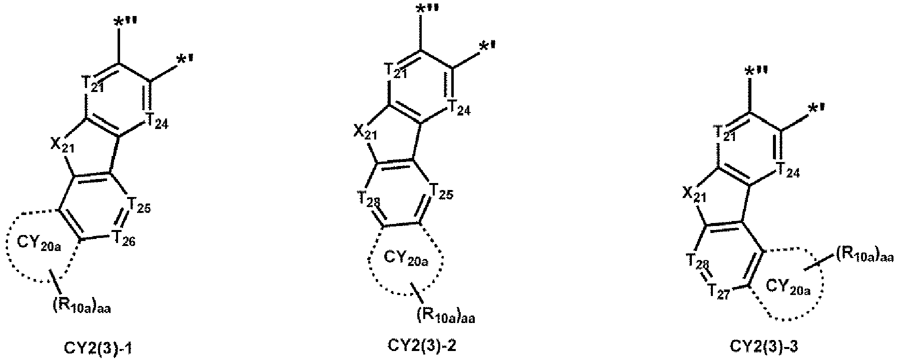 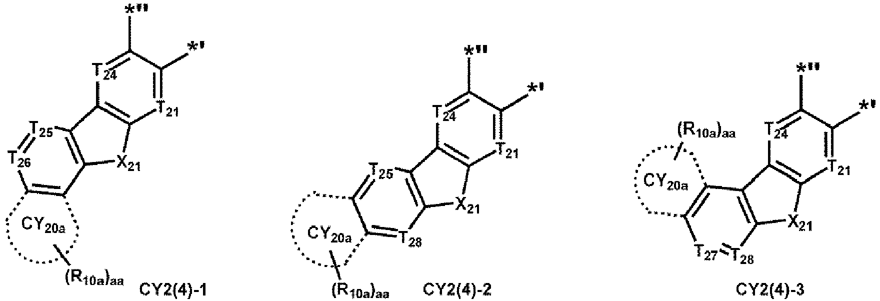 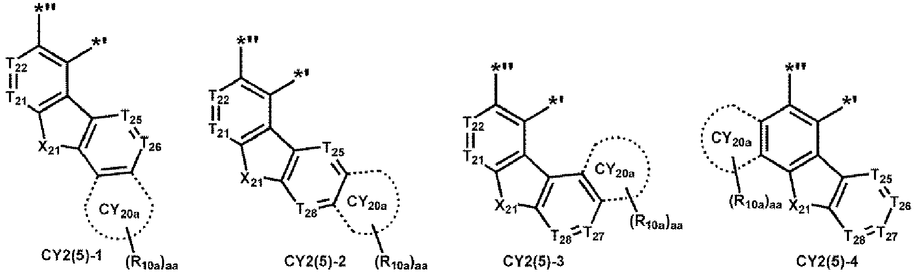 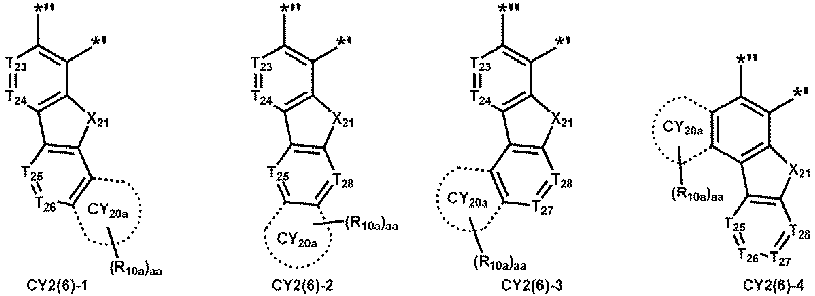
wherein, in Formulae CY2(1)-1 to CY2(1)-4, CY2(2)-1 to CY2(2)-4, CY2(3)-1 to CY2(3)-3, CY2(4)-1 to CY2(4)-3, CY2(5)-1 to CY2(5)-4, and CY2(6)-1 to CY2(6)-4,
T₂₁ to T₂₈, X₂₁, *", and *' may respectively be understood by referring to the descriptions of T₂₁ to T₂₈, X₂₁, *", and *' in Formulae CY2(1) to CY2(6) provided herein,
ring CY₂₀ₐ may be a C₅-C₃₀ carbocyclic group or a C₁-C₃₀ heterocyclic group,
R₁₀ₐ may be the same as described herein, and
aa may be an integer from 0 to 10.

In some embodiments, ring CY₂₀ₐ may be a cyclohexane group, a norbornane group, a benzene group, or a naphthalene group.

In one or more embodiments, in Formula 2A, a group represented by 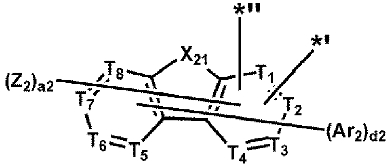 may be a group represented by one of Formulae CY2-1-1 to CY2-1-65, CY2-2-1 to CY2-2-65, CY2-3-1 to CY2-3-65, CY2-4-1 to CY2-4-65, CY2-5-1 to CY2-5-65, and CY2-6-1 to CY2-6-65: 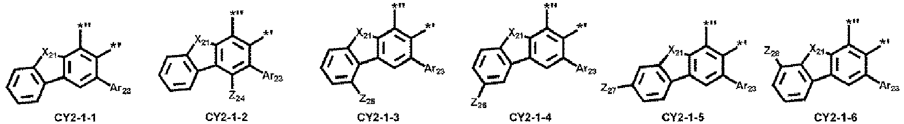 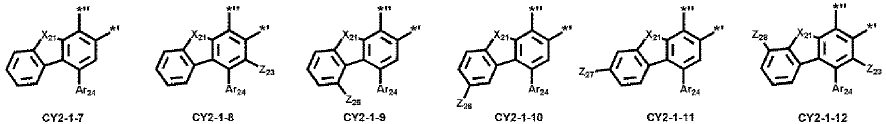 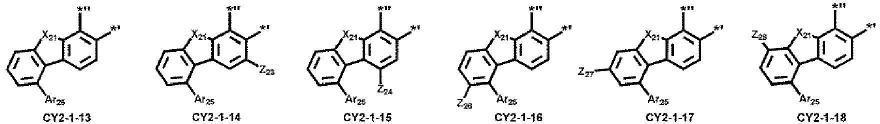 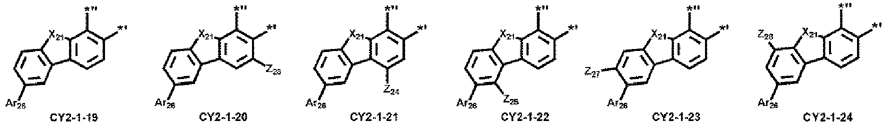 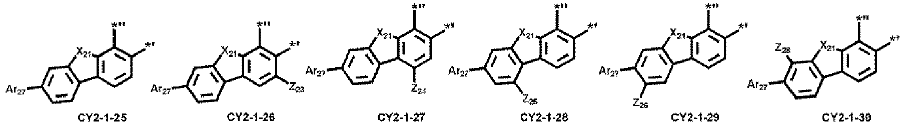 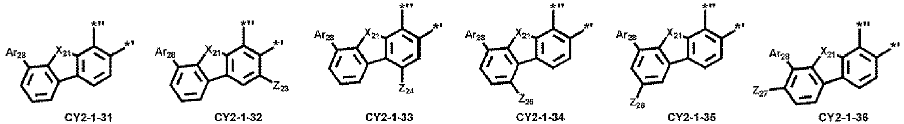 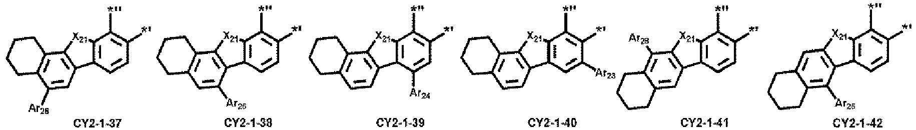 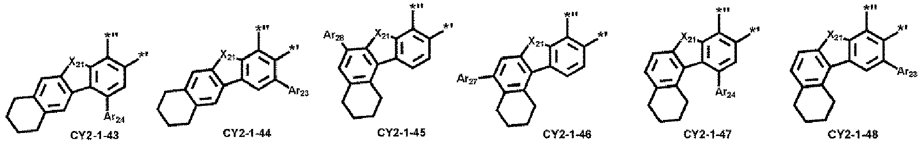 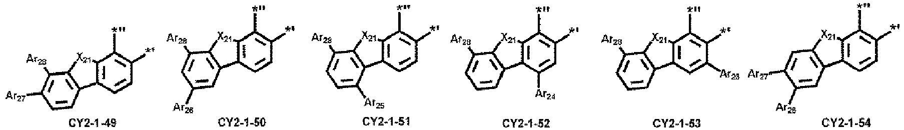 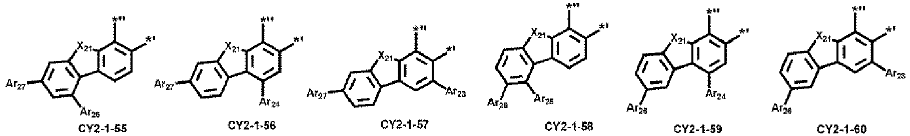 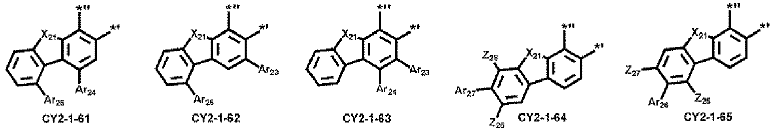 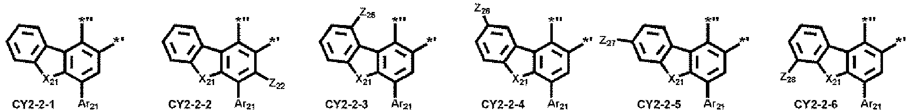 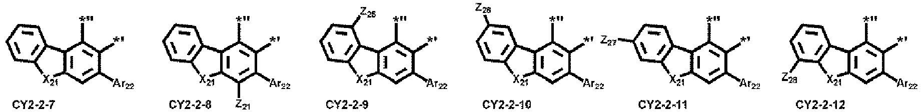 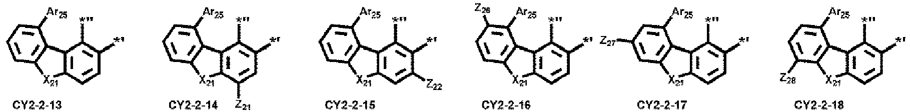 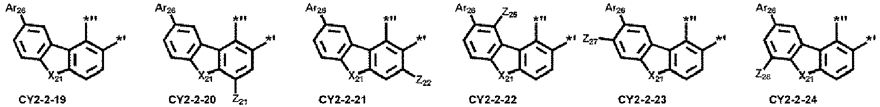 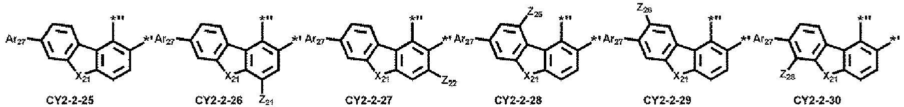 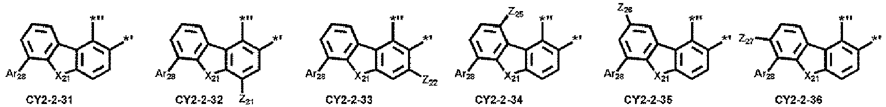 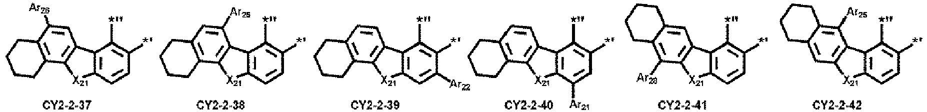 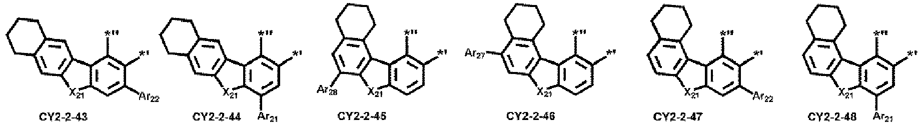 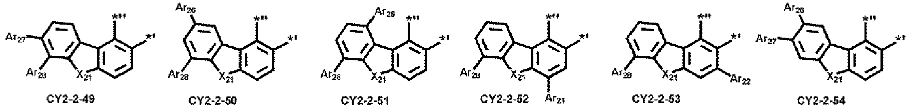 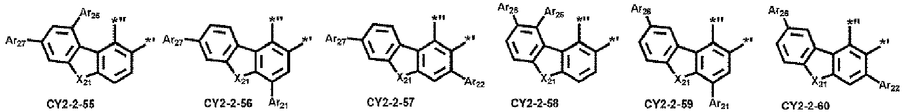 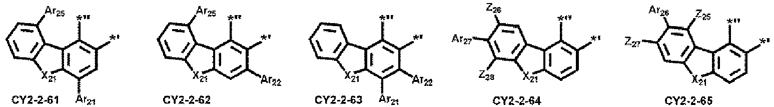 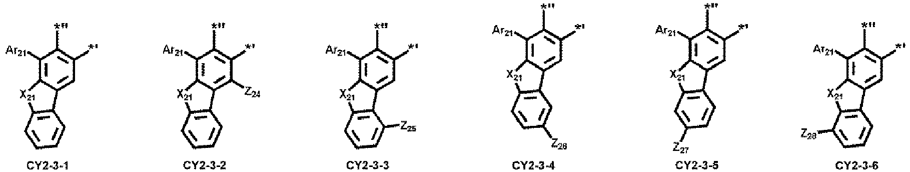 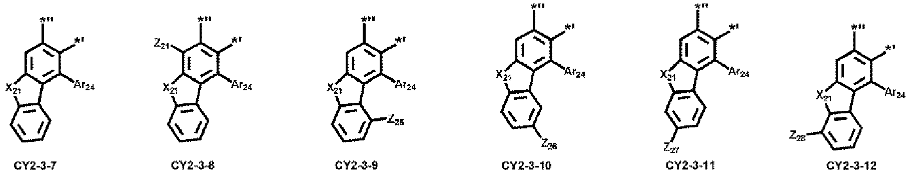 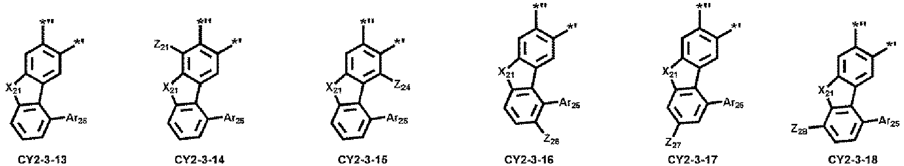 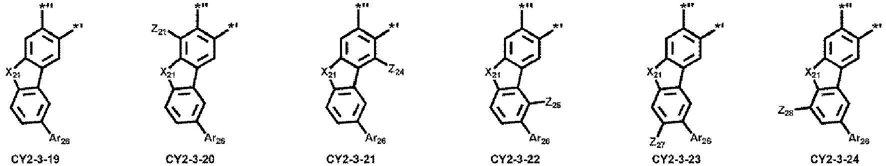 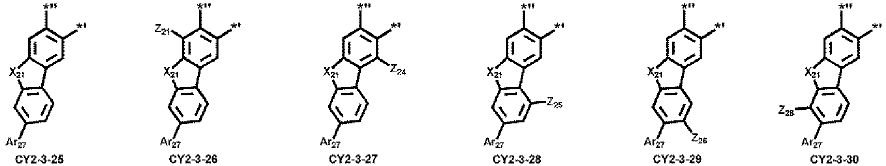 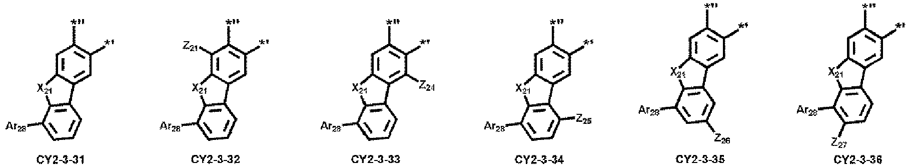 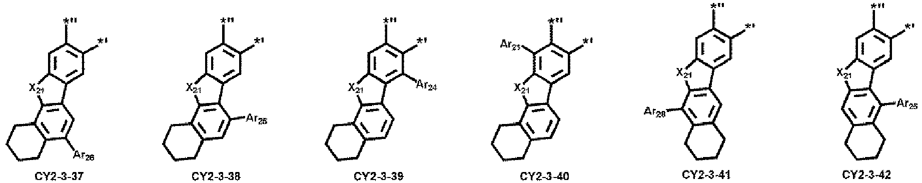 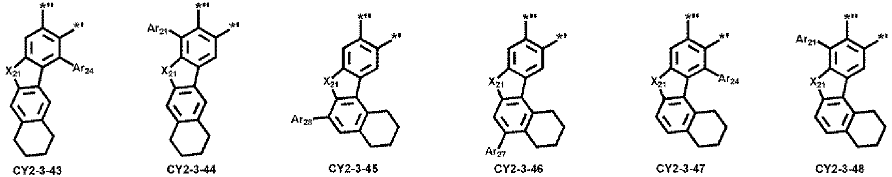 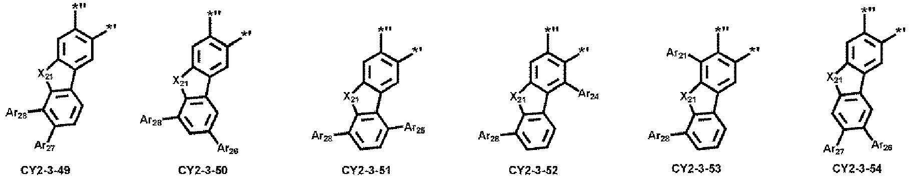 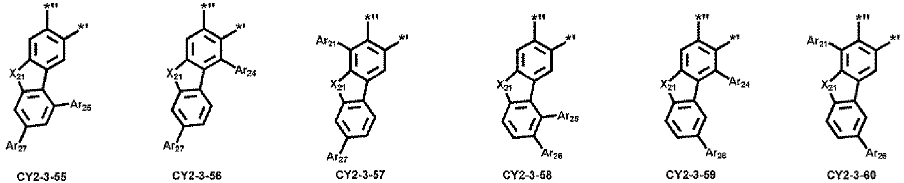 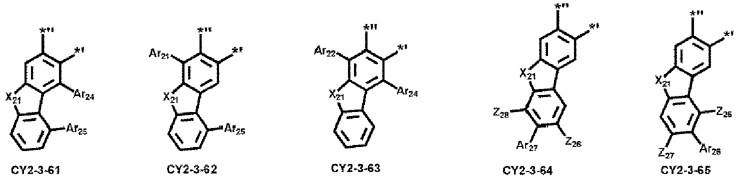 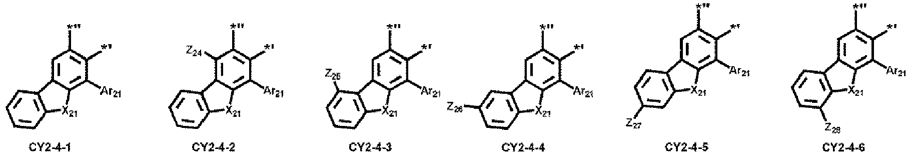 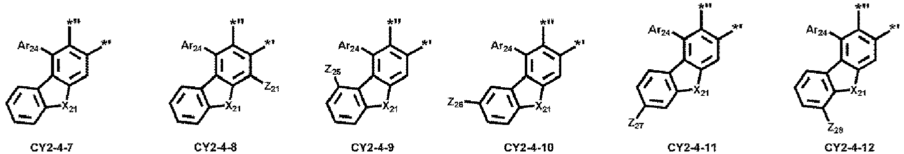 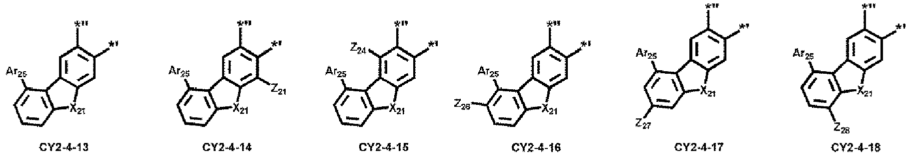 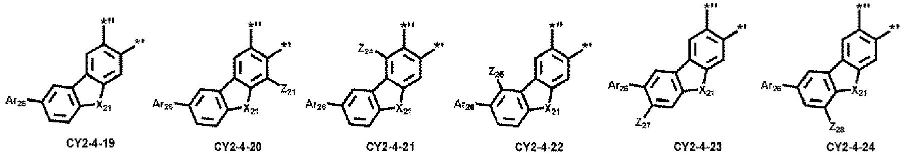 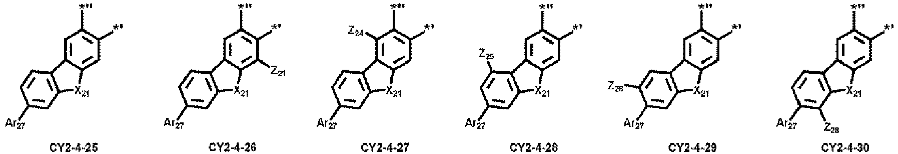 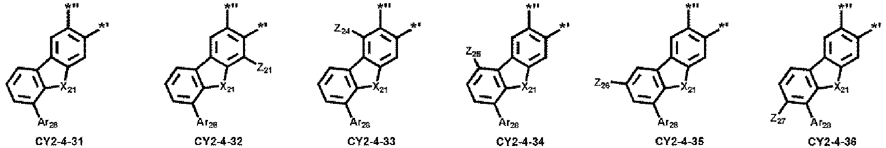 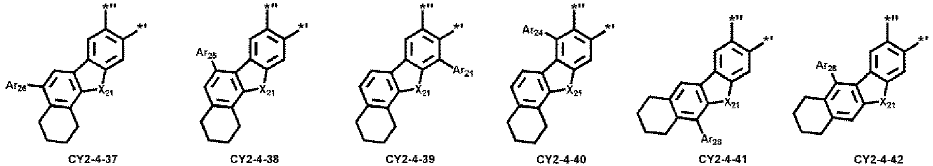 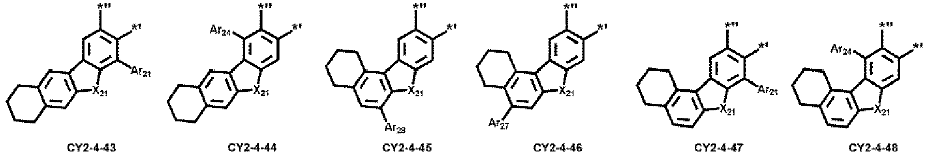 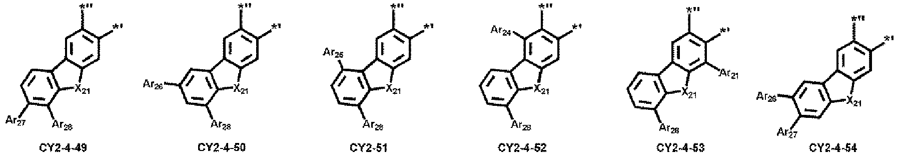 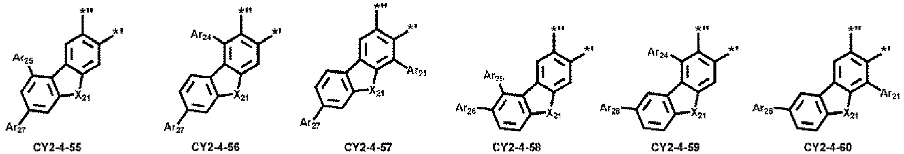 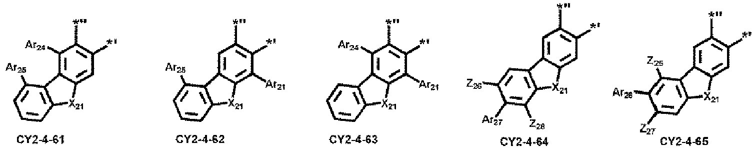 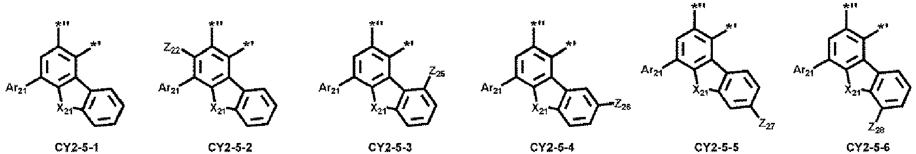 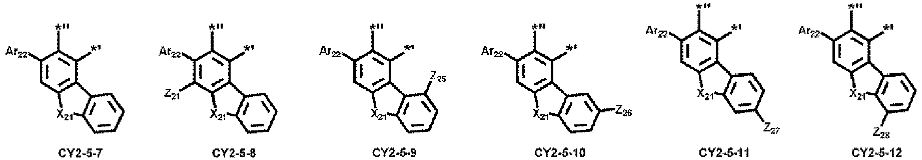 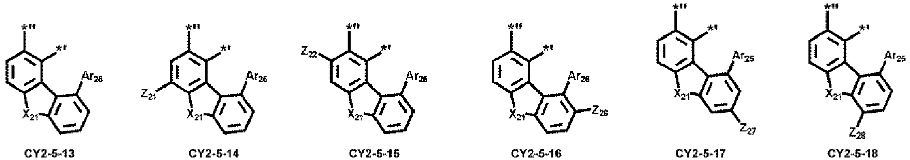 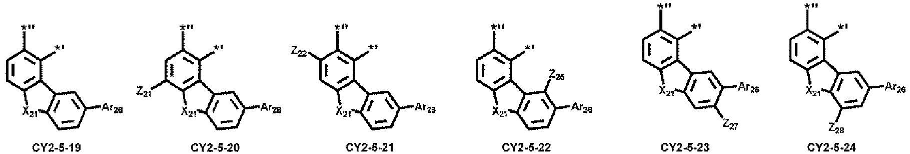 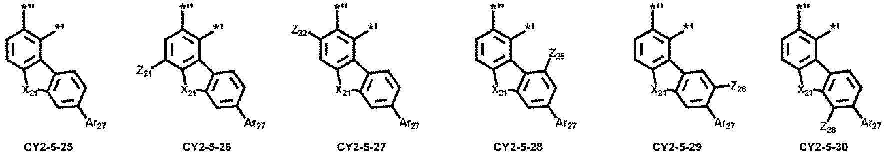 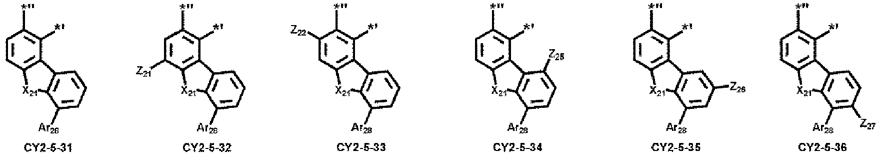 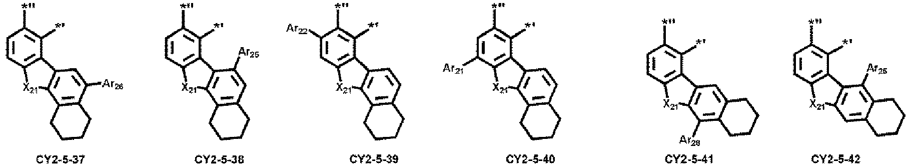 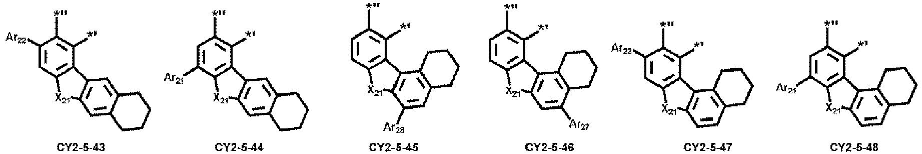 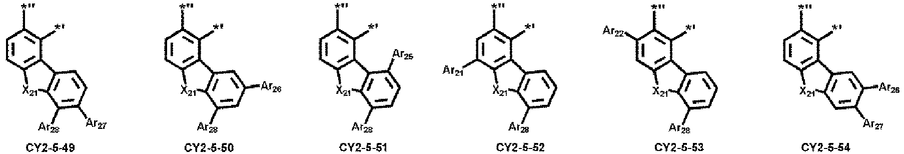 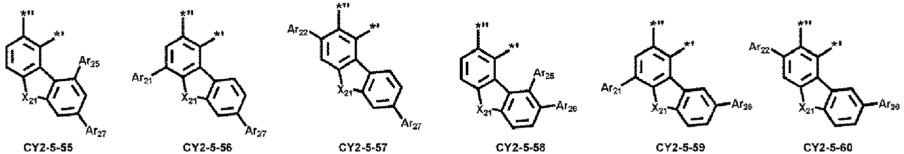 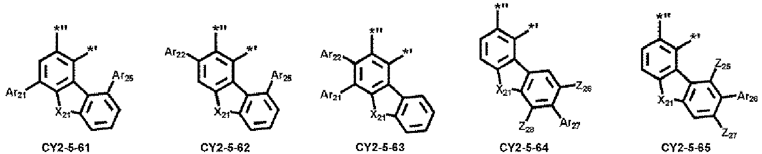 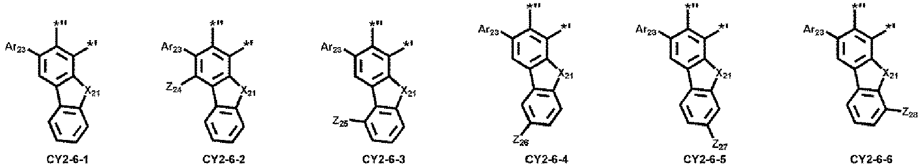 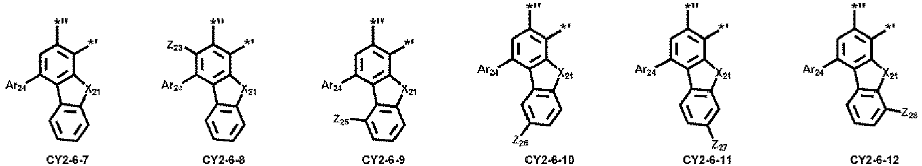 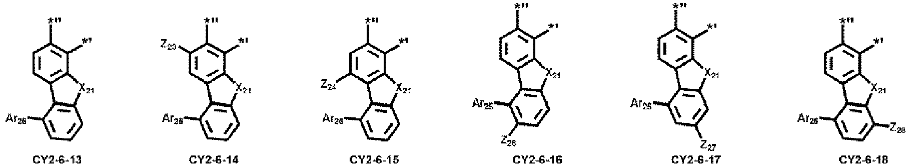 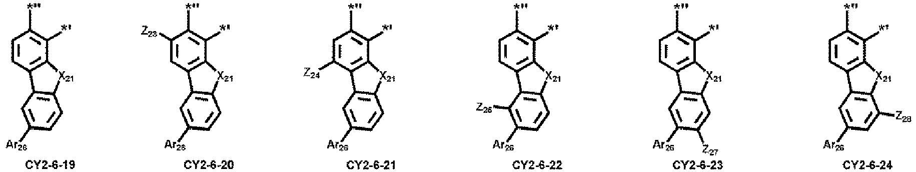 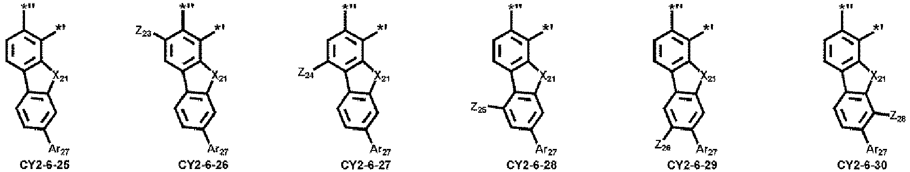 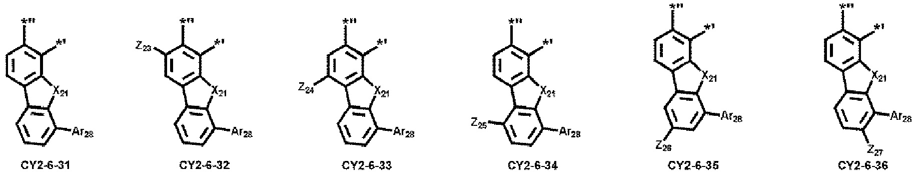 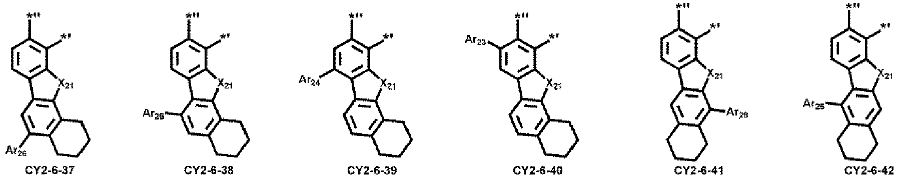 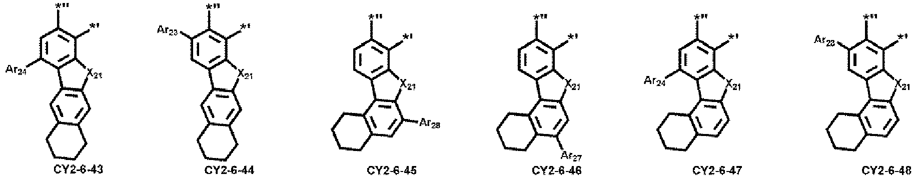 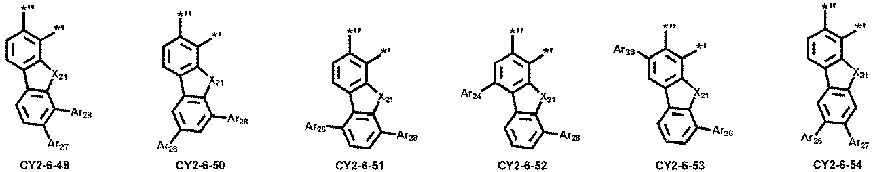 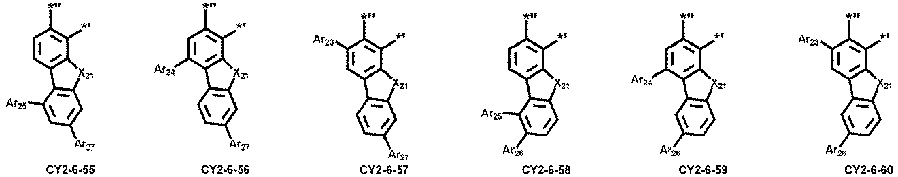 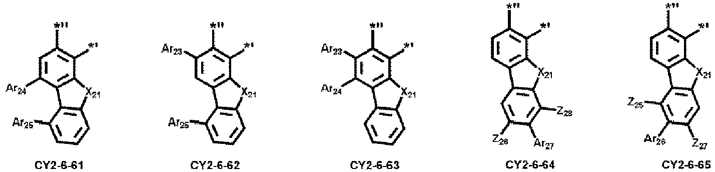
wherein, in Formulae CY2-1-1 to CY2-1-65, CY2-2-1 to CY2-2-65, CY2-3-1 to CY2-3-65, CY2-4-1 to CY2-4-65, CY2-5-1 to CY2-5-65, and CY2-6-1 to CY2-6-65,
X₂₁ may be the same as described herein,
Z₂₁ to Z₂₈ may each be the same as described in connection with Z₂ provided herein, wherein Z₂₁ to Z₂₈ may not each be hydrogen,
Ar₂₁ to Ar₂₈ may each be the same as described in connection with Ar₂ provided herein,
*" indicates a binding site to ring CY₁ in Formula 2A, and
"indicates a binding site to M in Formula 1.

In one or more embodiments, in Formula 2B, a group represented by 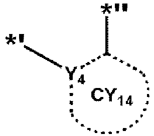 may be a group represented by one of Formulae CY14-1 to CY14-64: 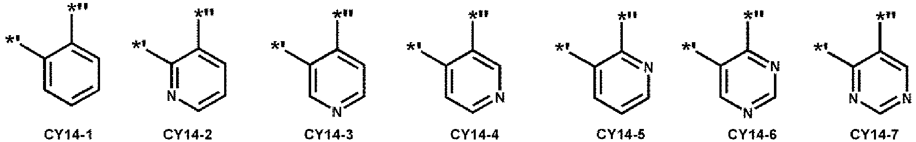 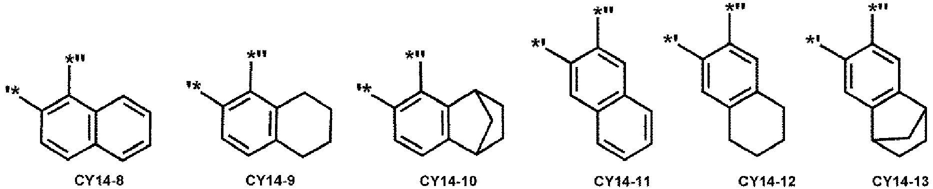 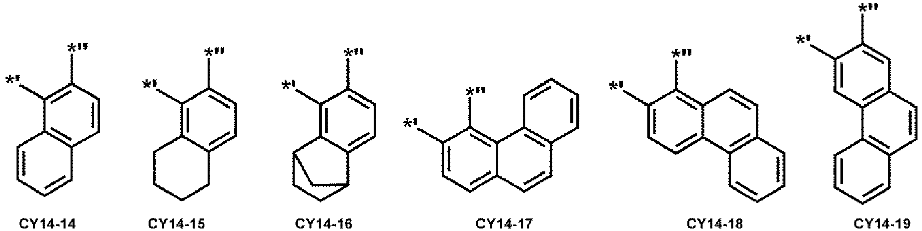 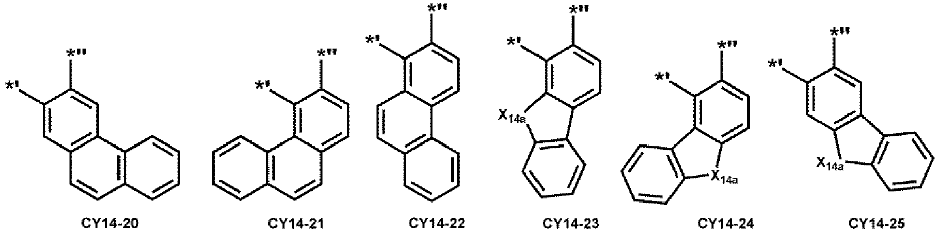 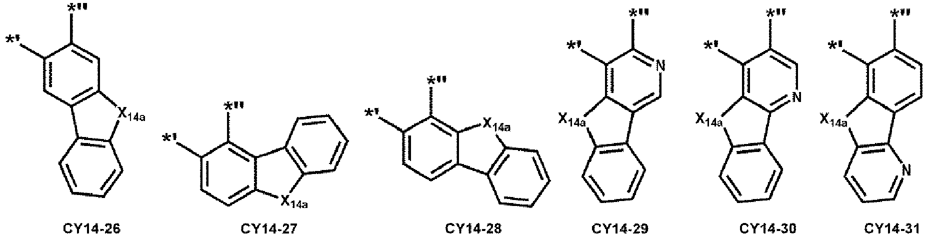 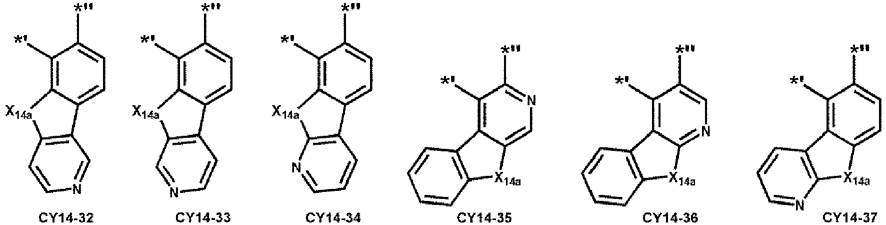 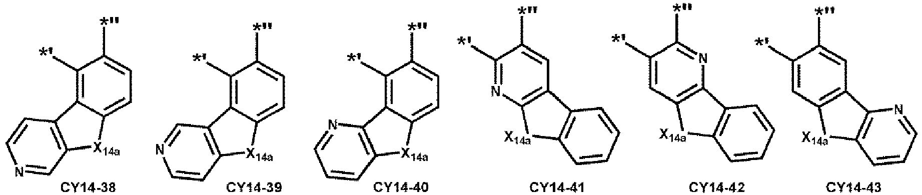 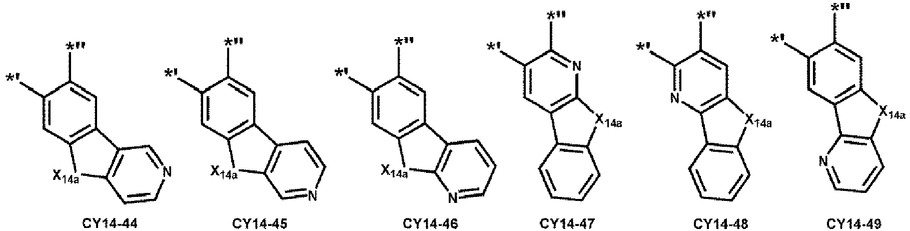 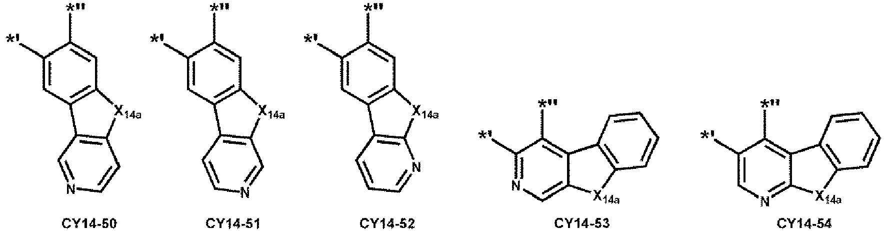 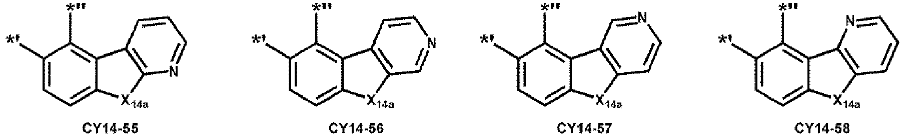 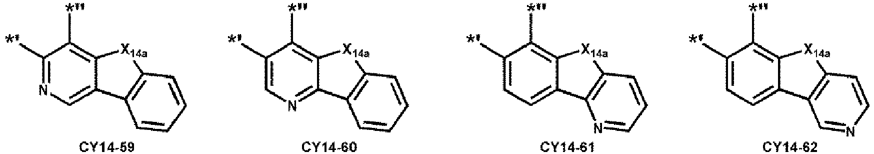 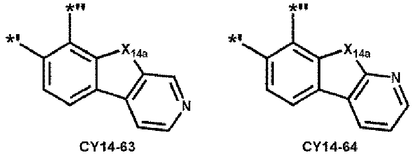
wherein, in Formulae CY14-1 to CY14-64,
X₁₄ₐ may be O, S, N, C, or Si,
*" indicates a binding site to a carbon atom in an adjacent pyridine ring in Formula 2B, and
"indicates a binding site to M in Formula 1.

Each of a carbon and X₁₄ₐ in Formulae CY14-1 to CY14-64 may be unsubstituted or substituted with R₁₄ provided herein.

In one or more embodiments, in Formula 2B, a group represented by 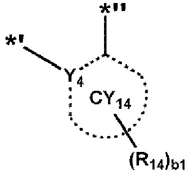 may be a group represented by one of Formulae CY14(1) to CY14(63): 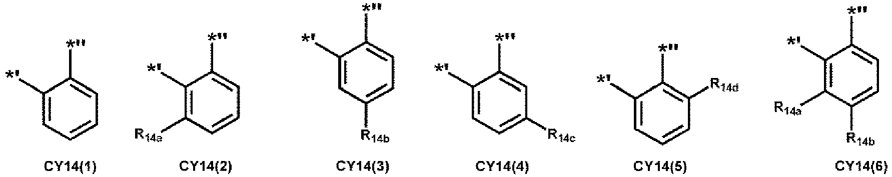 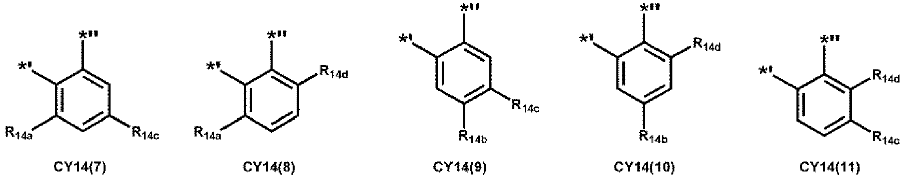 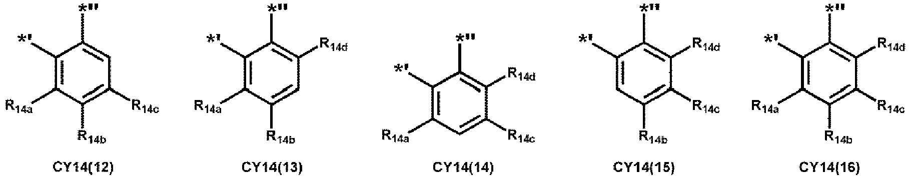 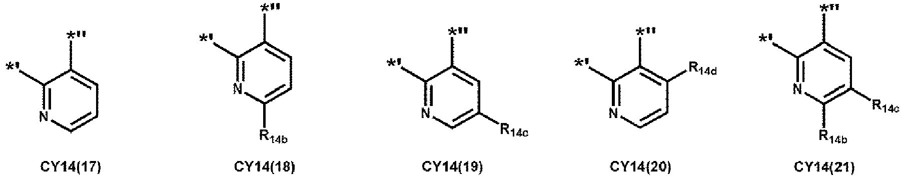 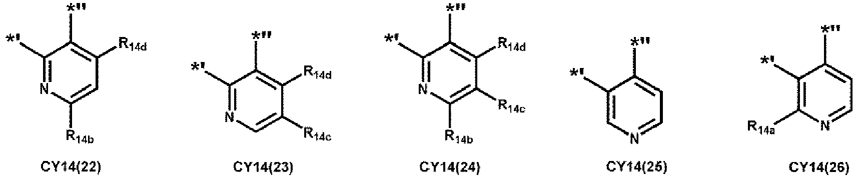 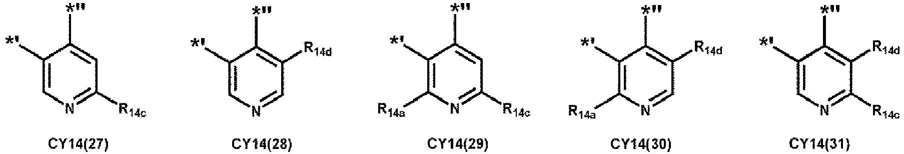 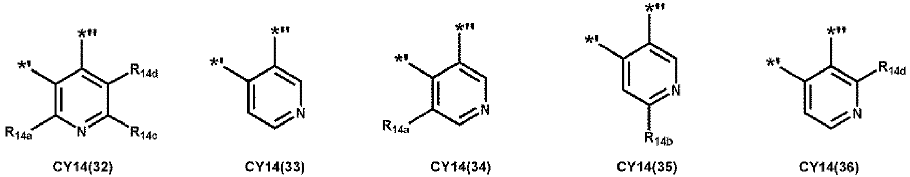 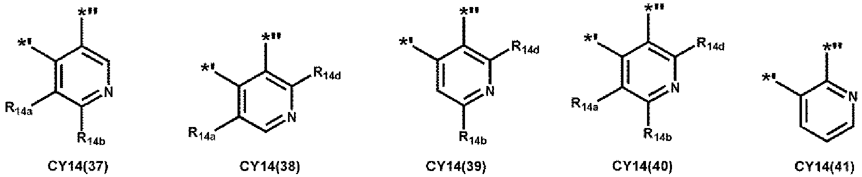 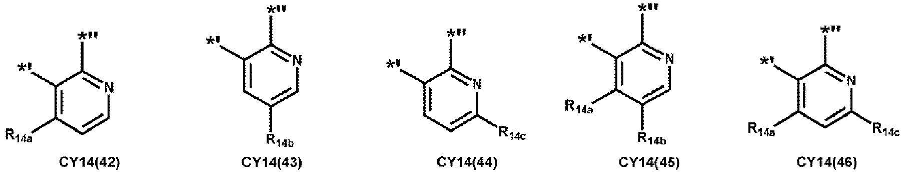 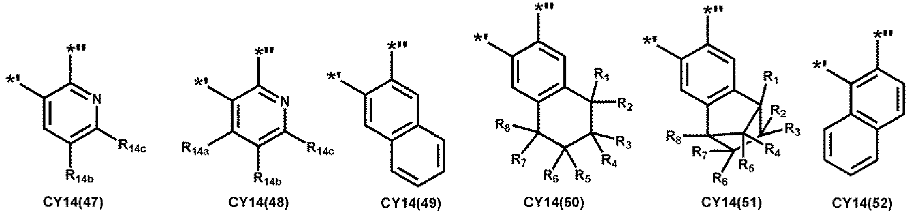 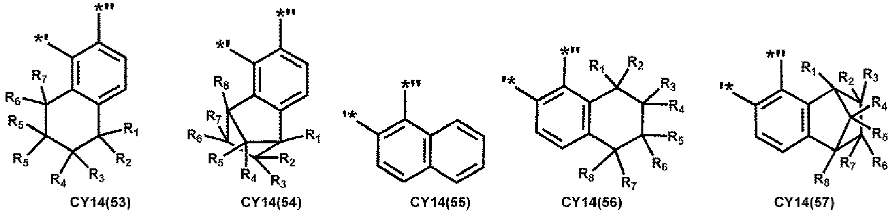 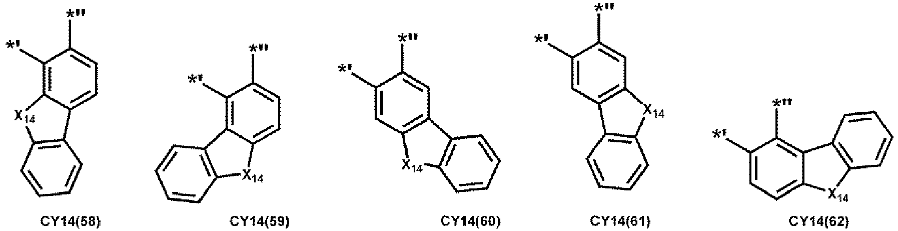 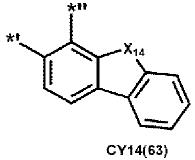
wherein, in Formulae CY14(1) to CY14(63),
R₁₄ₐ to R_{14d} may each be the same as described in connection with R₁₄ provided herein, wherein R₁₄ₐ to R_{14d} may not each be hydrogen,
X₁₄ may be C(R₁)(R₂), N(R₁), O, S, or Si(R₁)(R₂),
R₁ to R₈ may each be the same as described in connection with R₁₄ provided herein,
*" indicates a binding site to a carbon atom in an adjacent pyridine ring in Formula 2B, and
"indicates a binding site to M in Formula 1.

In one or more embodiments, the number of silicon (Si) atoms in the organometallic compound represented by Formula 1 may be 1 or 2.

In one or more embodiments, the organometallic compound may be one of Compounds 1 to 5140:

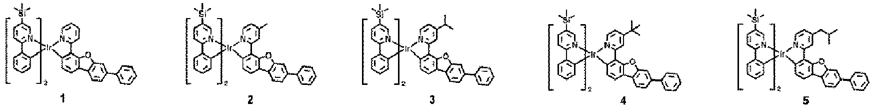

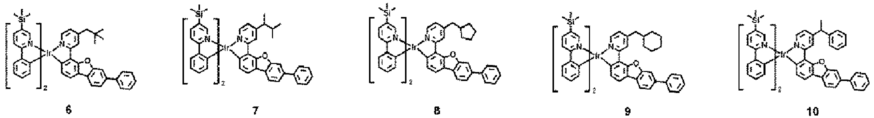

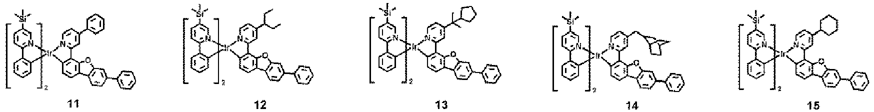

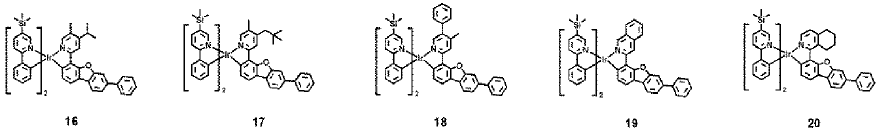

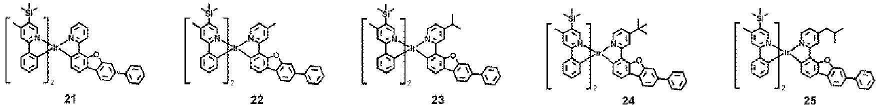

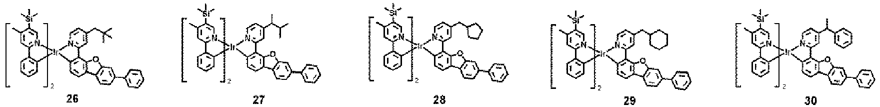

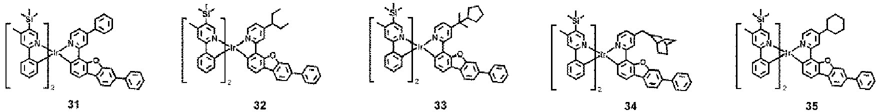

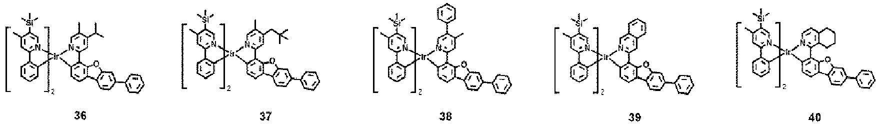

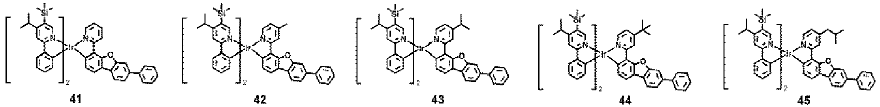

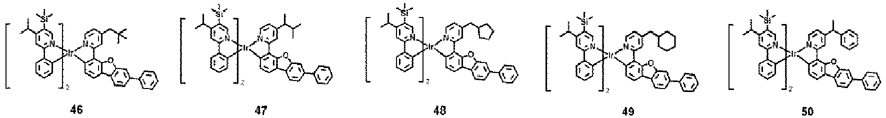

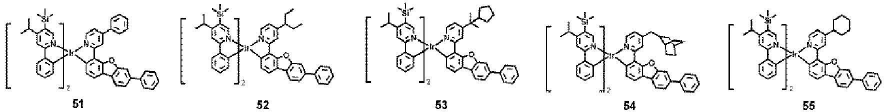

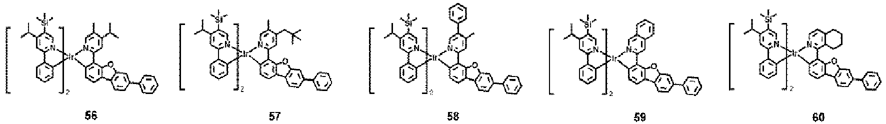

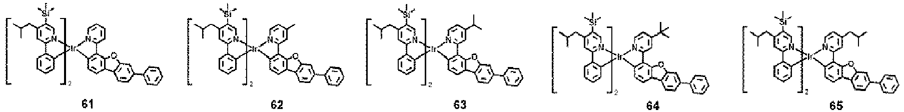

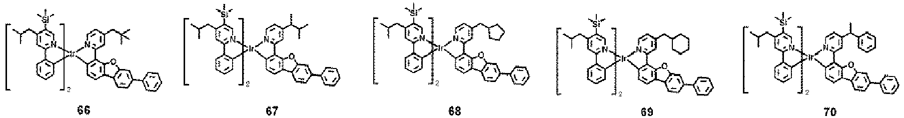

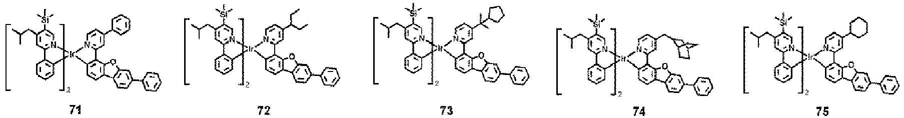

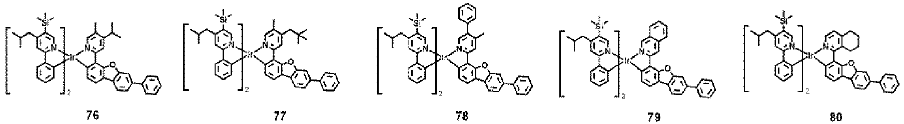

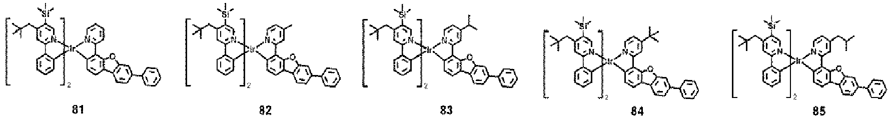

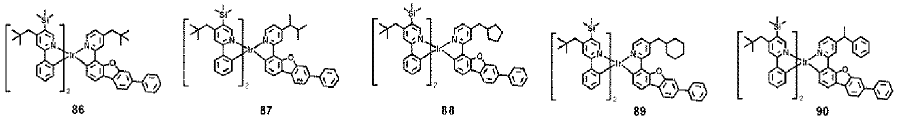

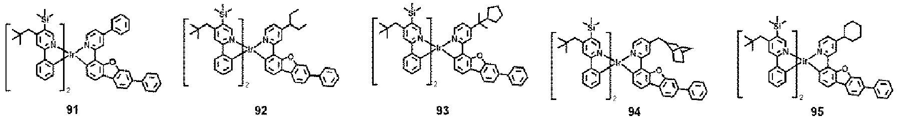

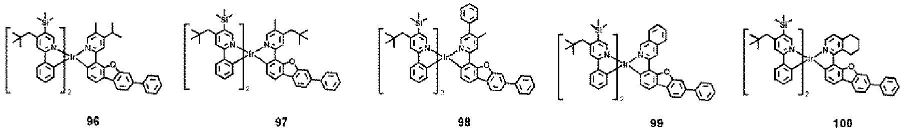

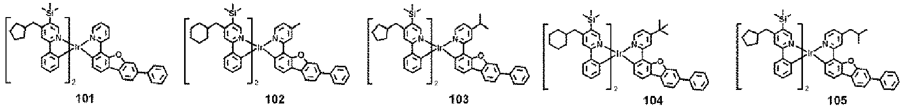

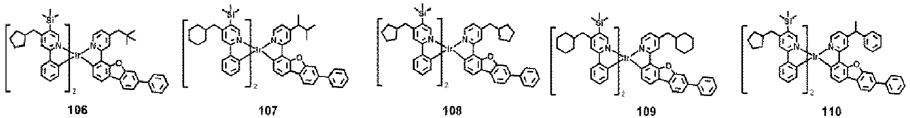

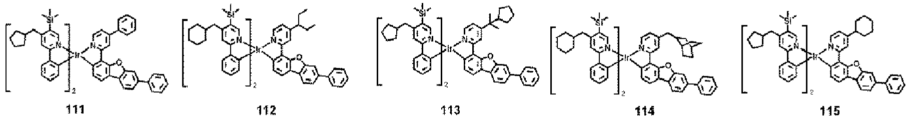

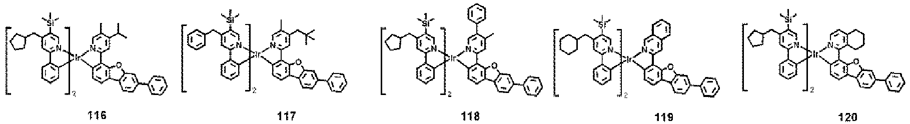

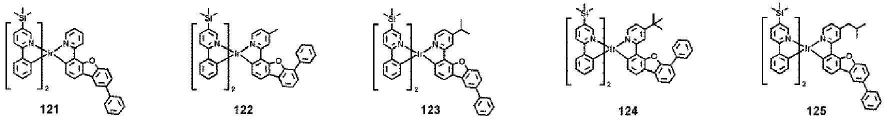

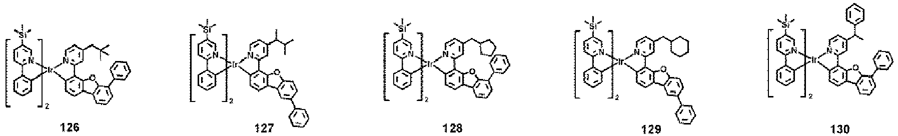

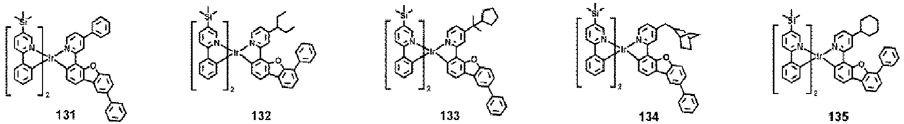

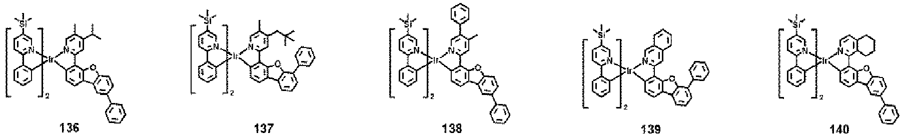

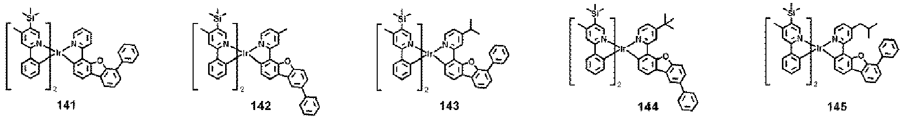

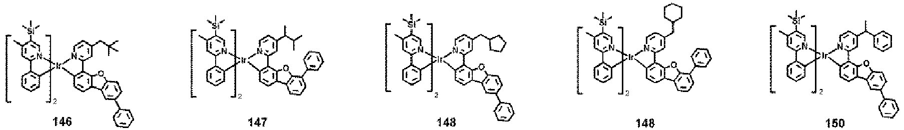

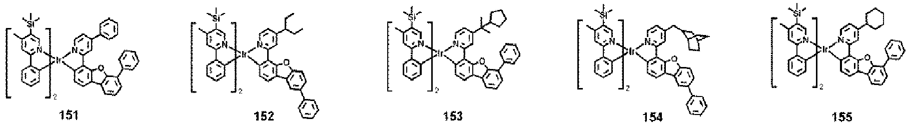

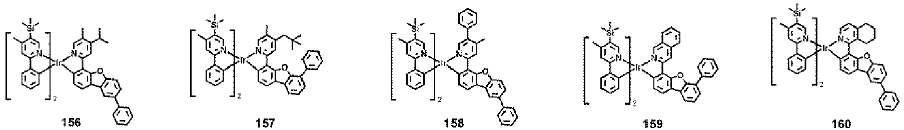

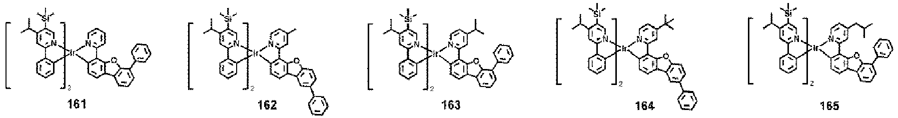

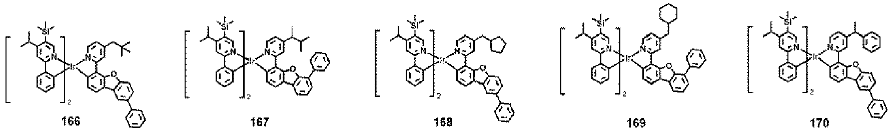

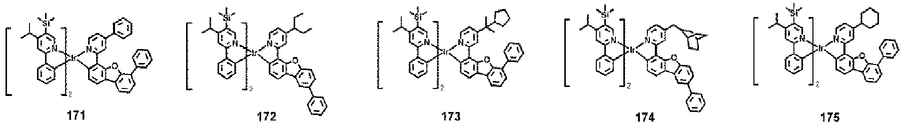

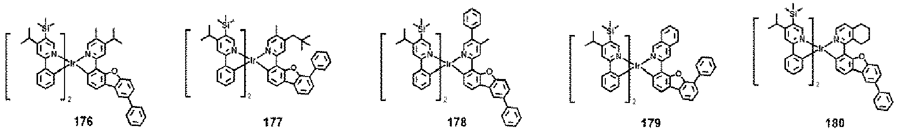

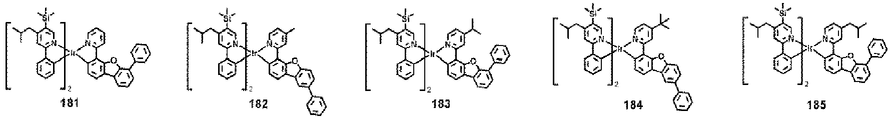

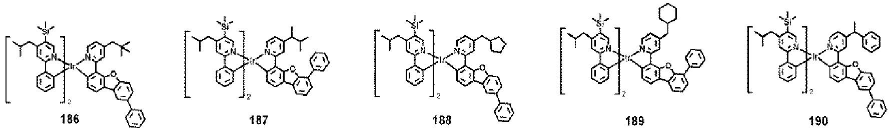

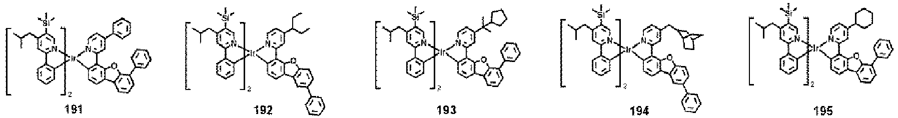

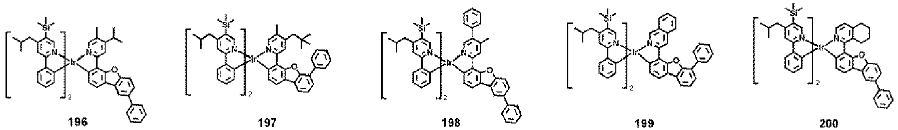

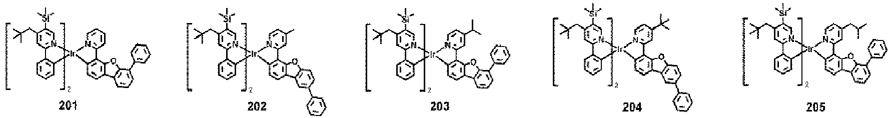

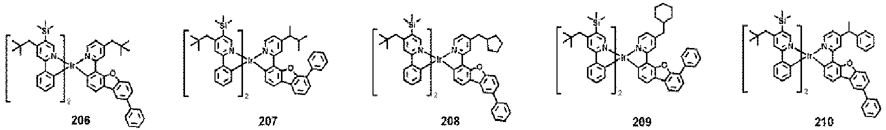

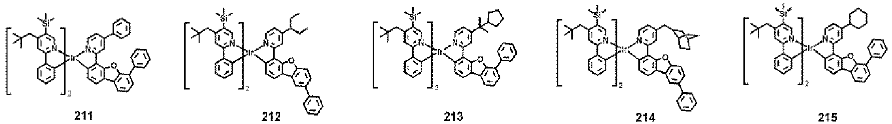

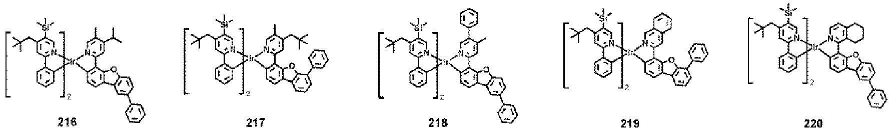

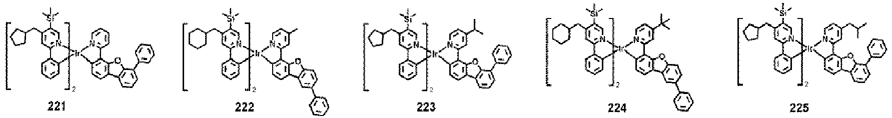

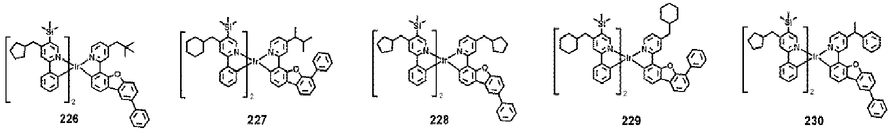

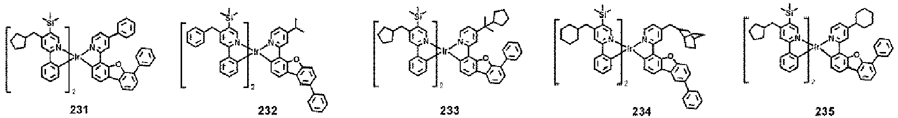

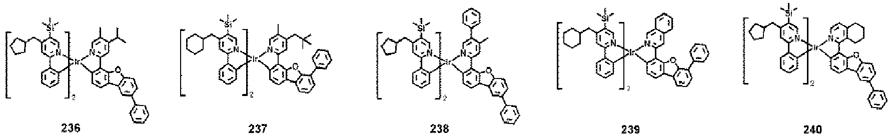

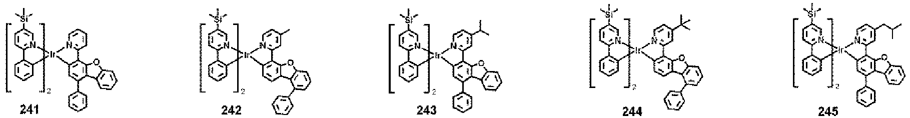

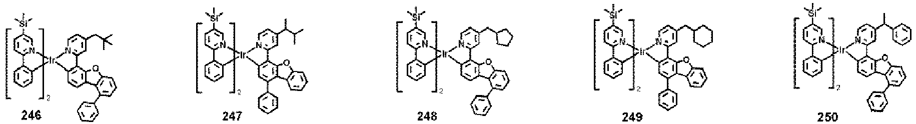

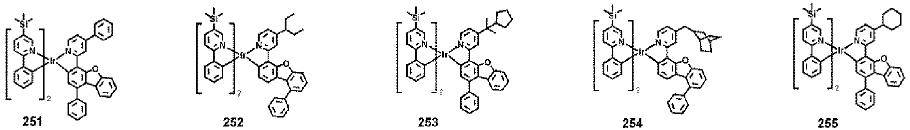

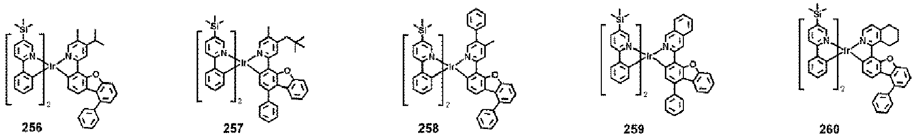

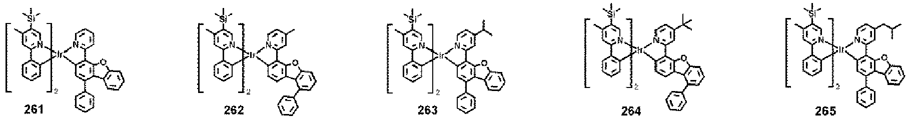

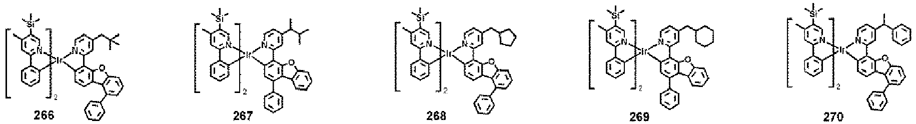

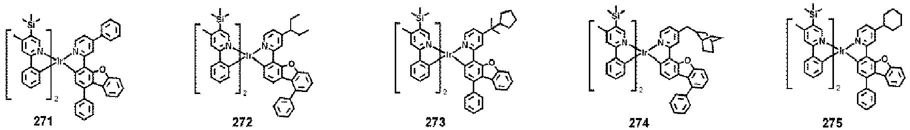

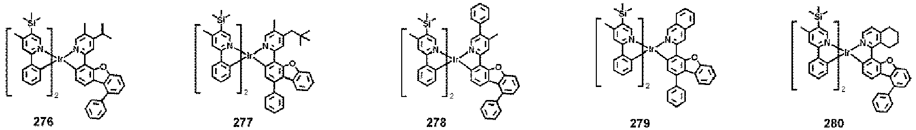

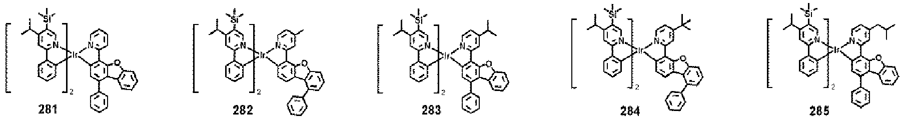

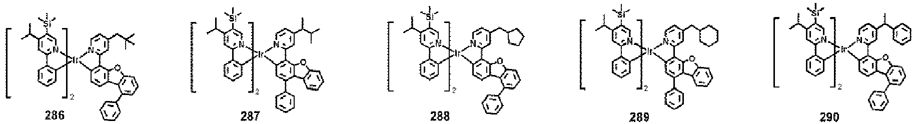

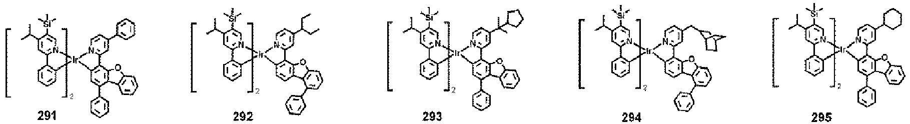

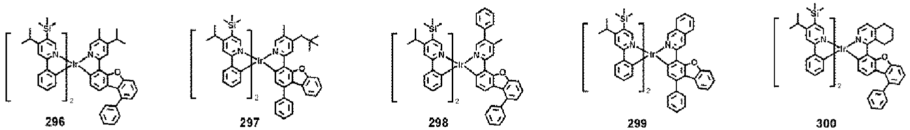

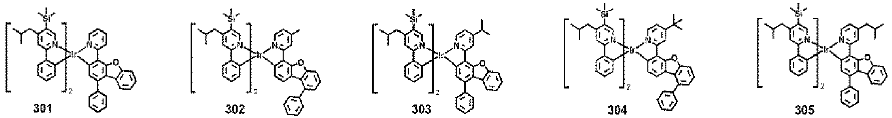

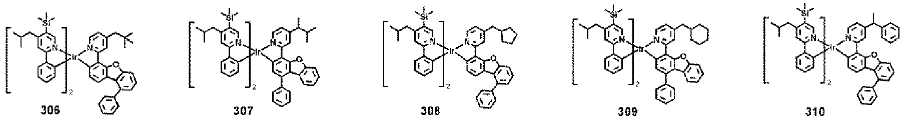

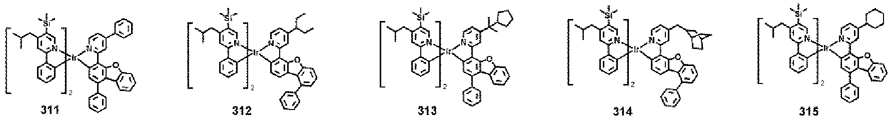

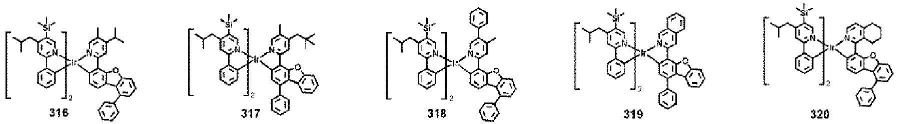

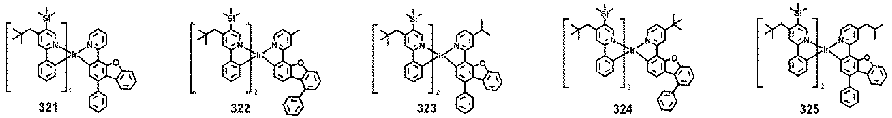

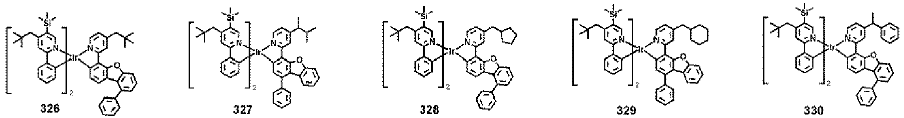

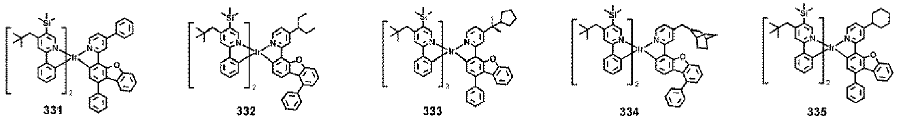

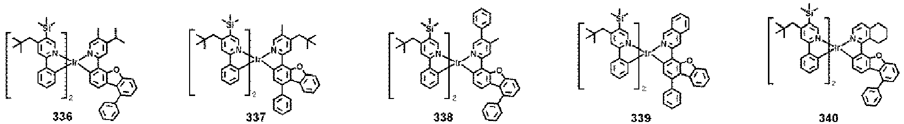

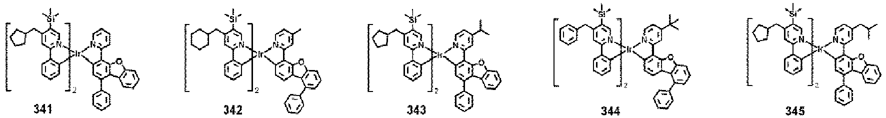

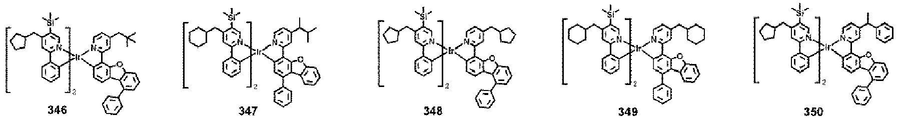

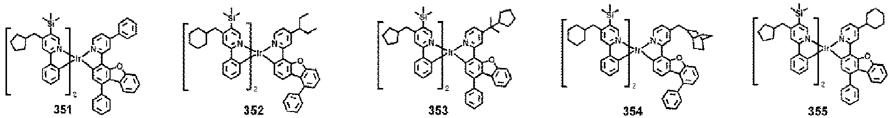

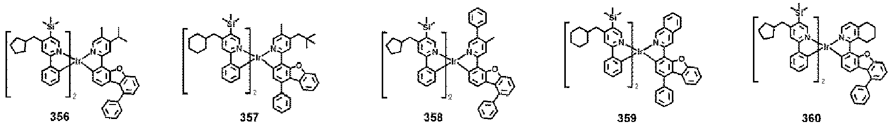

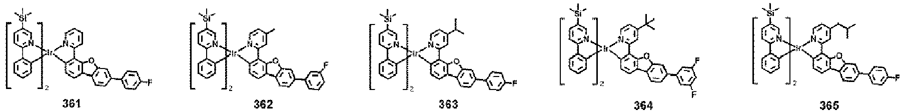

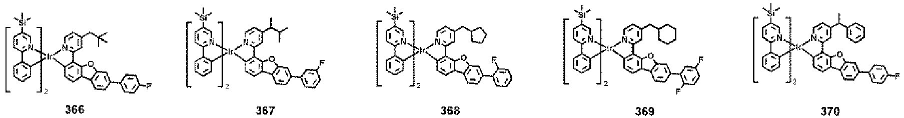

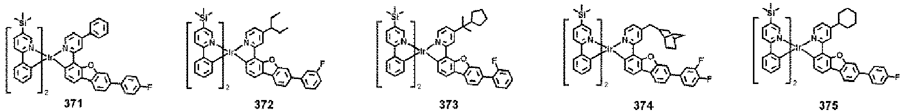

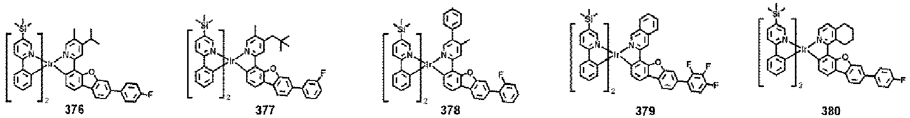

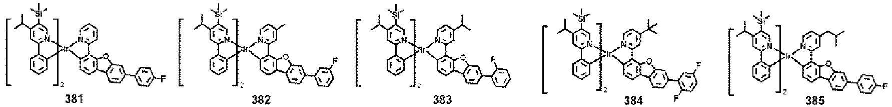

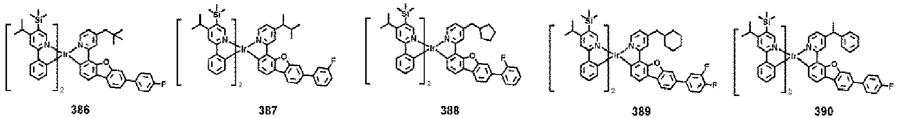

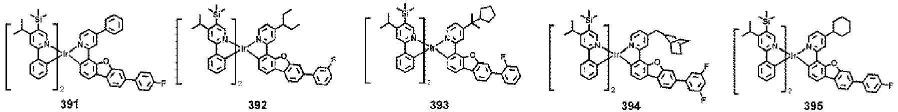

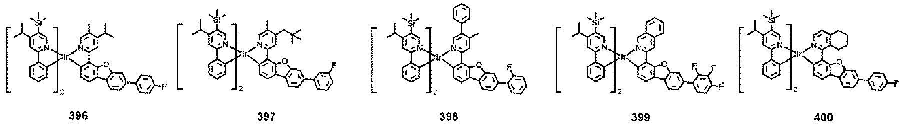

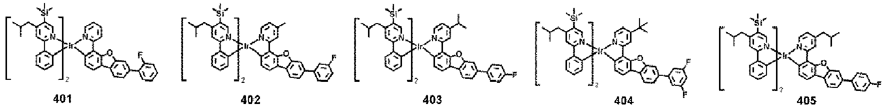

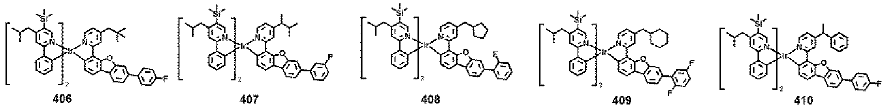

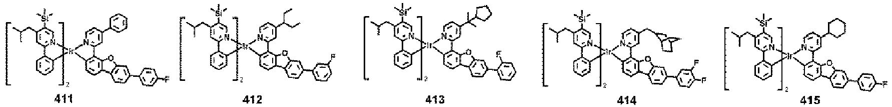

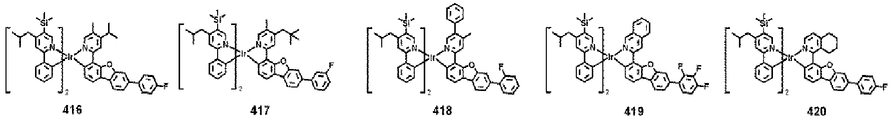

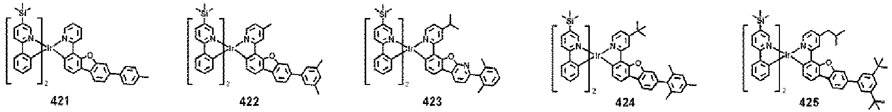

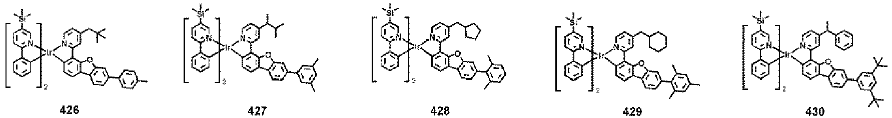

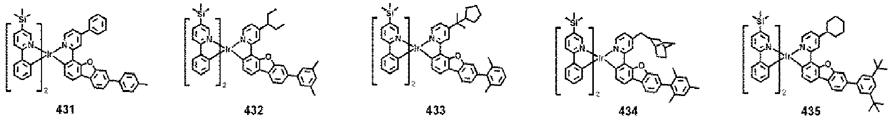

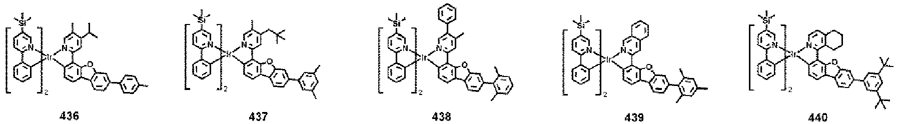

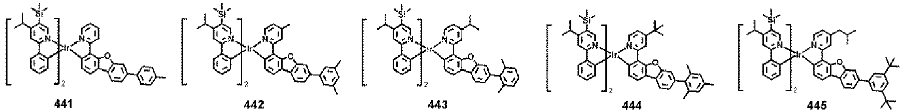

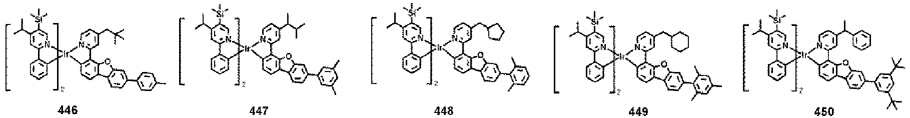

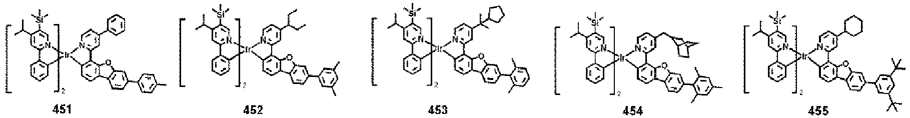

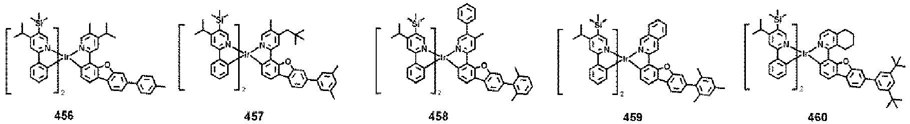

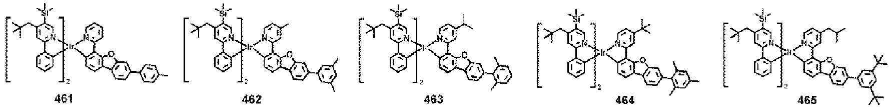

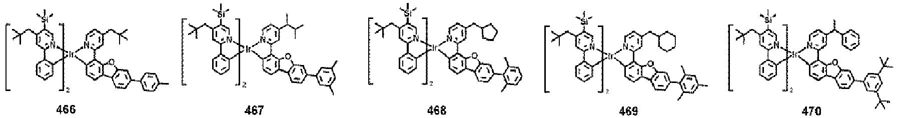

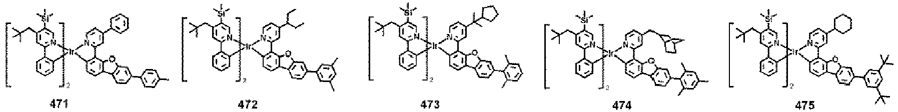

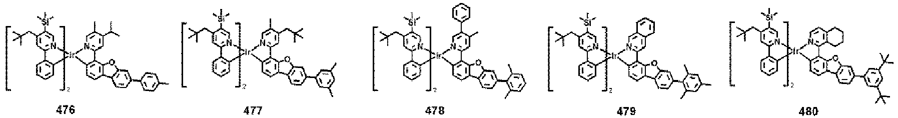

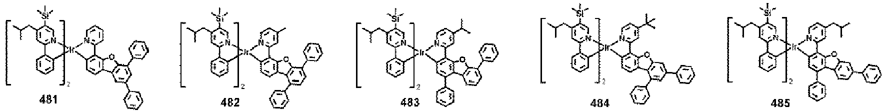

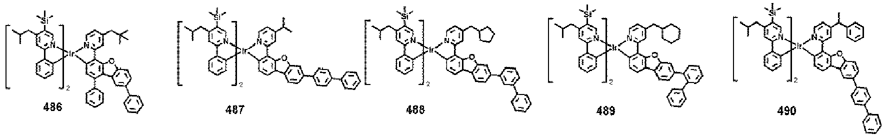

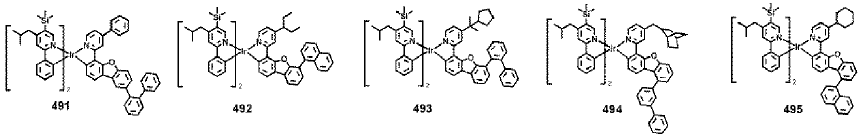

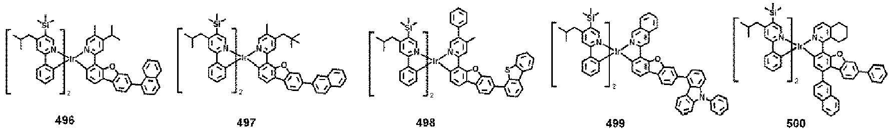

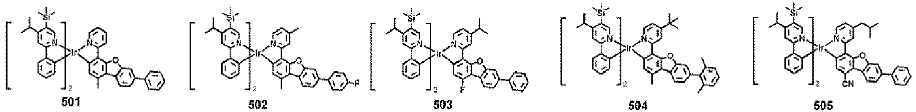

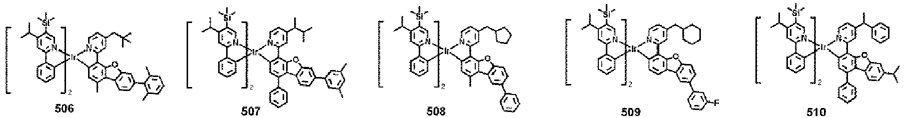

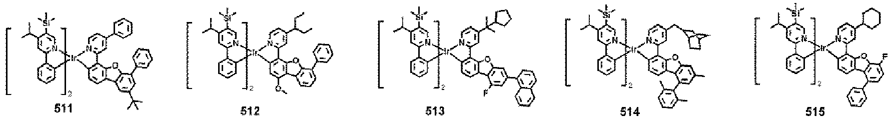

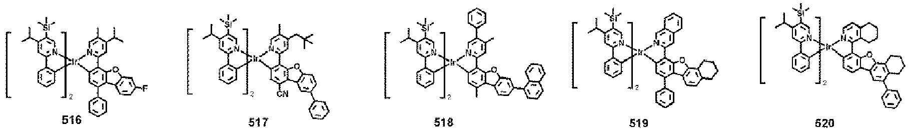

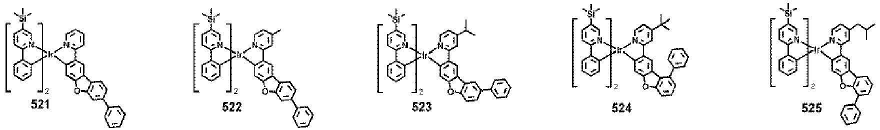

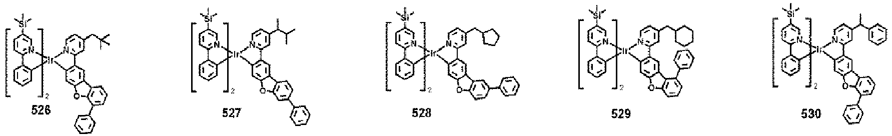

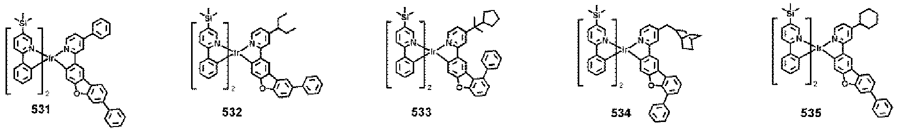

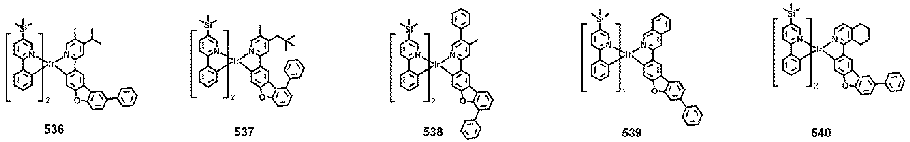

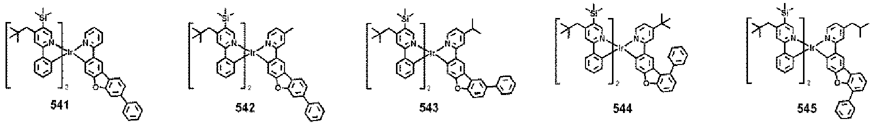

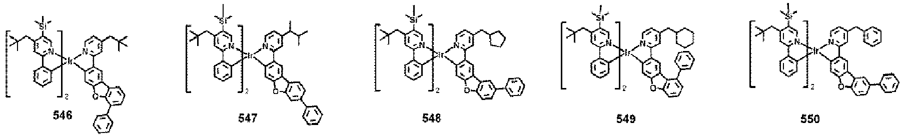

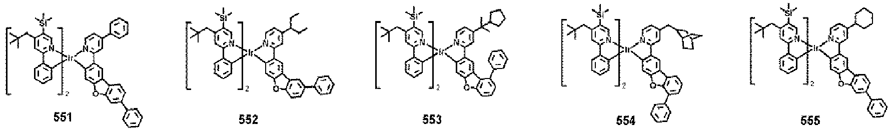

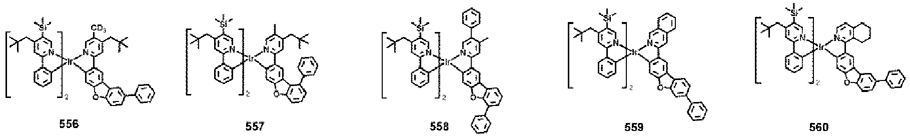

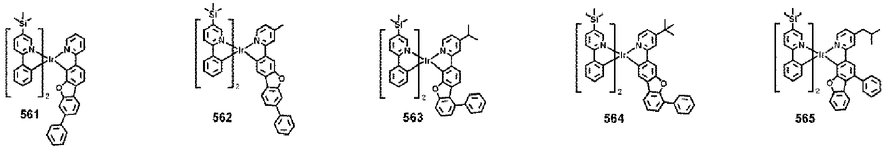

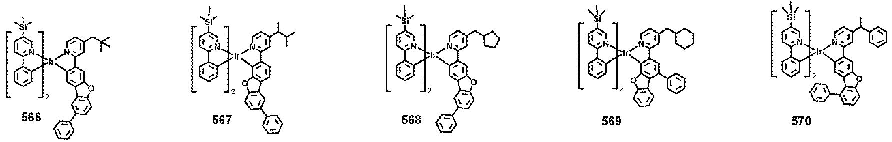

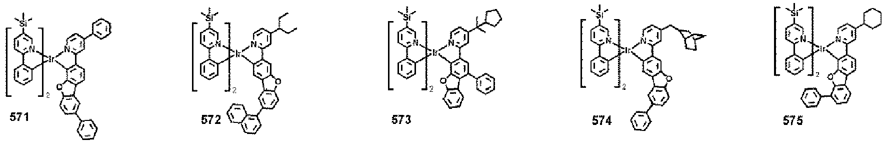

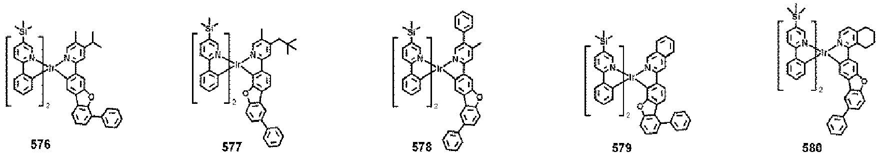

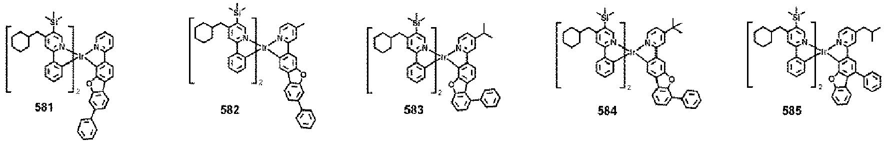

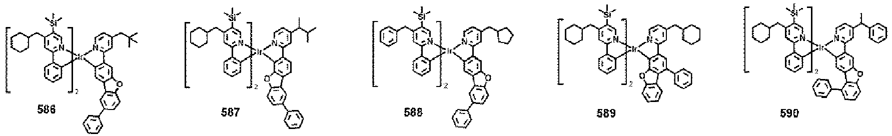

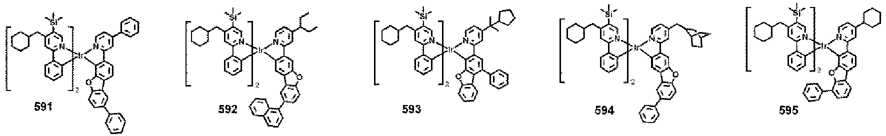

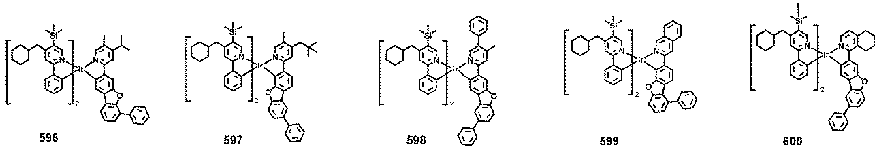

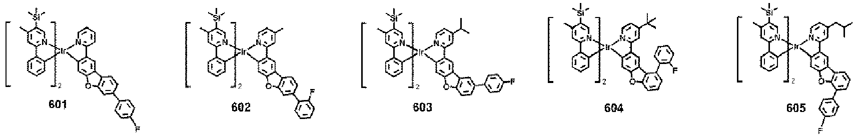

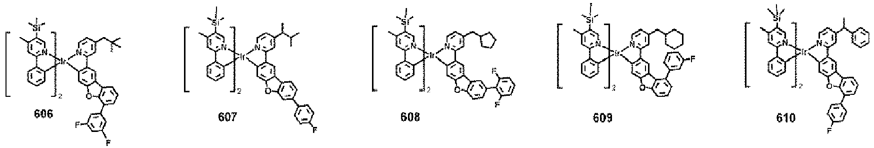

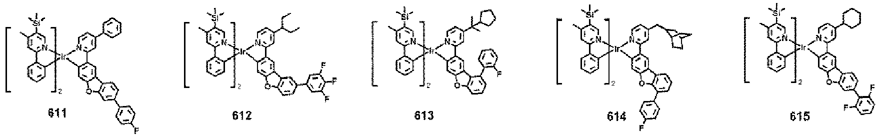

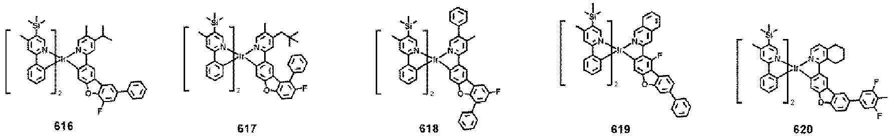

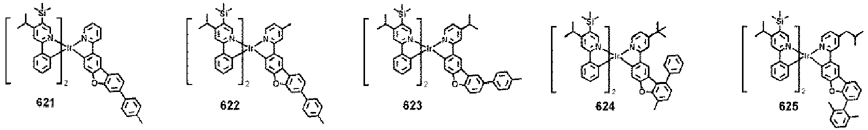

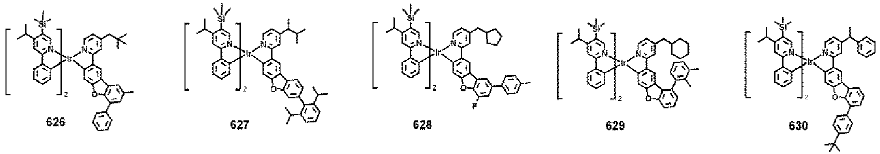

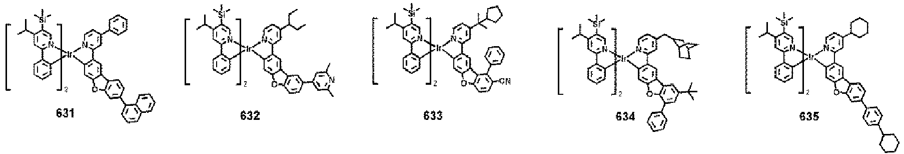

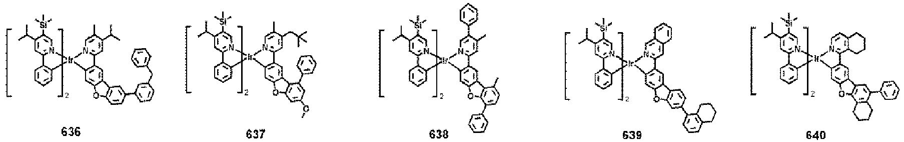

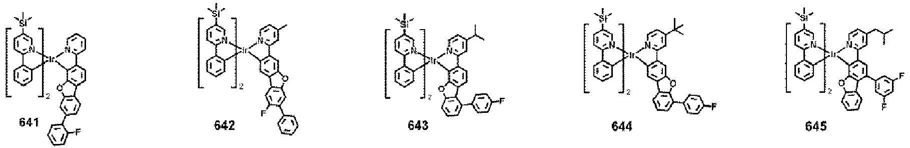

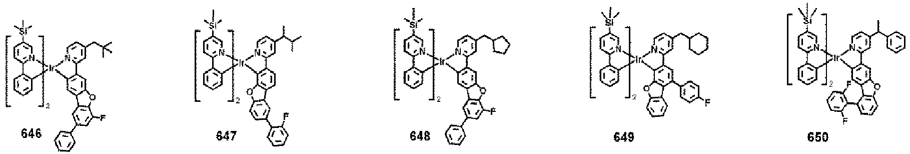

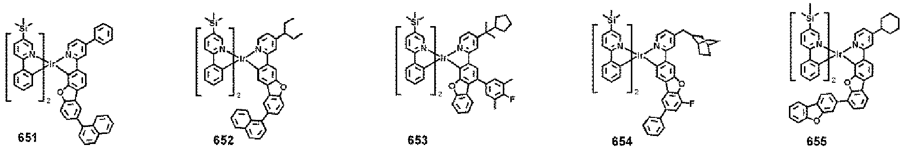

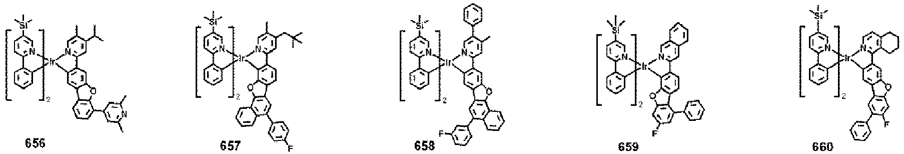

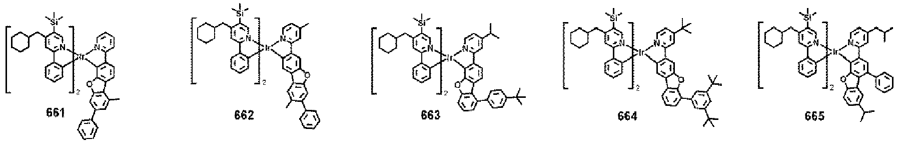

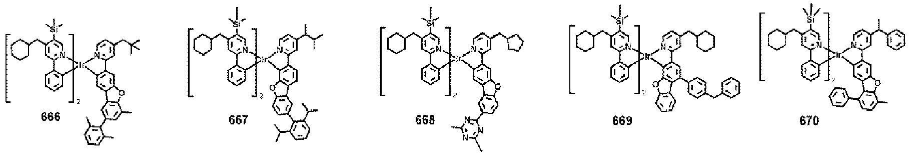

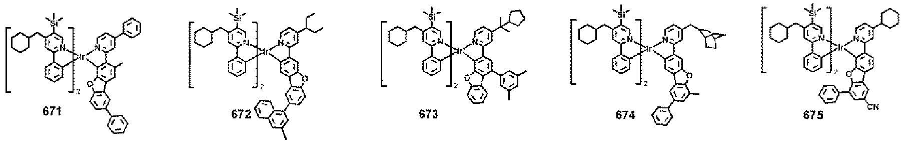

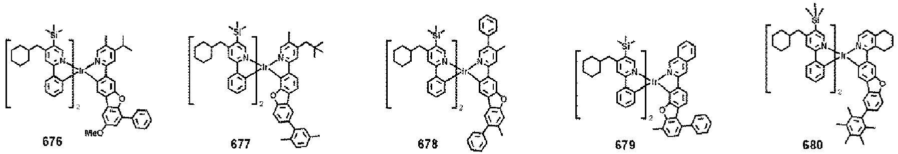

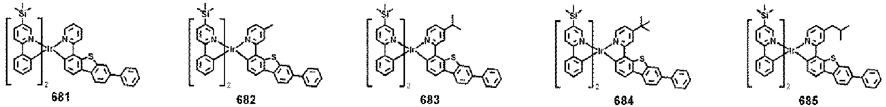

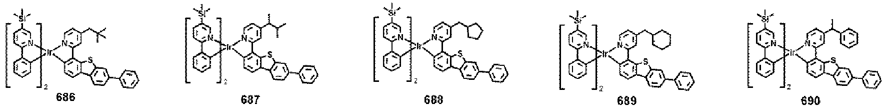

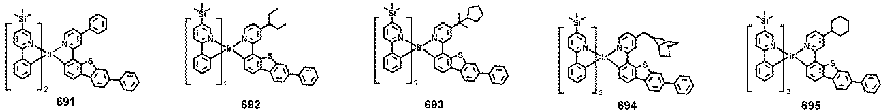

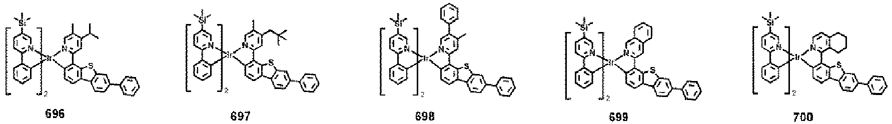

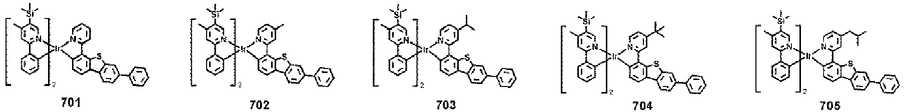

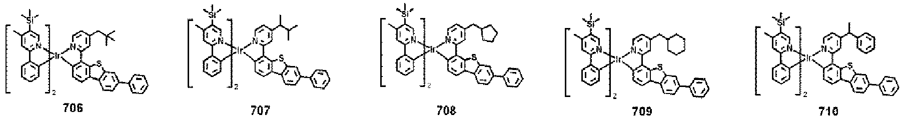

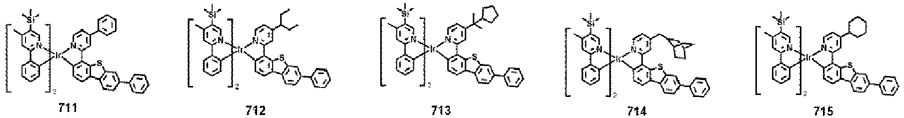

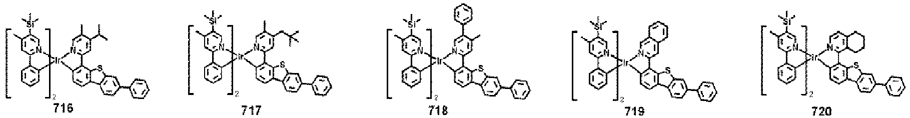

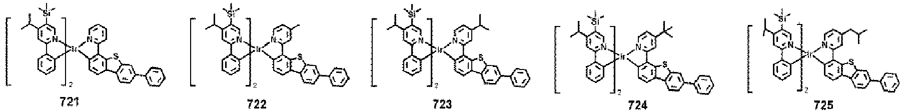

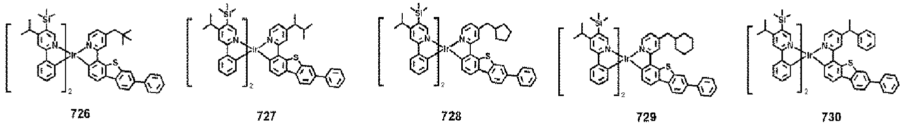

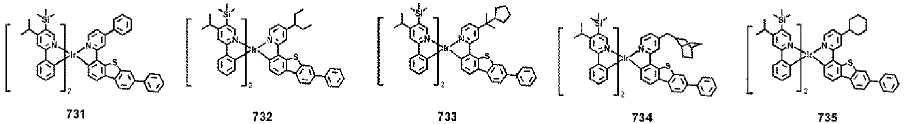

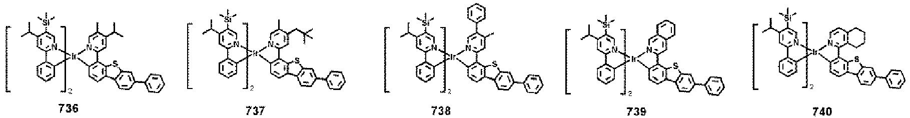

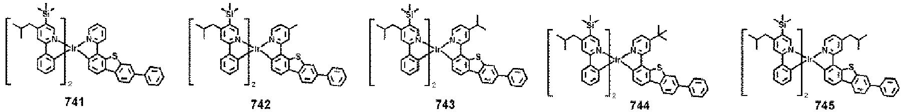

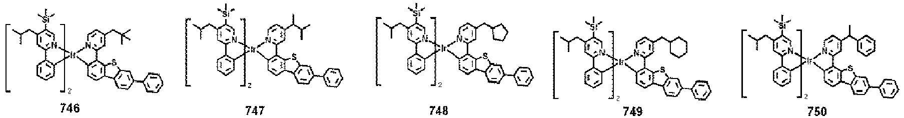

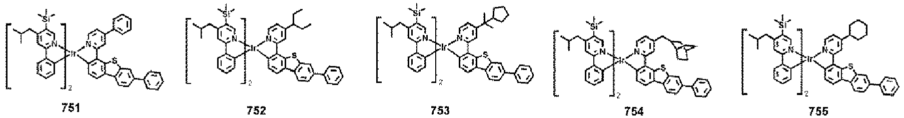

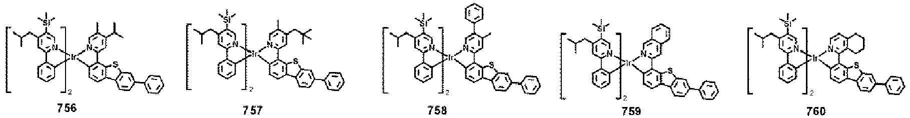

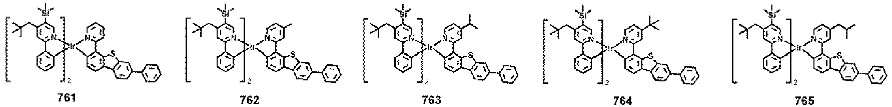

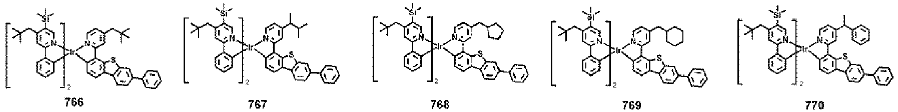

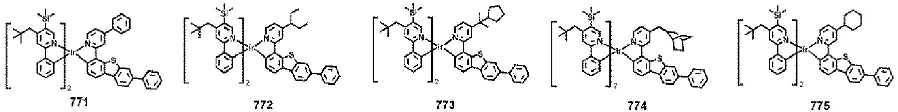

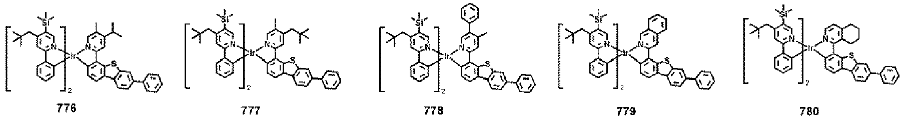

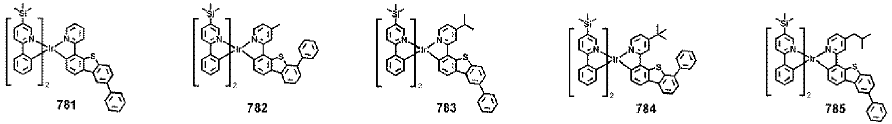

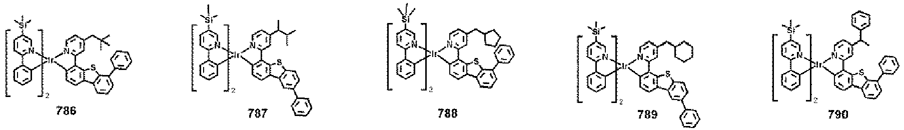

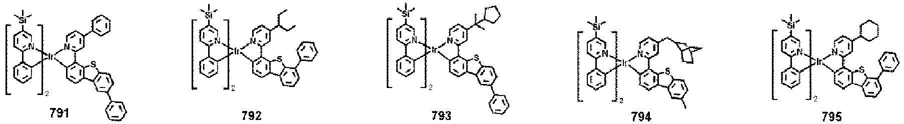

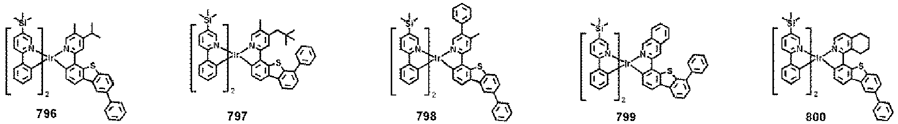

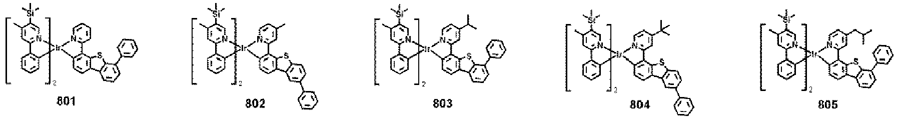

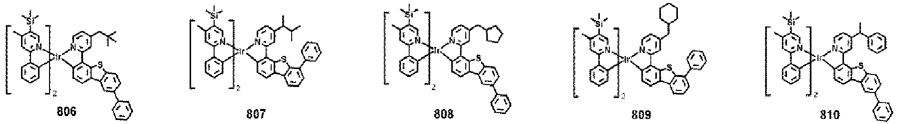

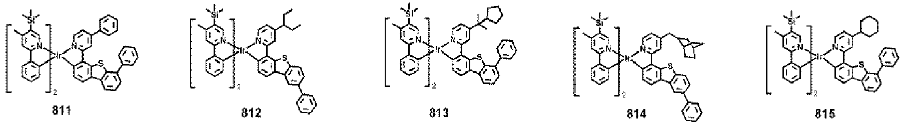

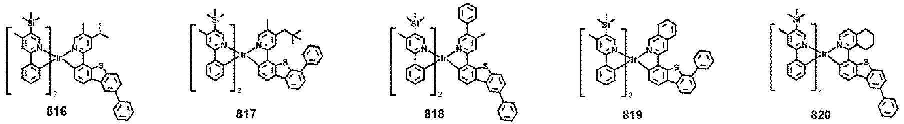

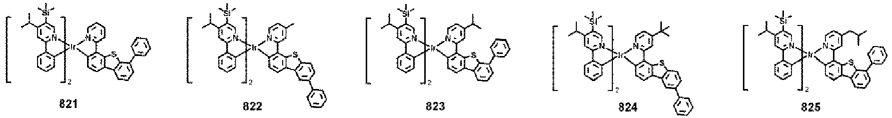

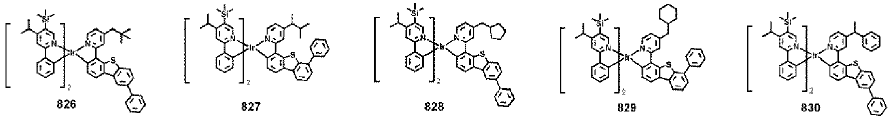

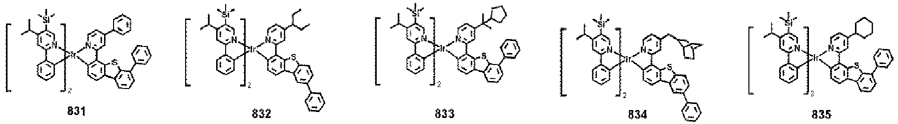

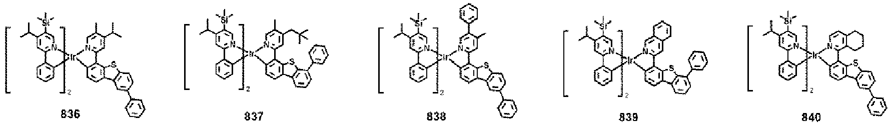

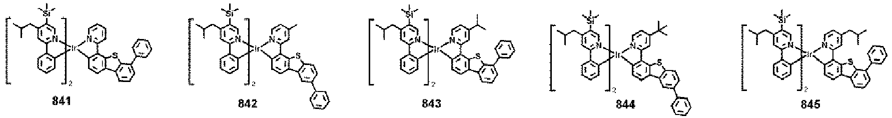

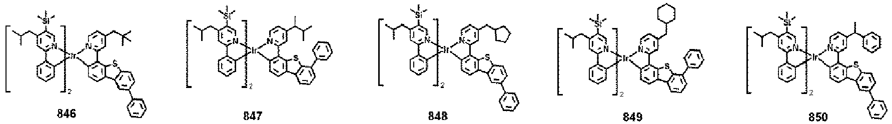

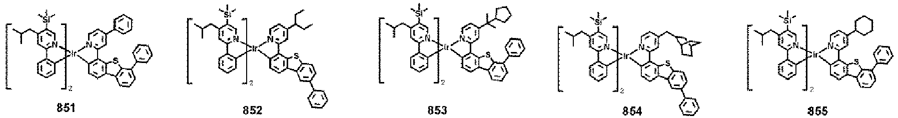

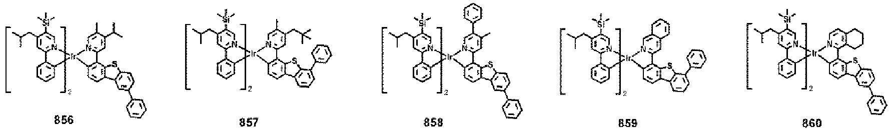

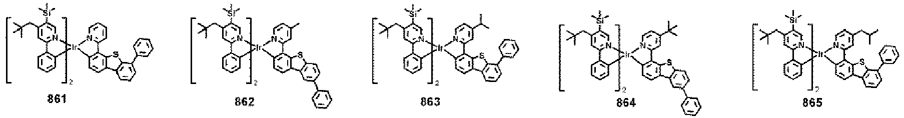

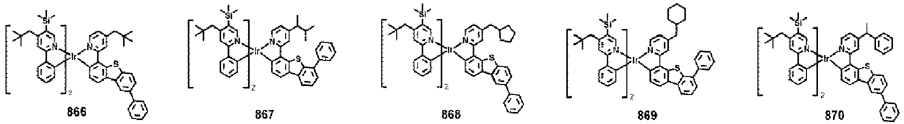

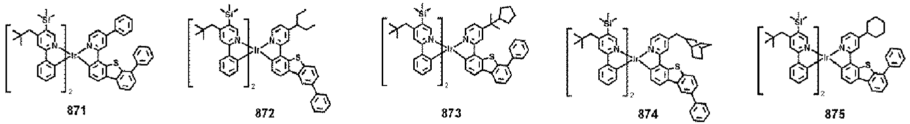

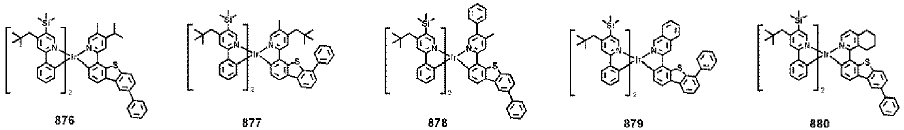

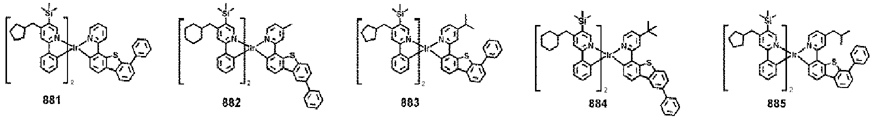

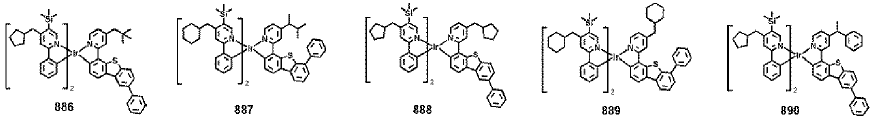

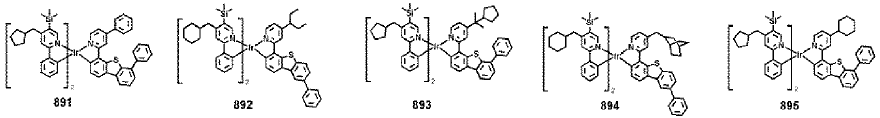

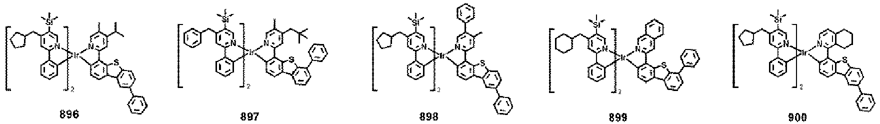

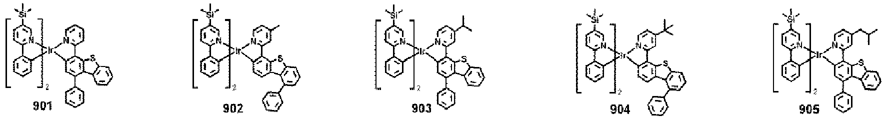

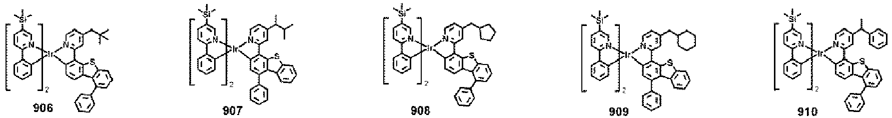

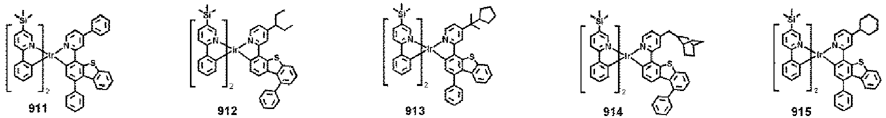

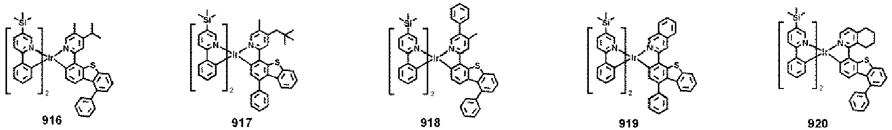

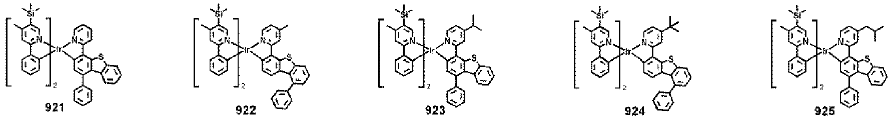

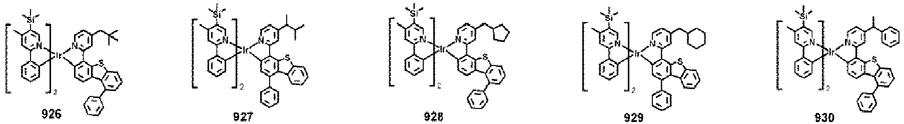

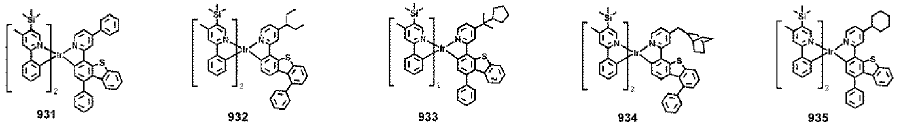

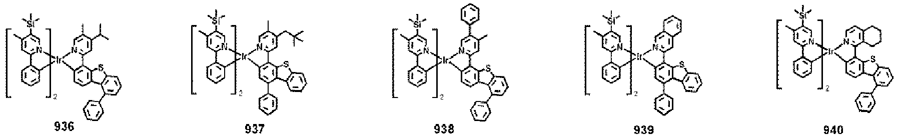

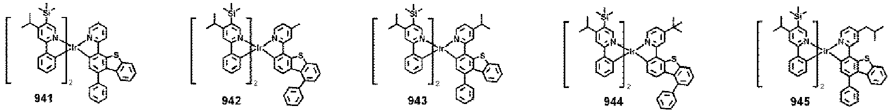

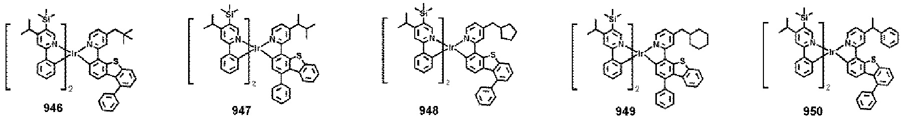

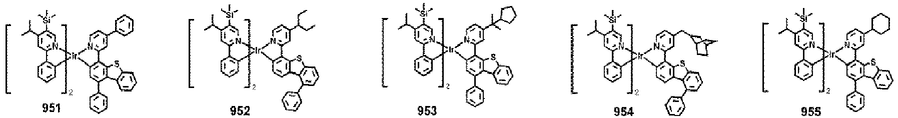

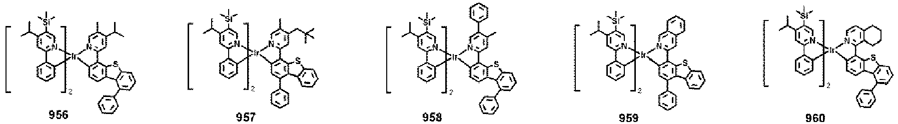

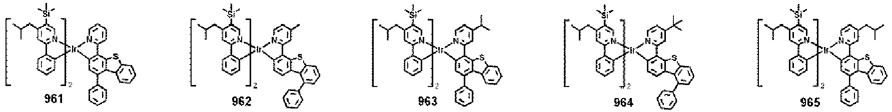

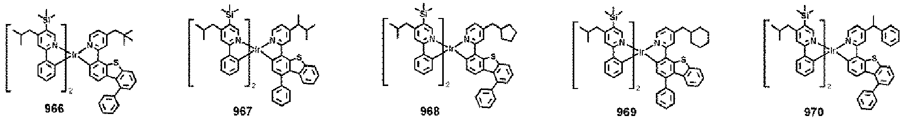

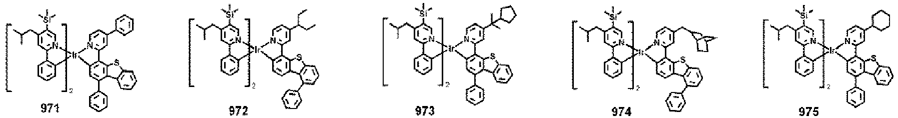

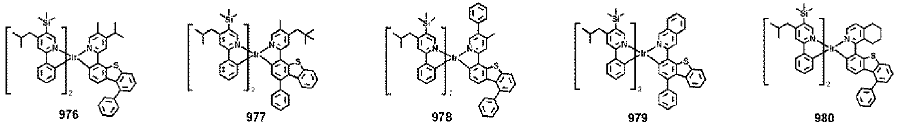

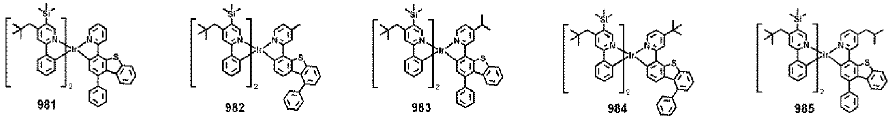

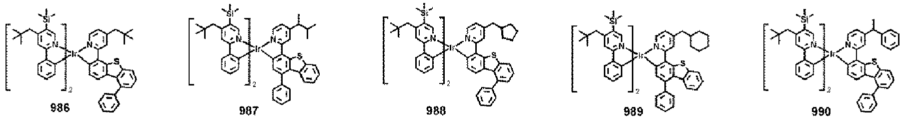

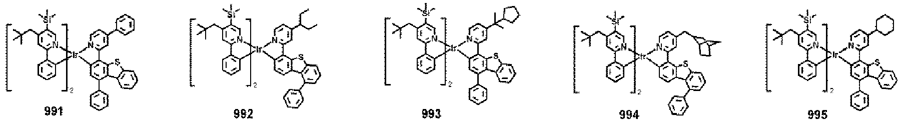

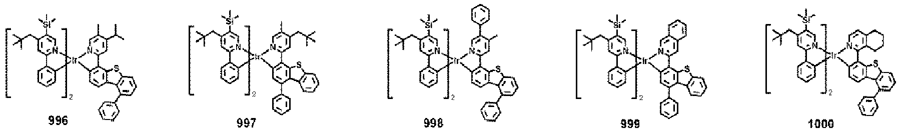

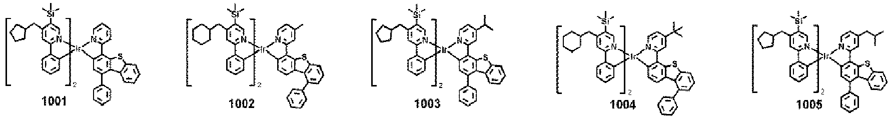

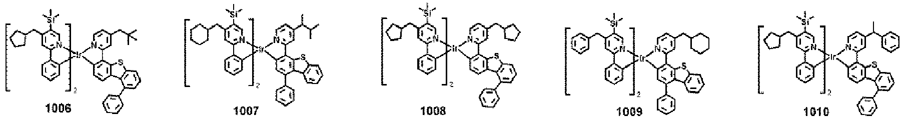

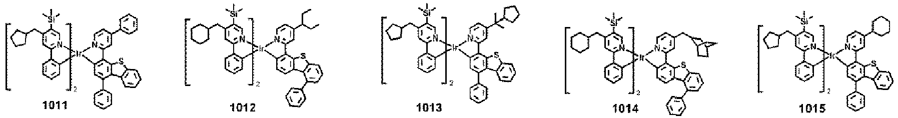

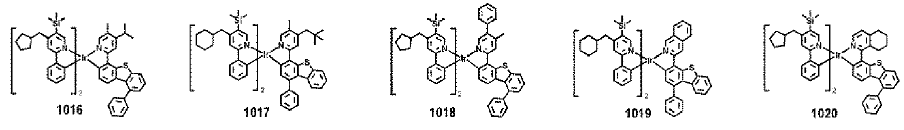

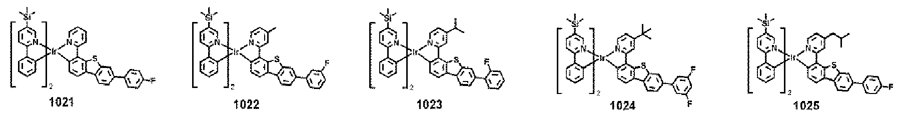

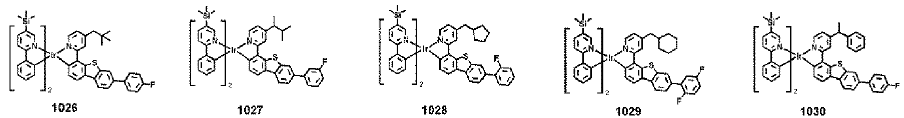

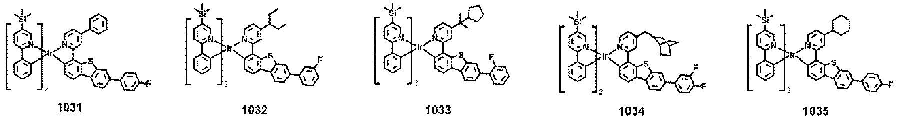

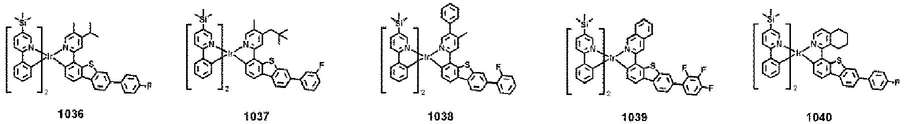

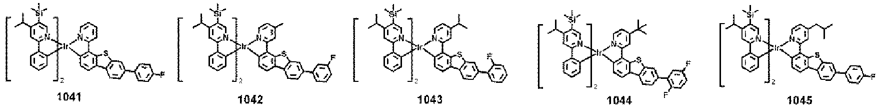

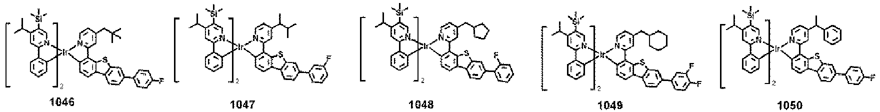

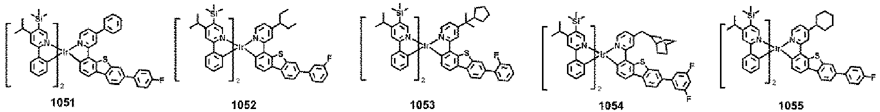

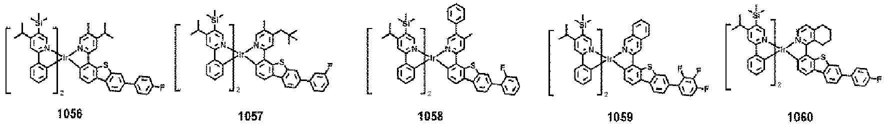

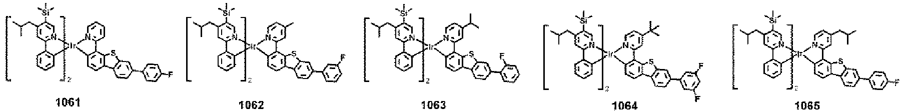

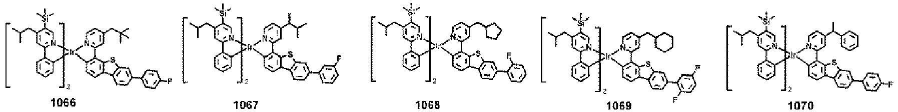

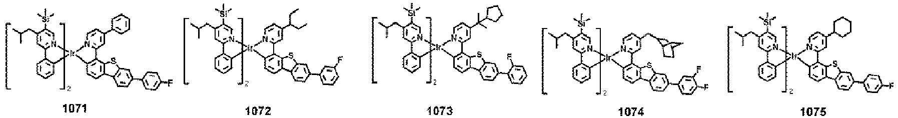

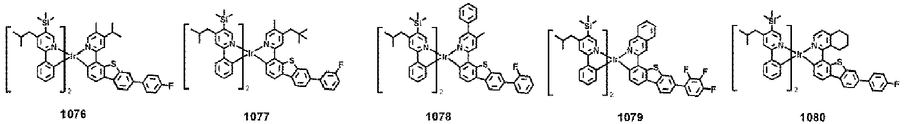

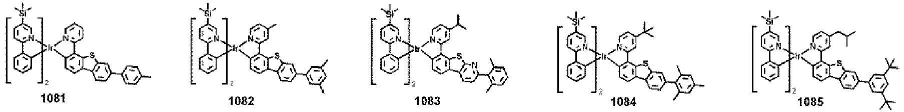

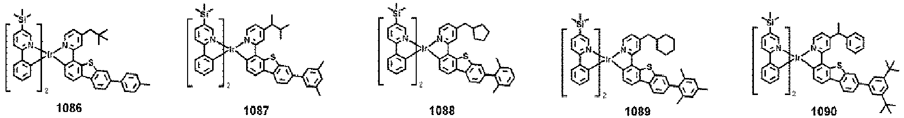

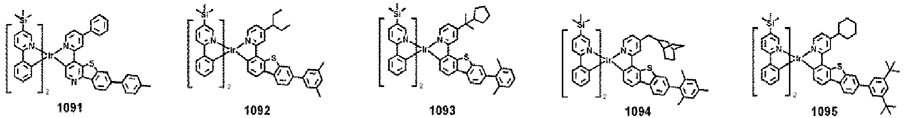

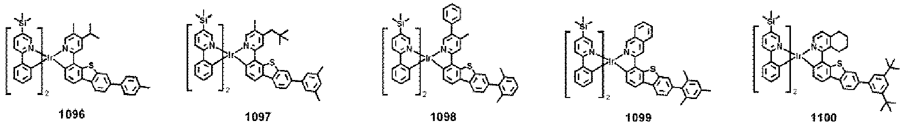

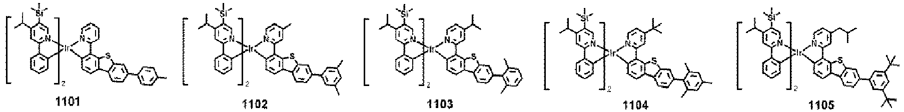

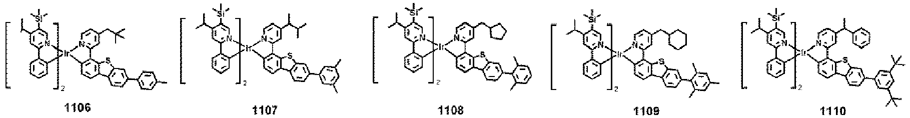

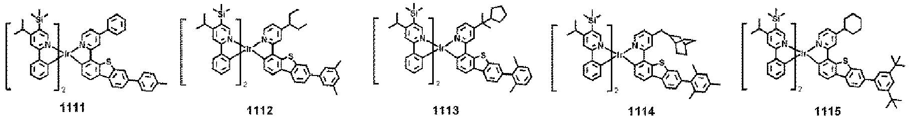

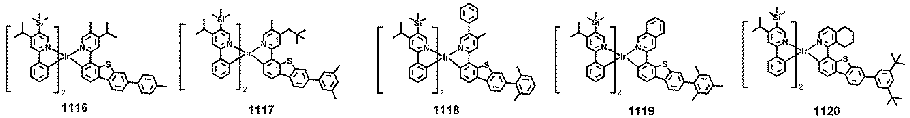

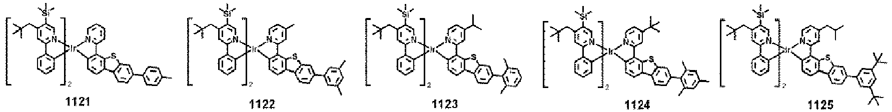

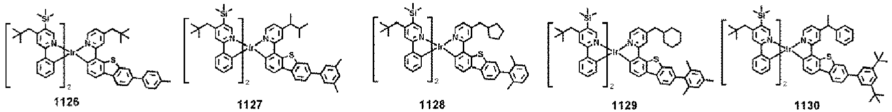

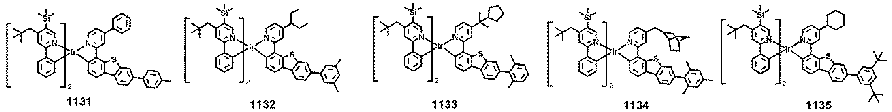

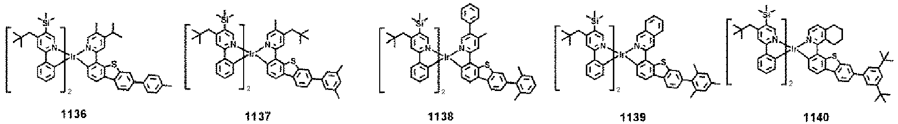

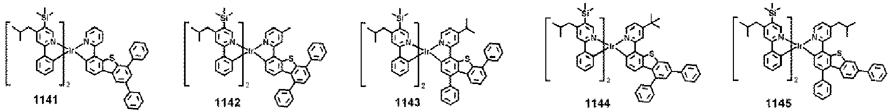

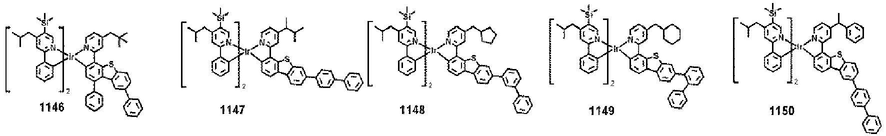

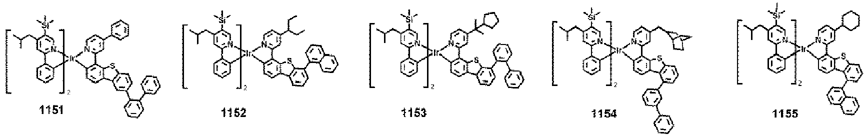

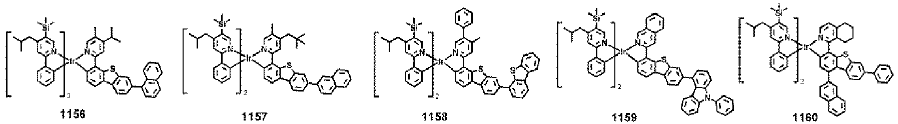

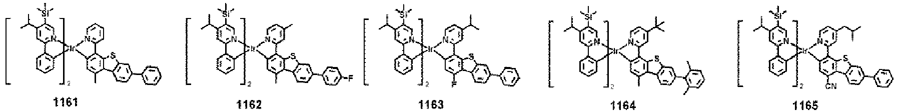

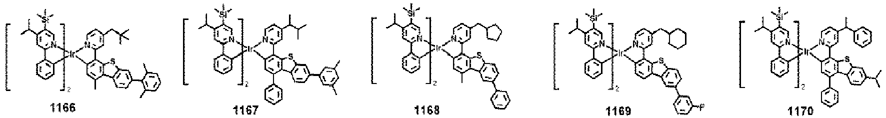

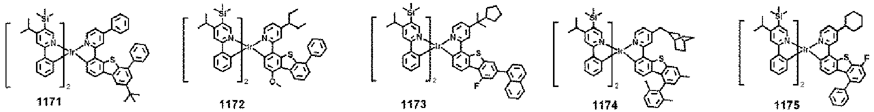

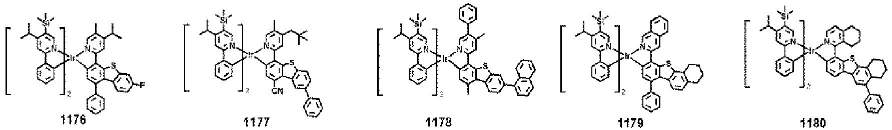

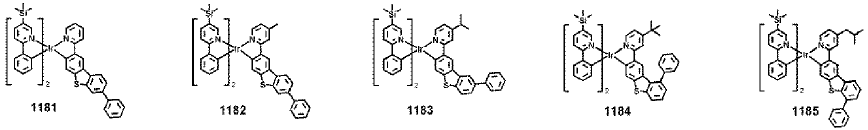

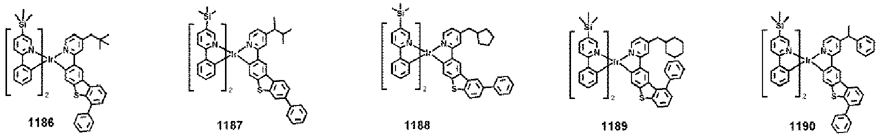

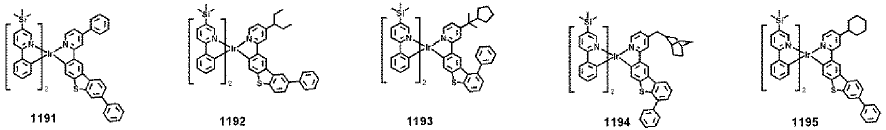

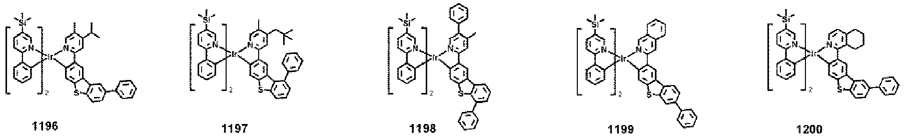

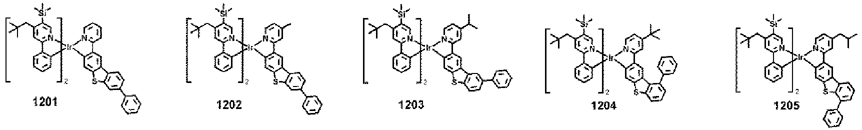

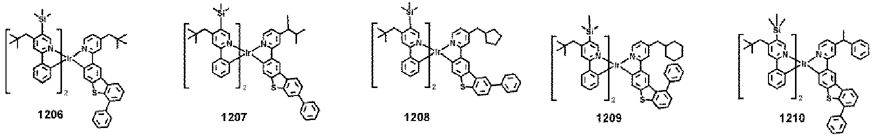

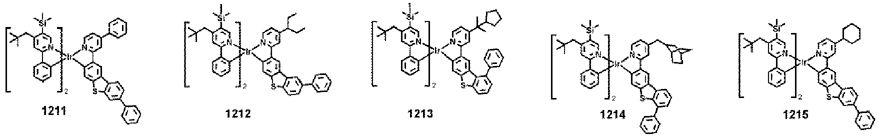

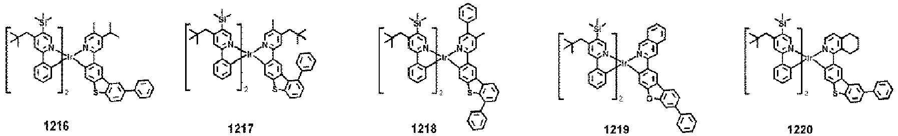

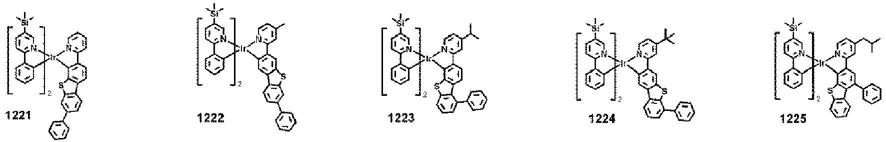

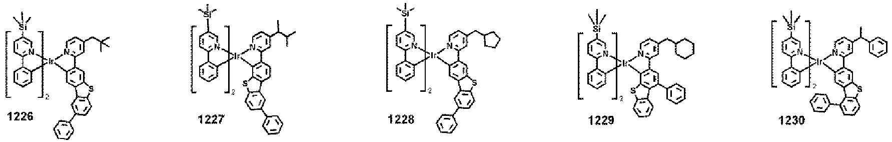

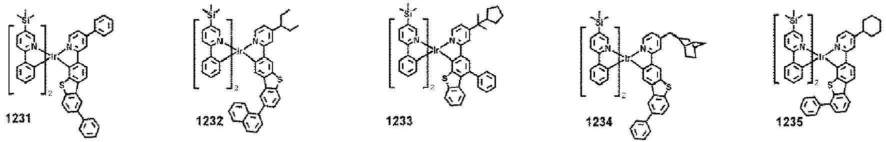

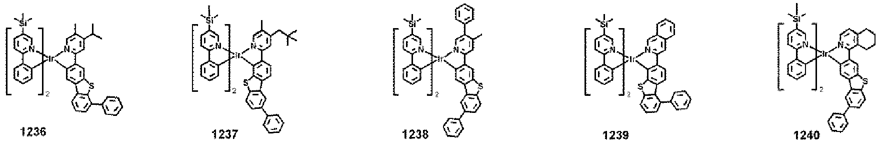

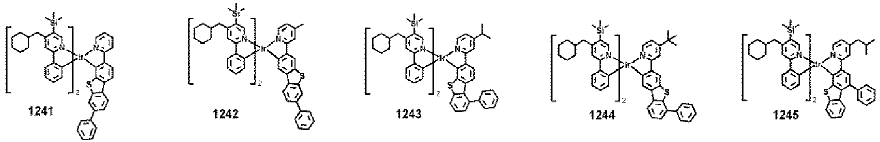

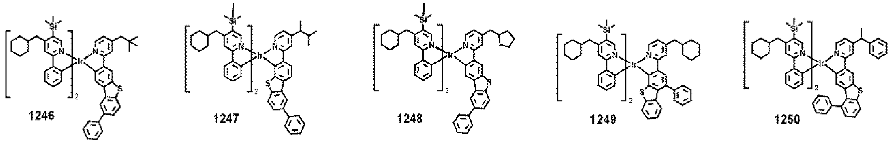

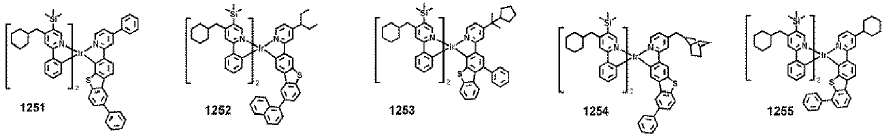

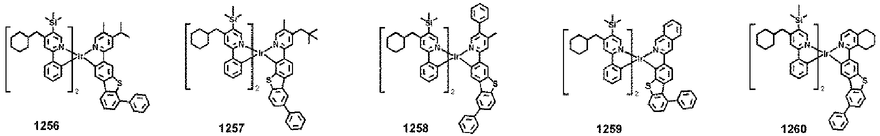

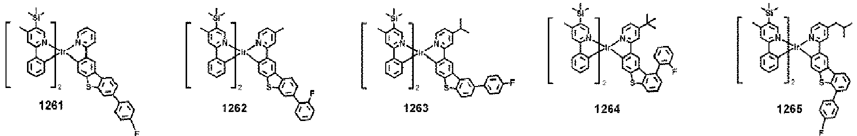

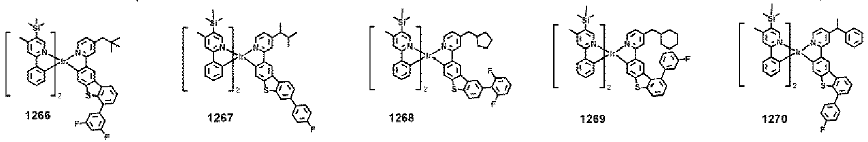

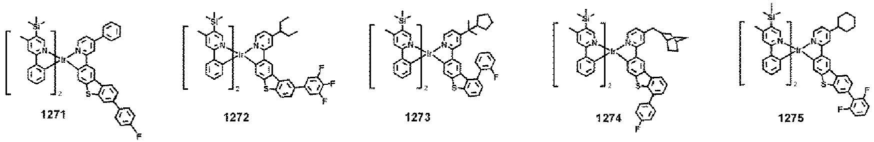

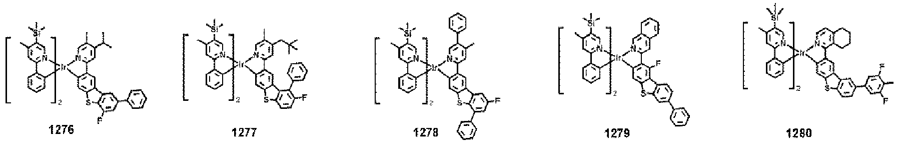

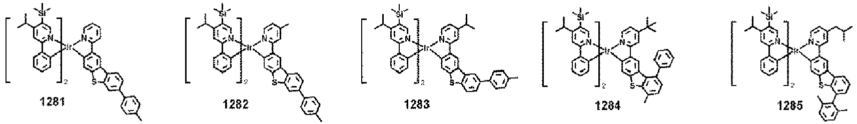

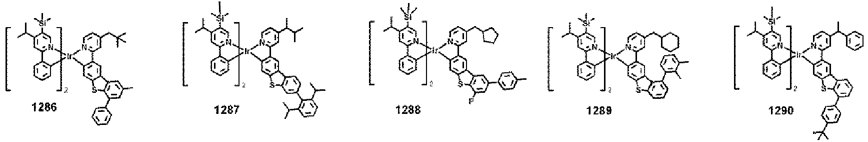

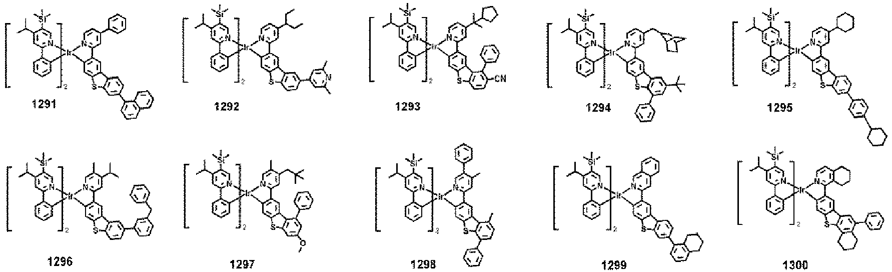

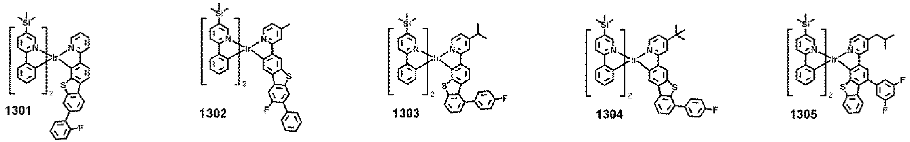

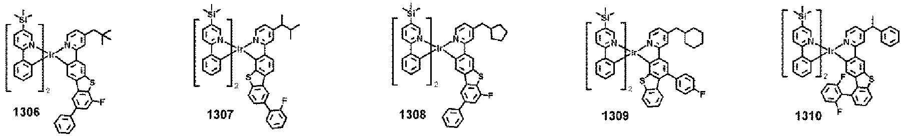

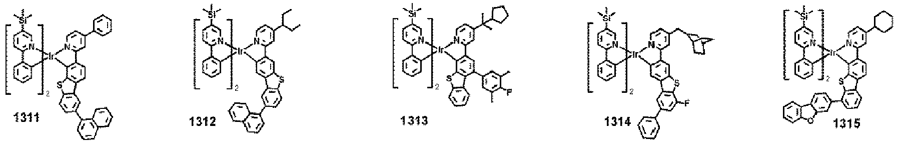

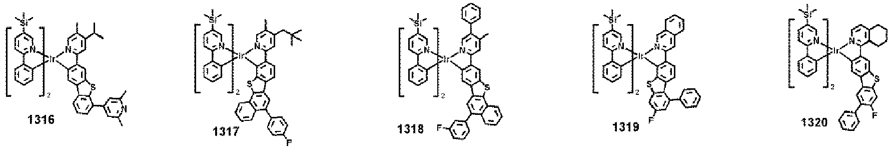

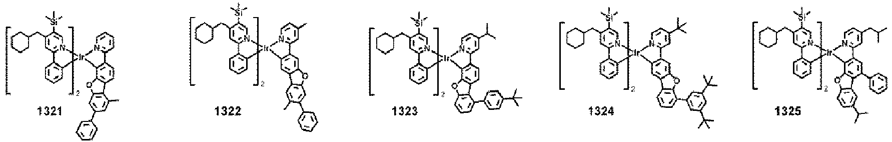

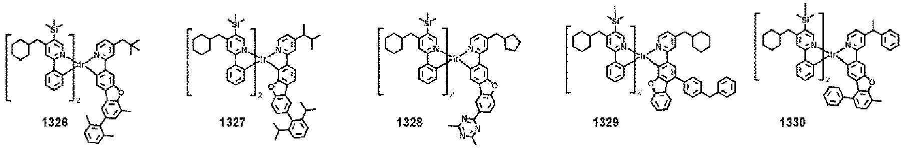

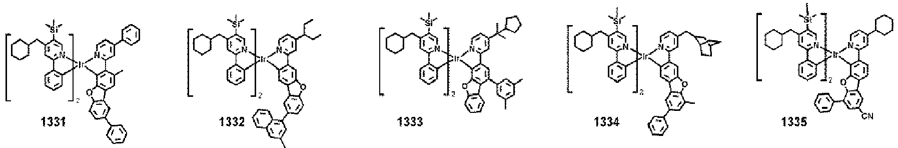

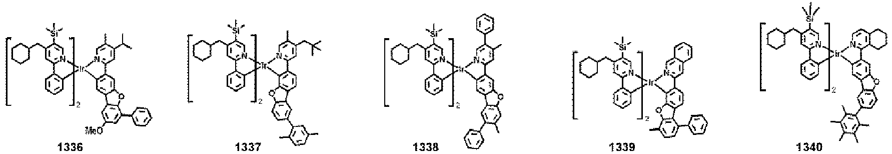

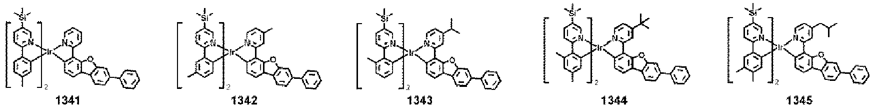

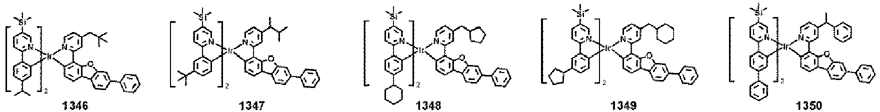

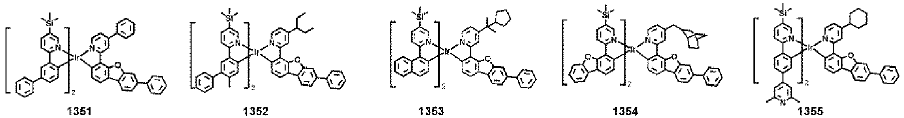

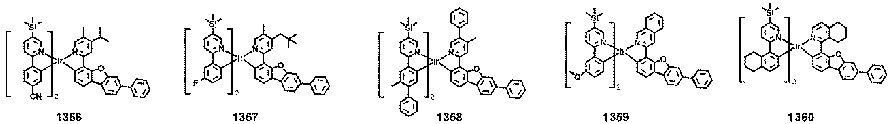

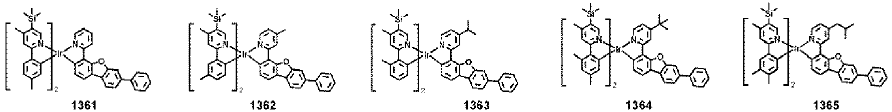

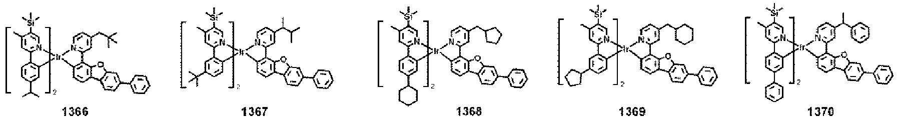

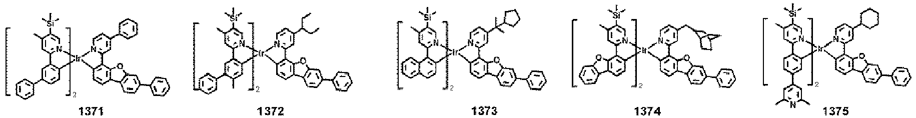

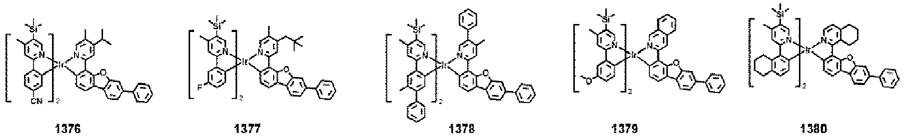

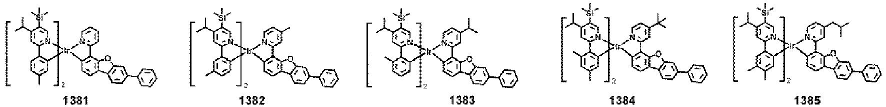

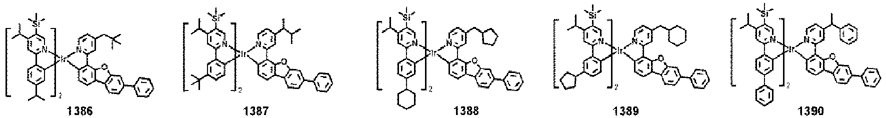

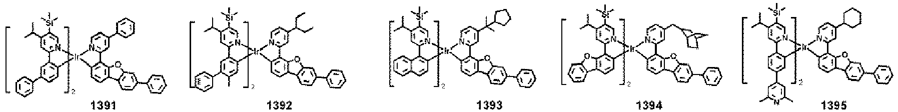

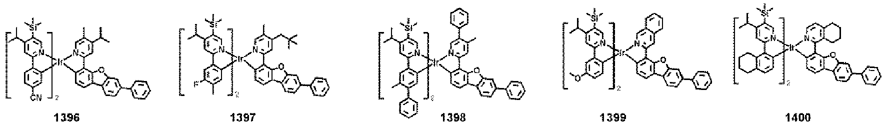

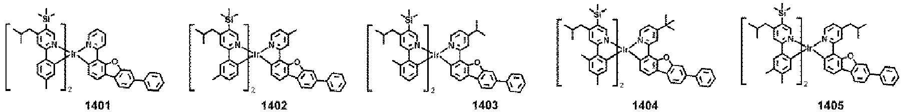

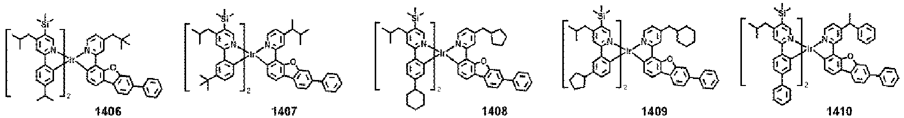

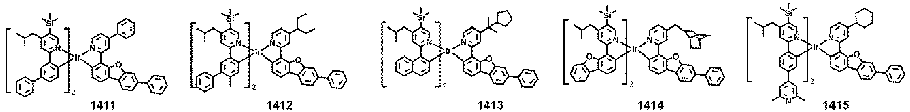

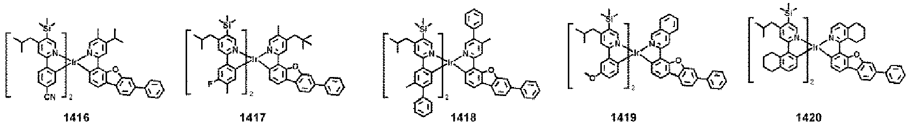

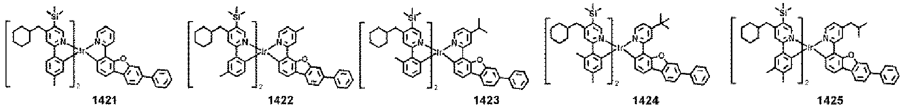

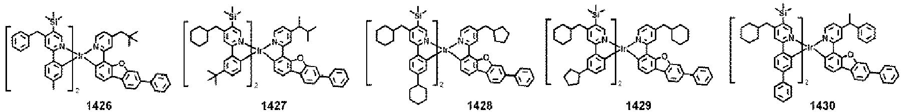

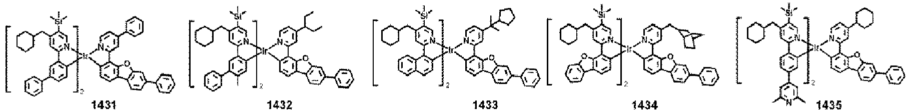

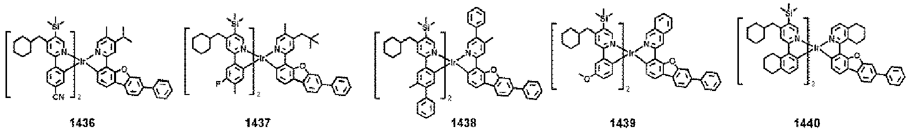

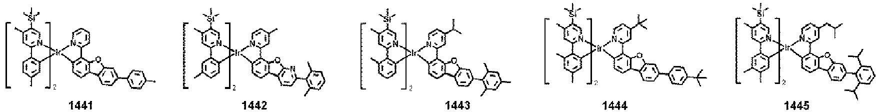

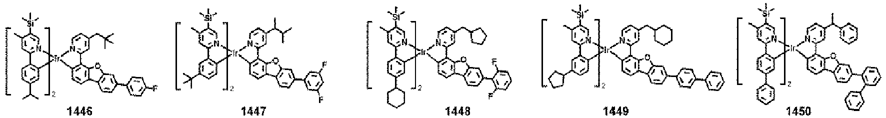

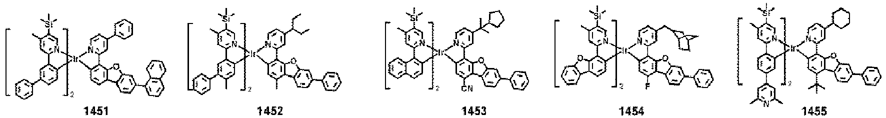

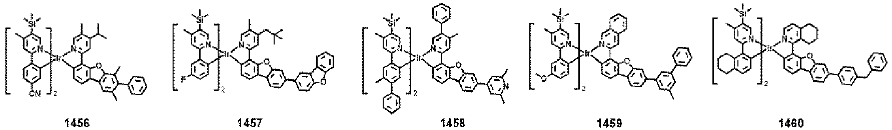

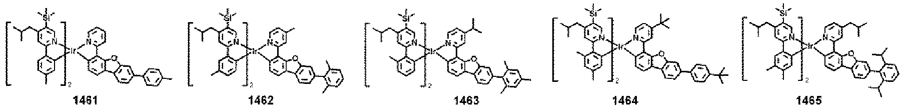

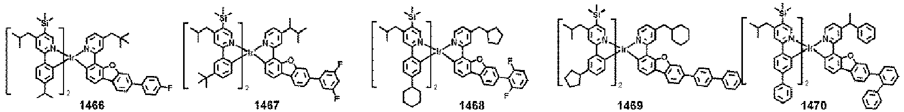

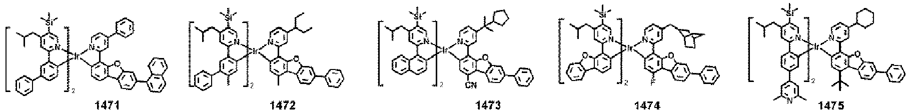

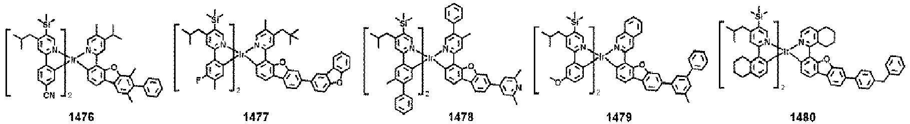

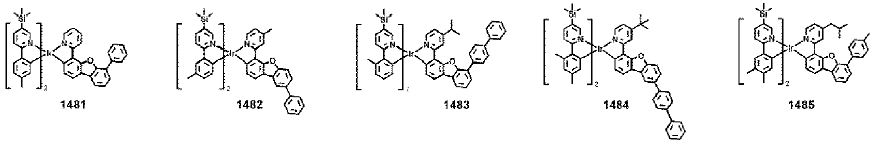

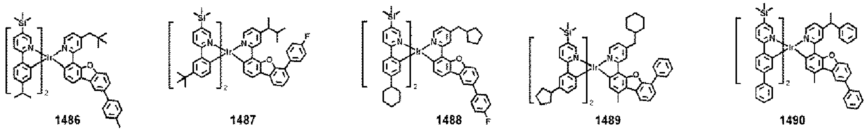

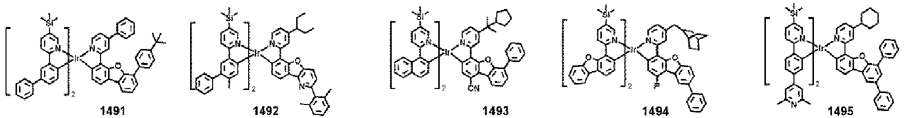

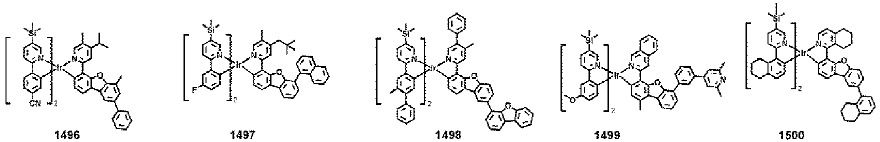

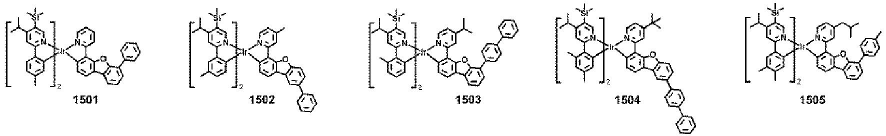

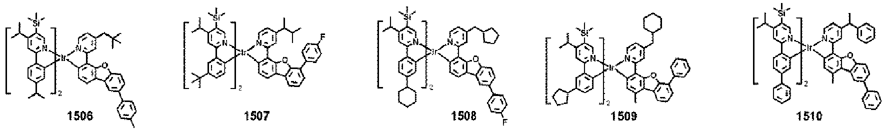

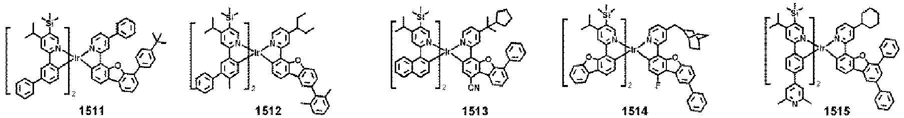

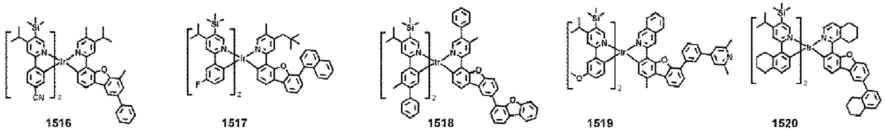

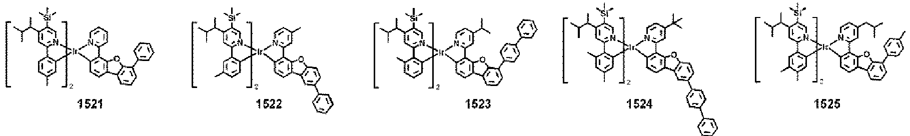

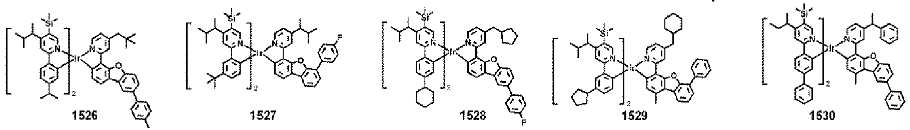

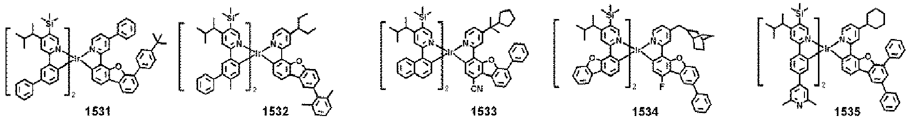

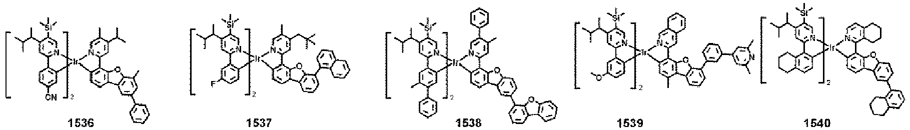

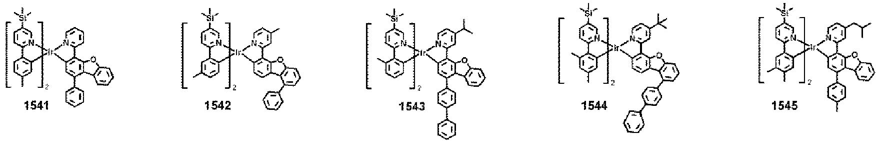

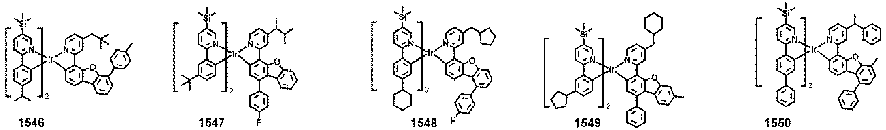

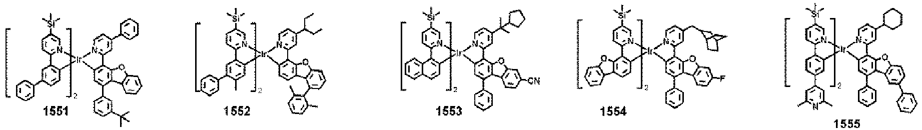

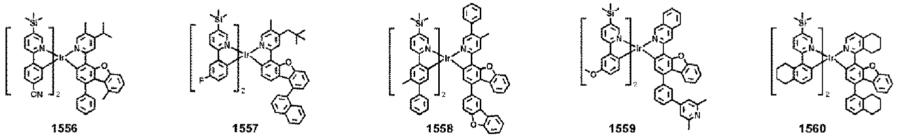

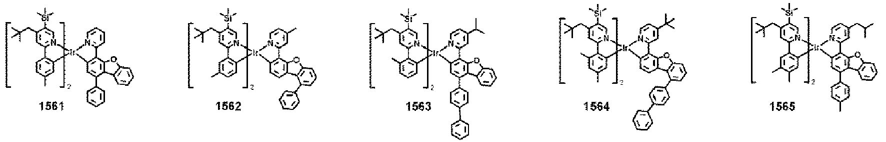

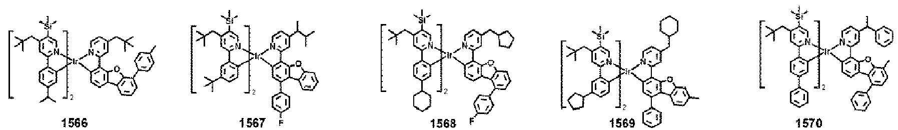

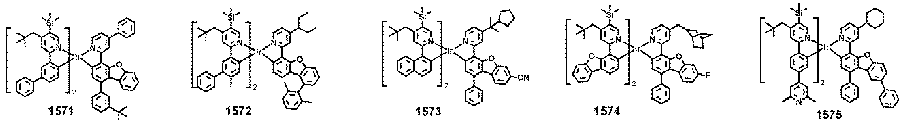

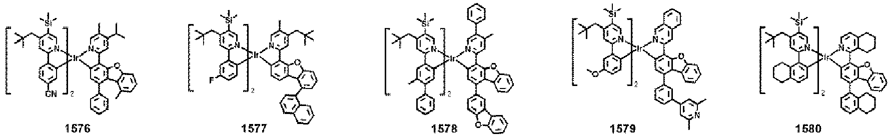

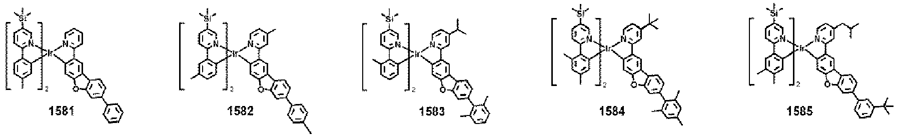

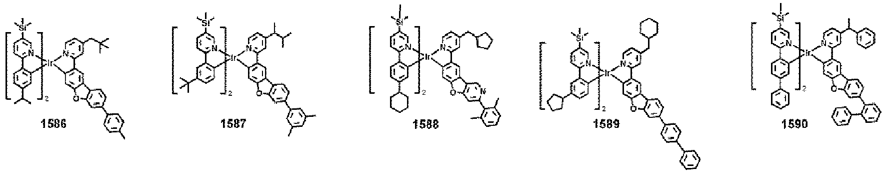

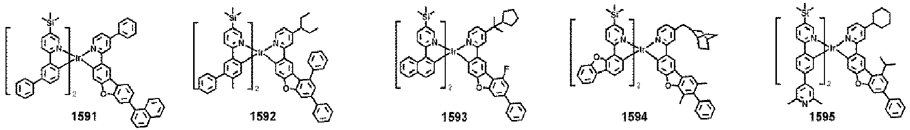

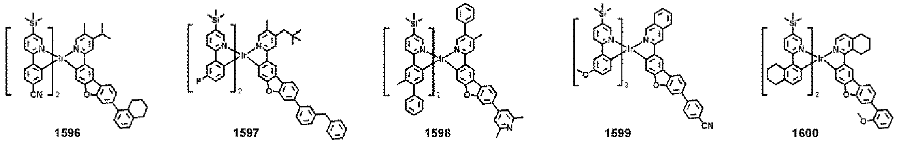

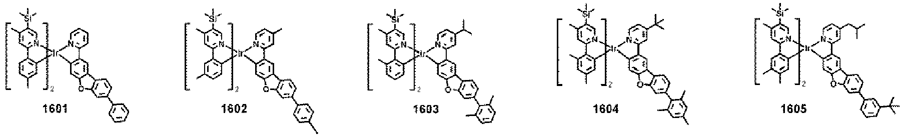

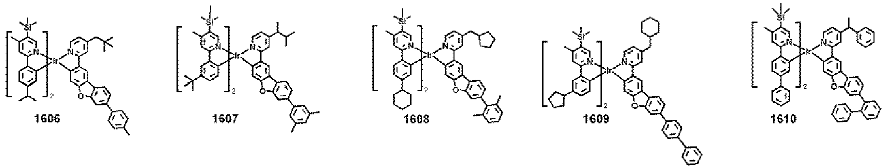

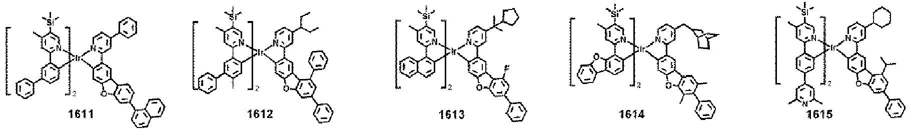

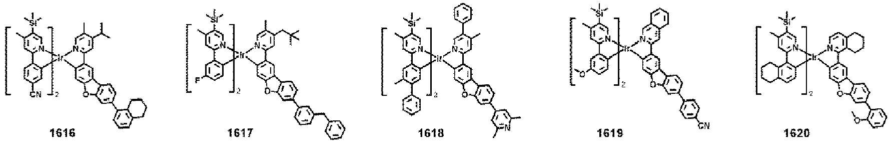

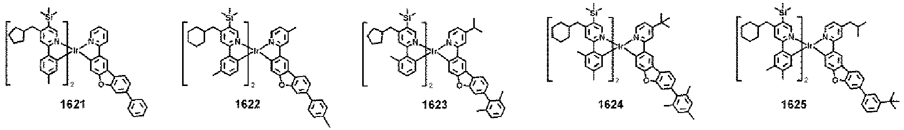

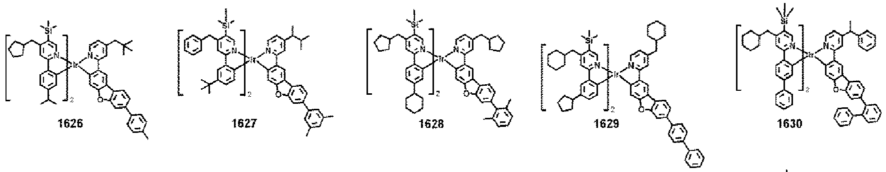

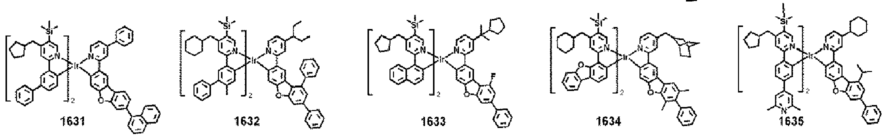

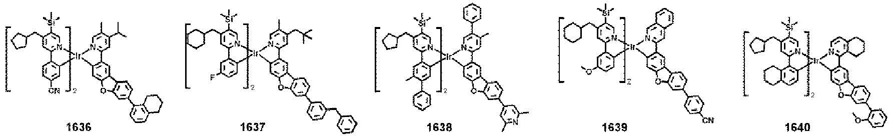

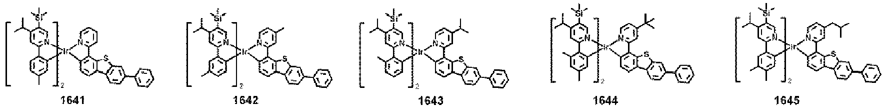

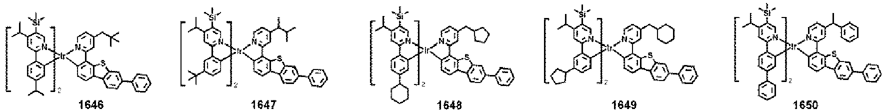

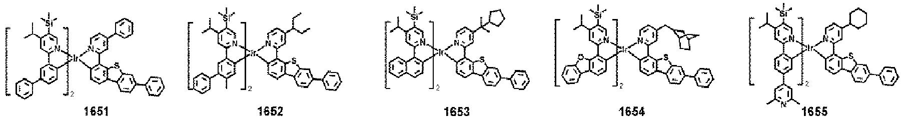

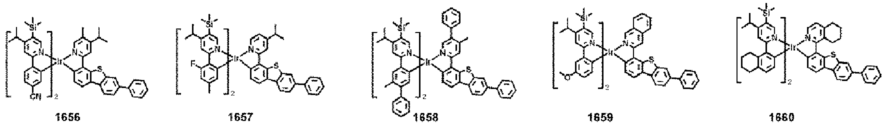

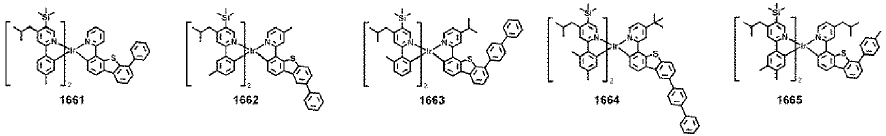

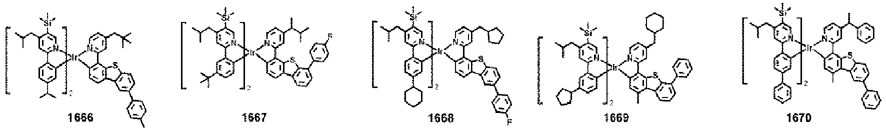

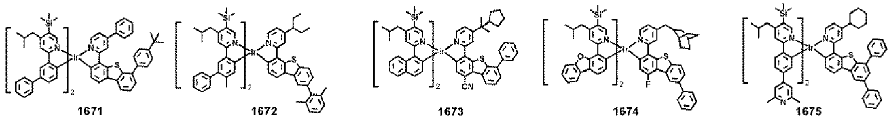

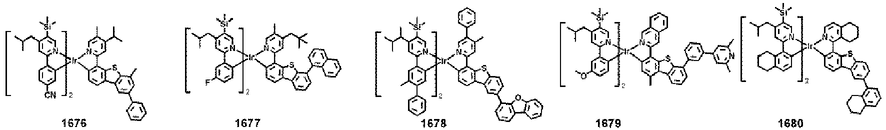

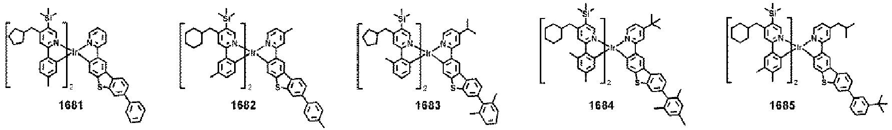

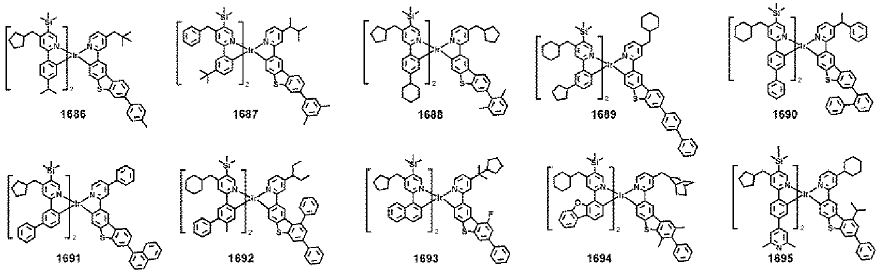

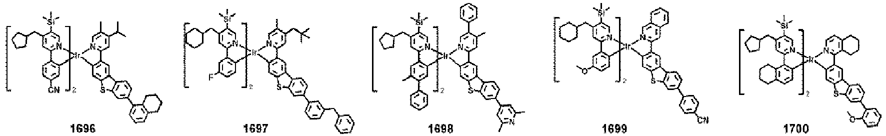

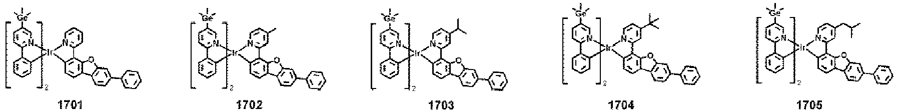

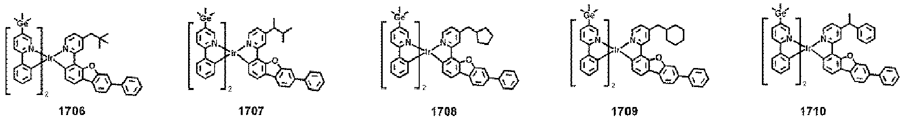

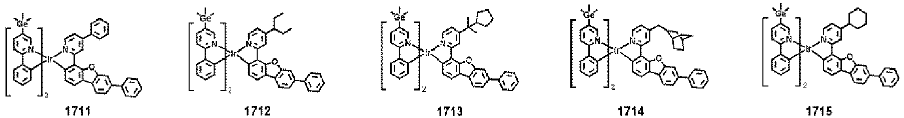

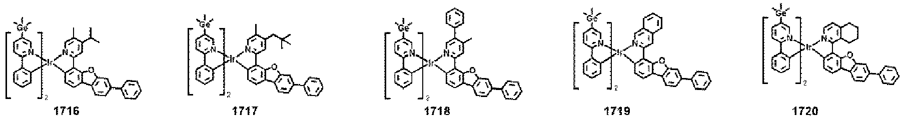

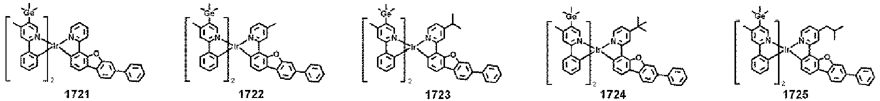

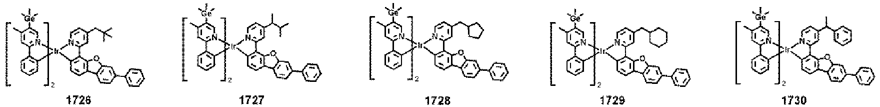

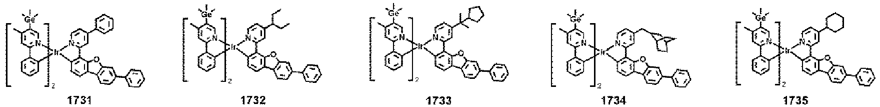

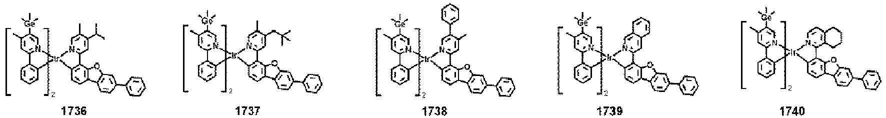

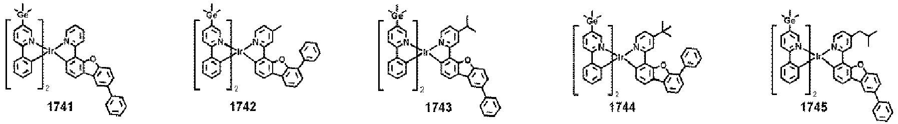

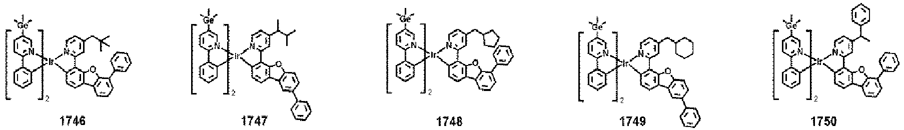

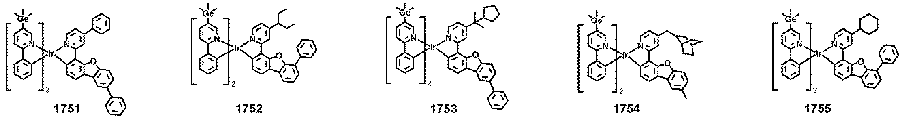

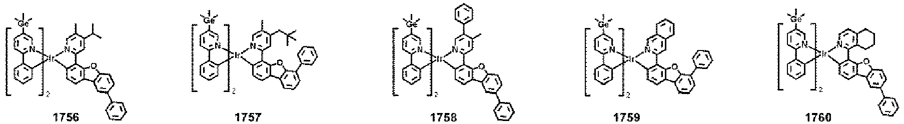

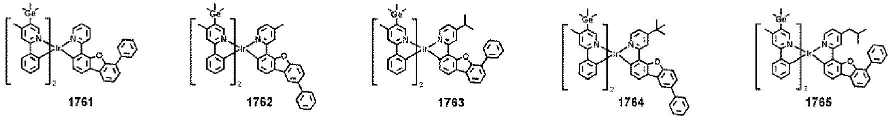

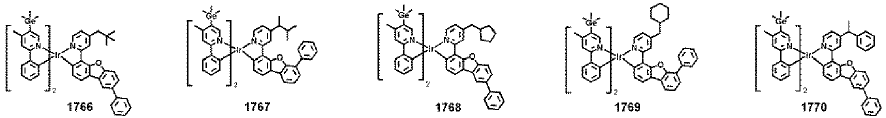

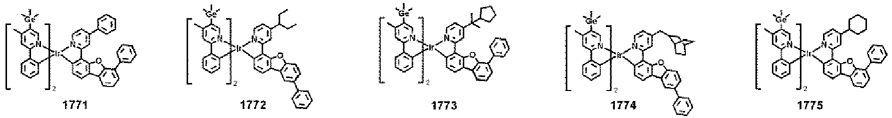

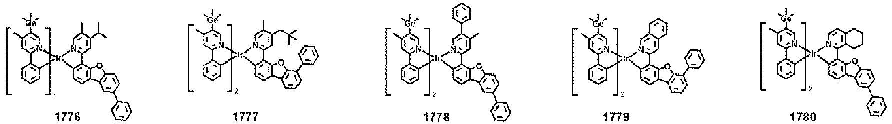

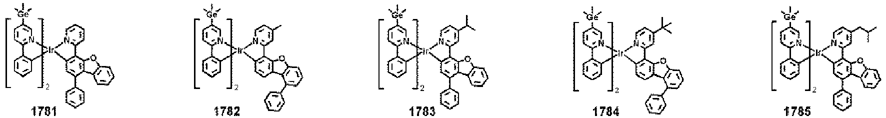

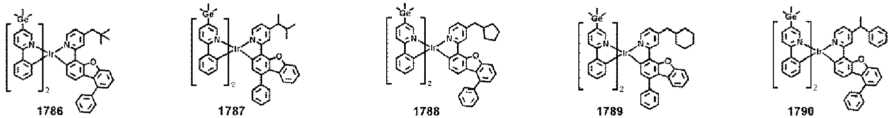

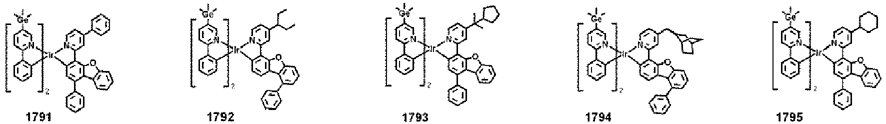

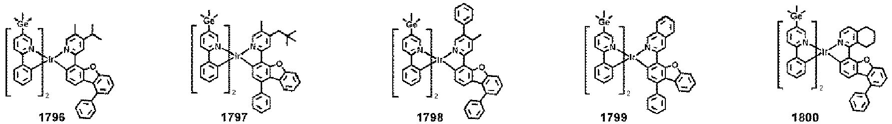

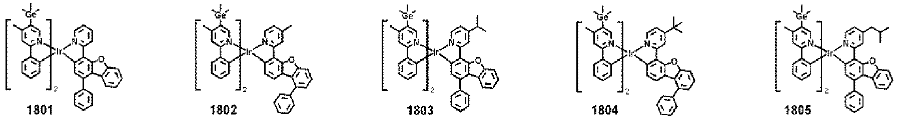

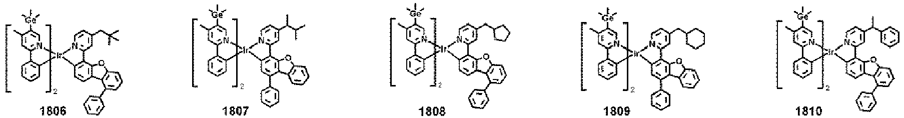

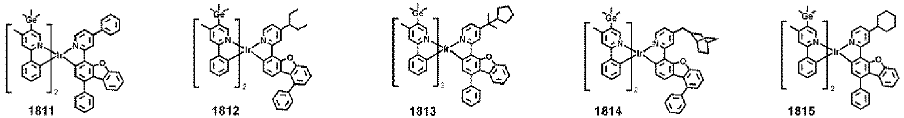

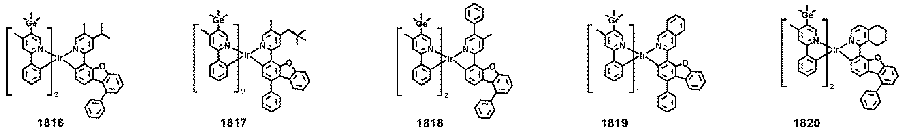

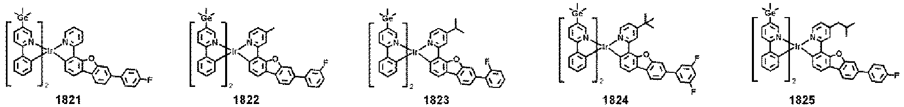

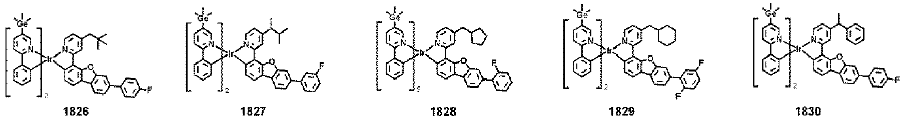

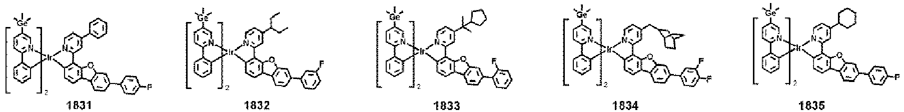

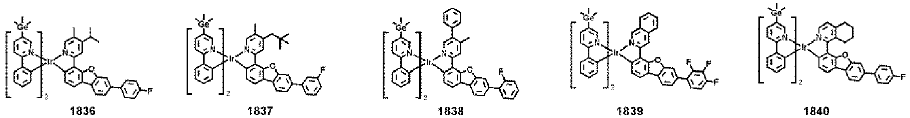

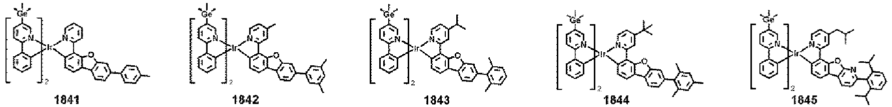

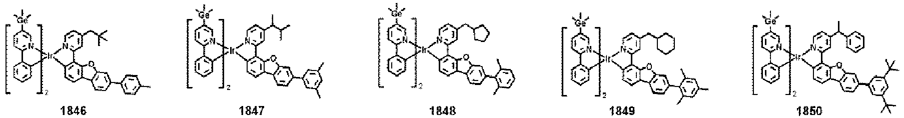

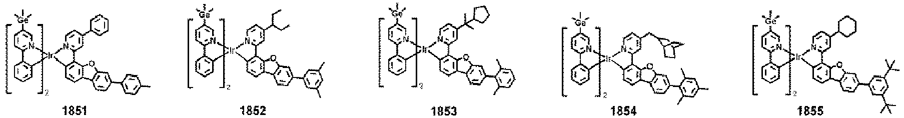

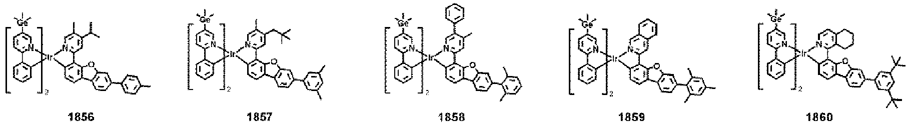

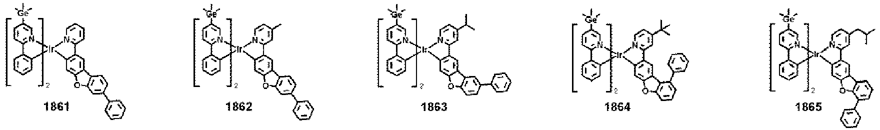

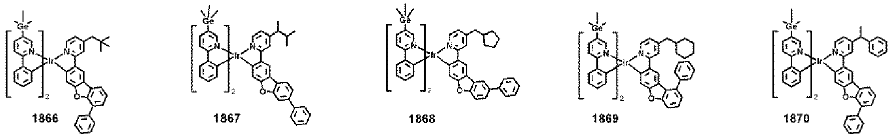

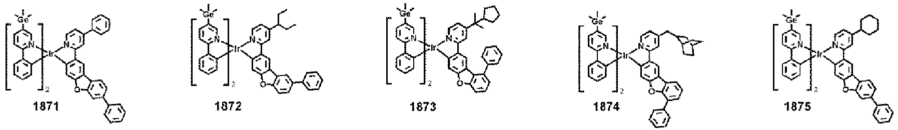

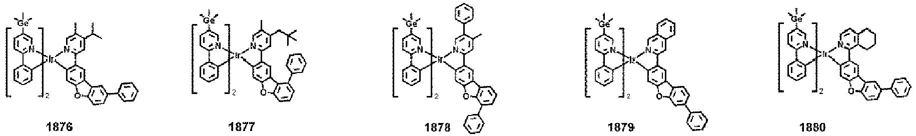

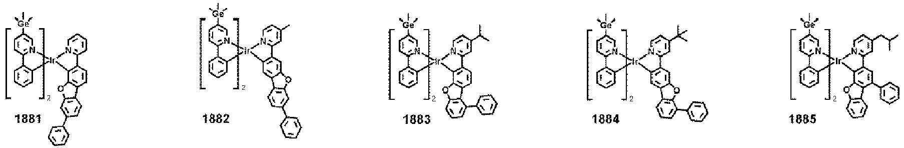

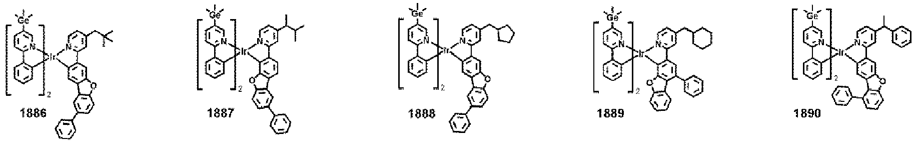

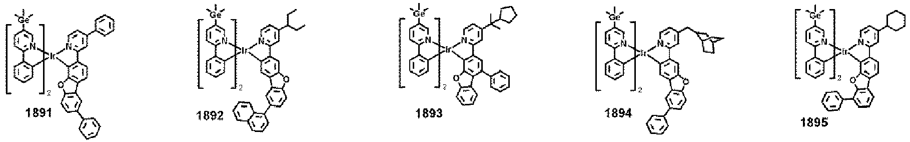

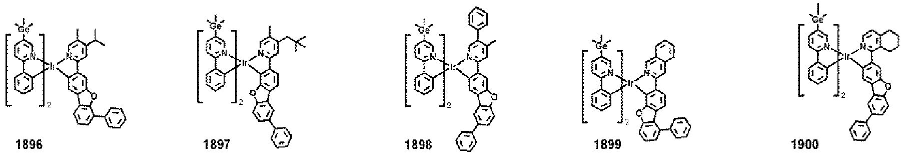

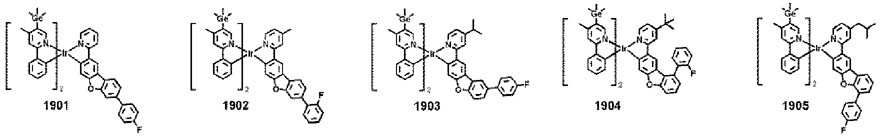

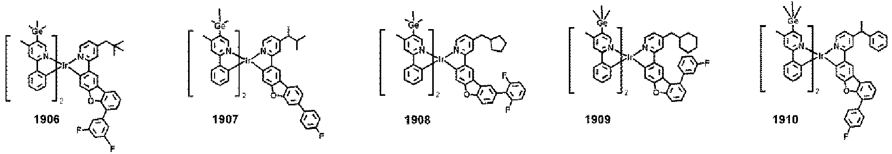

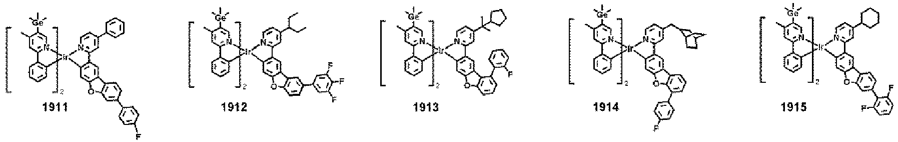

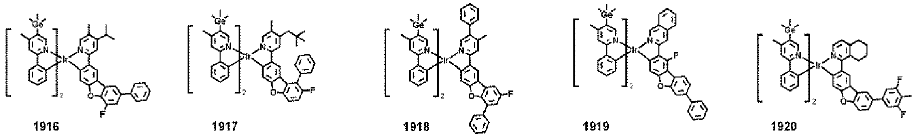

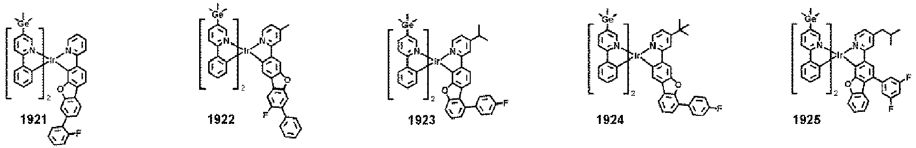

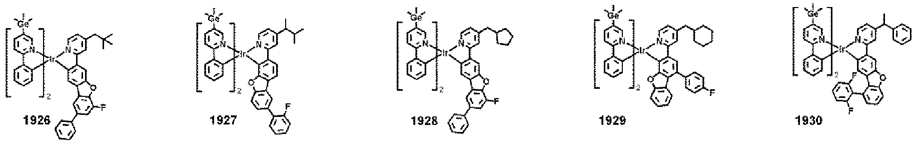

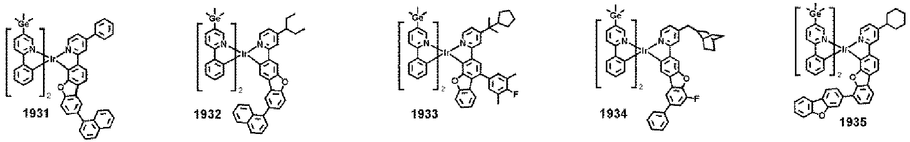

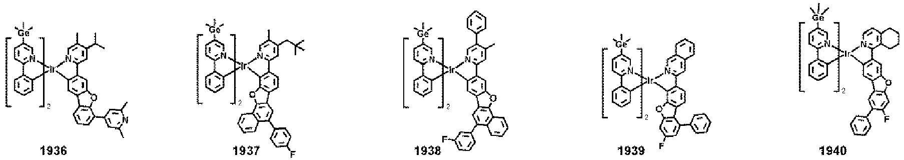

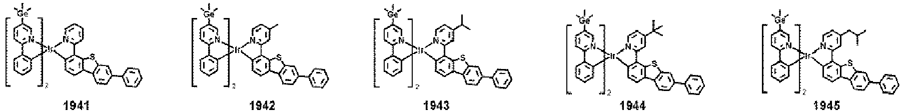

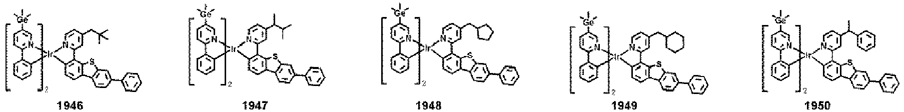

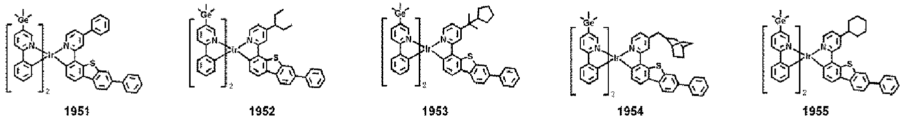

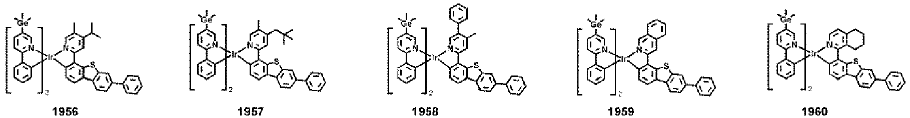

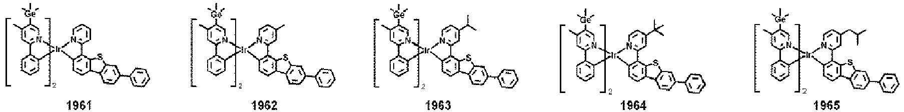

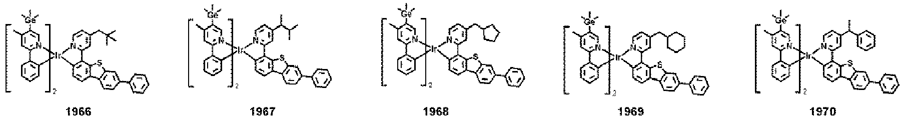

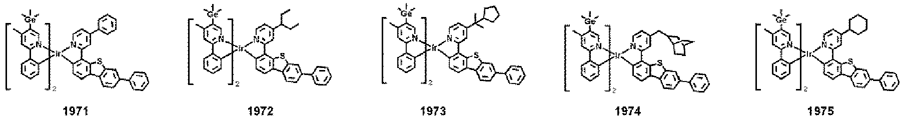

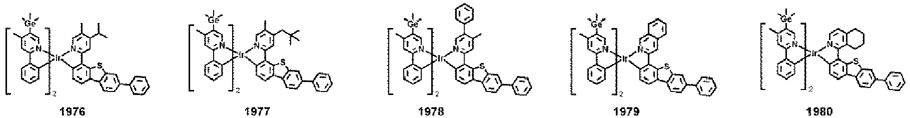

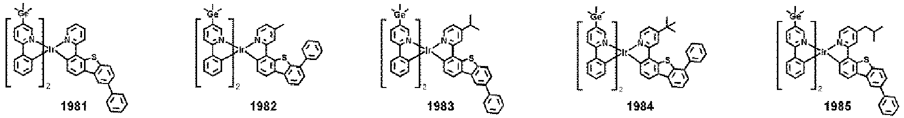

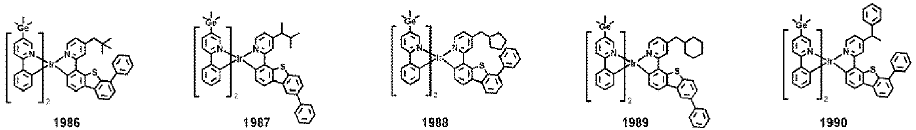

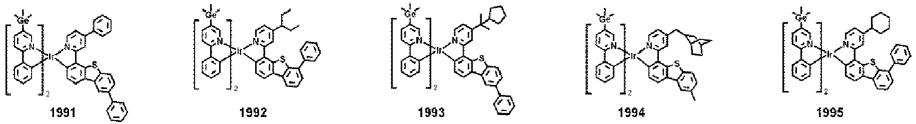

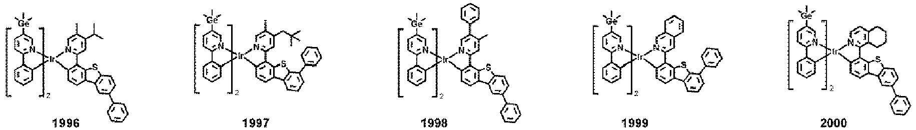

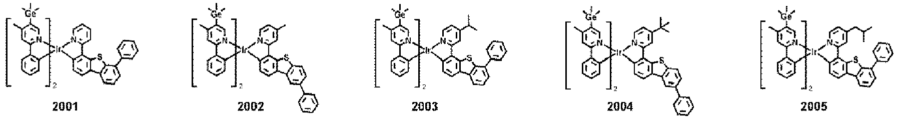

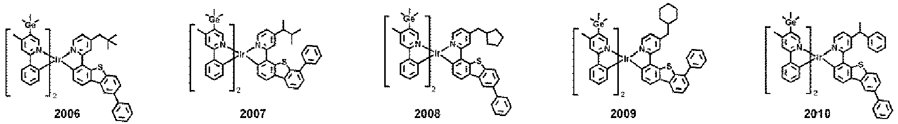

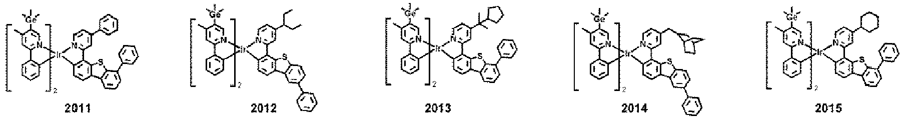

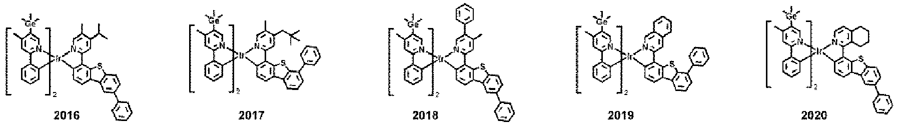

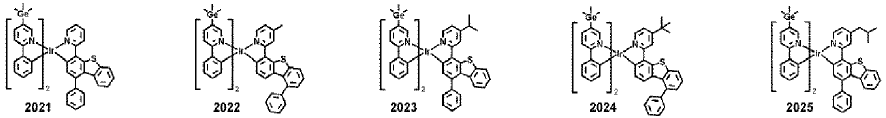

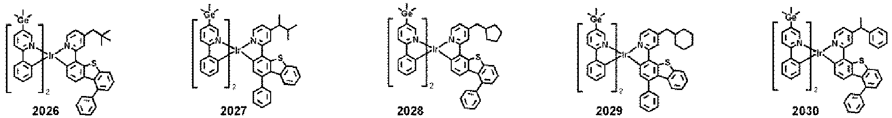

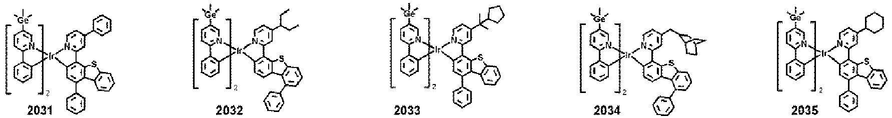

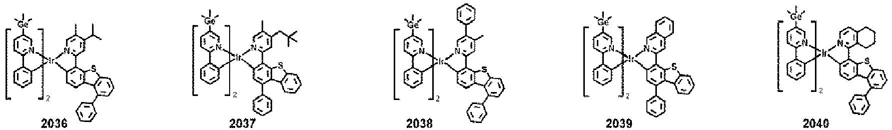

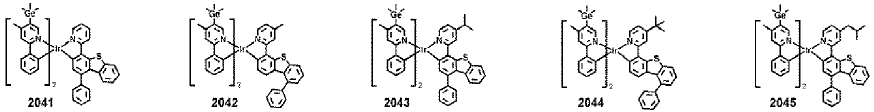

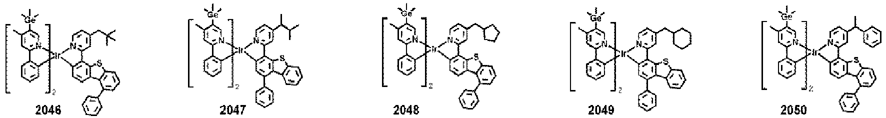

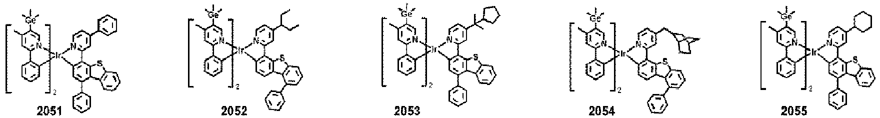

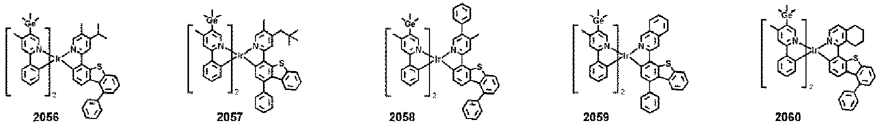

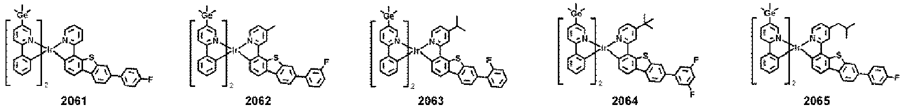

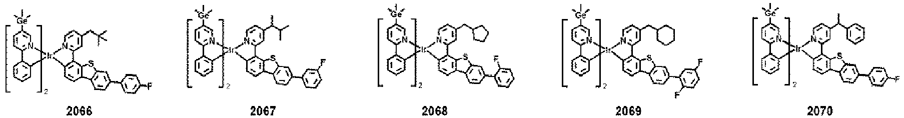

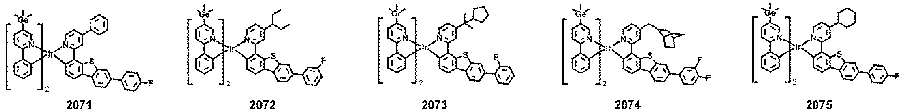

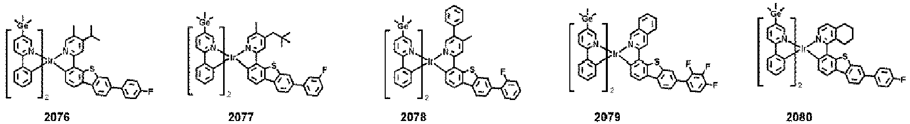

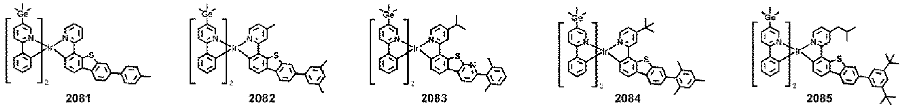

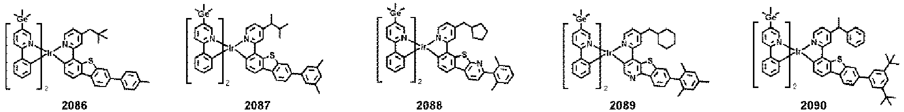

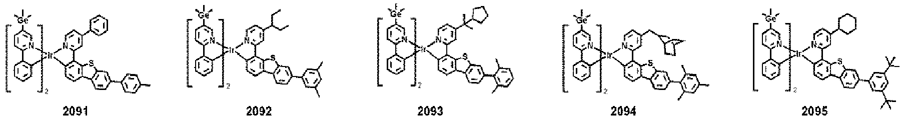

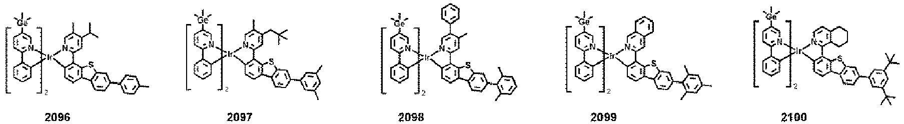

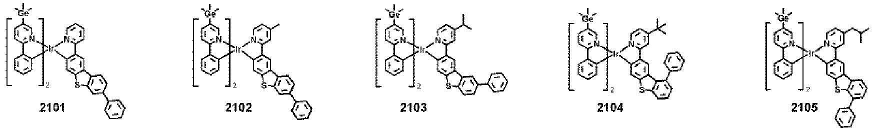

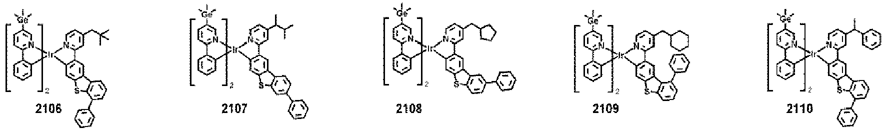

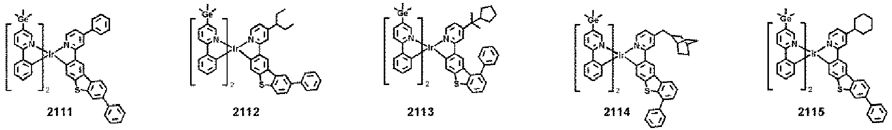

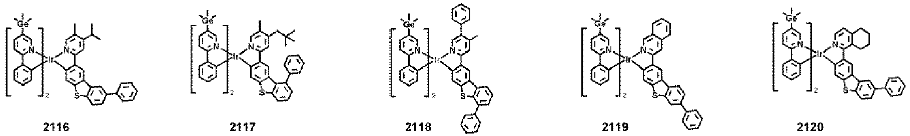

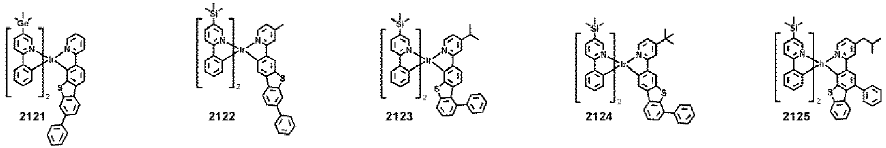

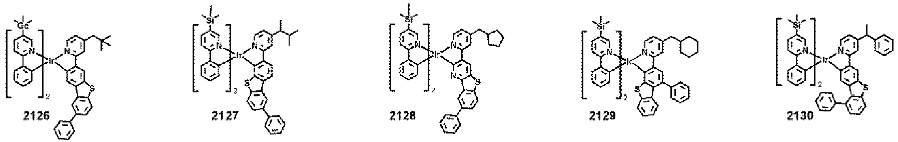

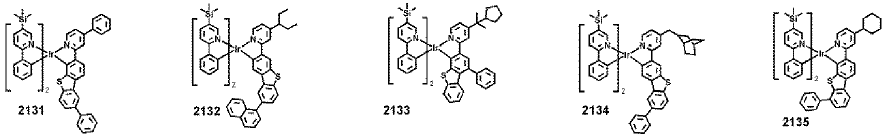

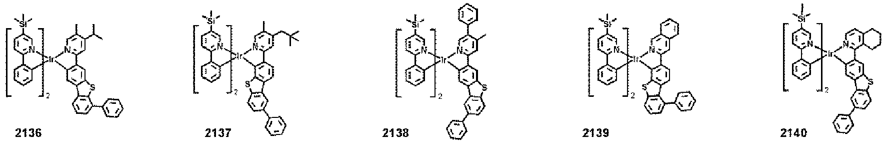

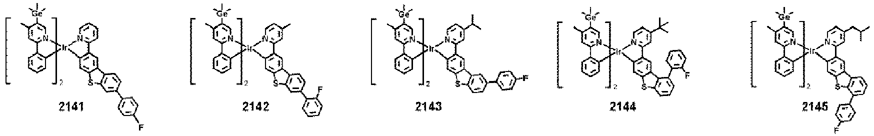

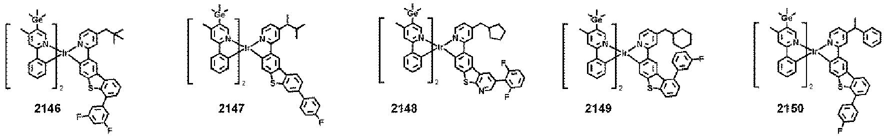

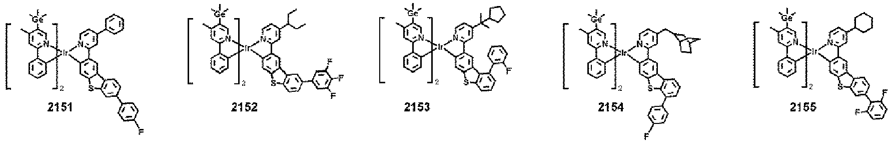

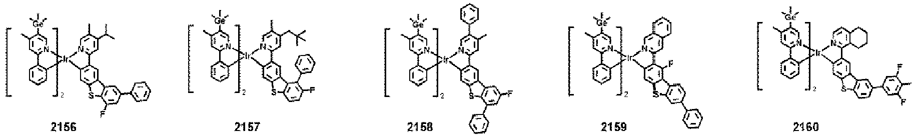

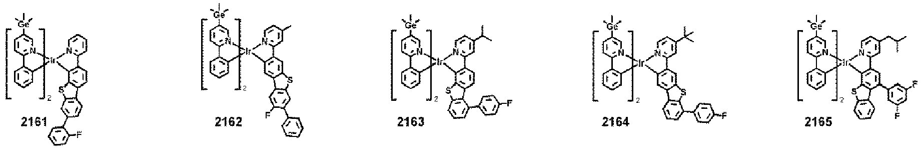

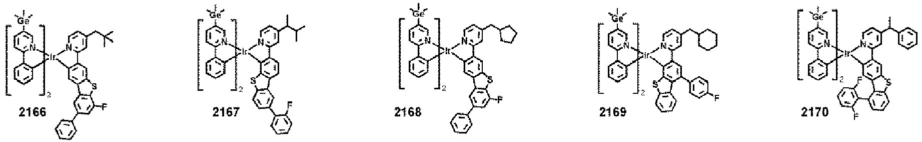

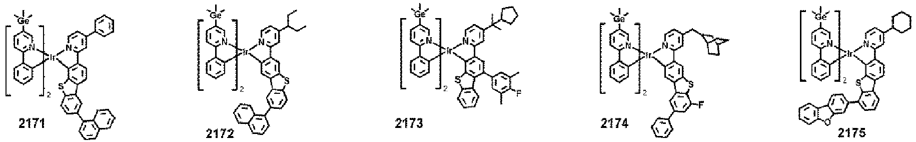

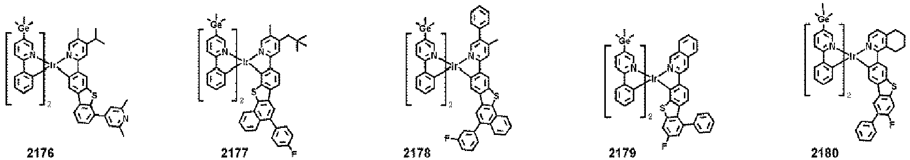

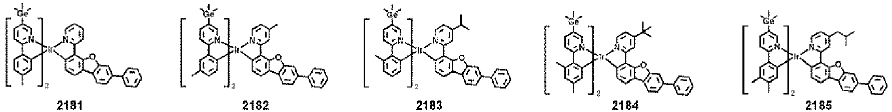

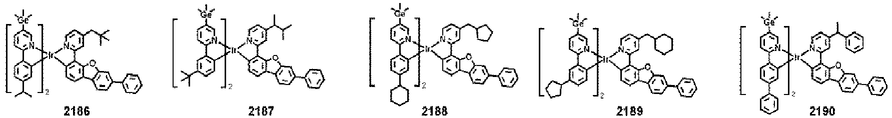

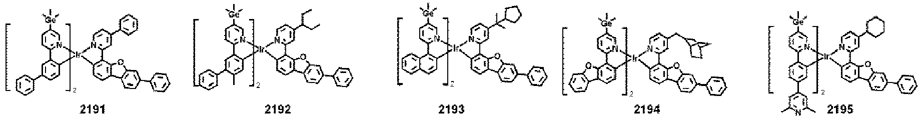

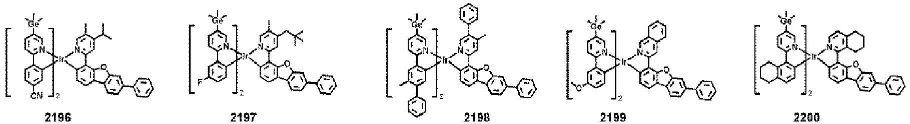

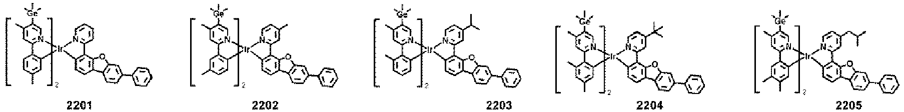

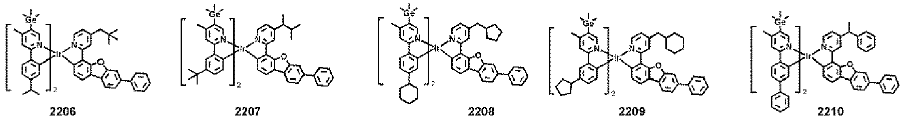

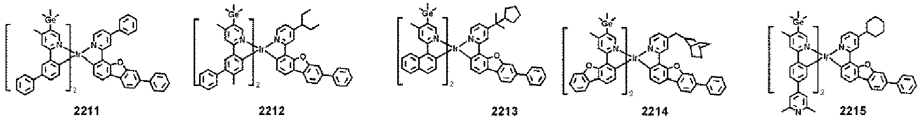

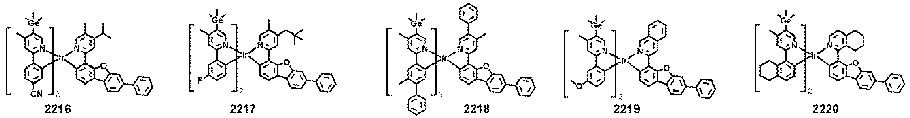

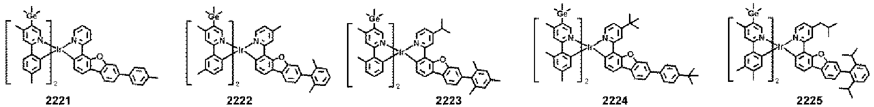

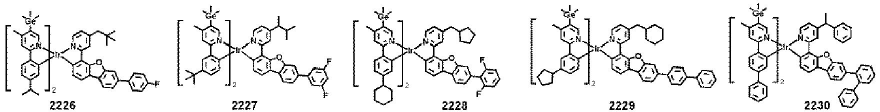

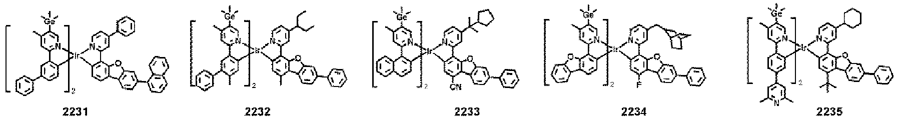

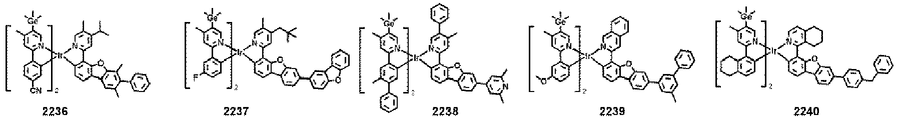

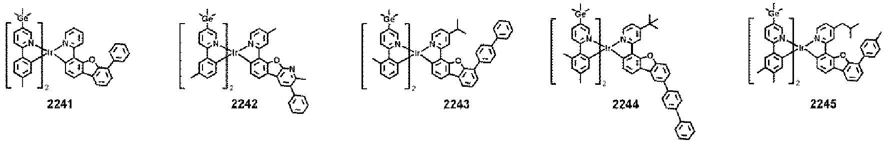

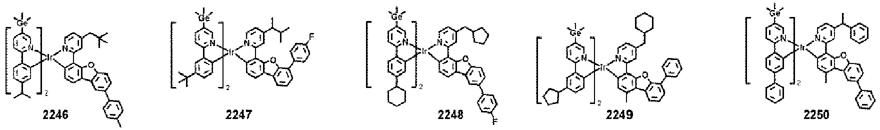

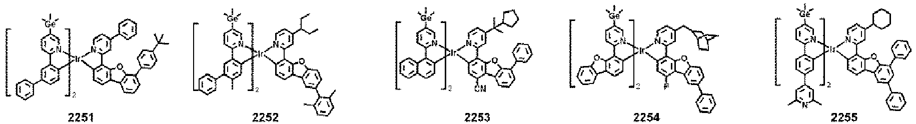

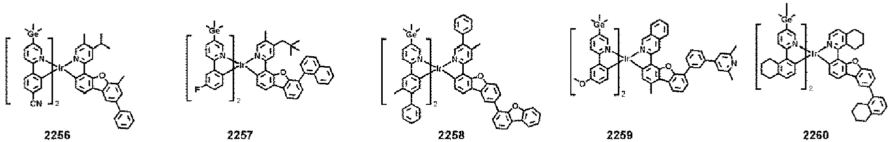

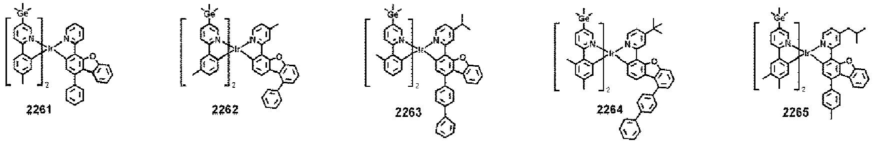

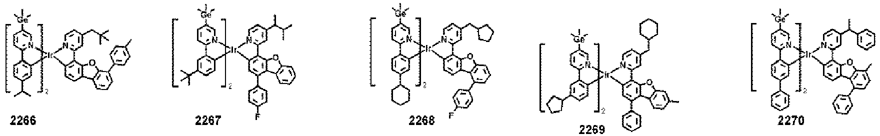

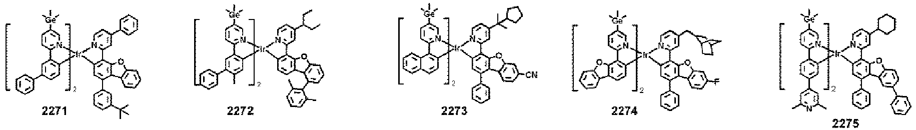

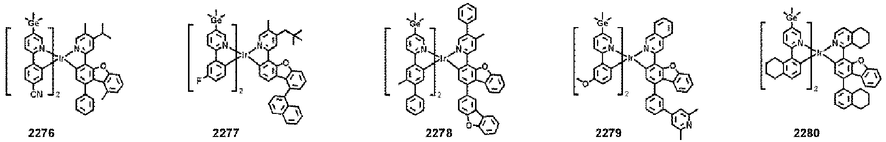

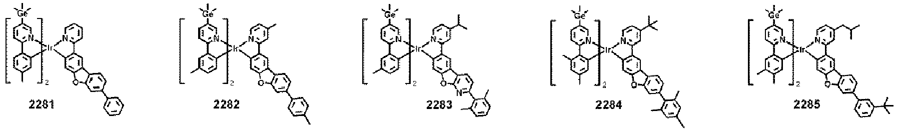

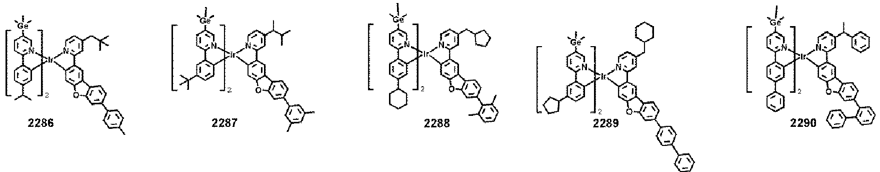

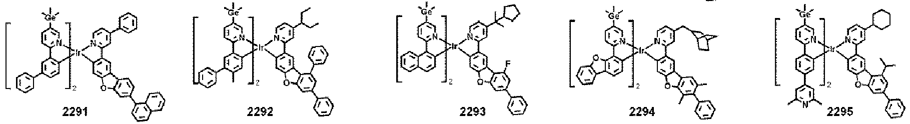

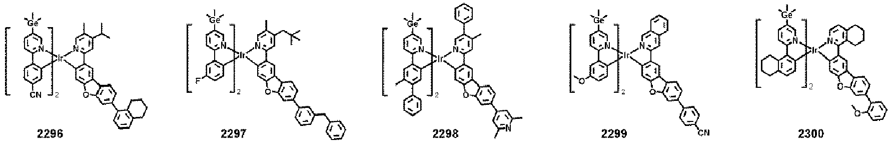

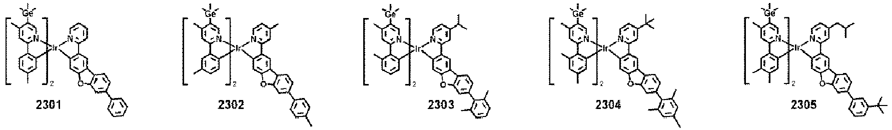

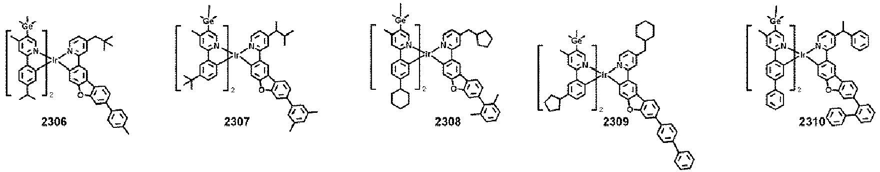

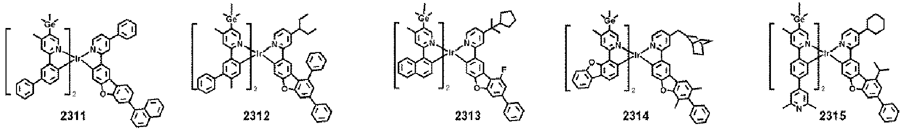

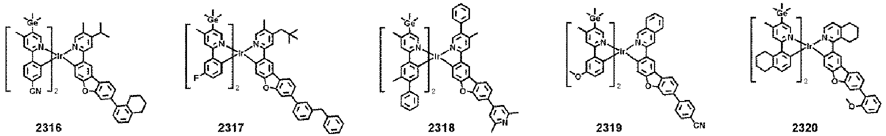

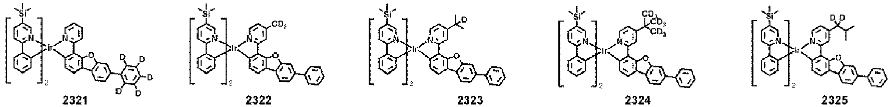

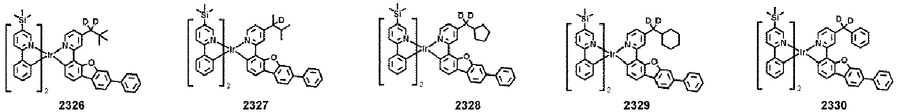

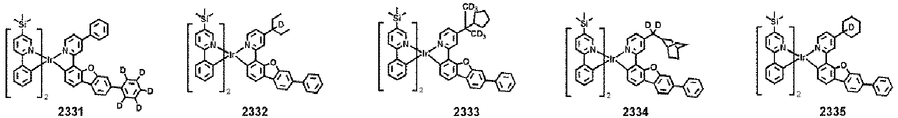

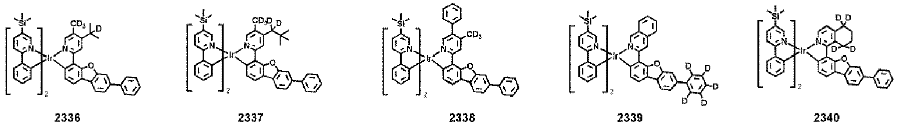

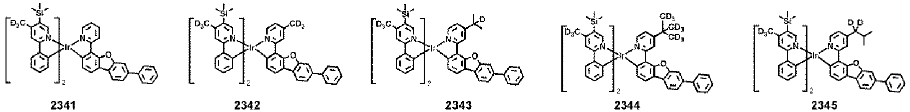

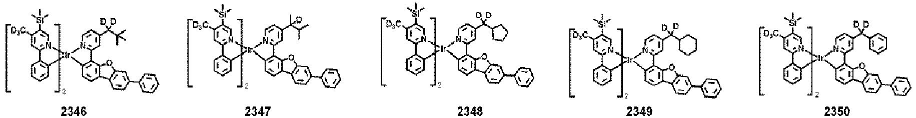

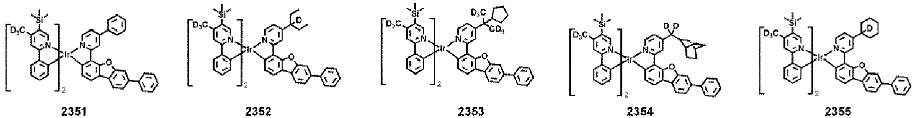

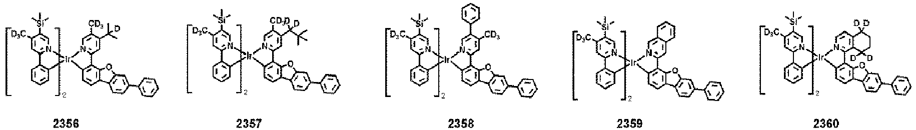

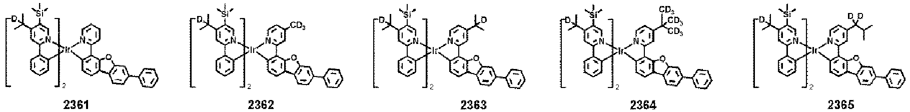

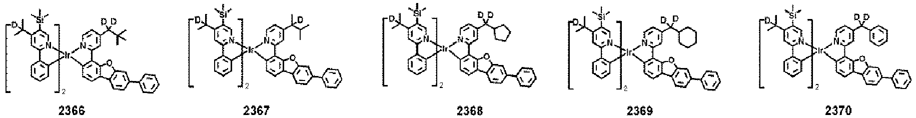

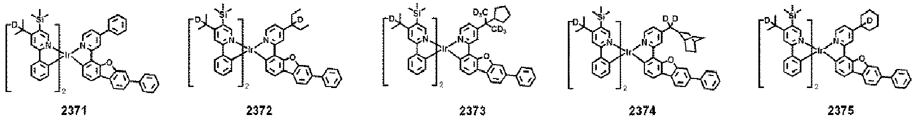

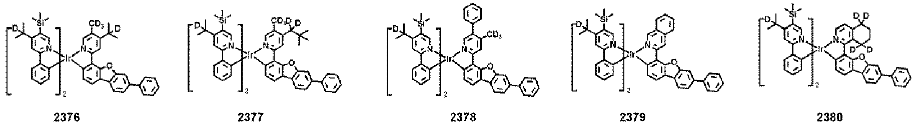

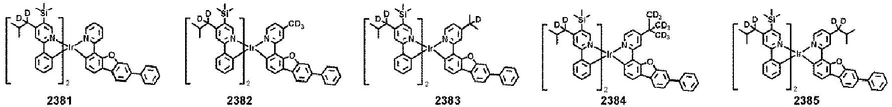

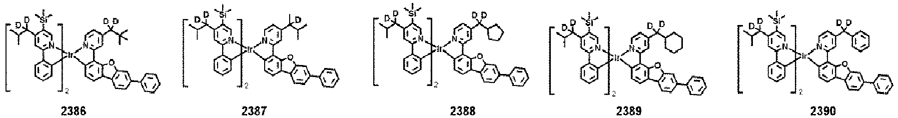

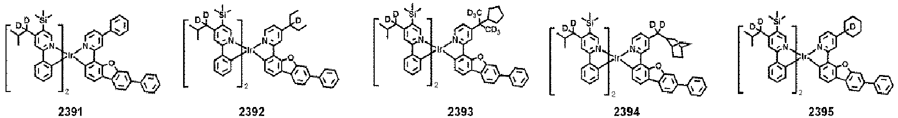

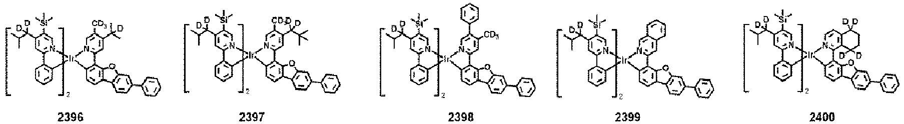

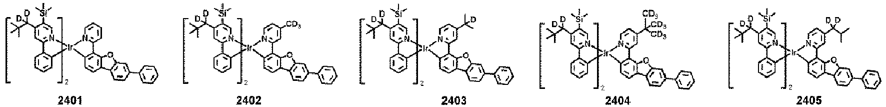

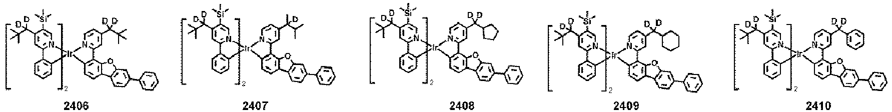

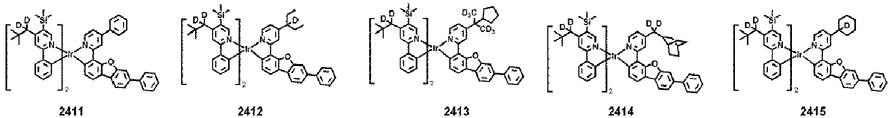

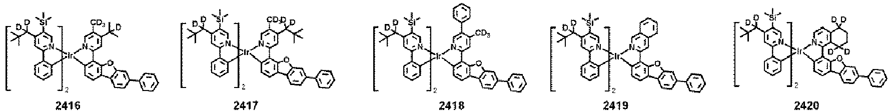

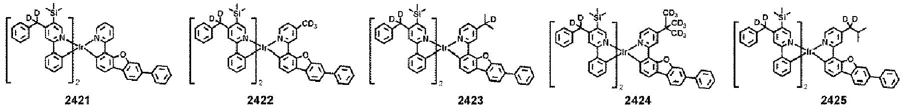

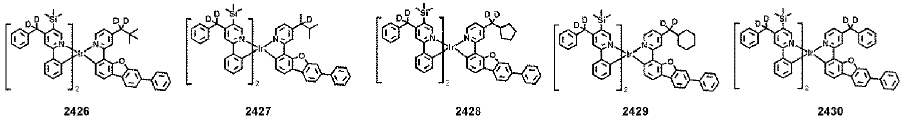

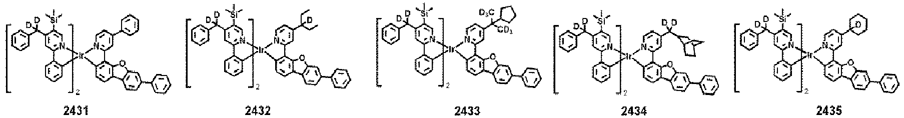

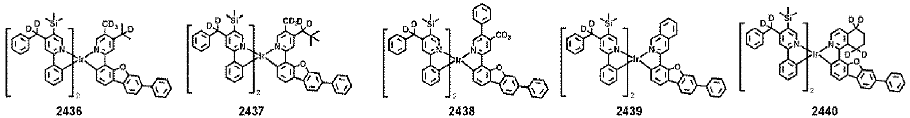

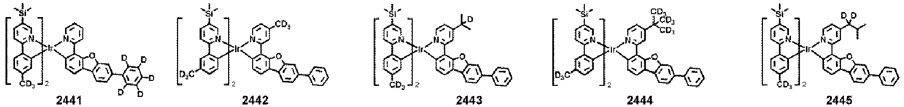

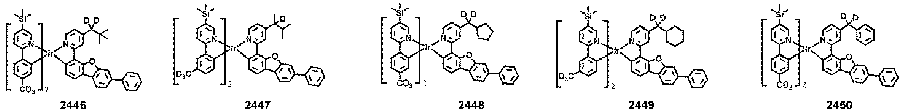

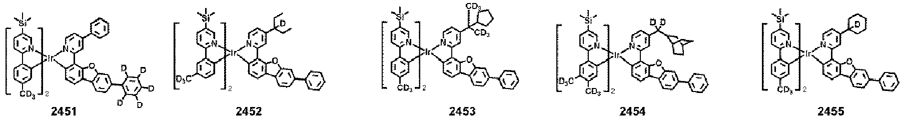

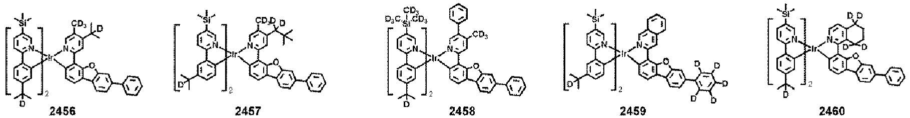

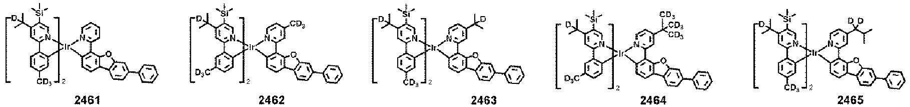

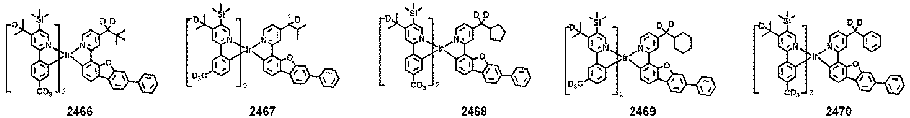

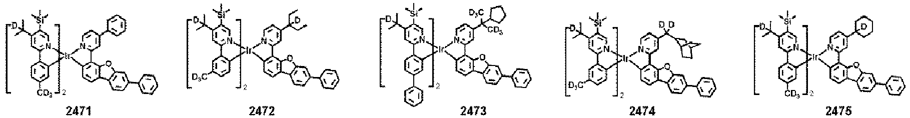

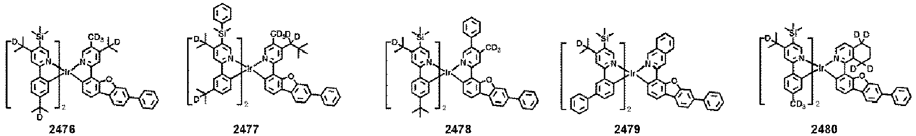

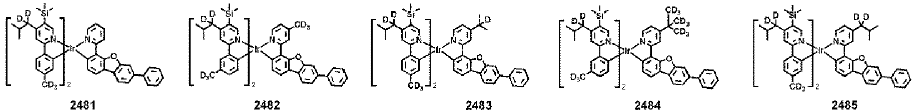

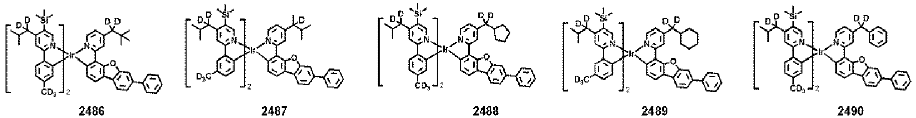

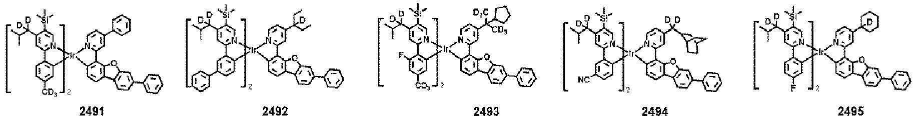

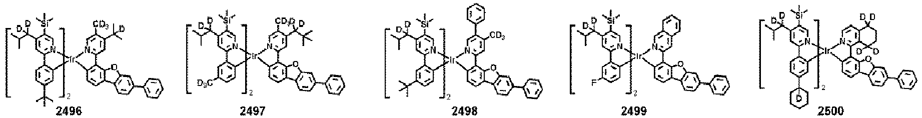

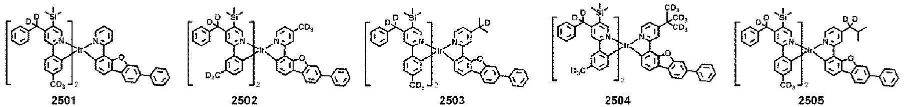

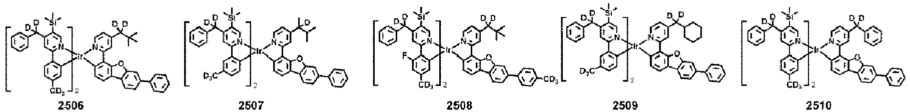

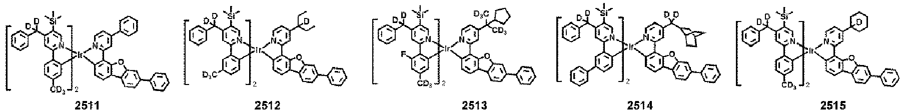

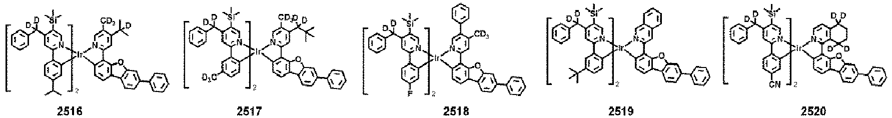

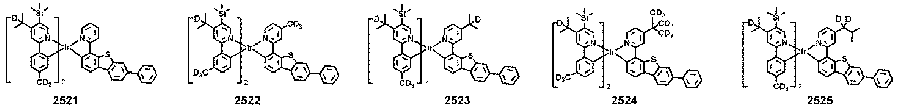

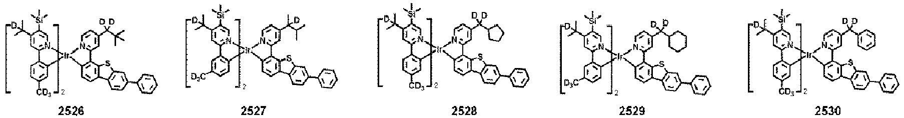

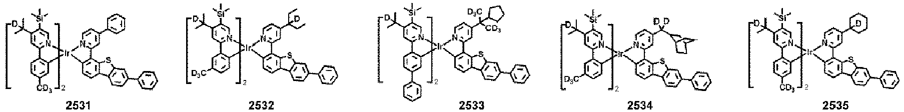

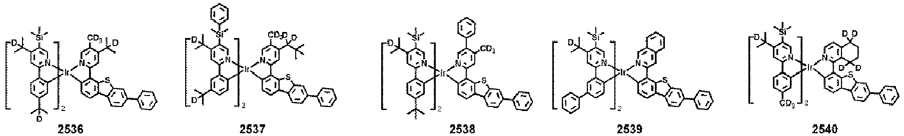

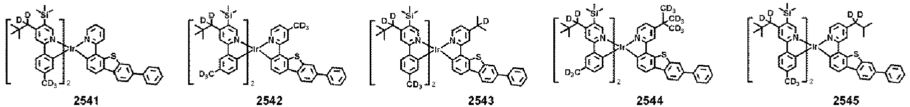

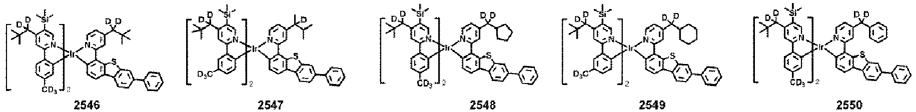

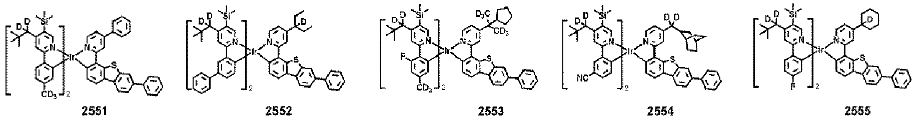

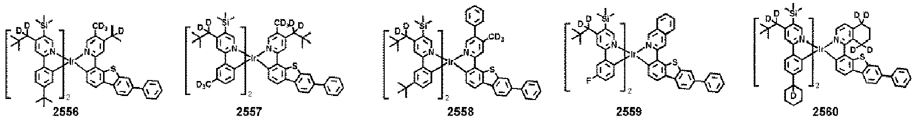

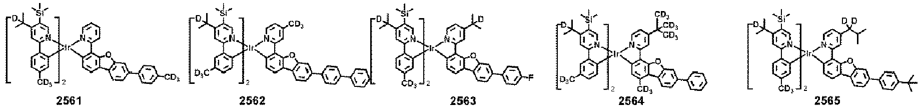

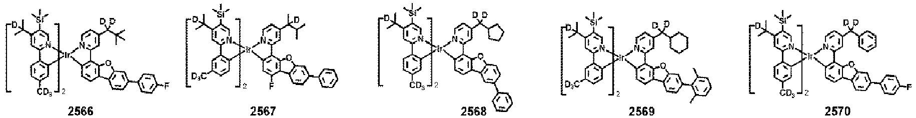

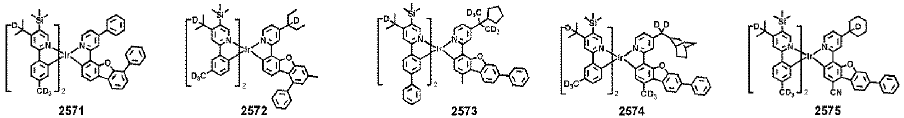

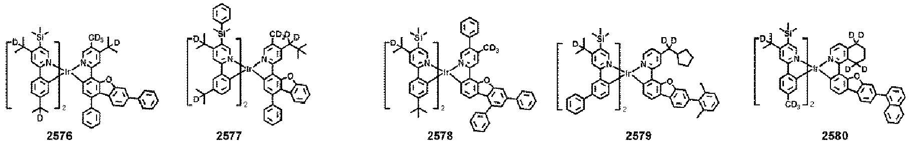

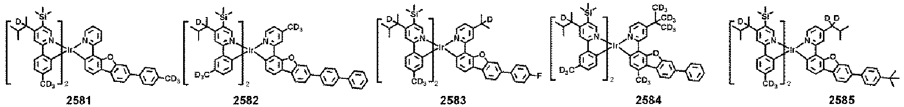

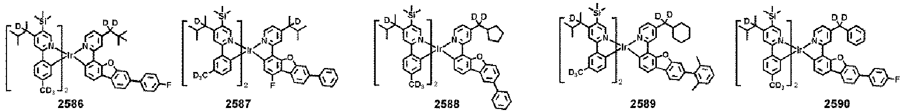

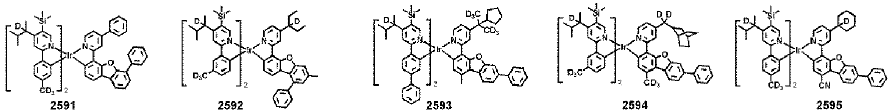

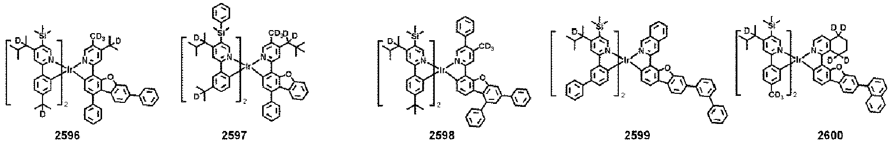

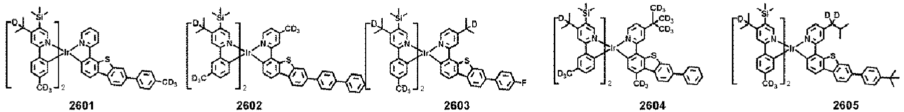

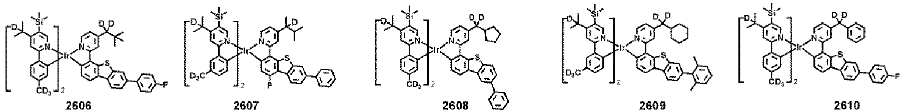

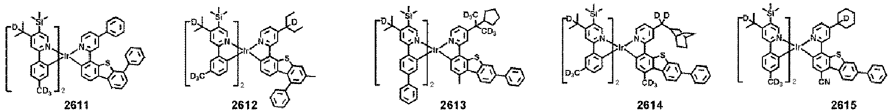

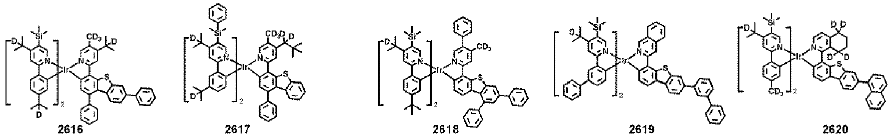

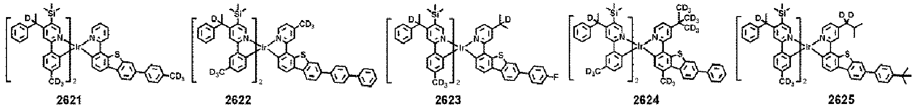

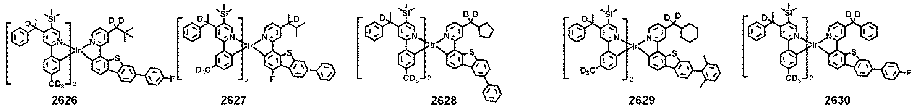

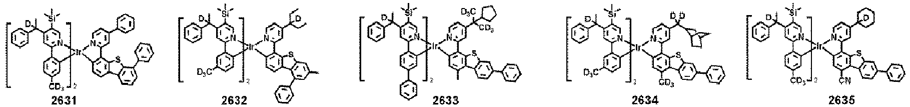

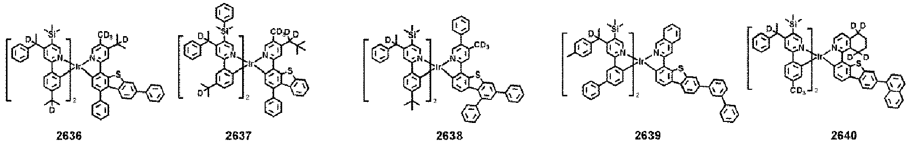

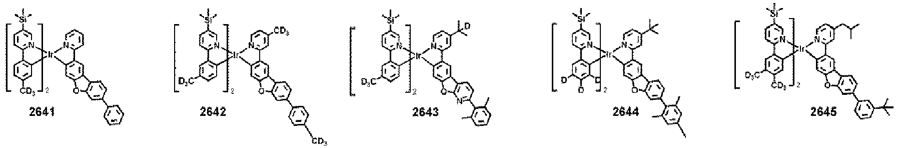

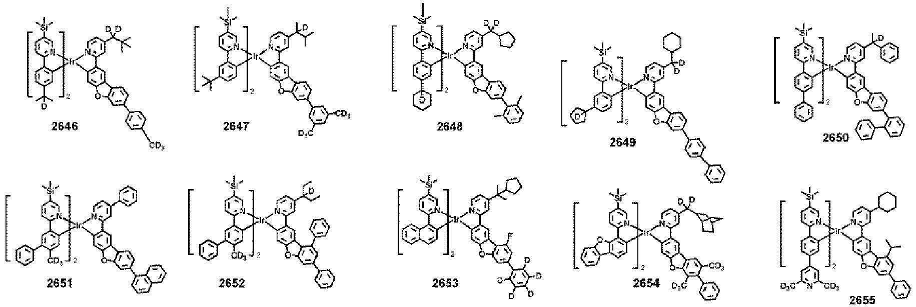

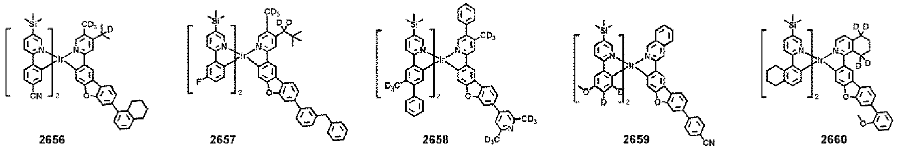

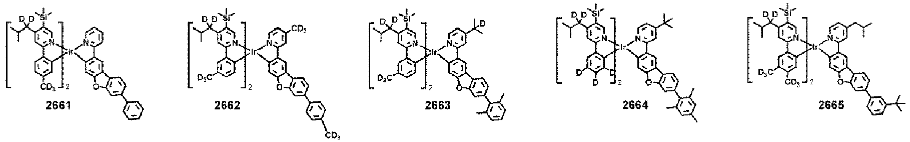

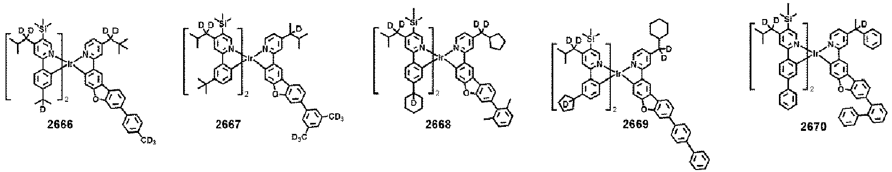

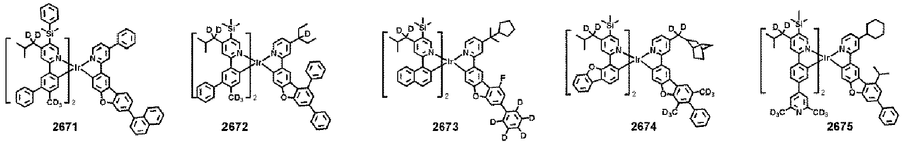

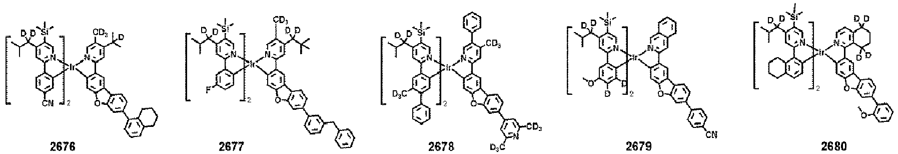

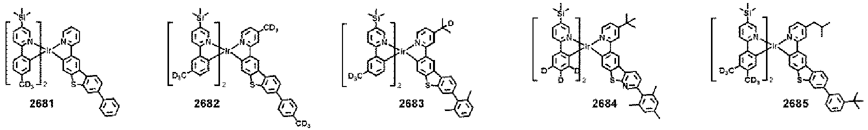

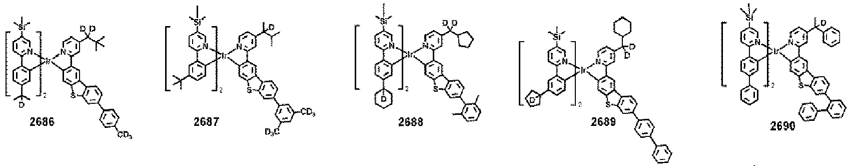

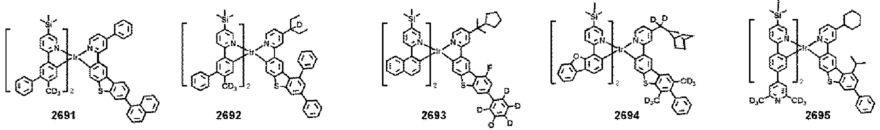

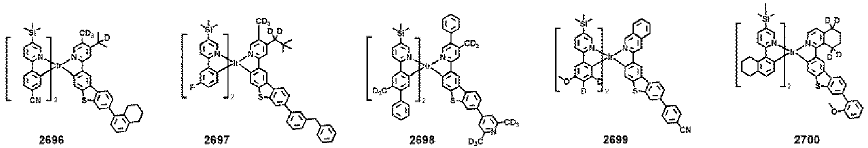

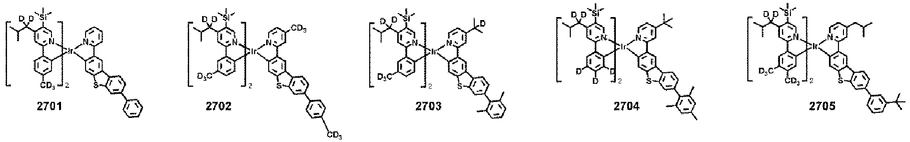

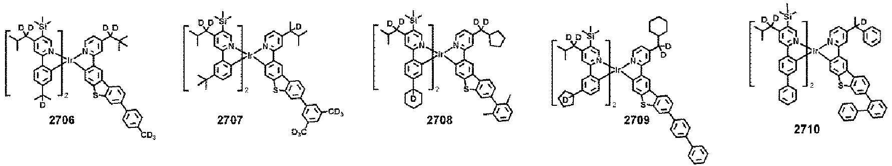

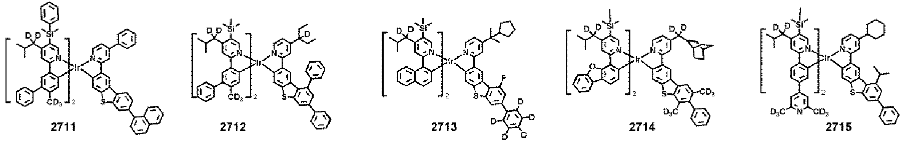

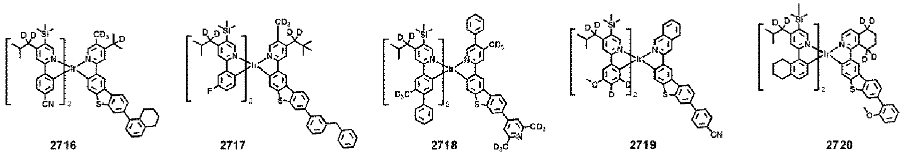

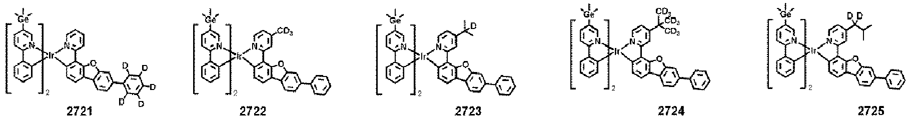

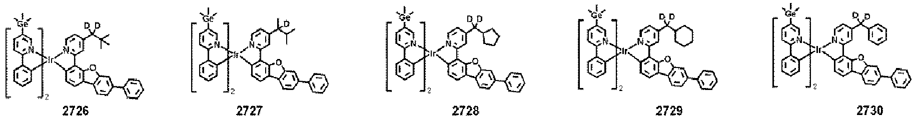

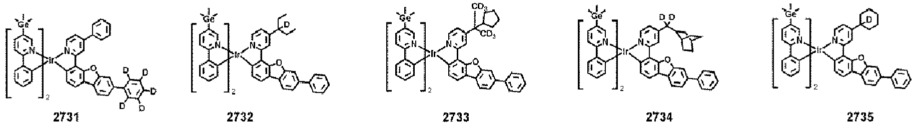

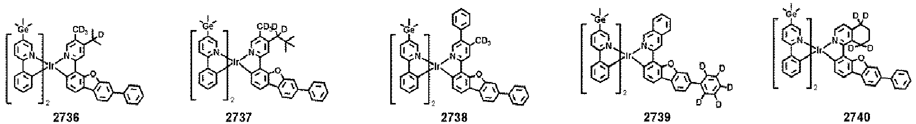

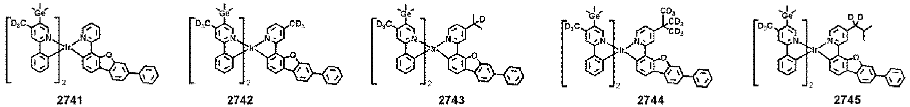

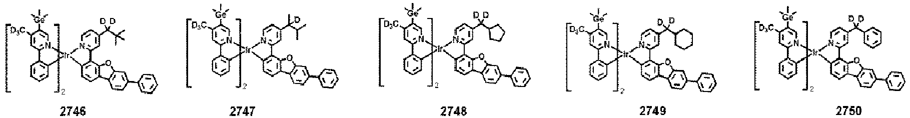

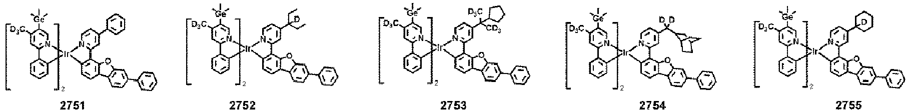

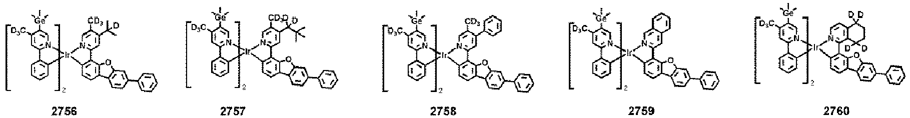

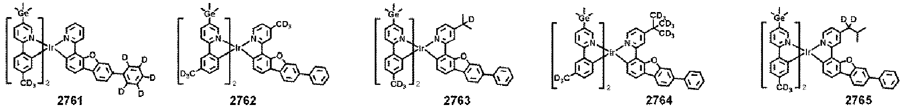

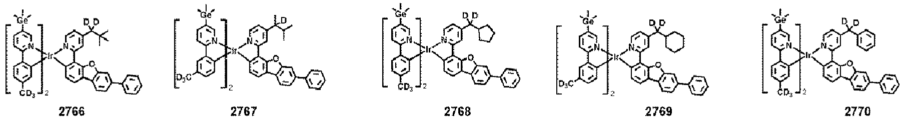

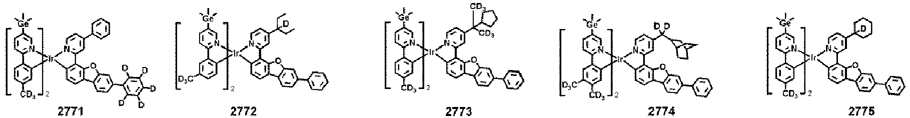

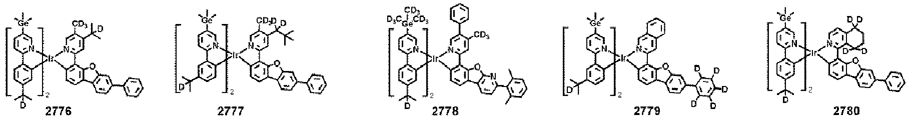

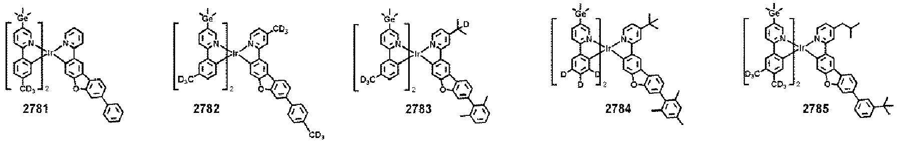

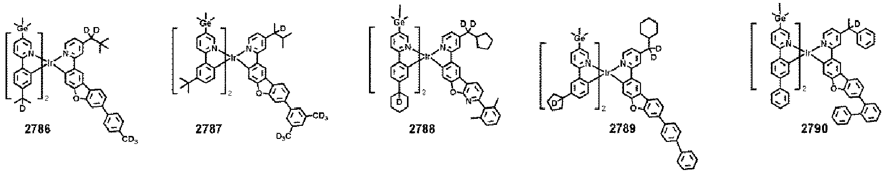

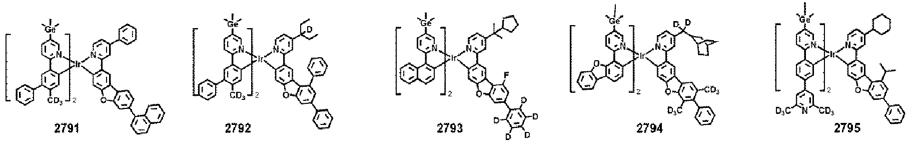

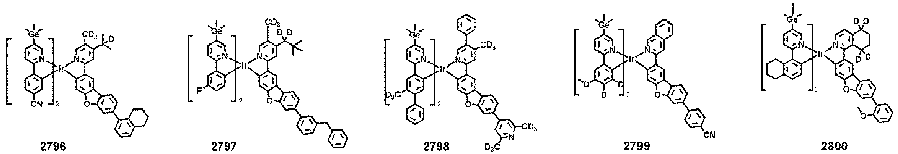

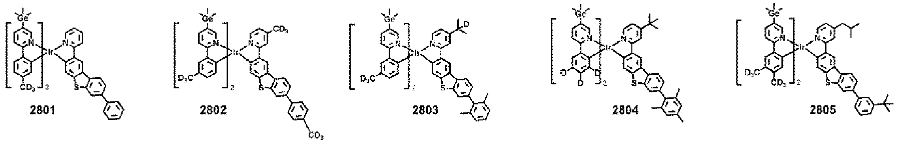

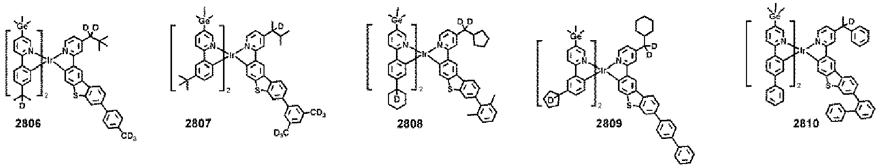

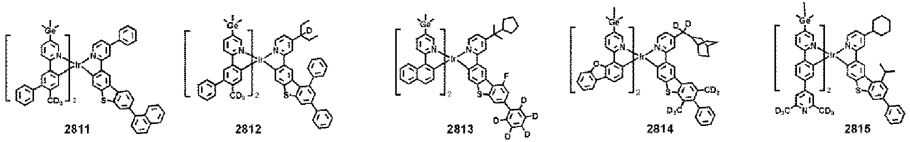

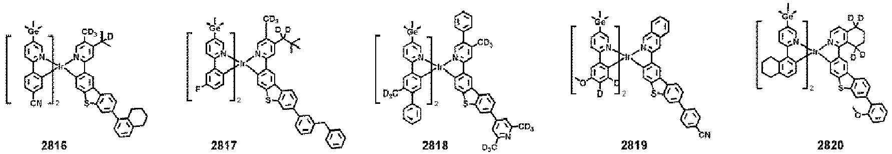

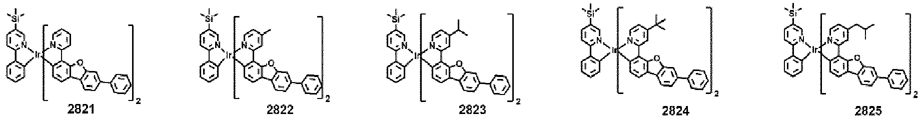

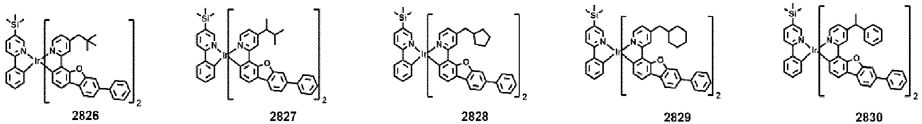

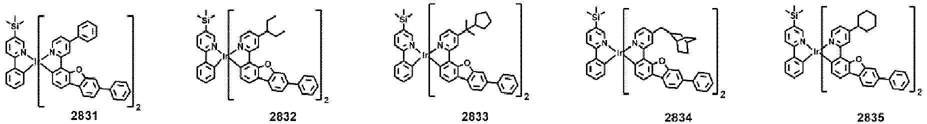

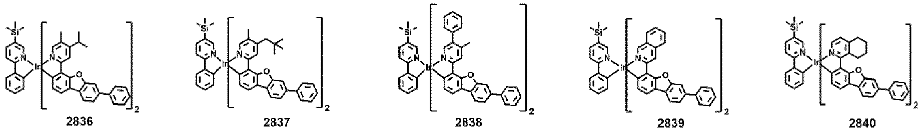

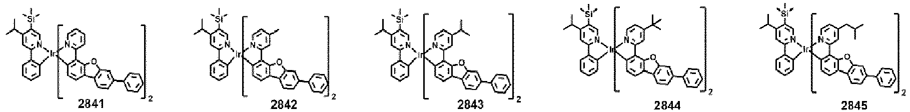

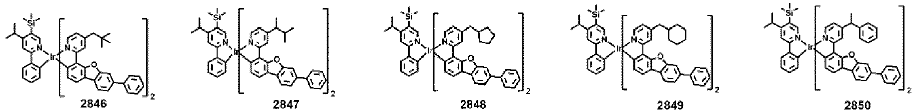

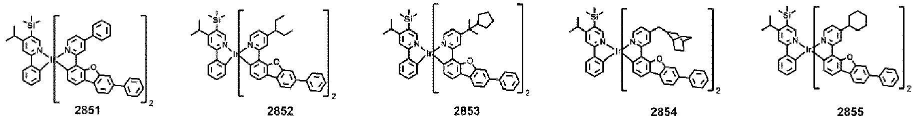

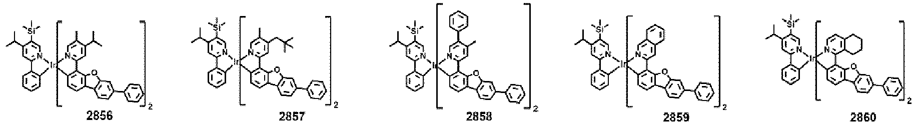

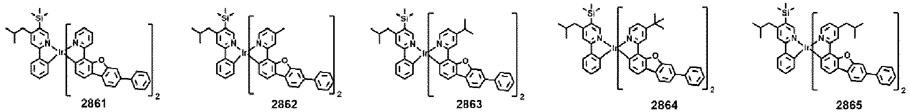

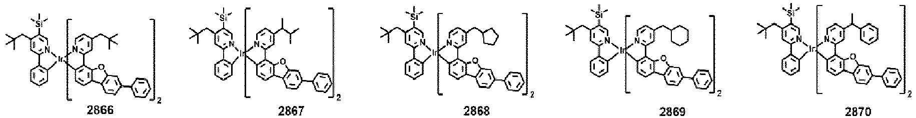

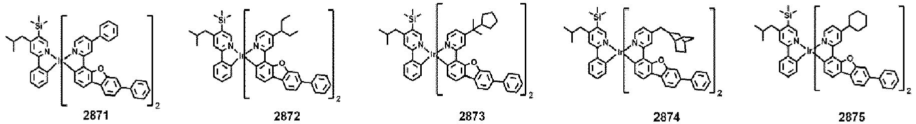

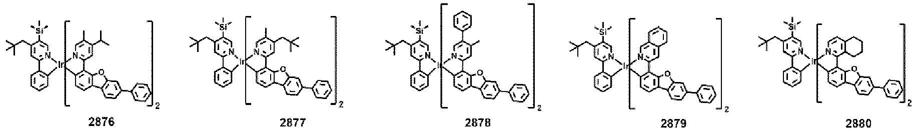

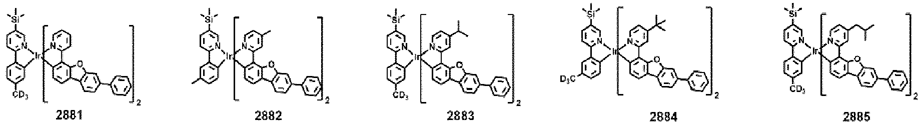

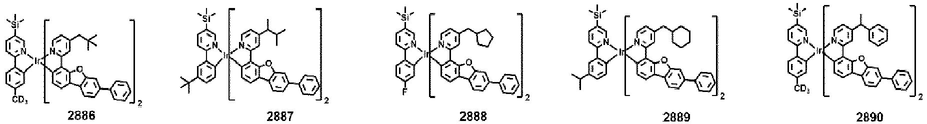

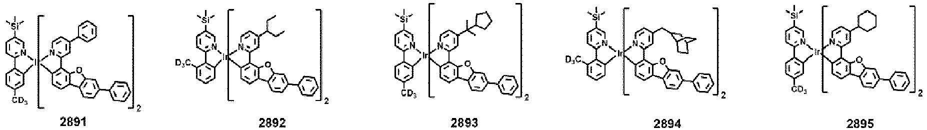

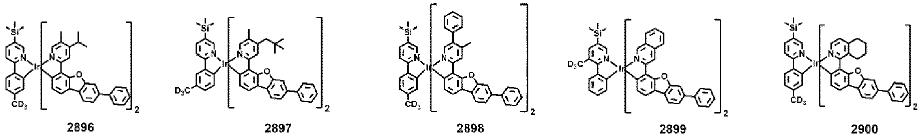

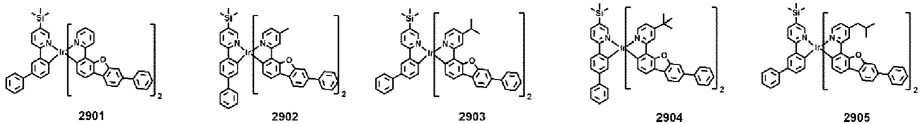

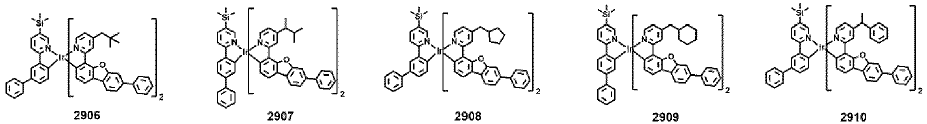

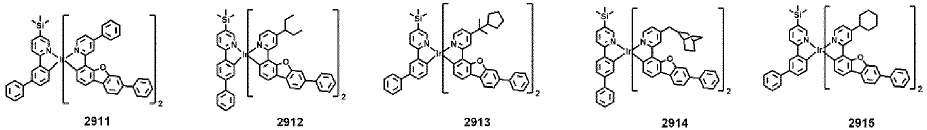

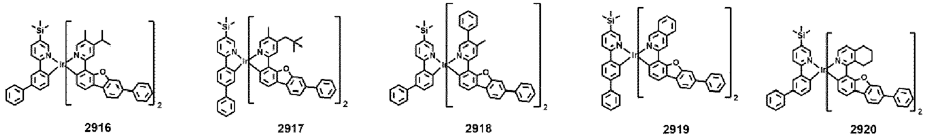

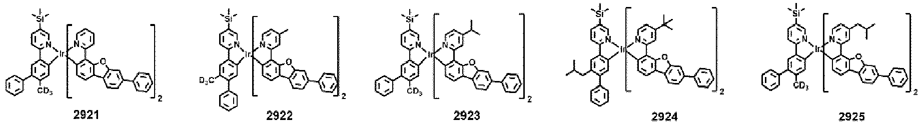

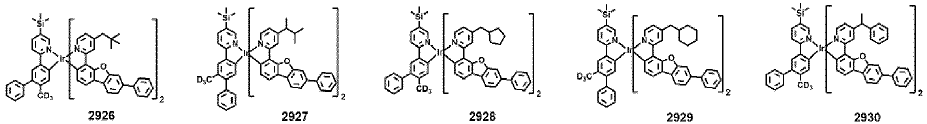

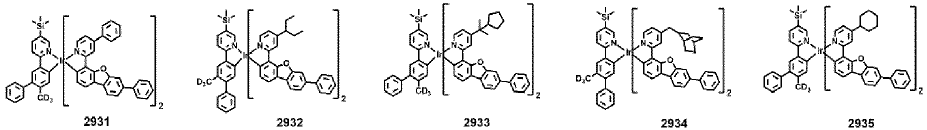

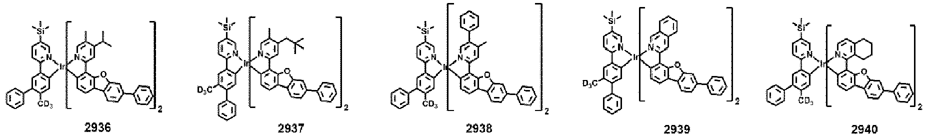

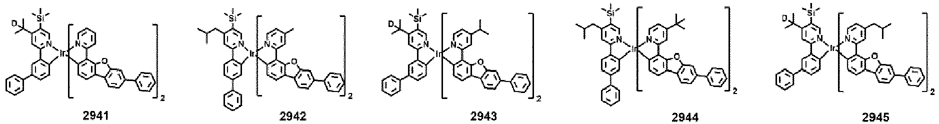

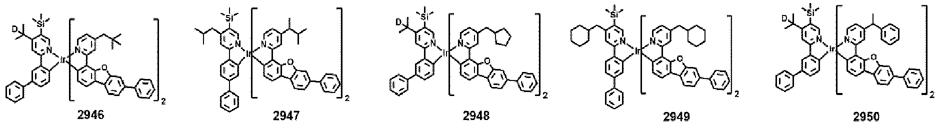

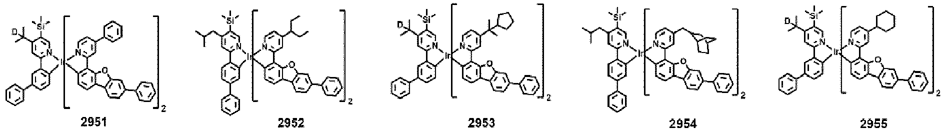

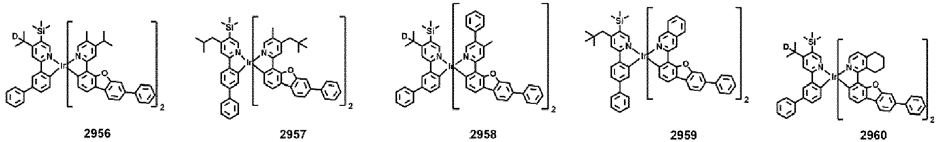

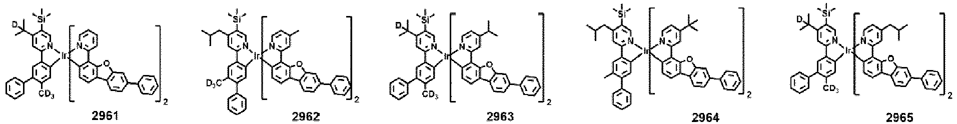

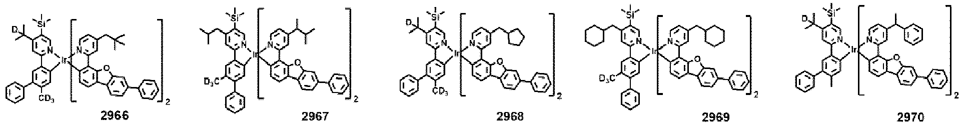

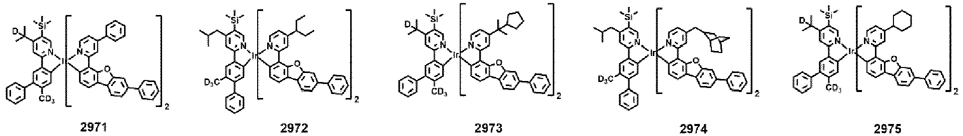

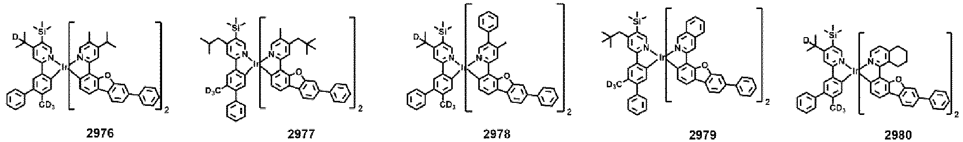

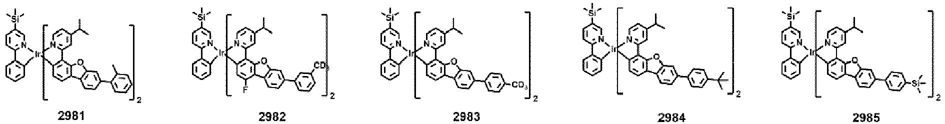

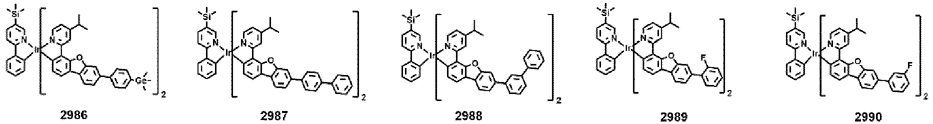

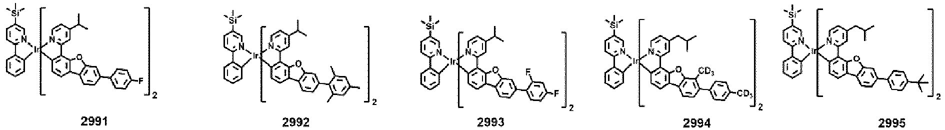

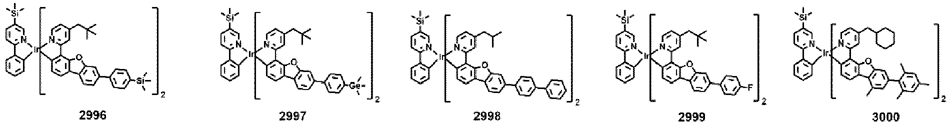

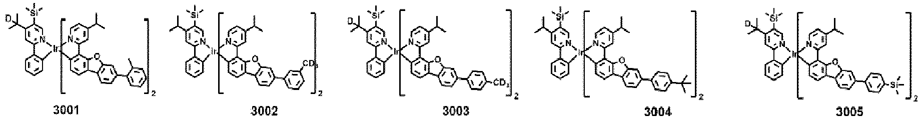

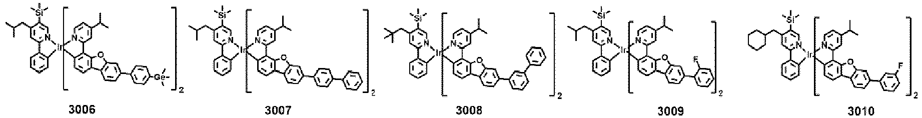

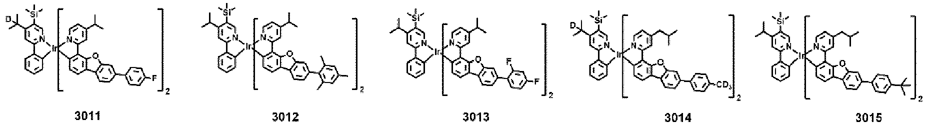

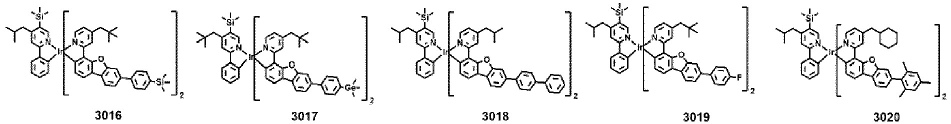

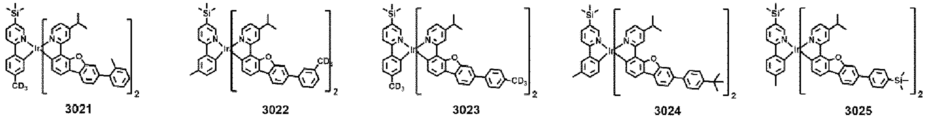

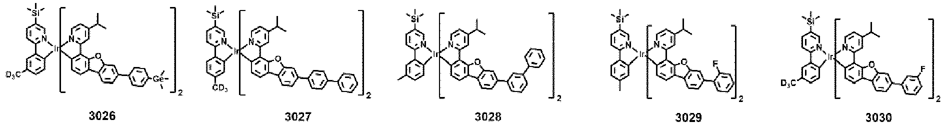

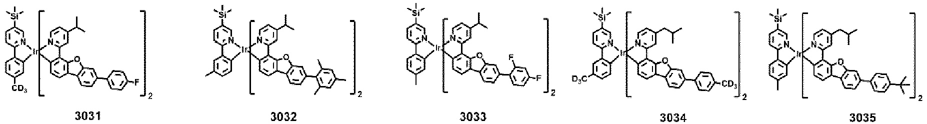

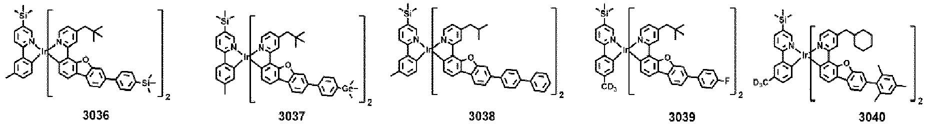

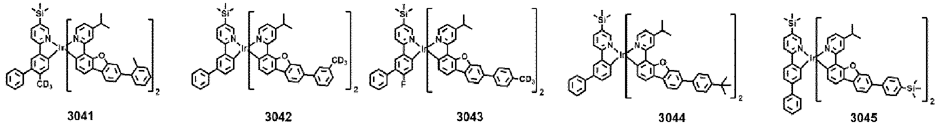

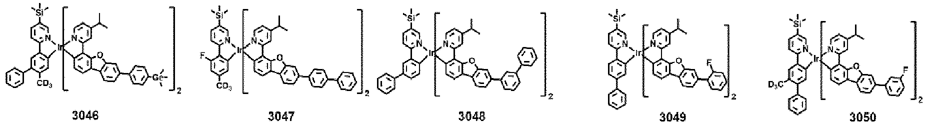

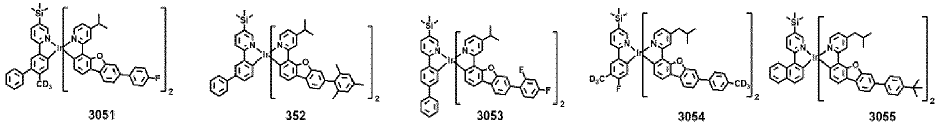

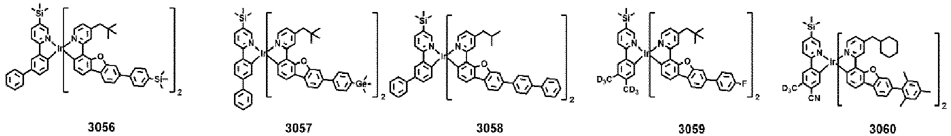

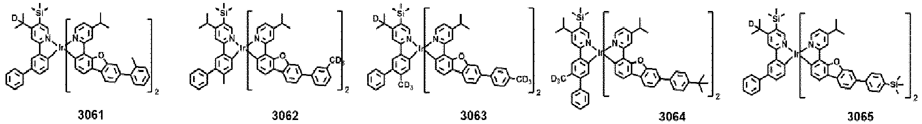

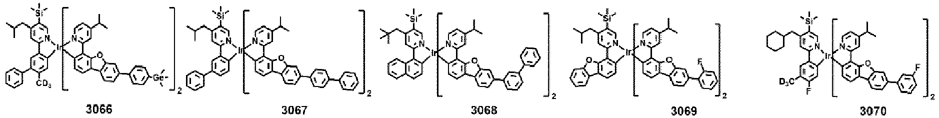

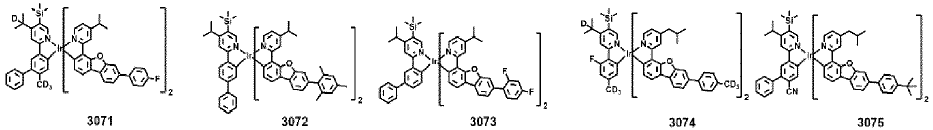

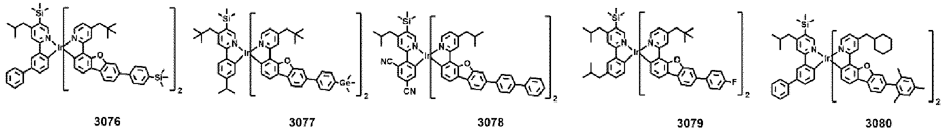

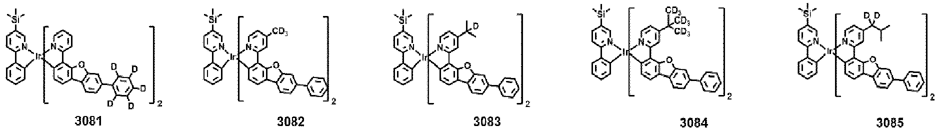

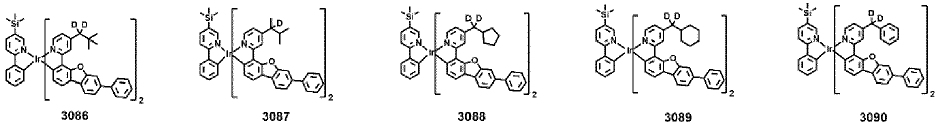

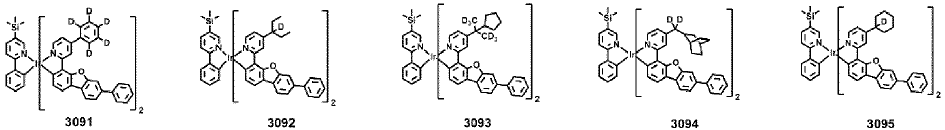

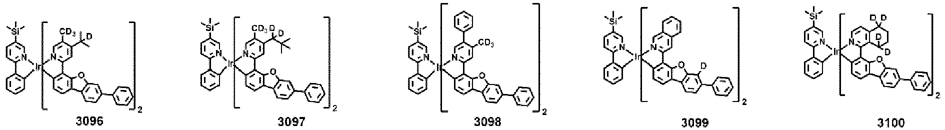

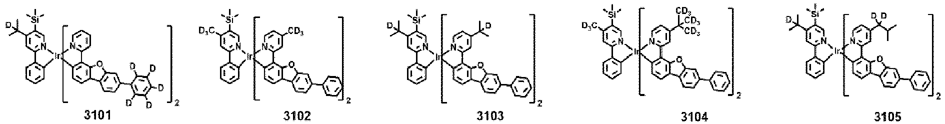

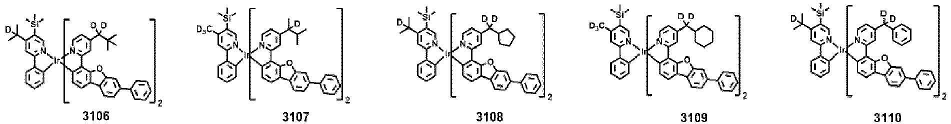

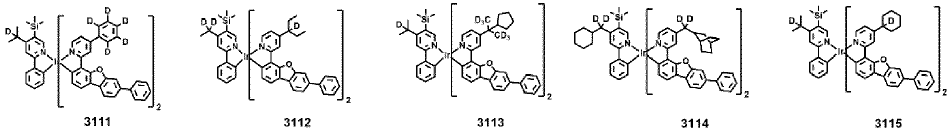

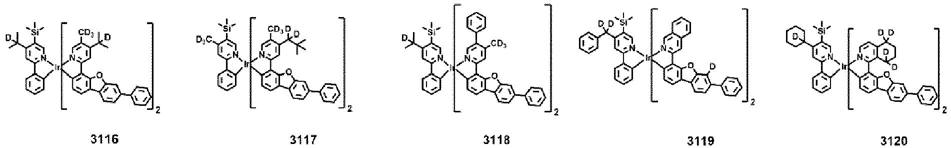

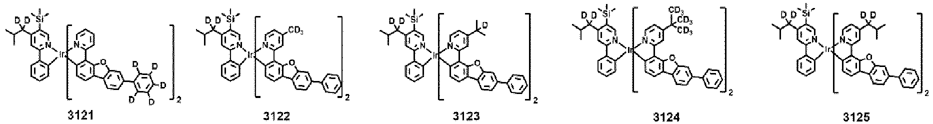

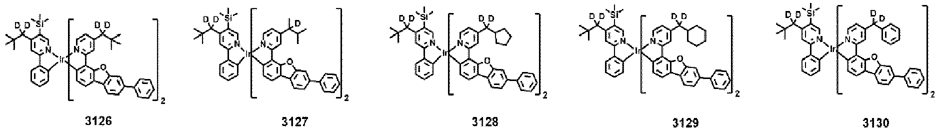

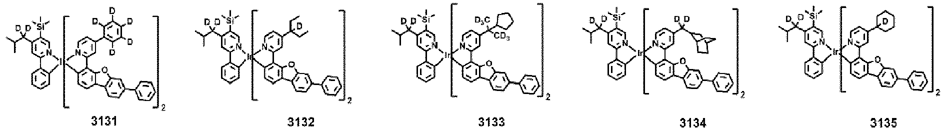

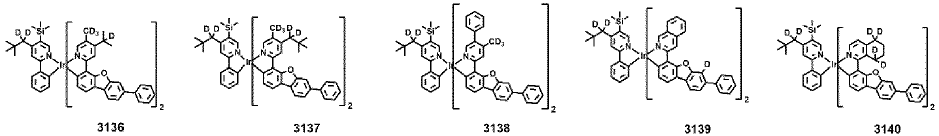

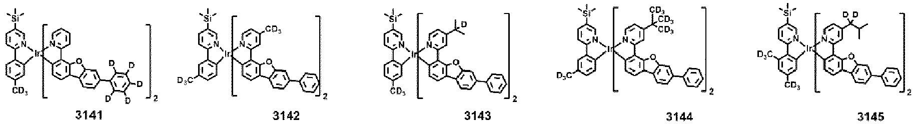

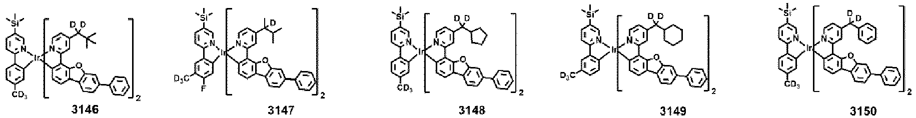

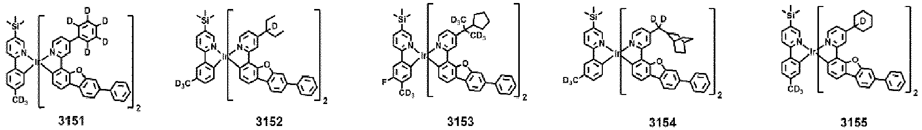

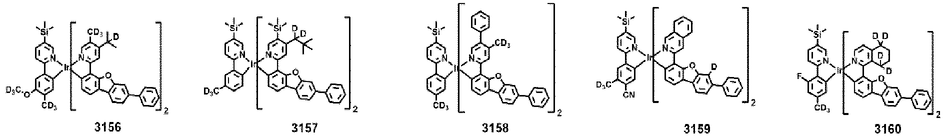

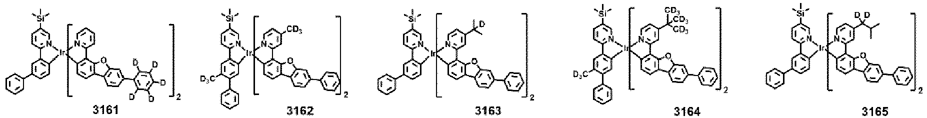

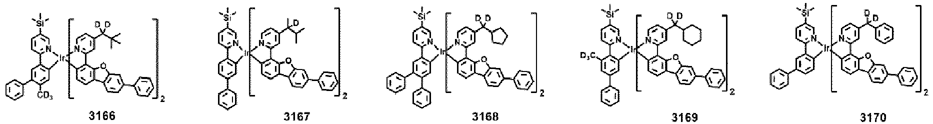

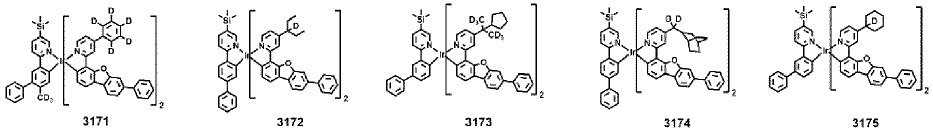

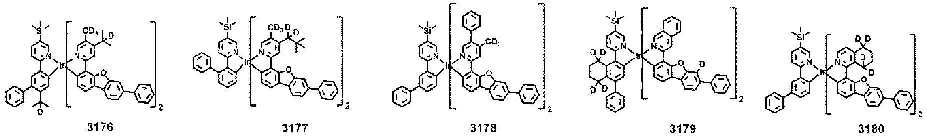

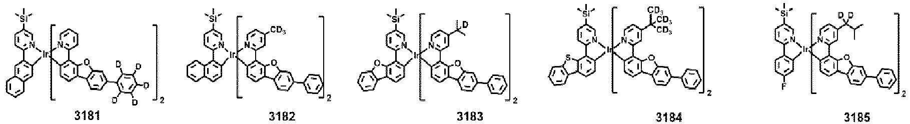

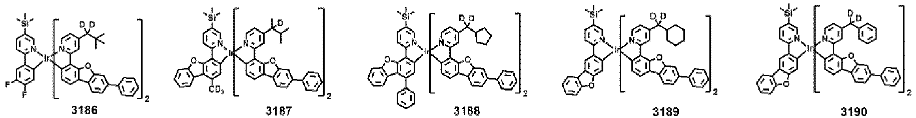

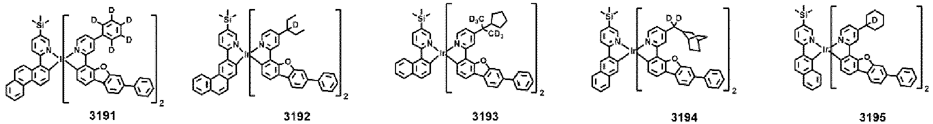

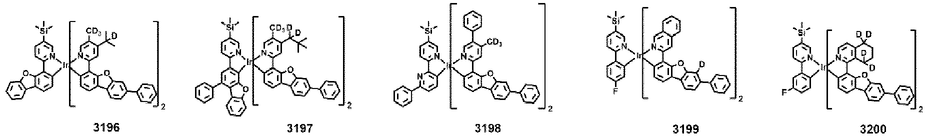

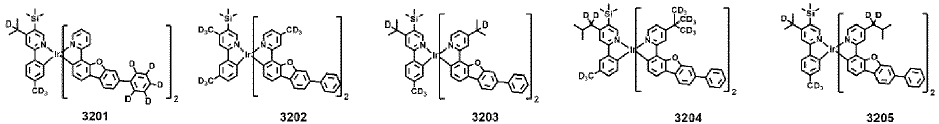

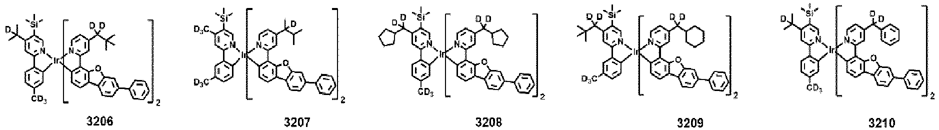

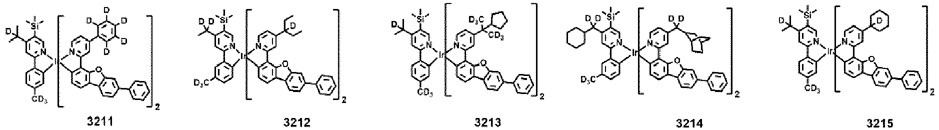

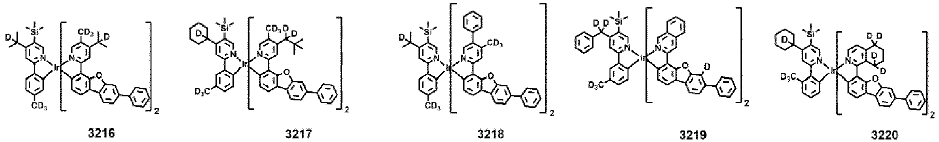

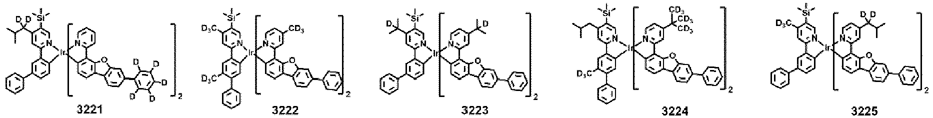

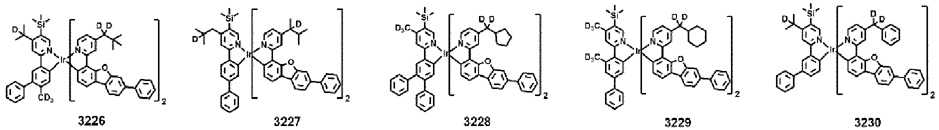

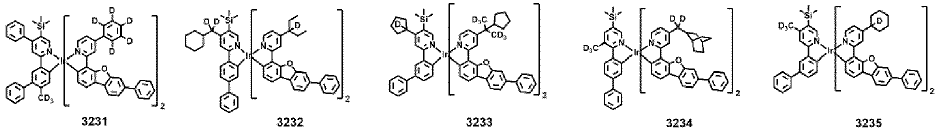

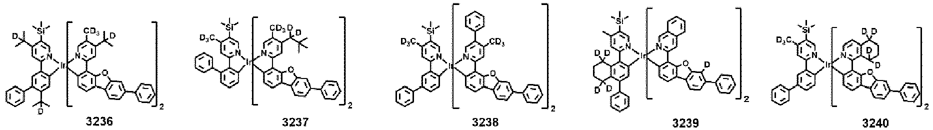

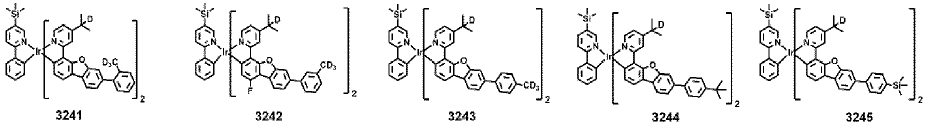

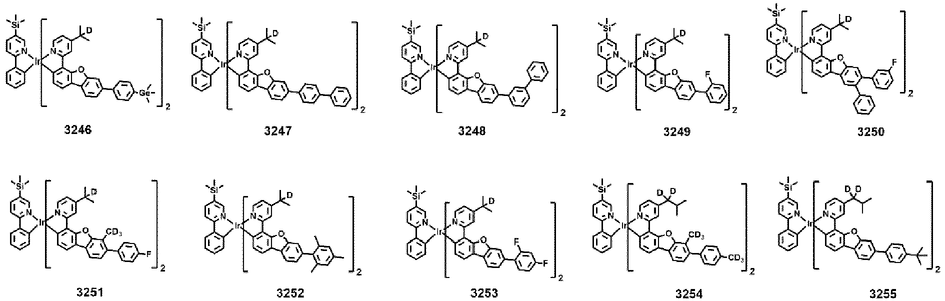

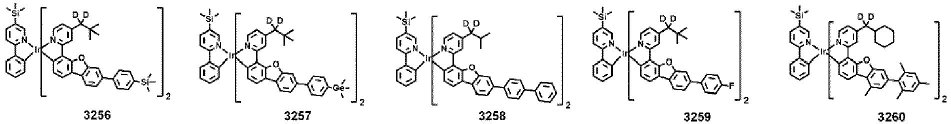

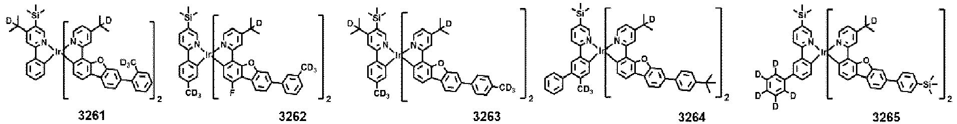

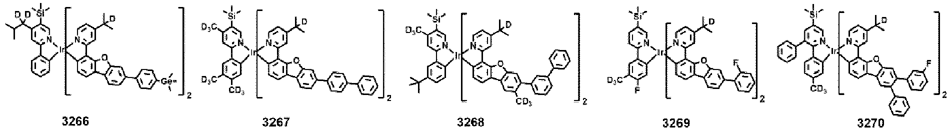

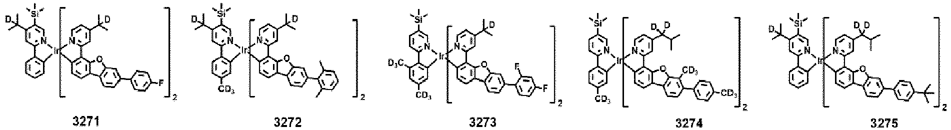

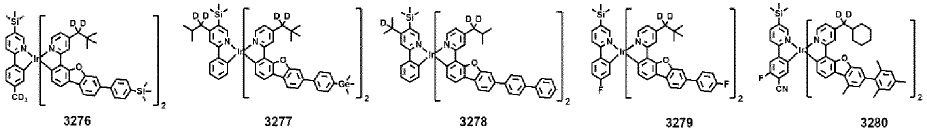

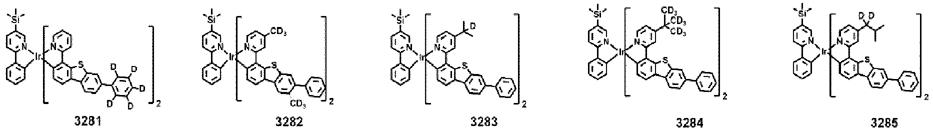

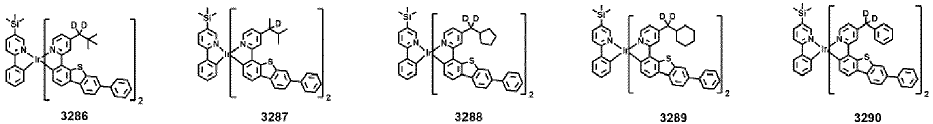

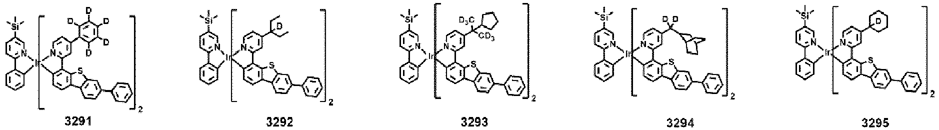

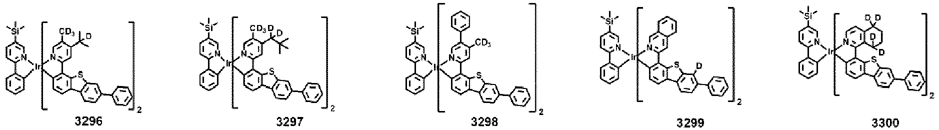

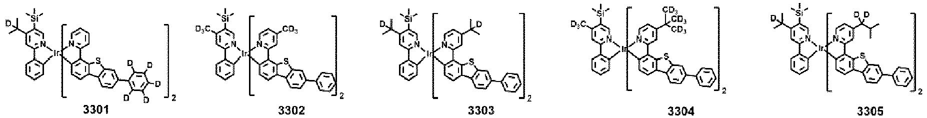

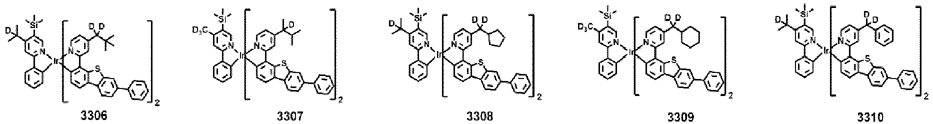

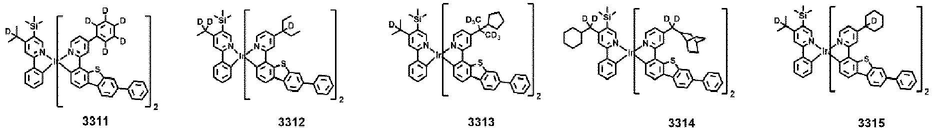

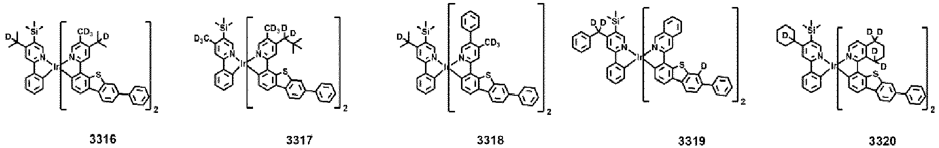

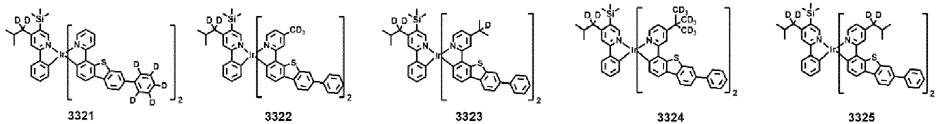

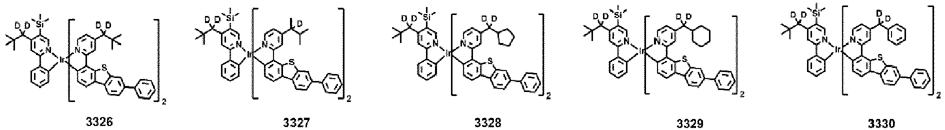

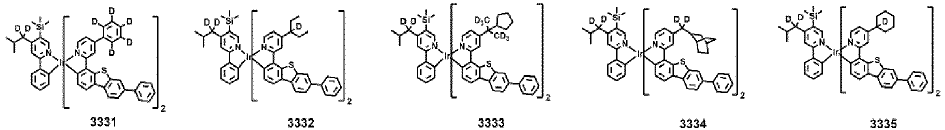

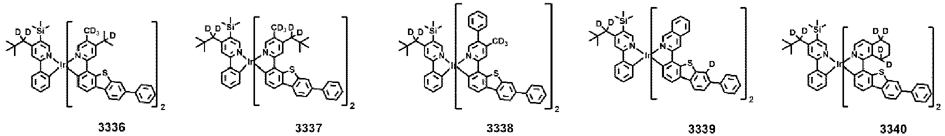

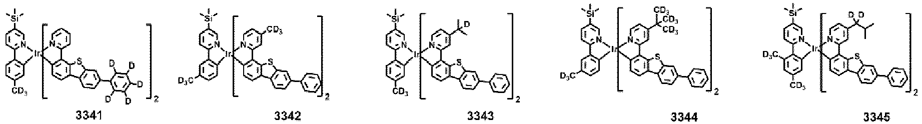

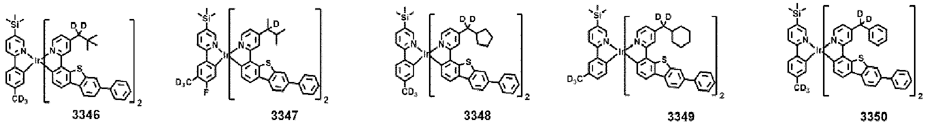

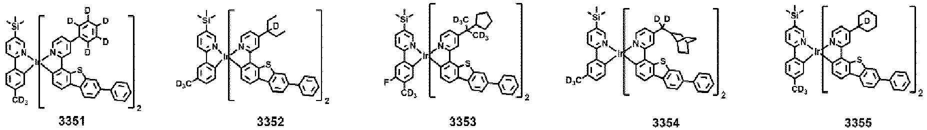

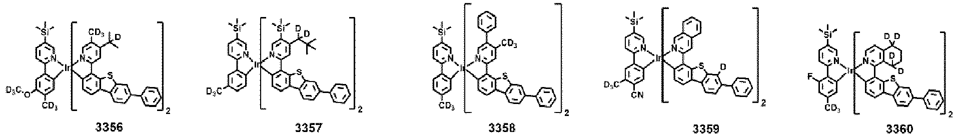

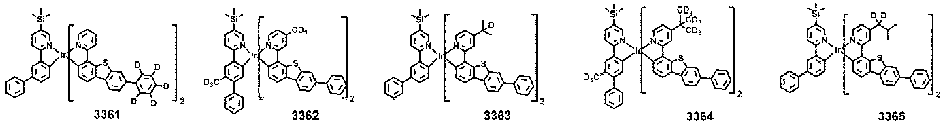

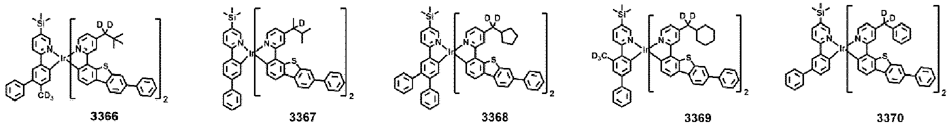

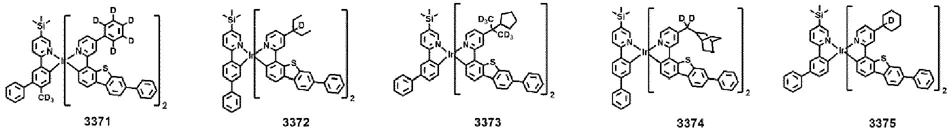

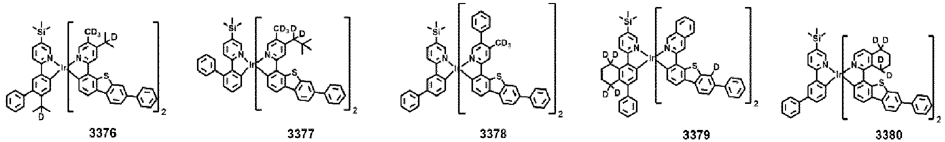

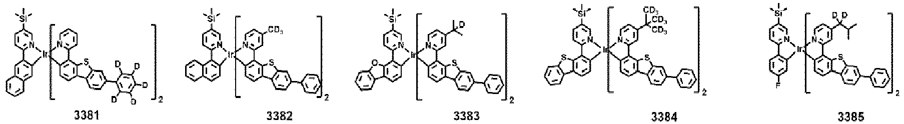

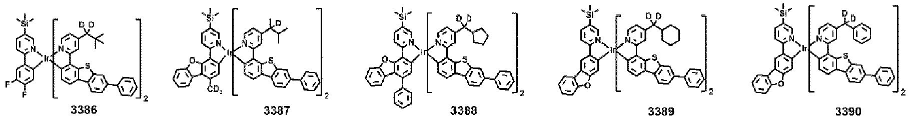

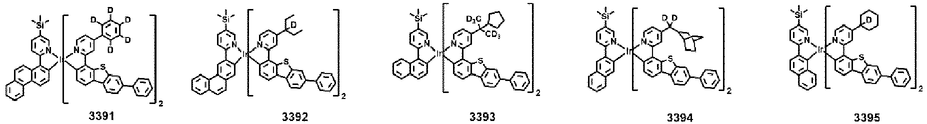

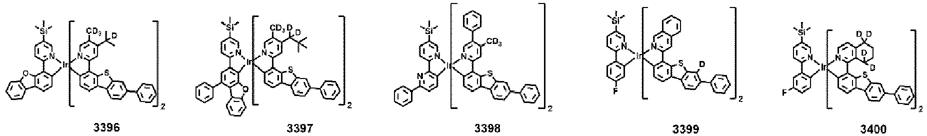

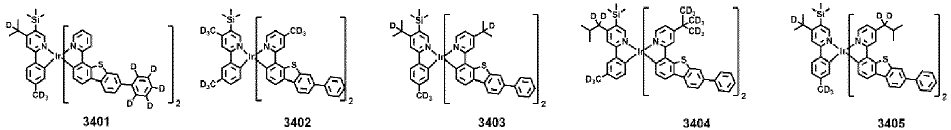

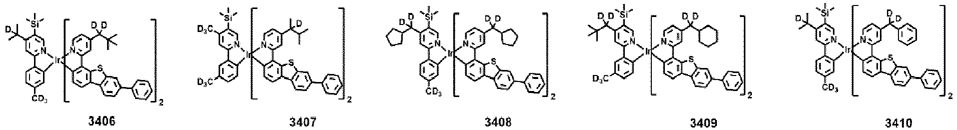

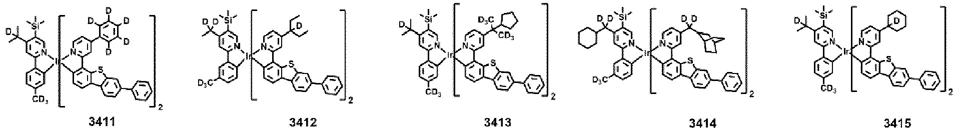

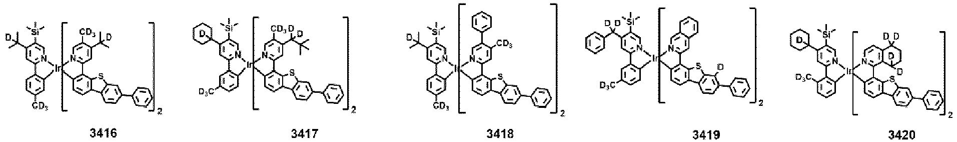

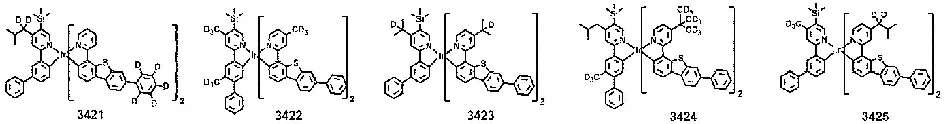

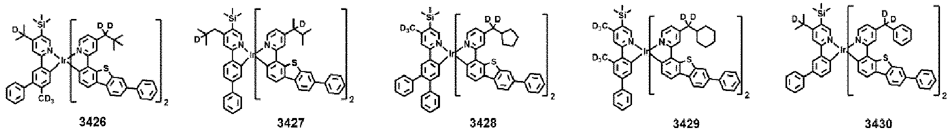

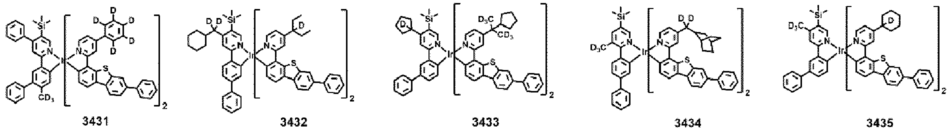

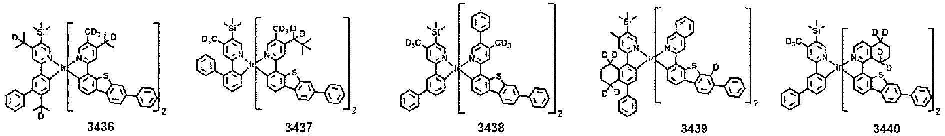

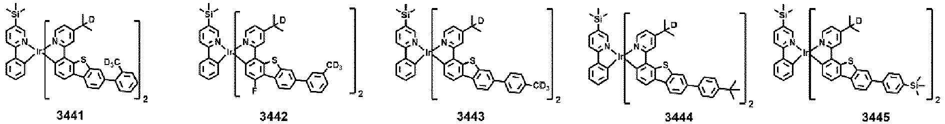

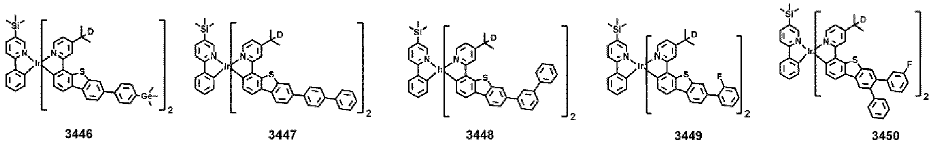

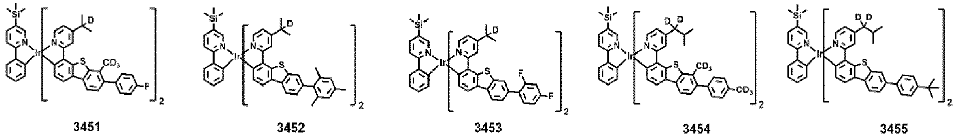

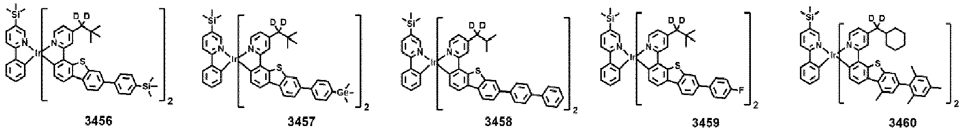

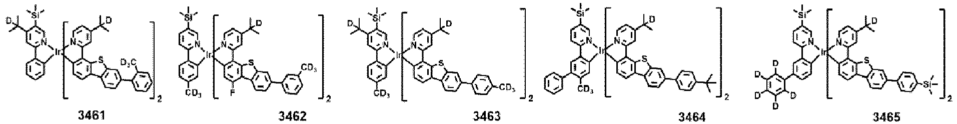

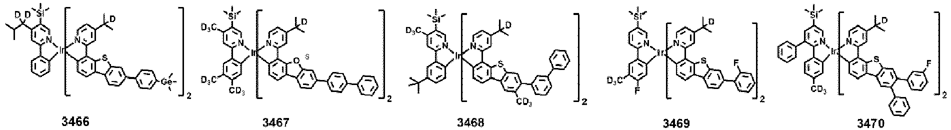

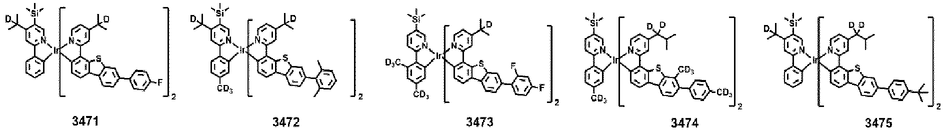

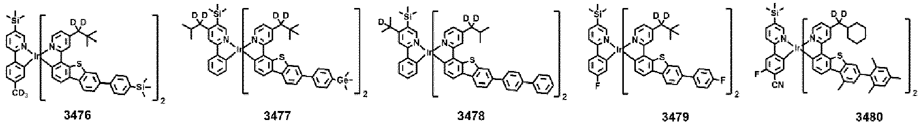

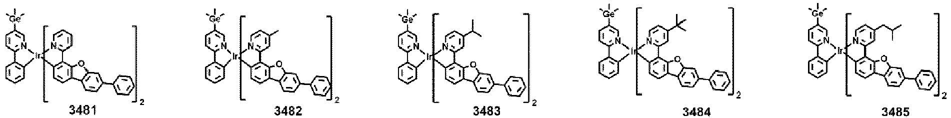

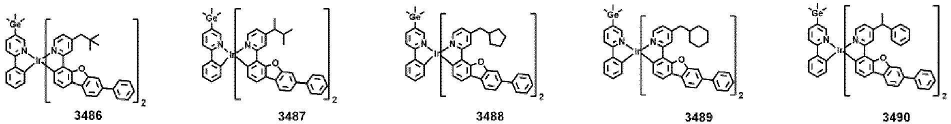

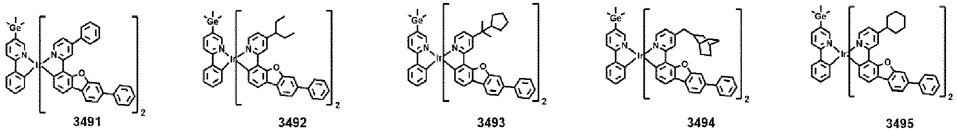

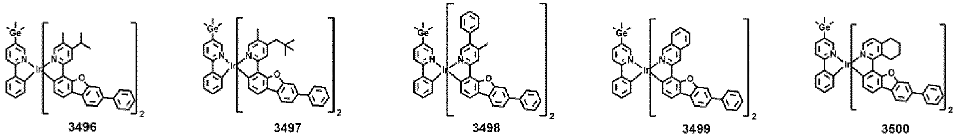

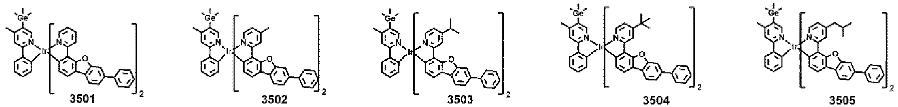

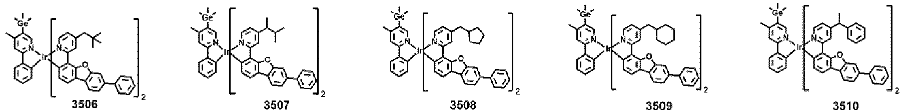

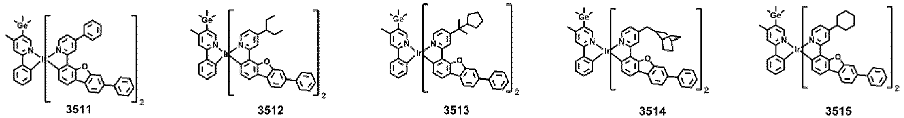

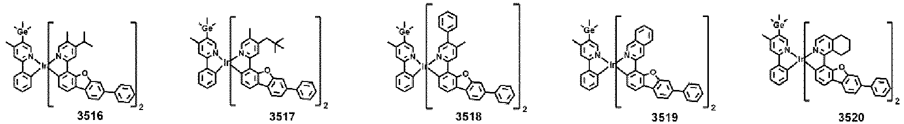

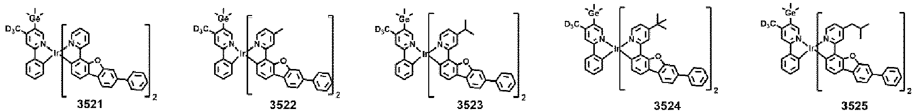

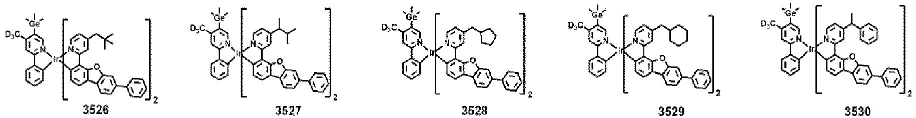

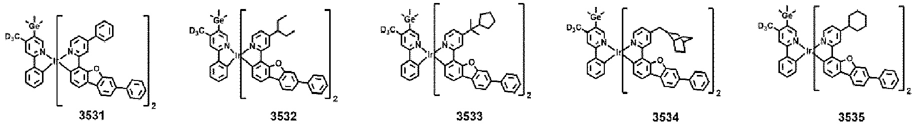

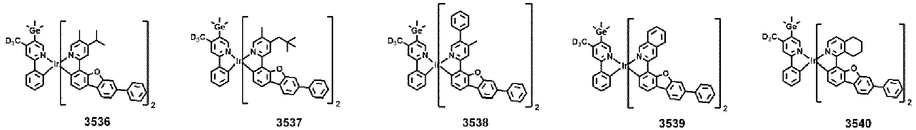

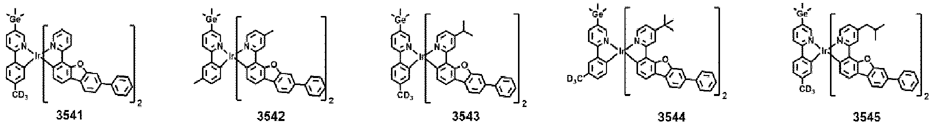

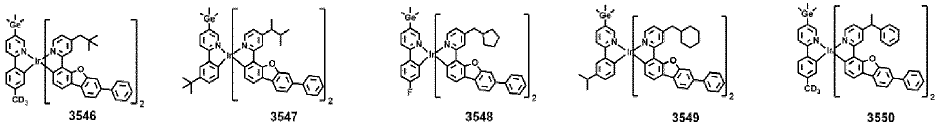

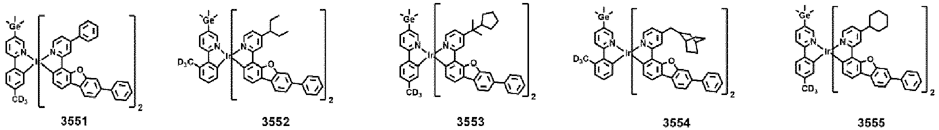

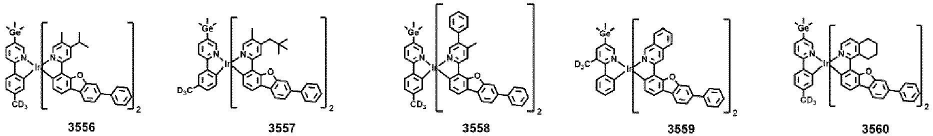

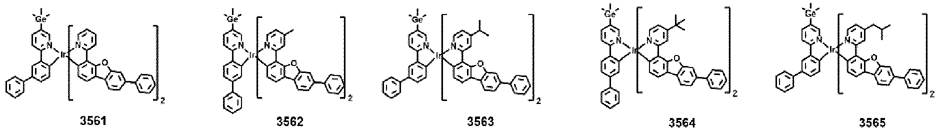

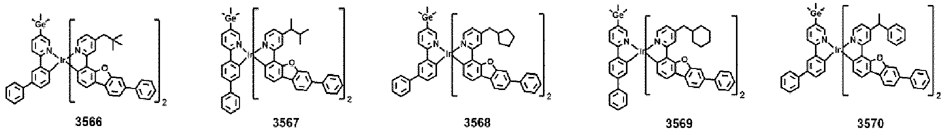

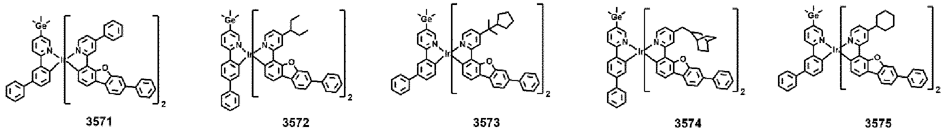

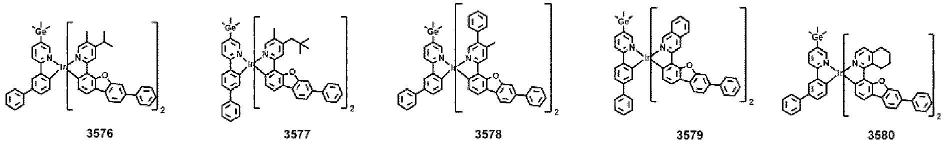

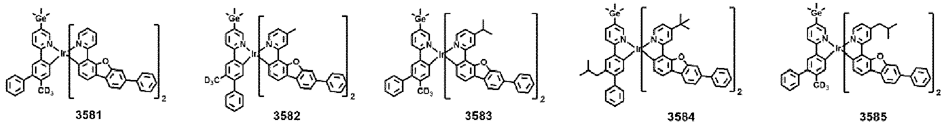

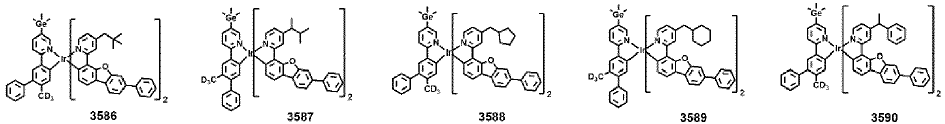

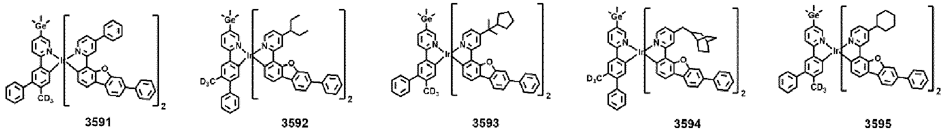

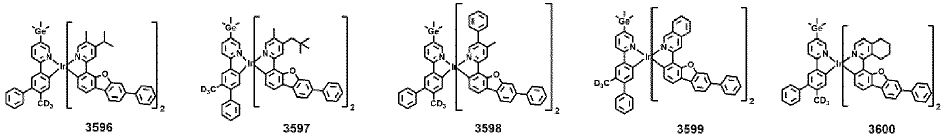

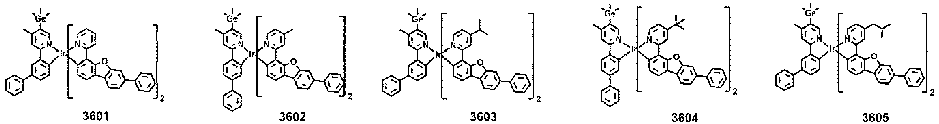

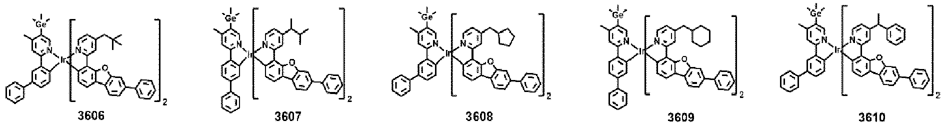

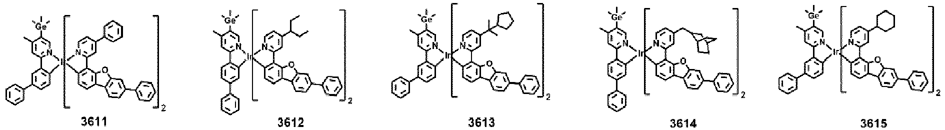

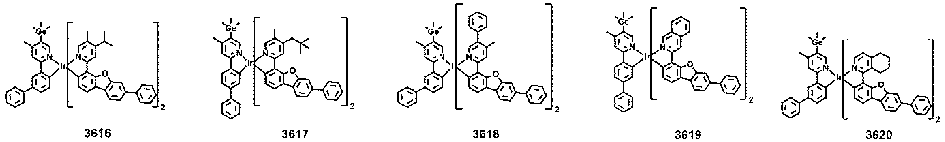

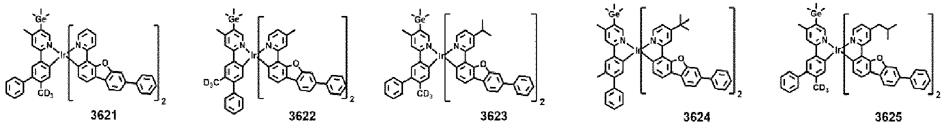

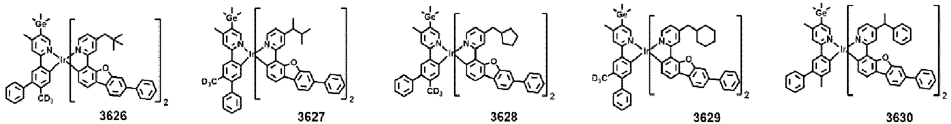

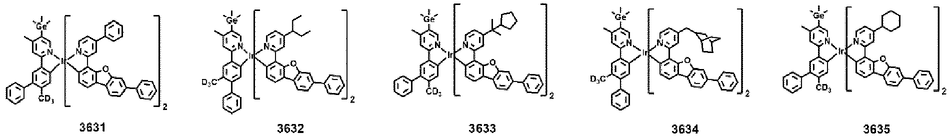

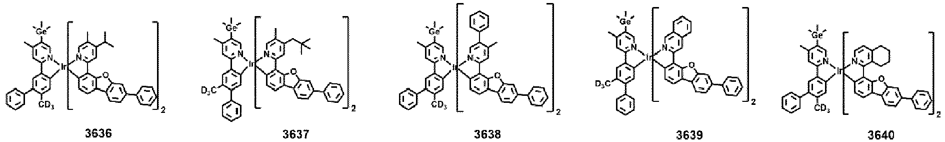

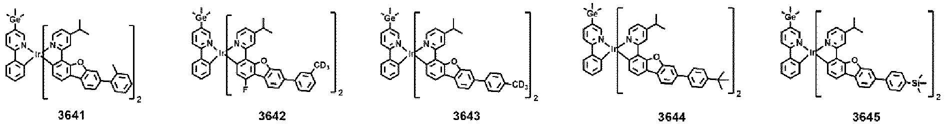

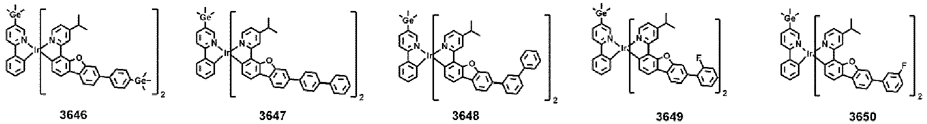

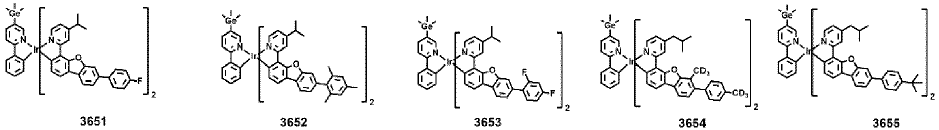

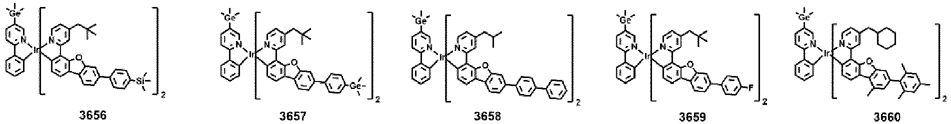

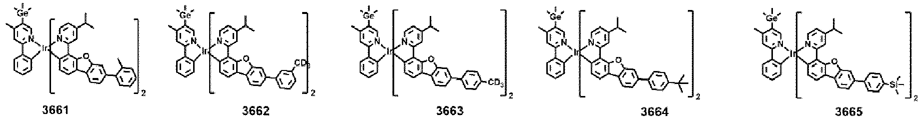

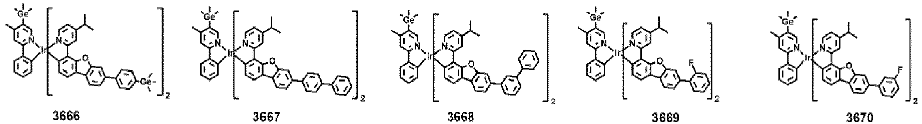

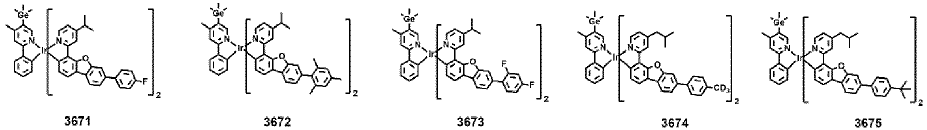

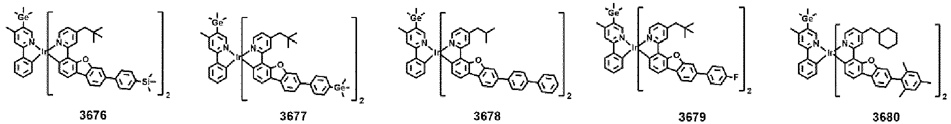

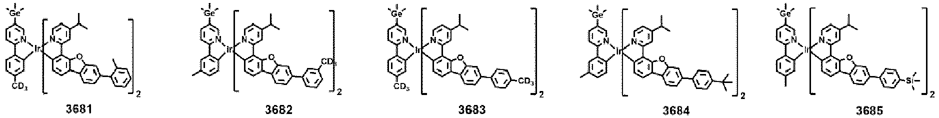

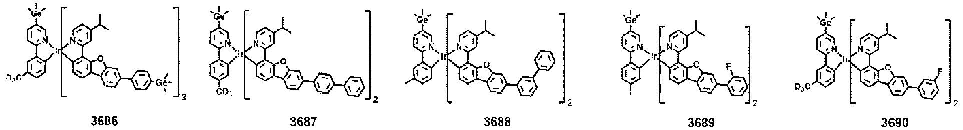

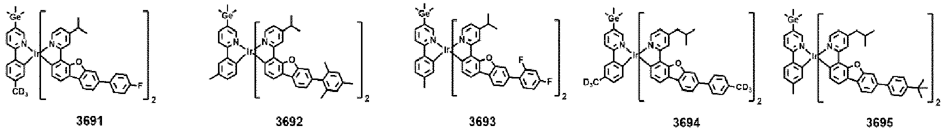

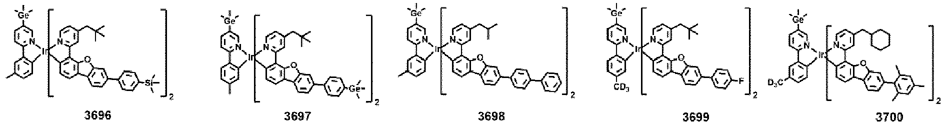

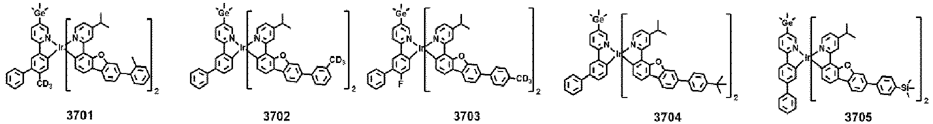

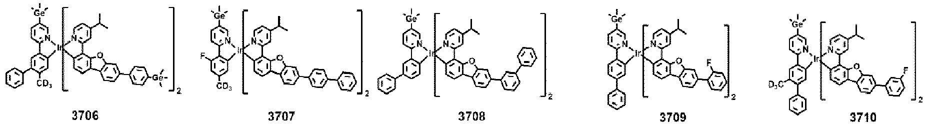

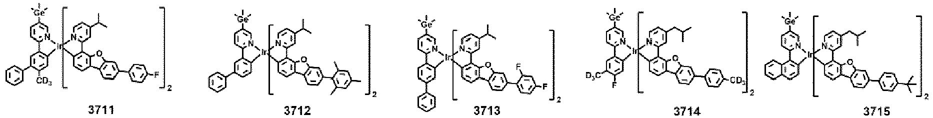

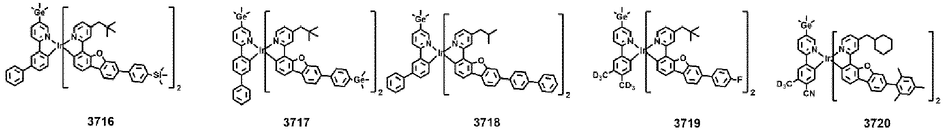

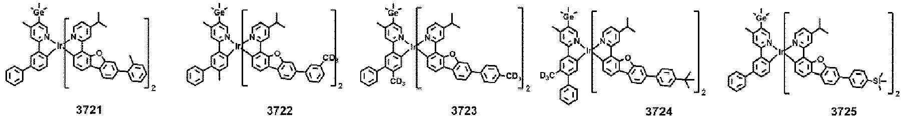

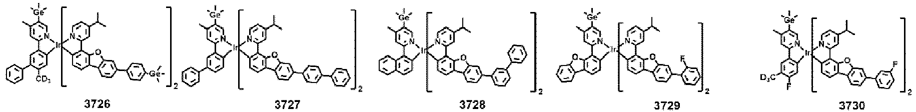

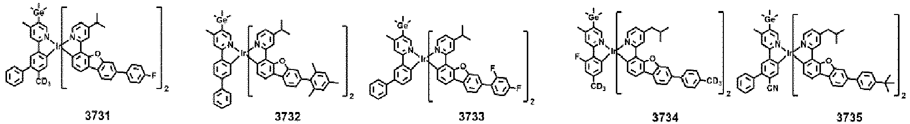

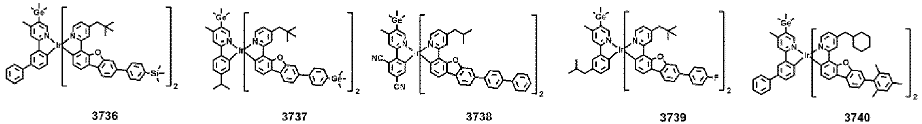

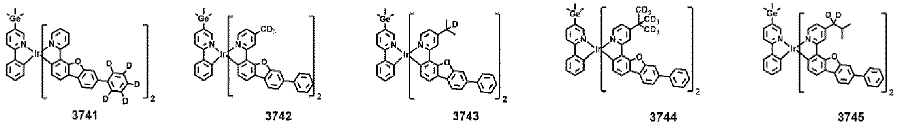

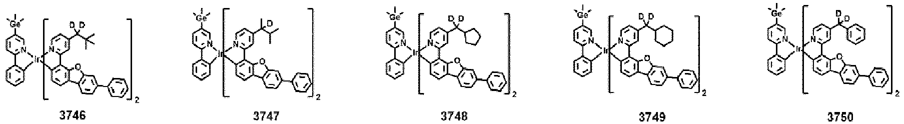

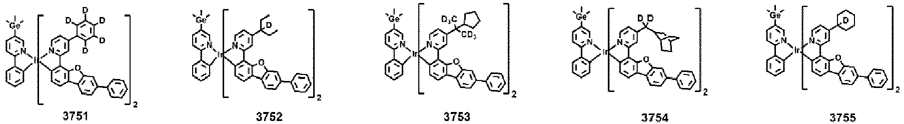

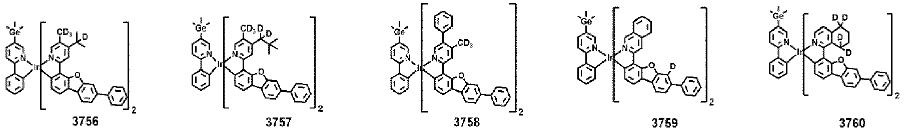

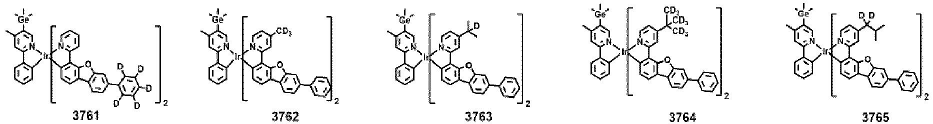

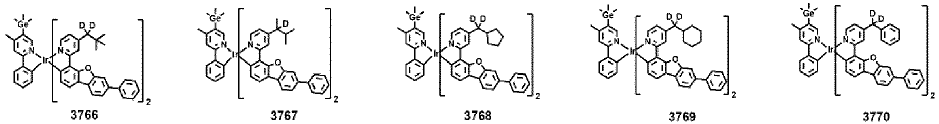

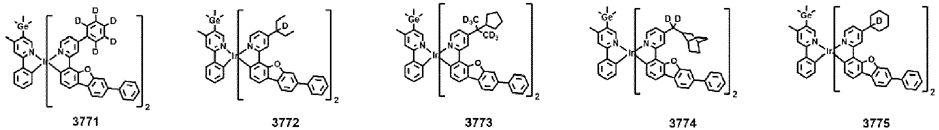

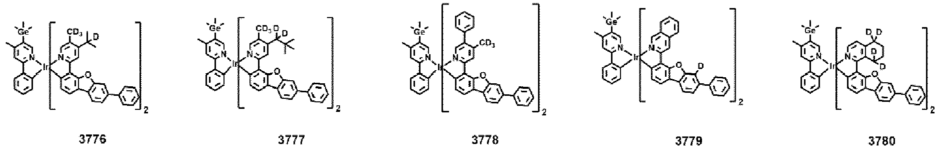

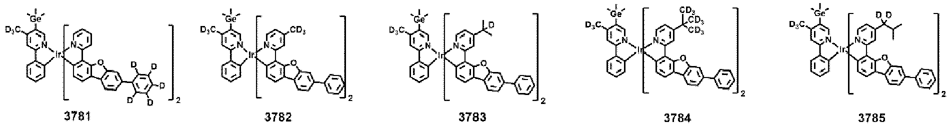

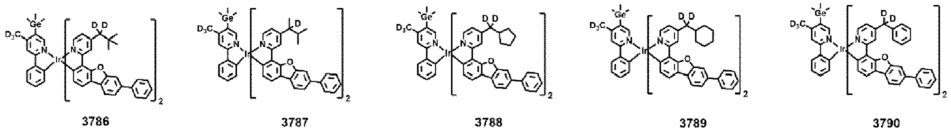

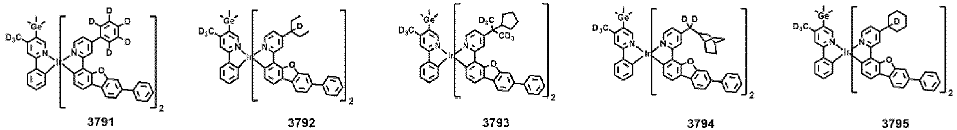

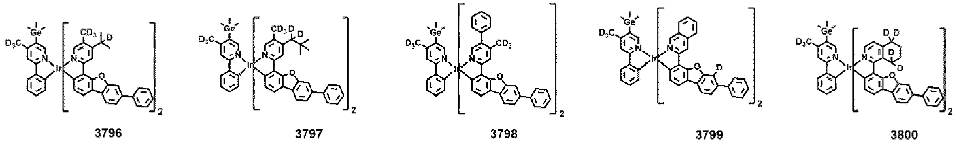

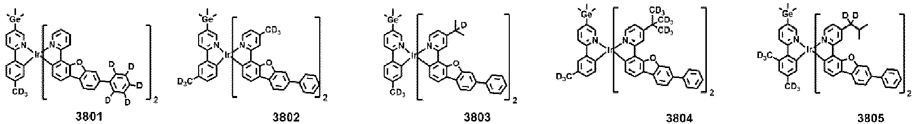

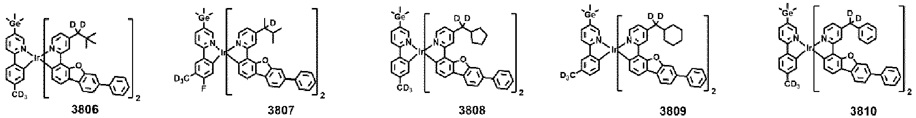

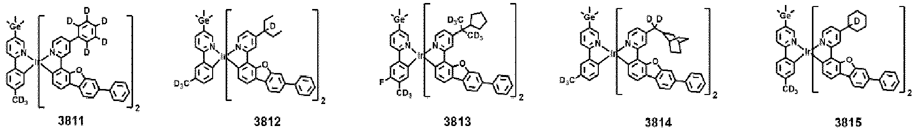

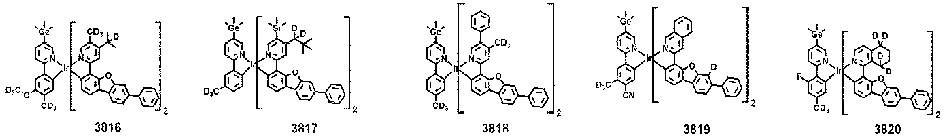

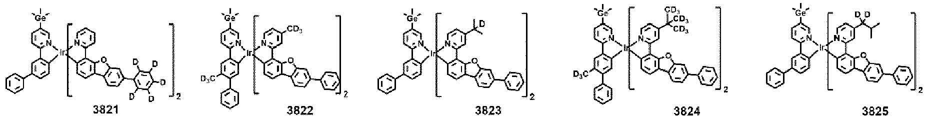

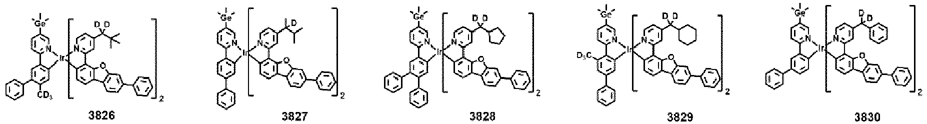

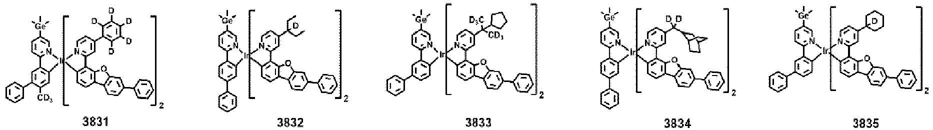

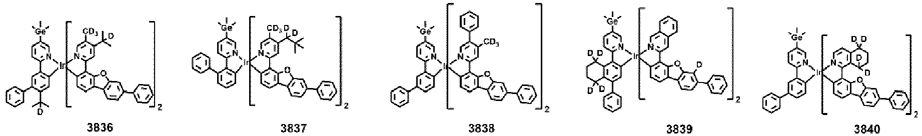

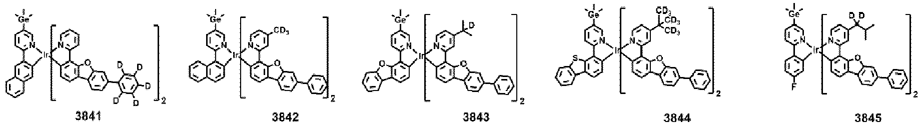

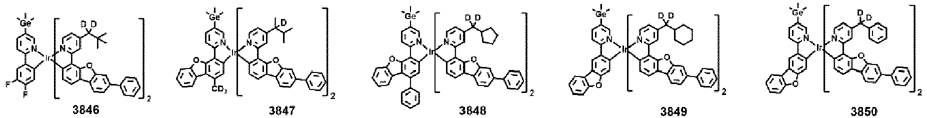

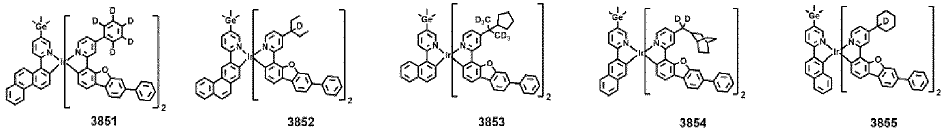

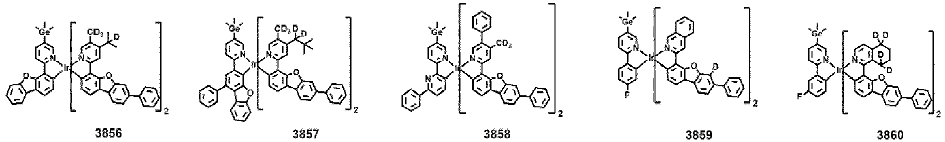

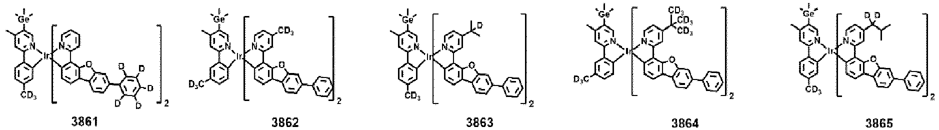

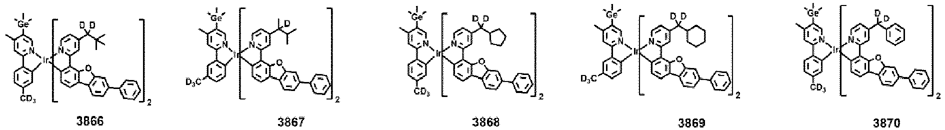

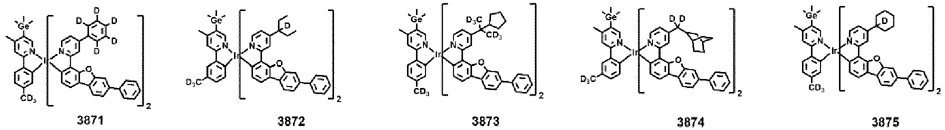

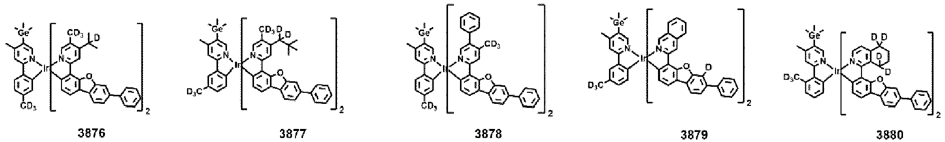

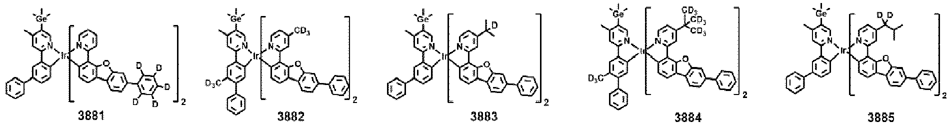

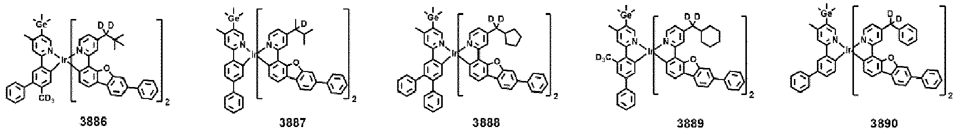

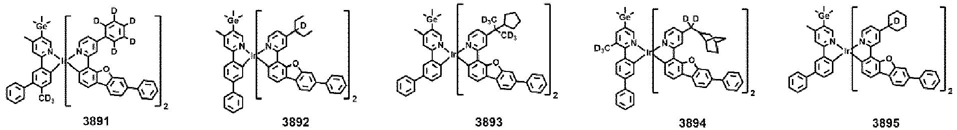

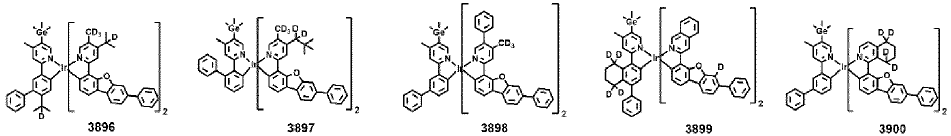

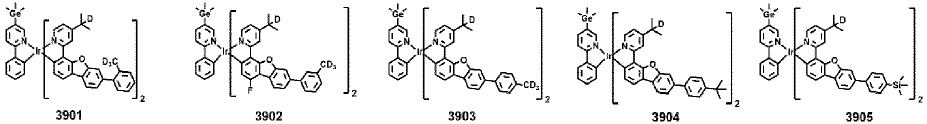

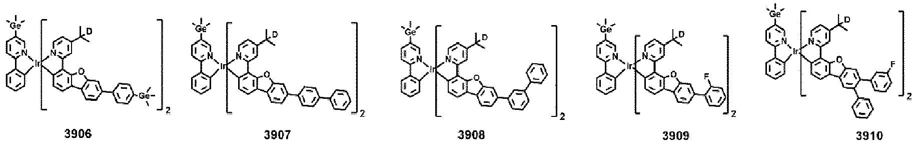

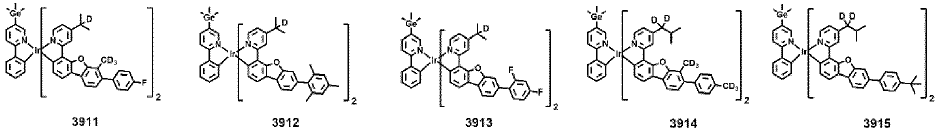

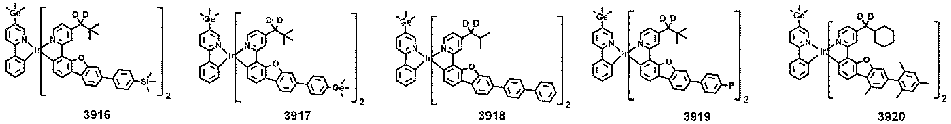

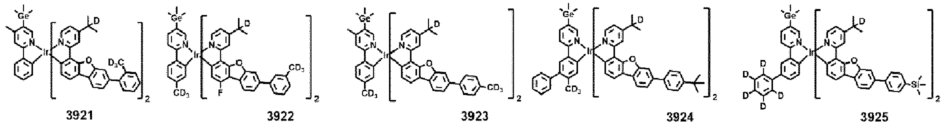

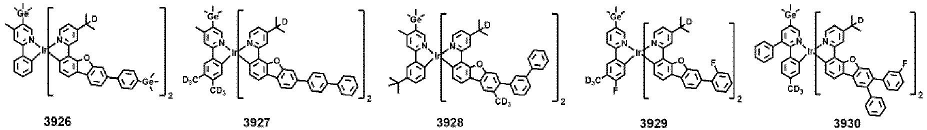

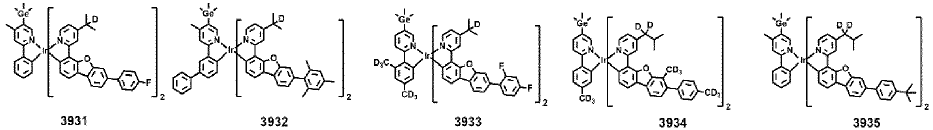

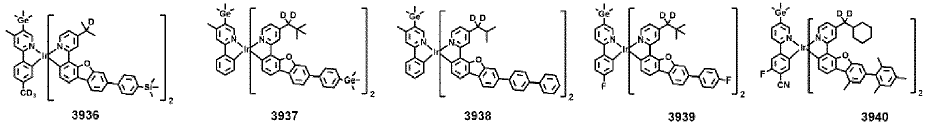

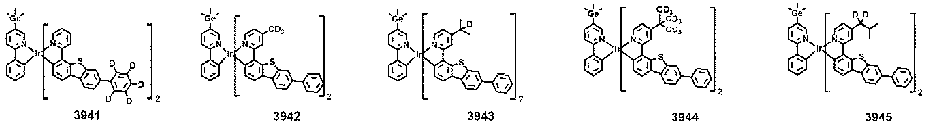

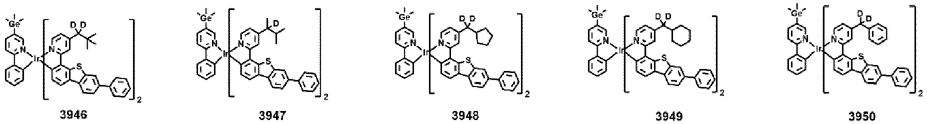

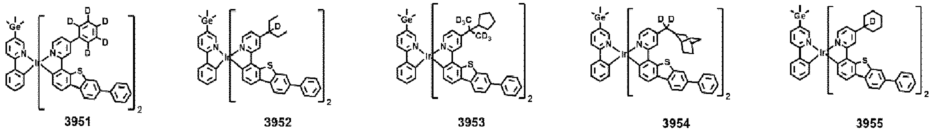

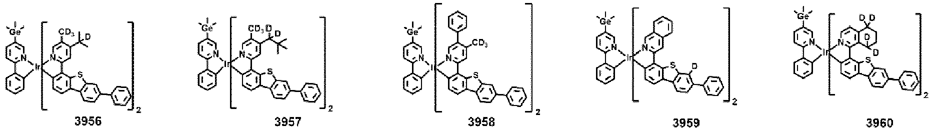

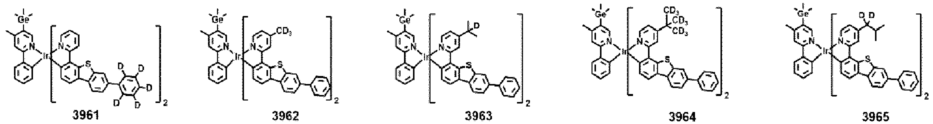

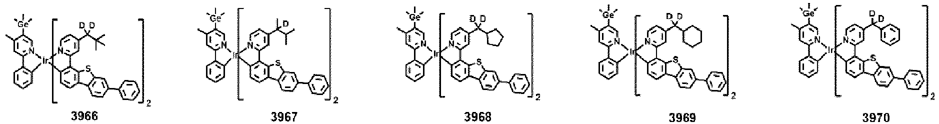

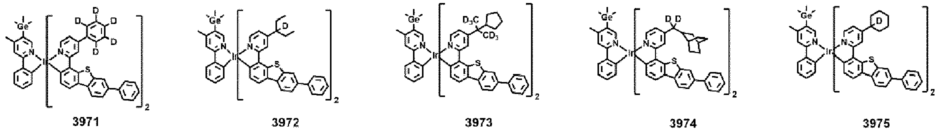

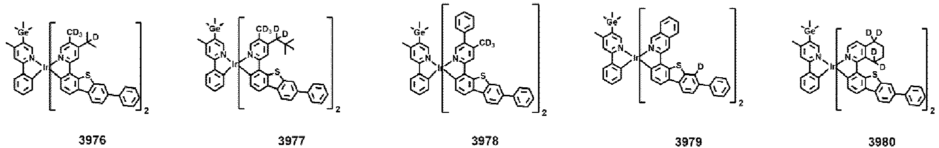

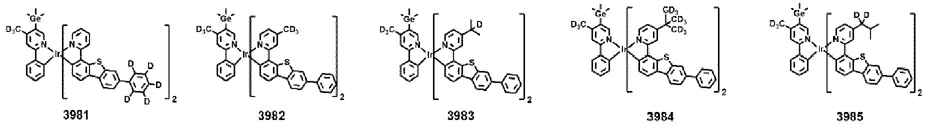

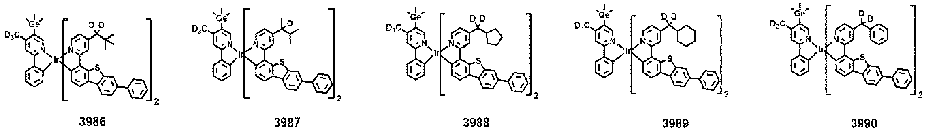

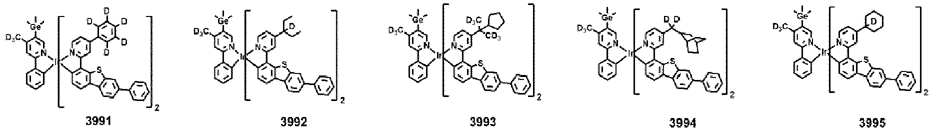

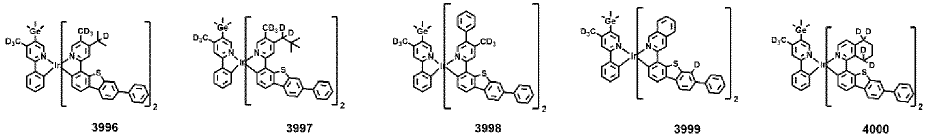

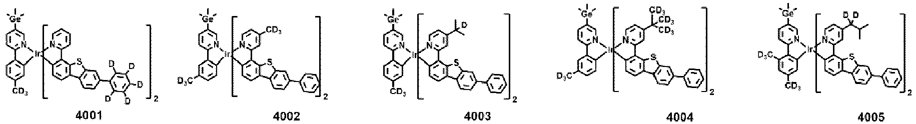

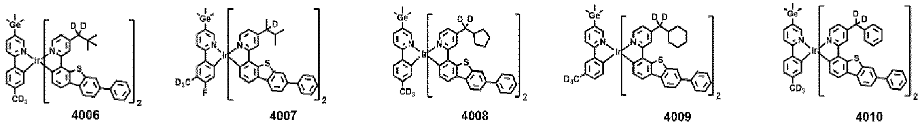

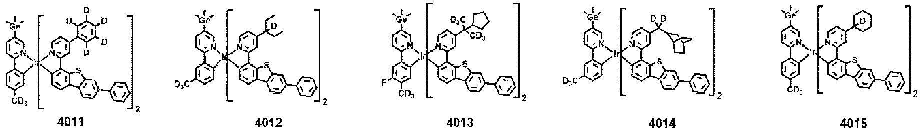

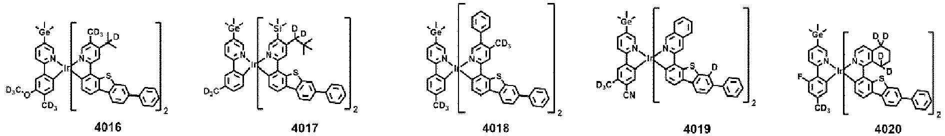

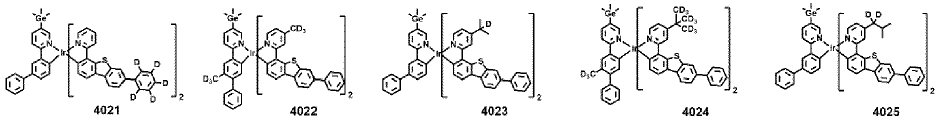

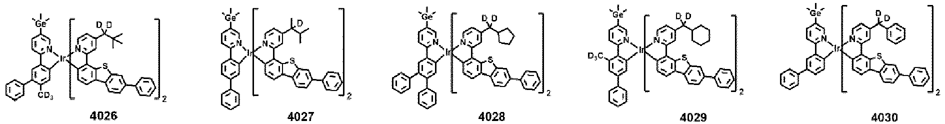

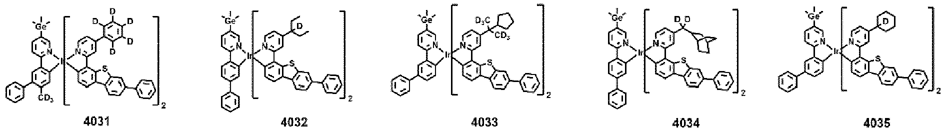

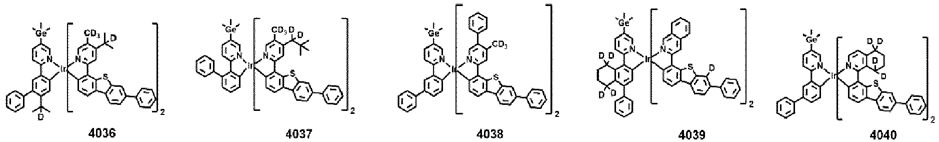

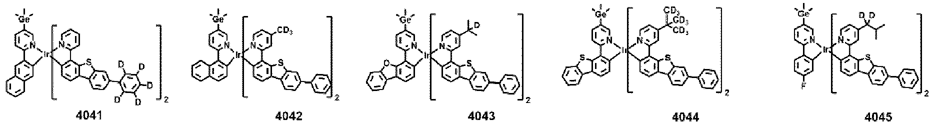

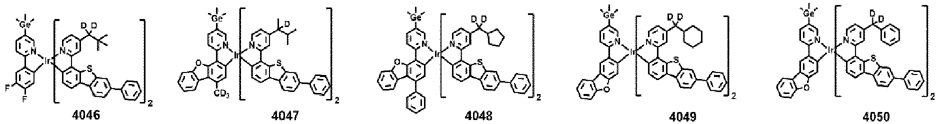

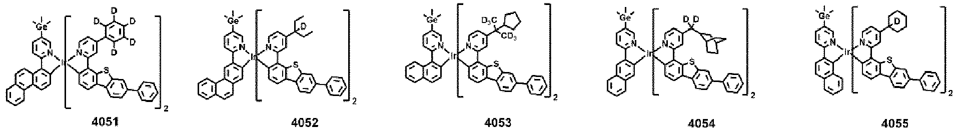

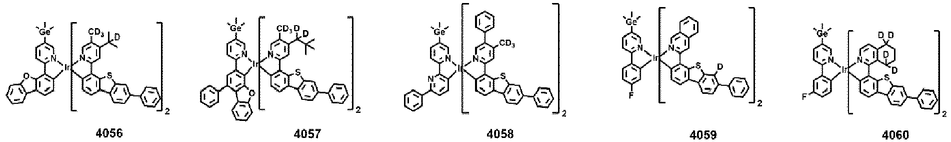

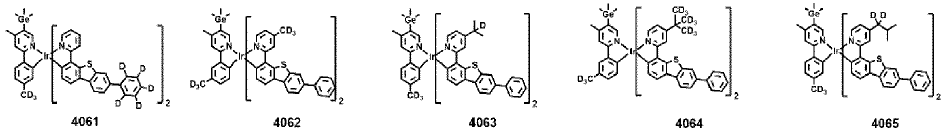

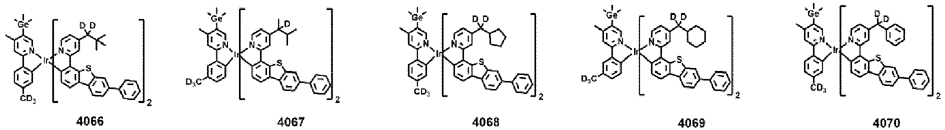

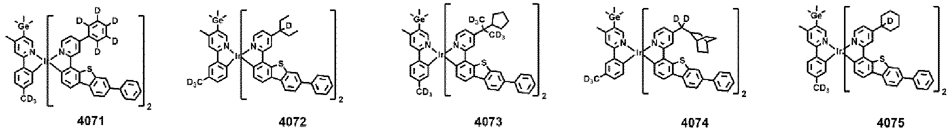

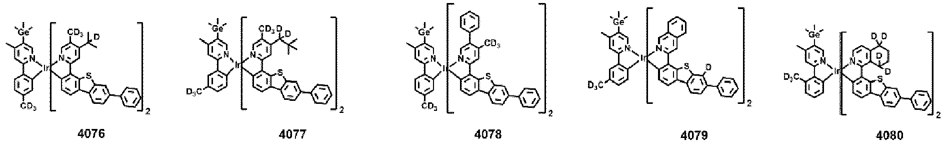

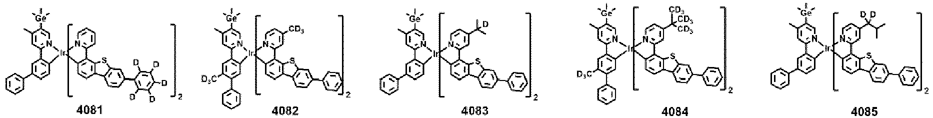

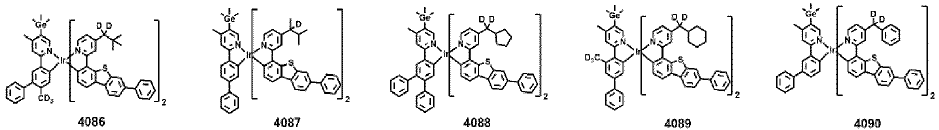

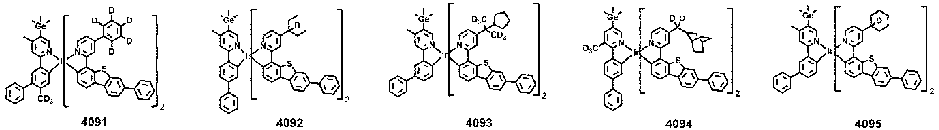

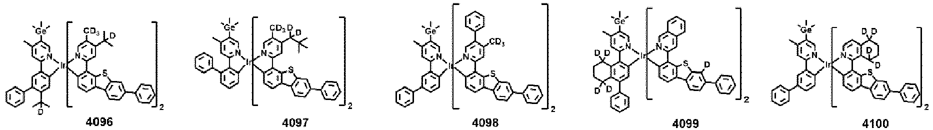

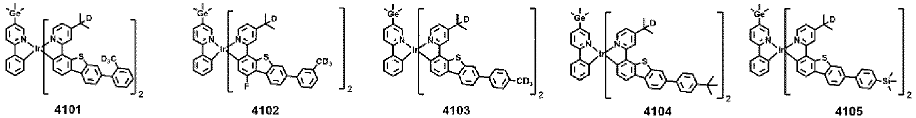

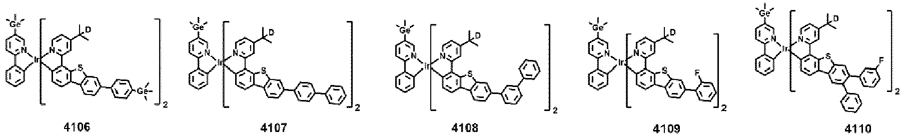

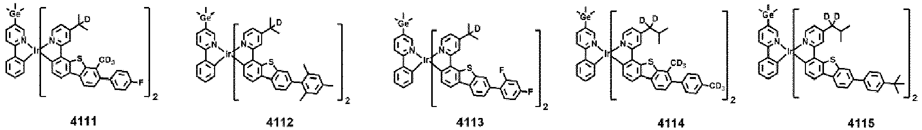

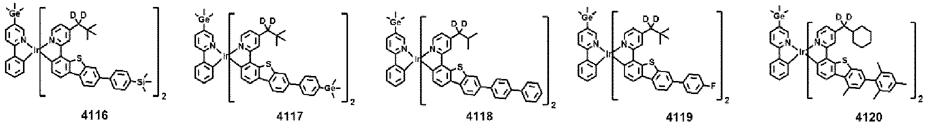

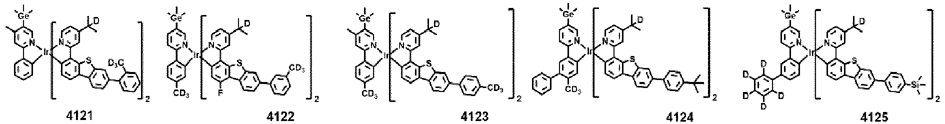

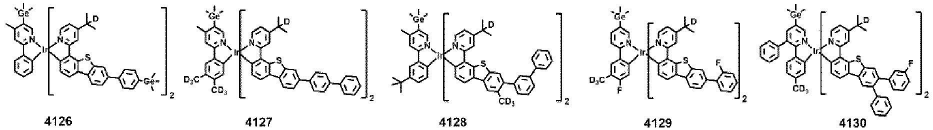

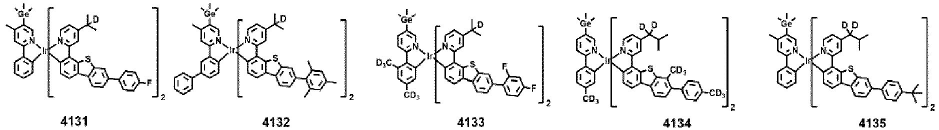

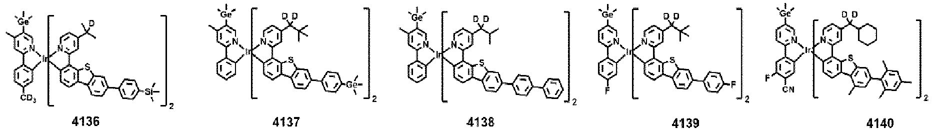

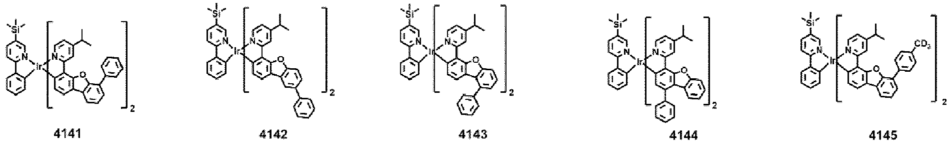

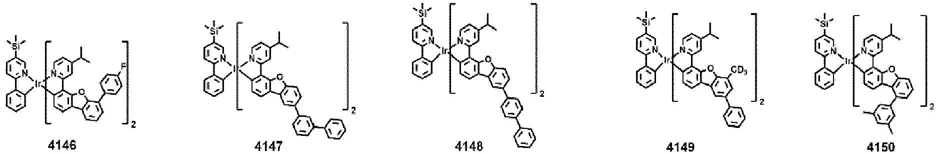

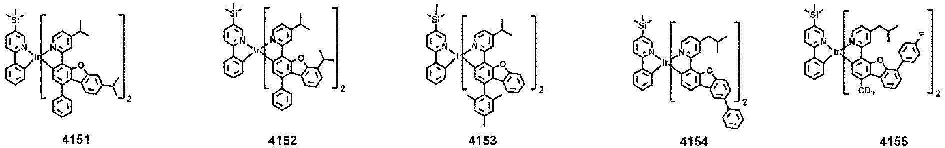

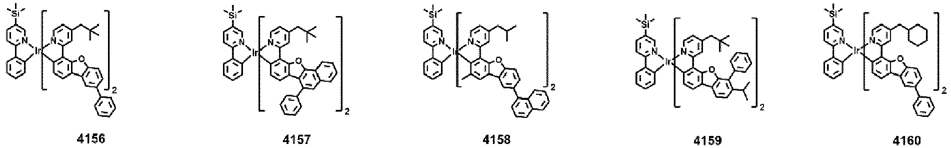

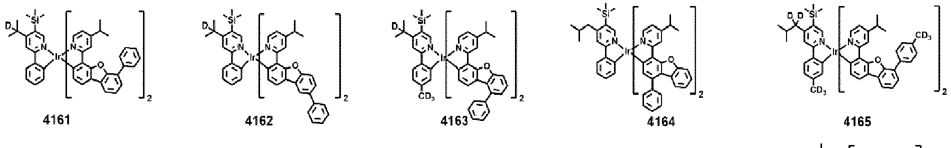

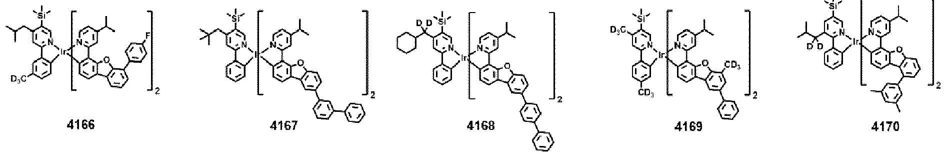

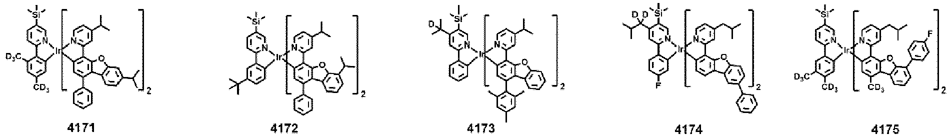

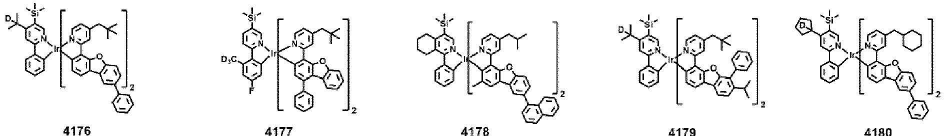

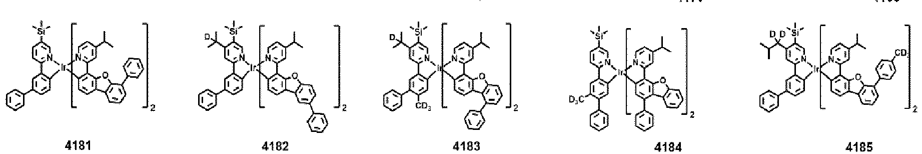

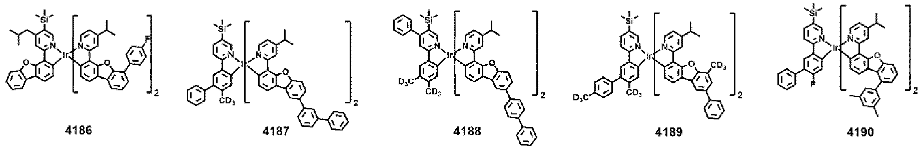

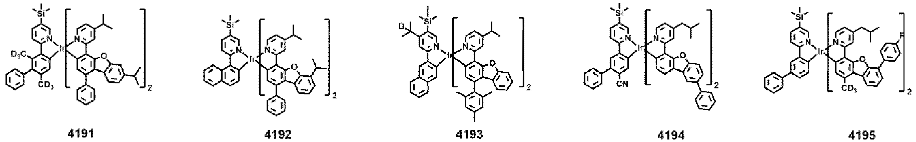

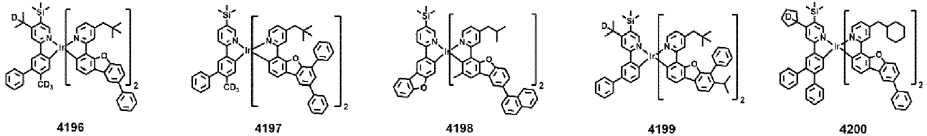

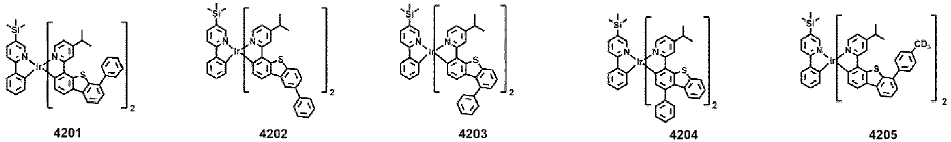

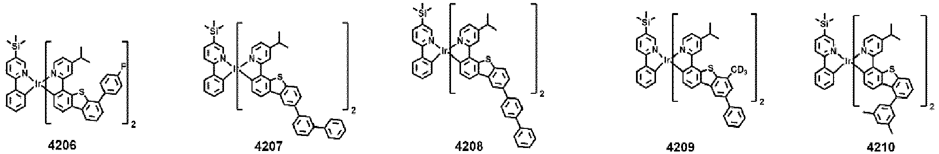

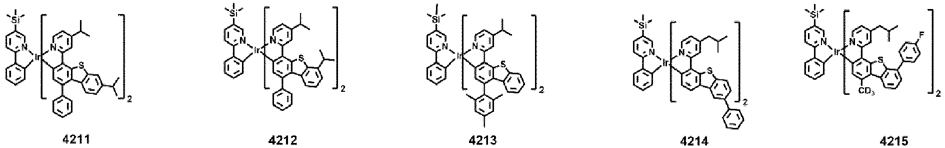

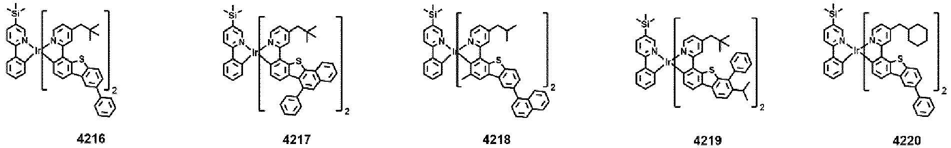

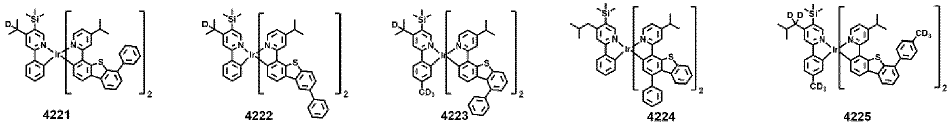

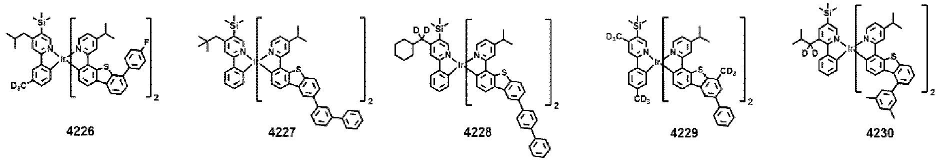

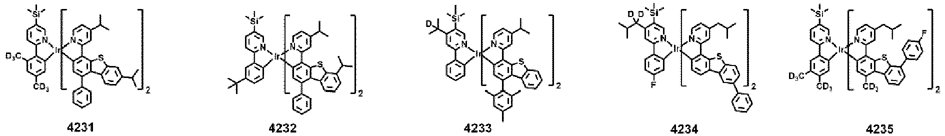

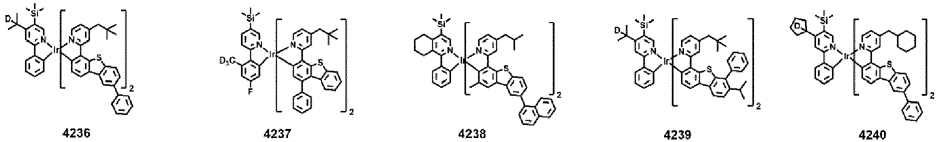

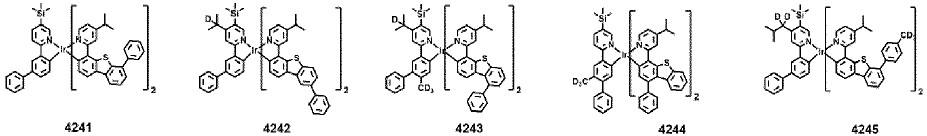

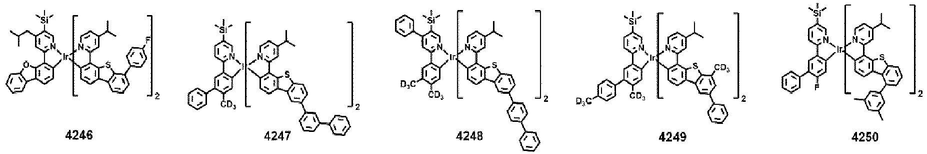

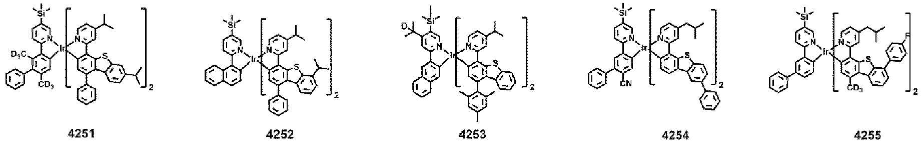

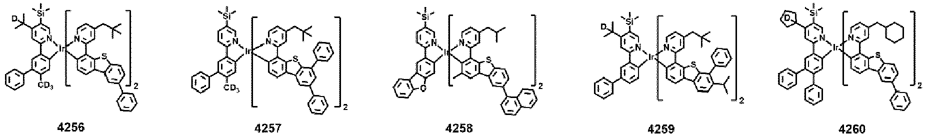

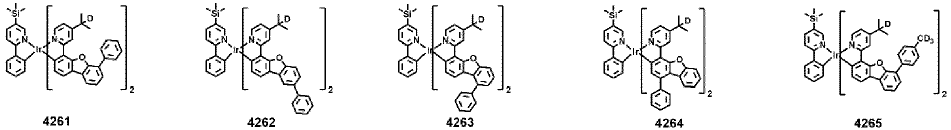

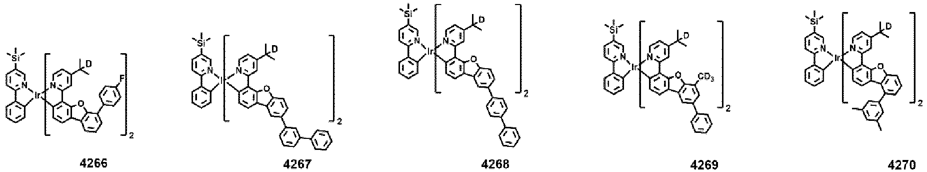

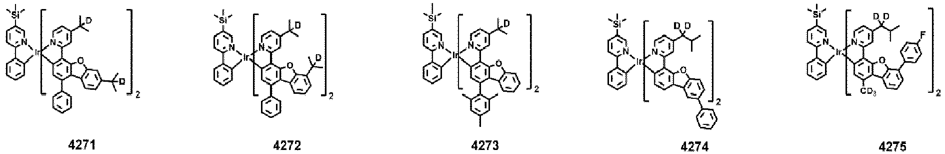

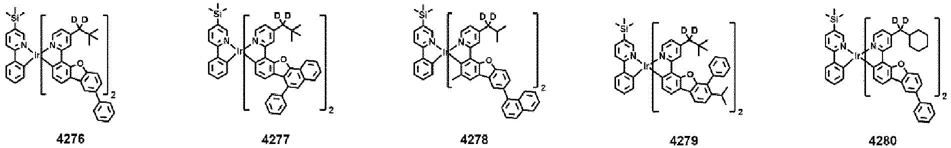

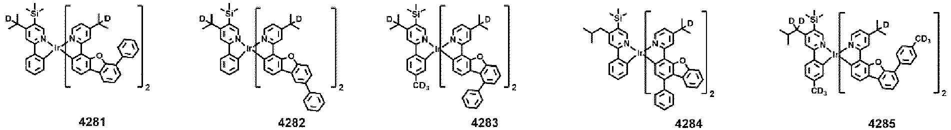

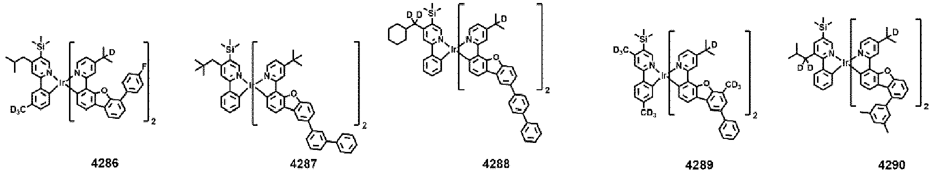

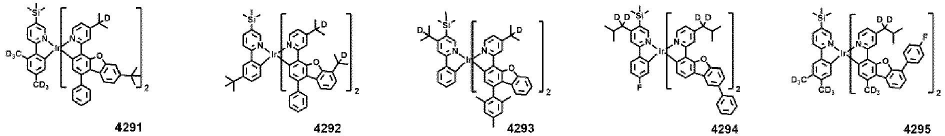

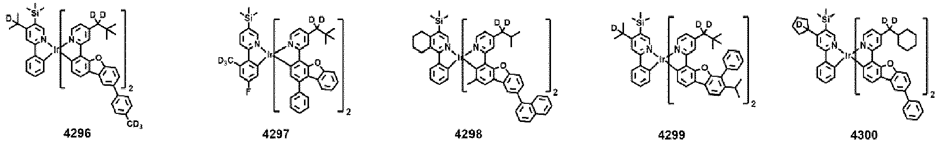

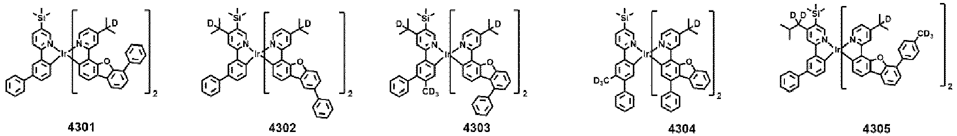

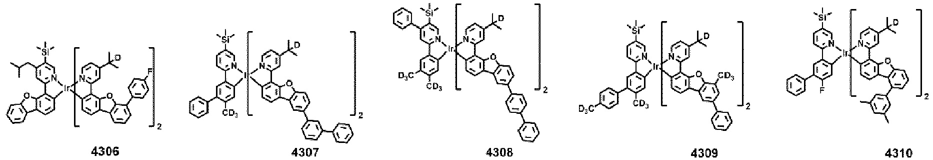

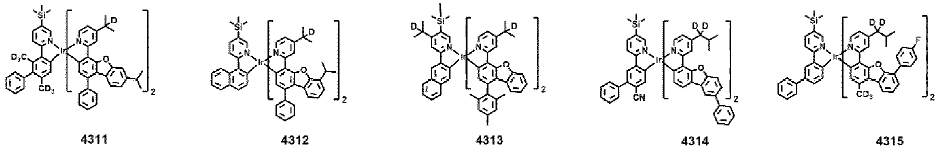

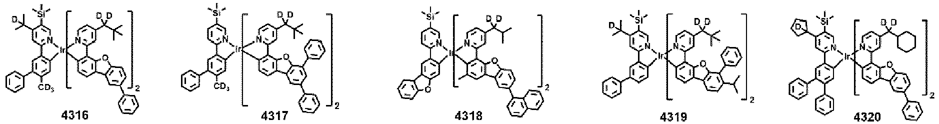

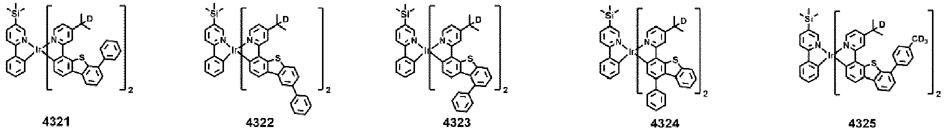

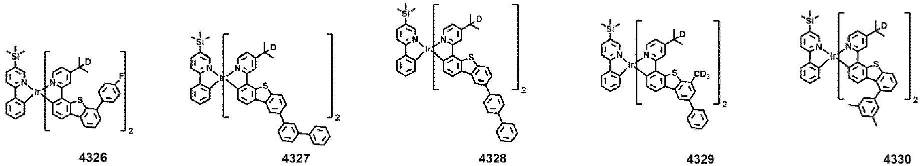

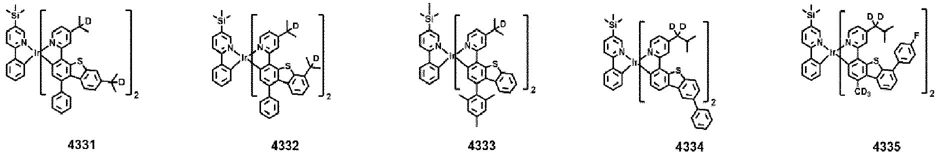

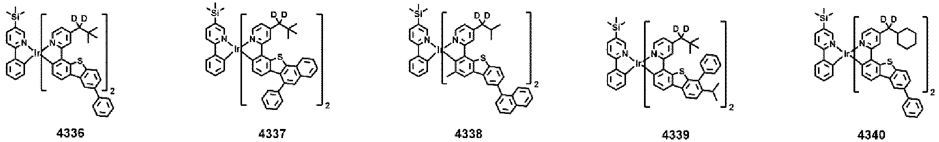

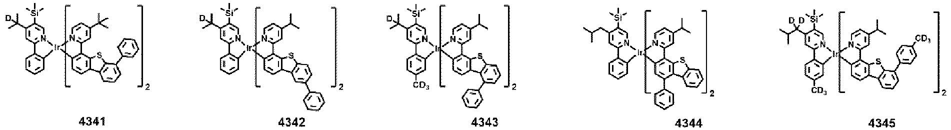

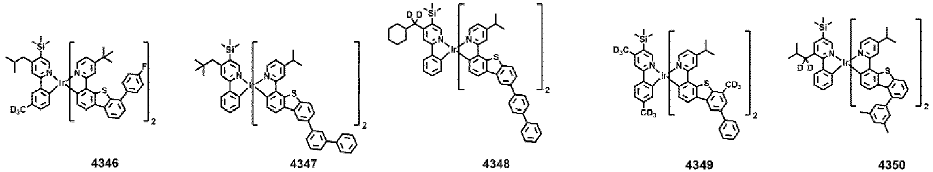

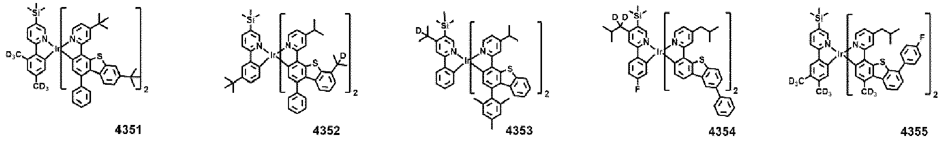

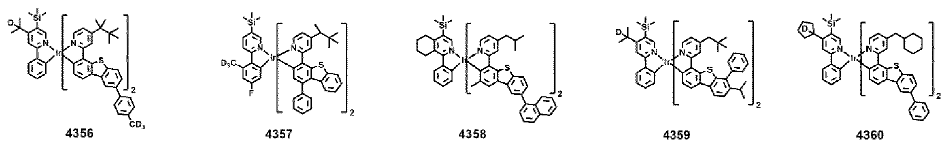

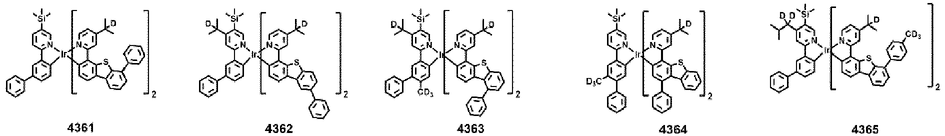

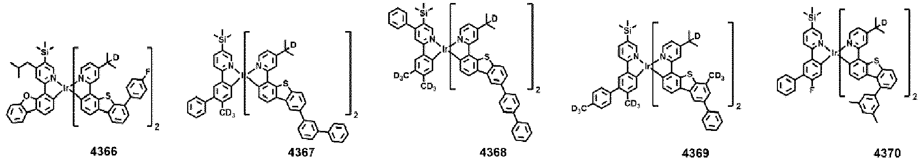

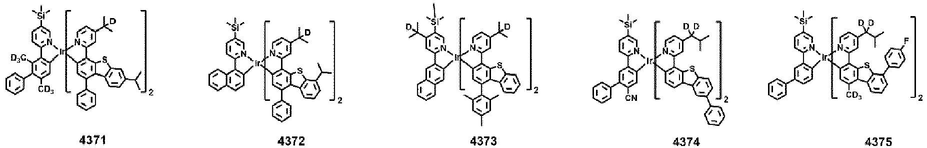

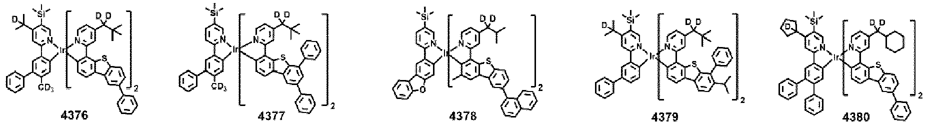

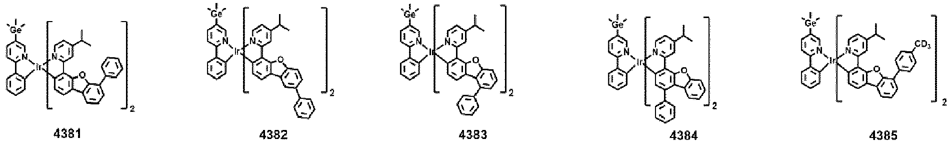

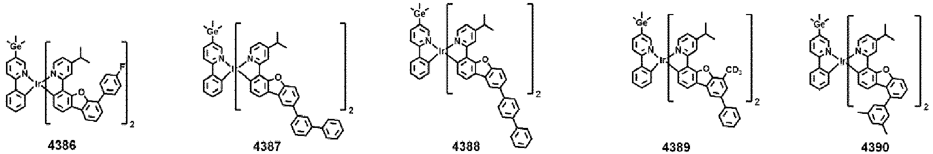

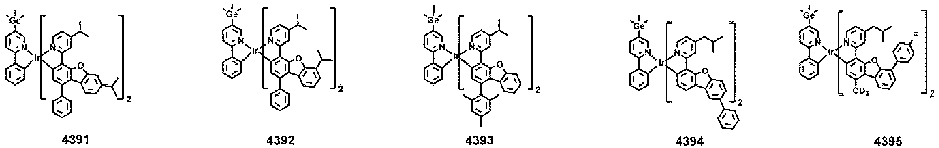

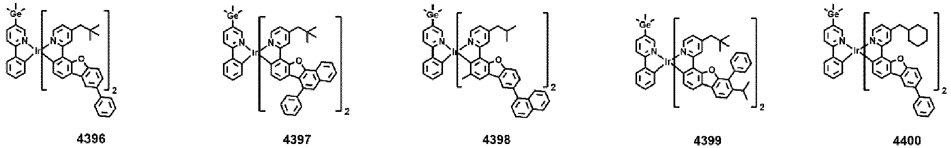

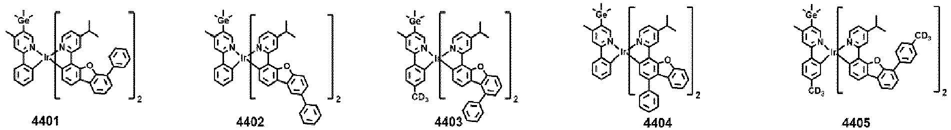

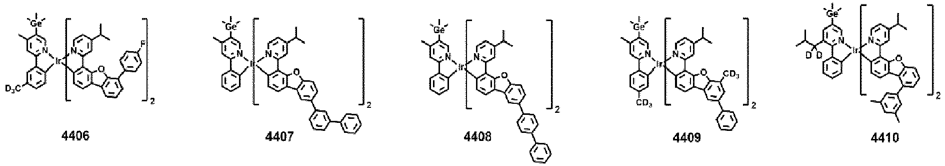

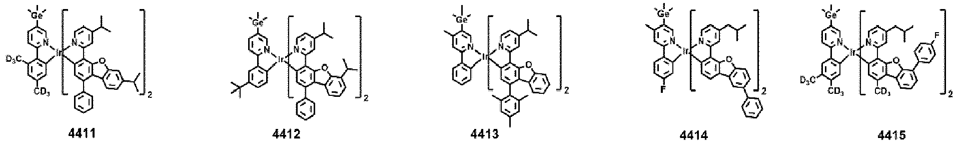

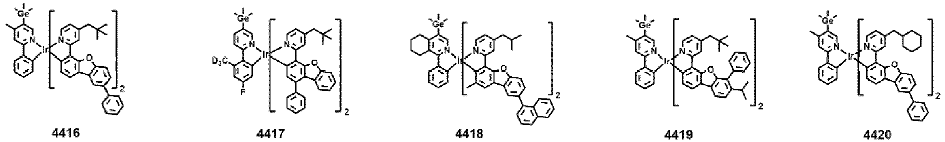

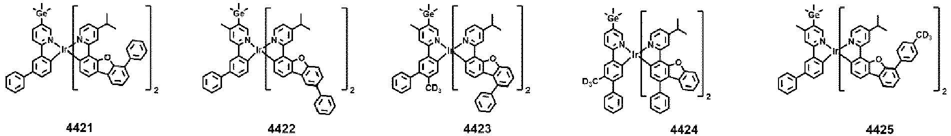

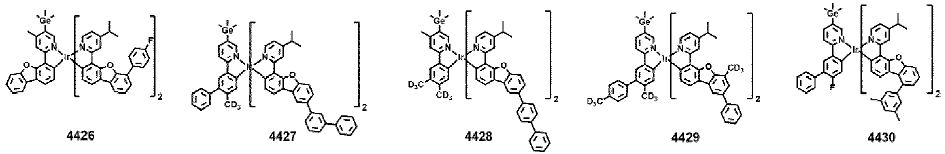

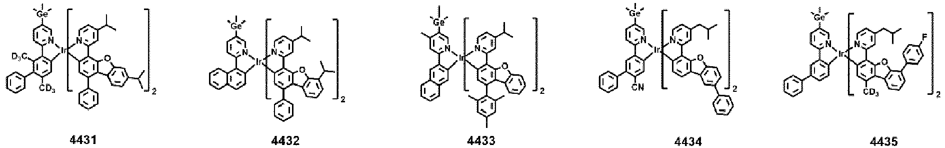

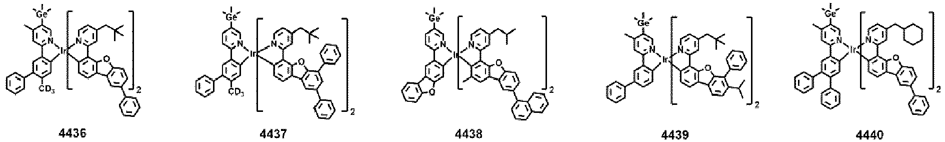

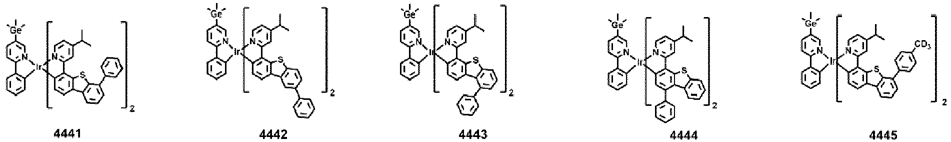

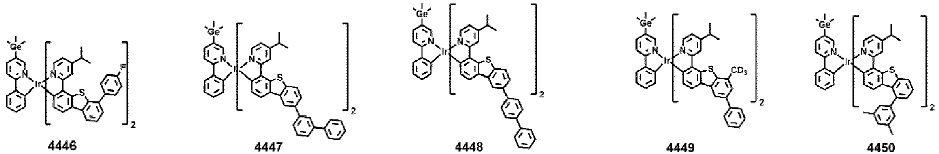

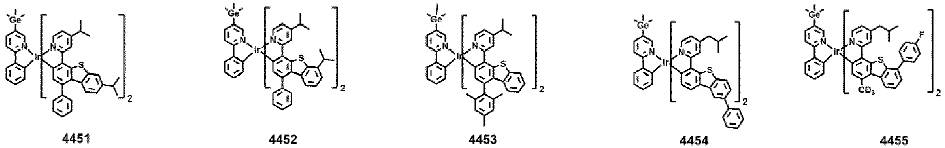

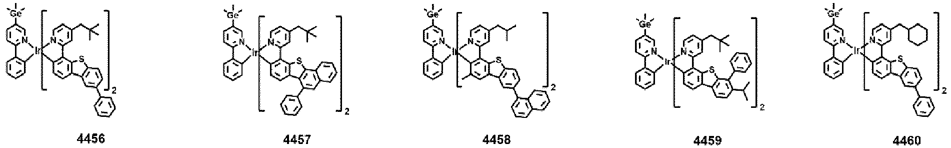

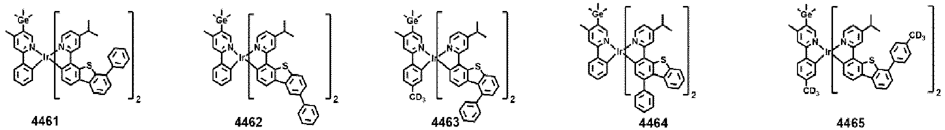

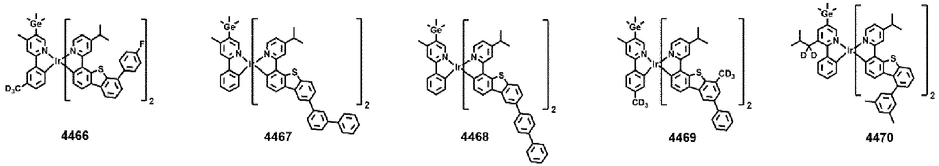

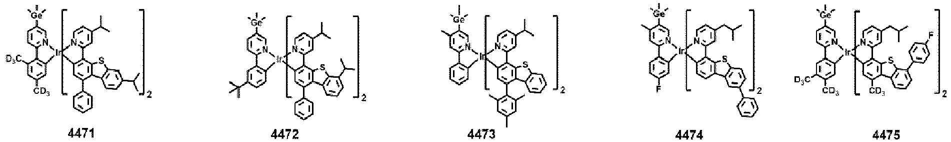

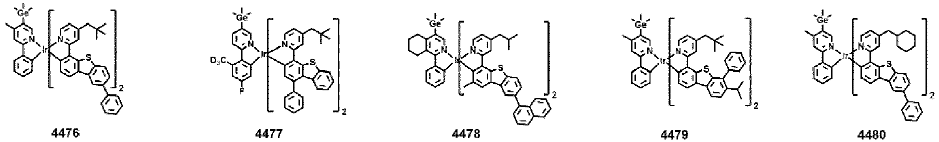

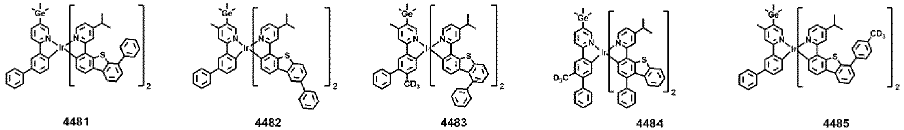

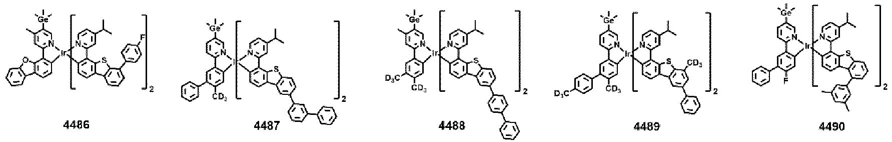

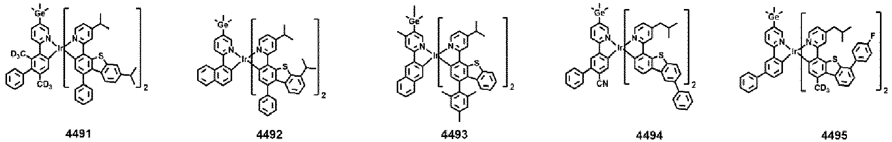

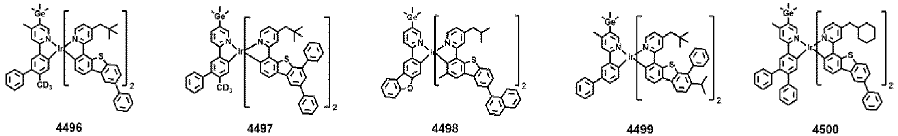

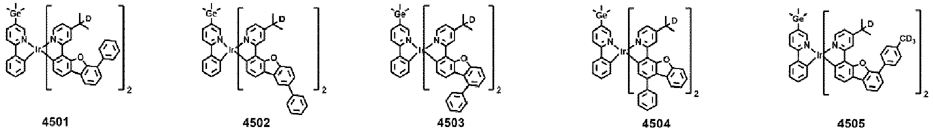

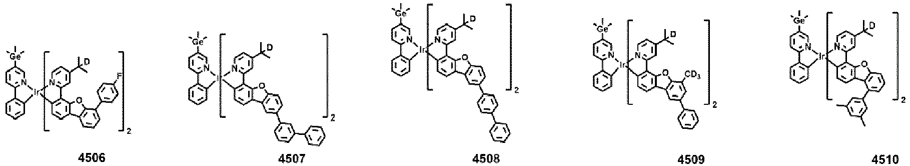

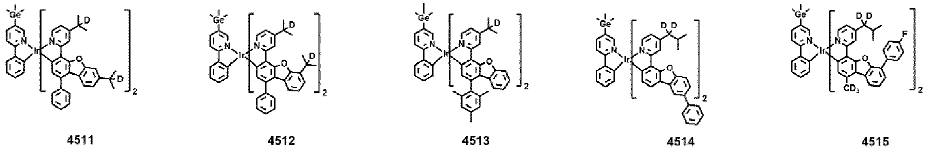

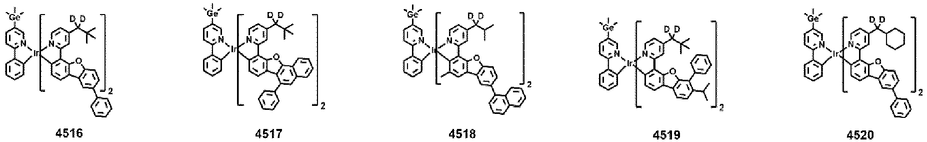

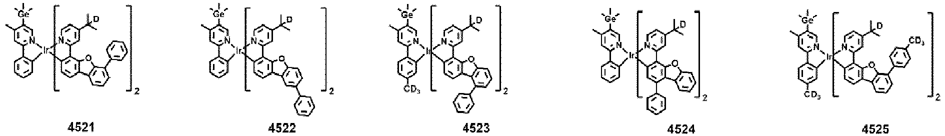

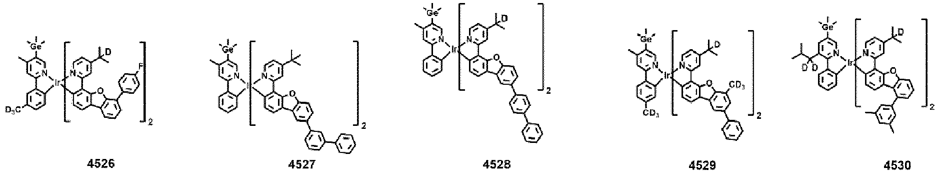

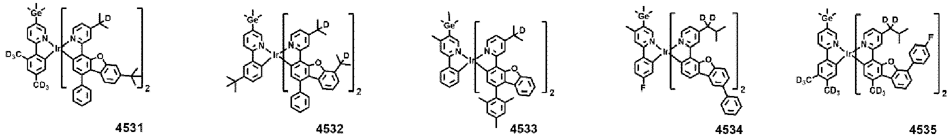

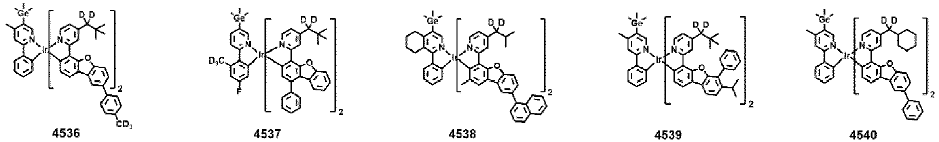

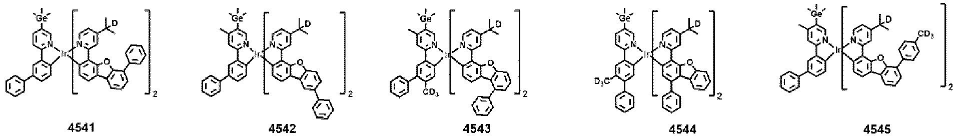

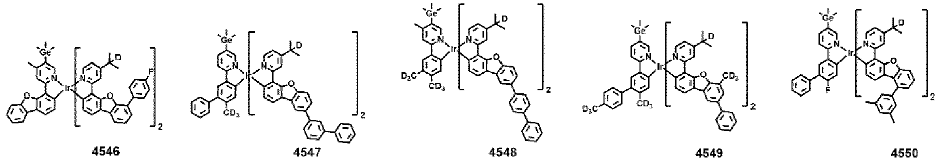

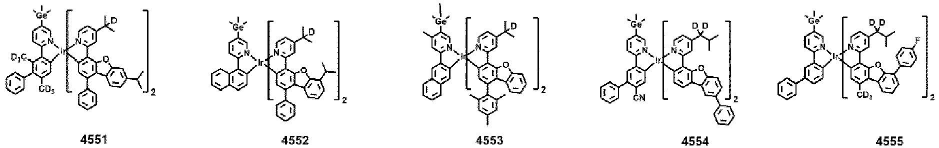

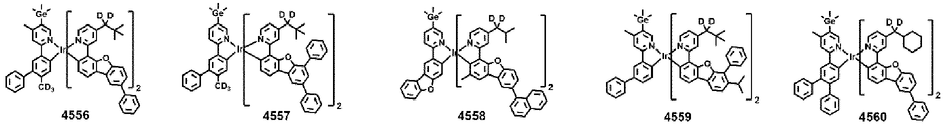

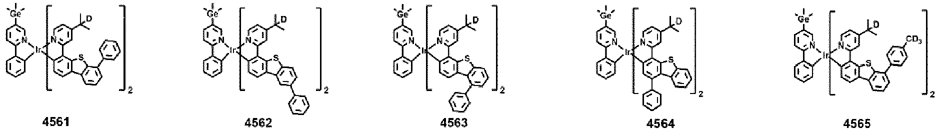

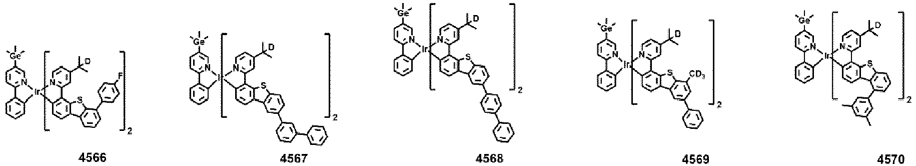

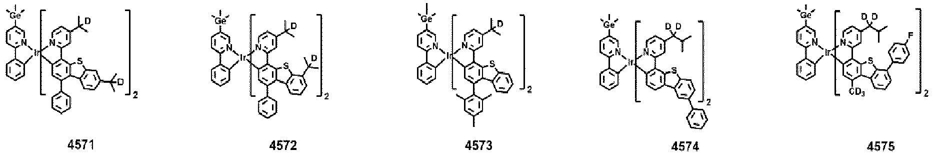

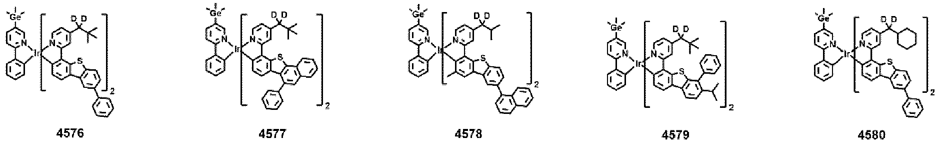

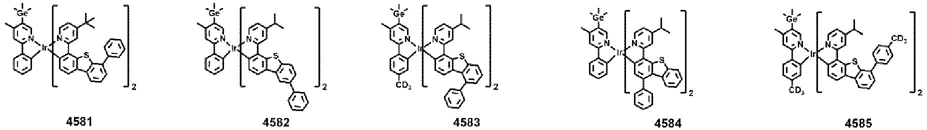

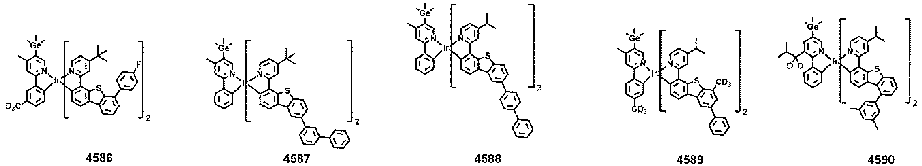

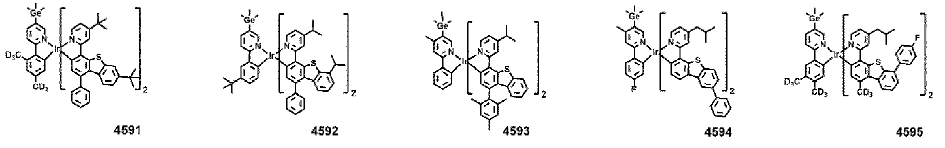

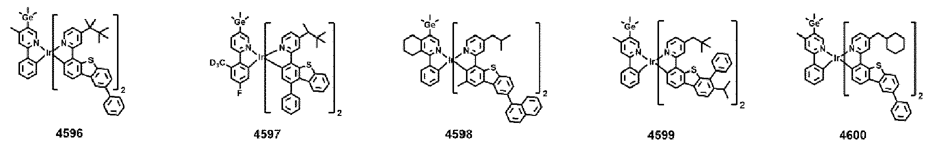

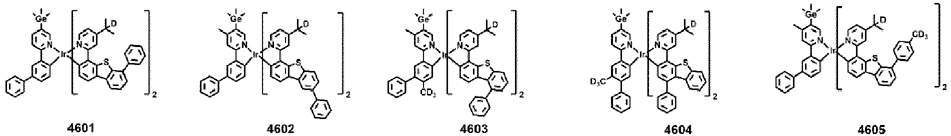

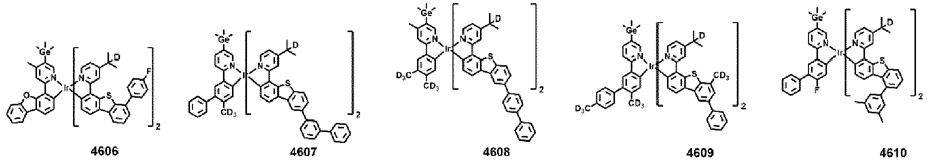

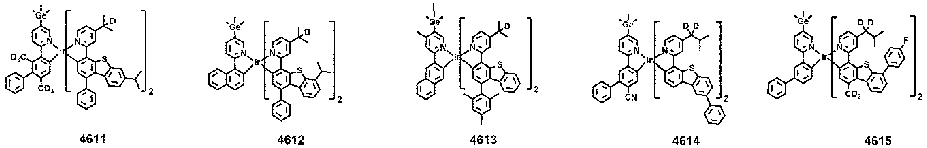

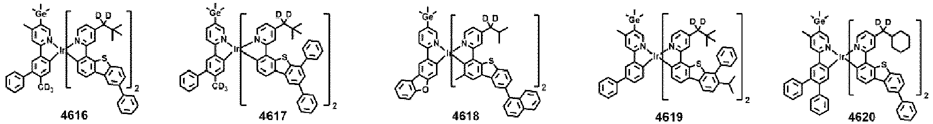

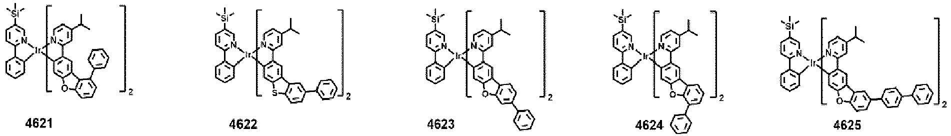

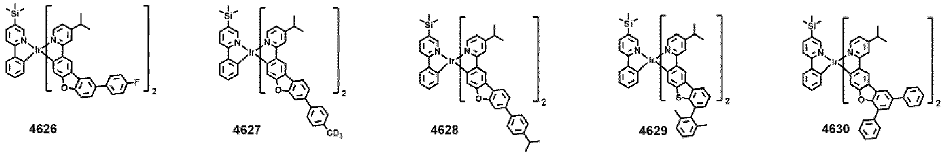

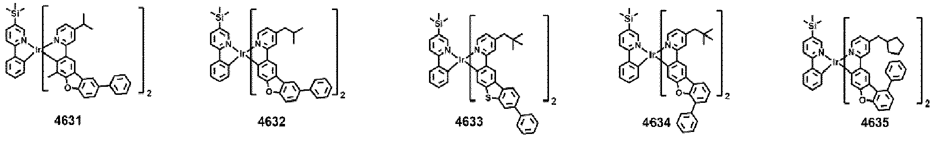

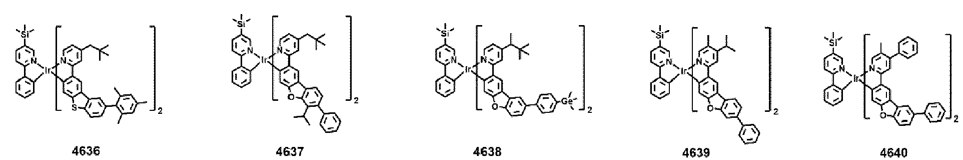

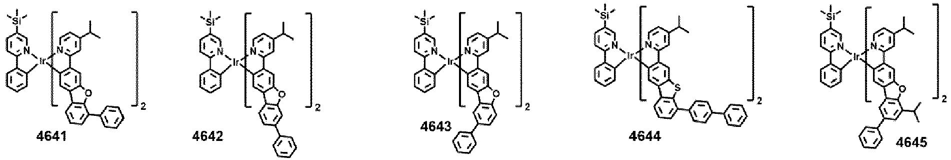

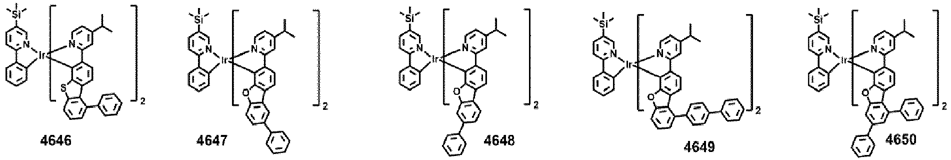

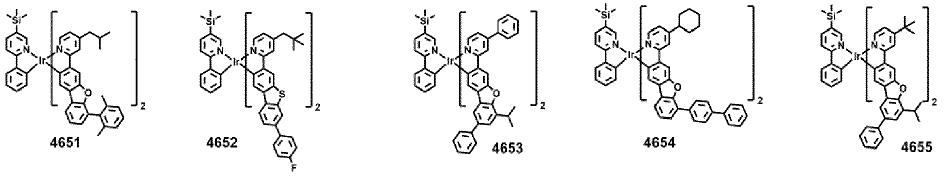

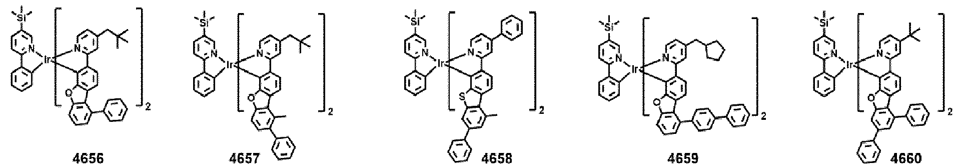

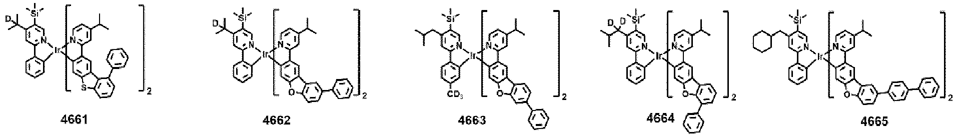

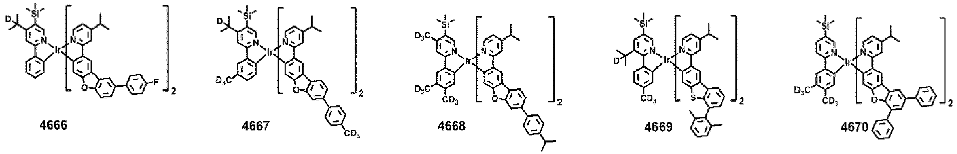

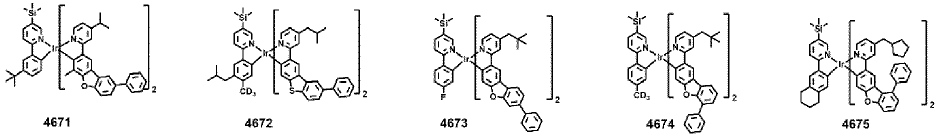

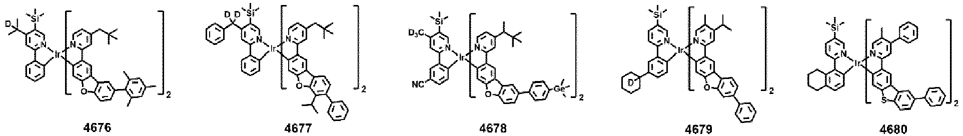

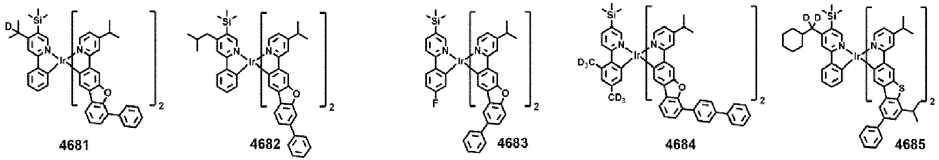

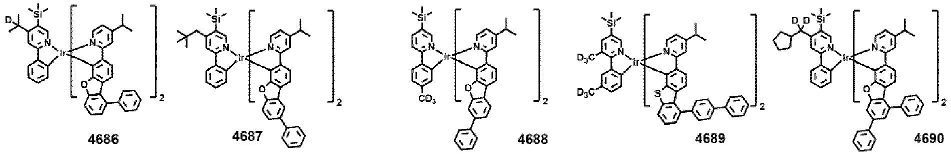

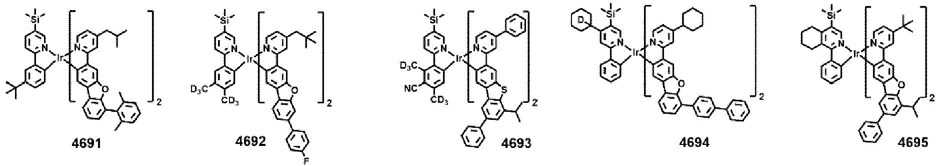

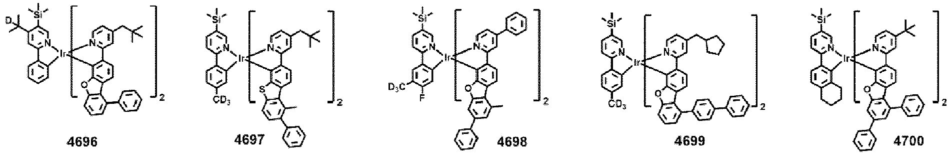

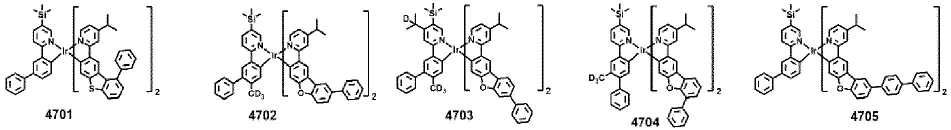

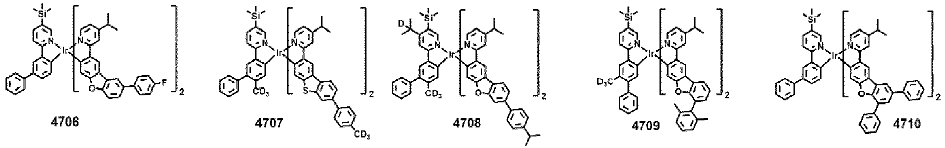

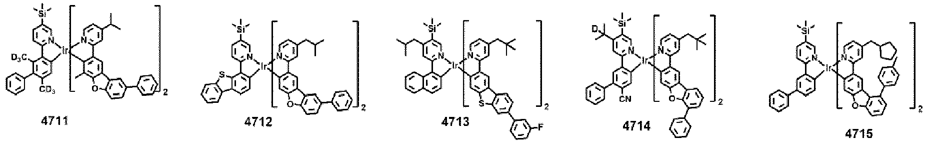

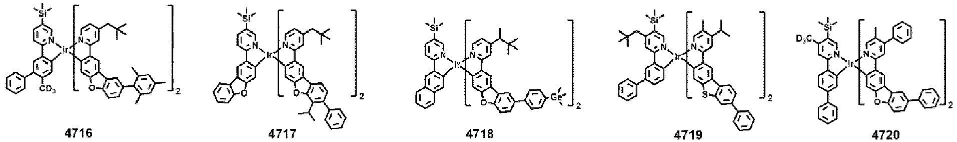

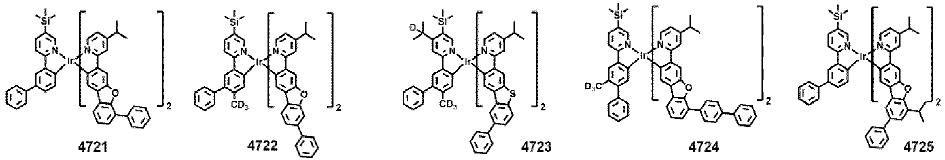

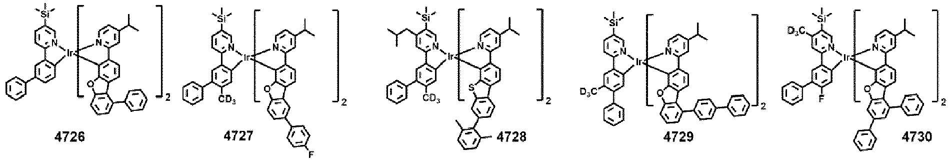

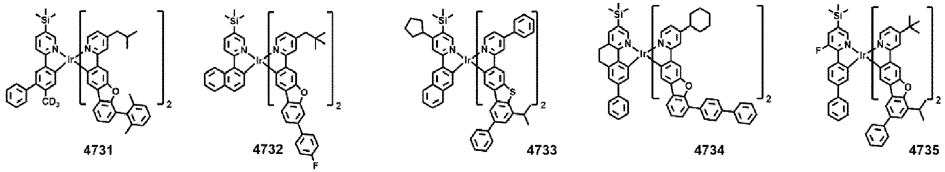

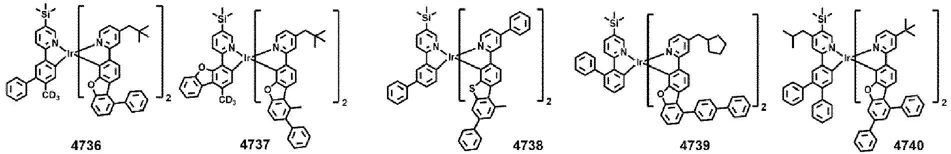

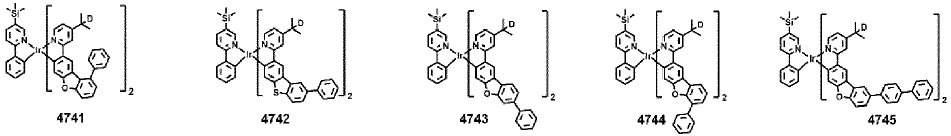

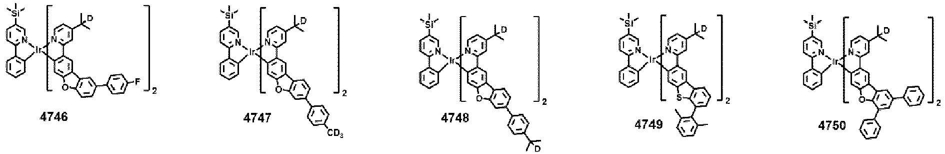

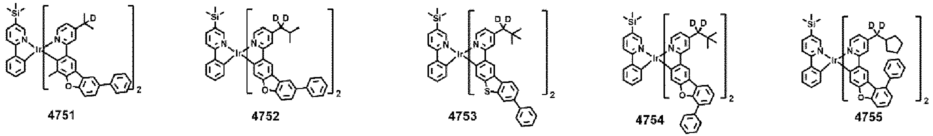

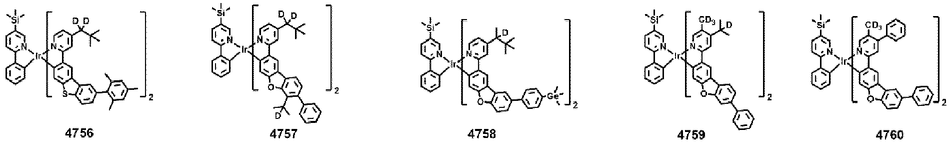

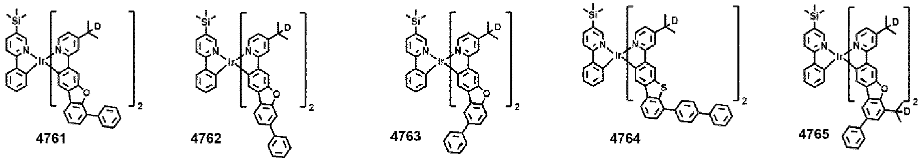

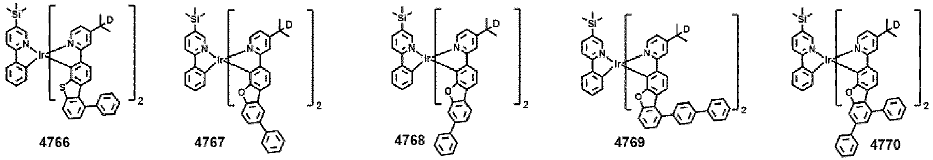

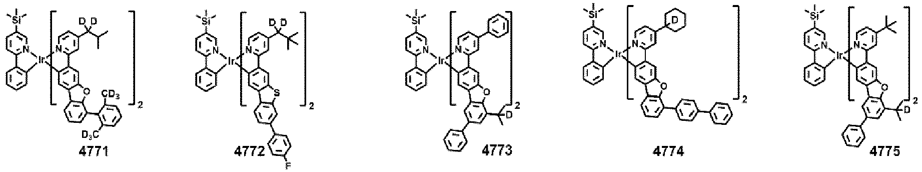

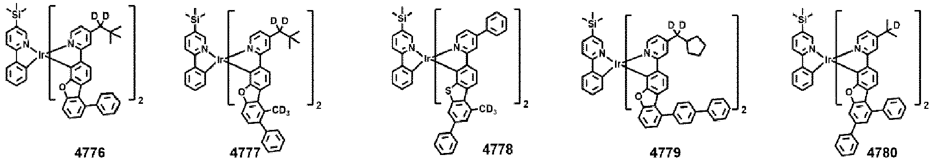

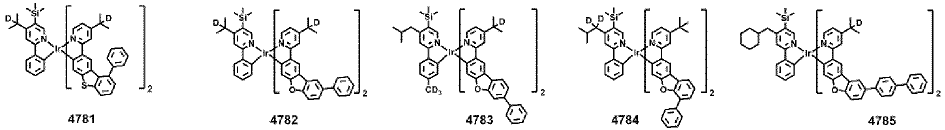

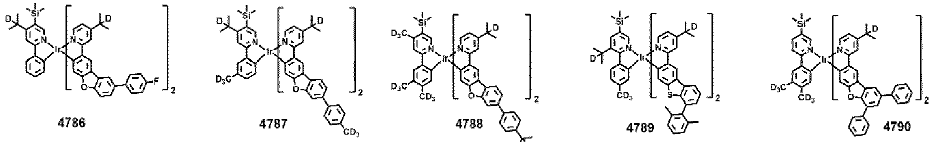

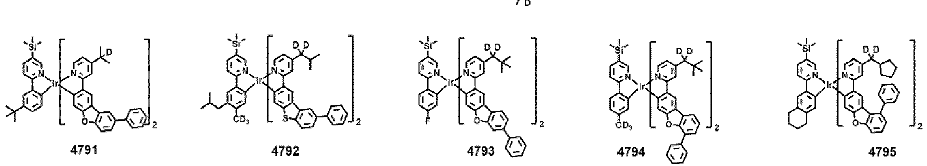

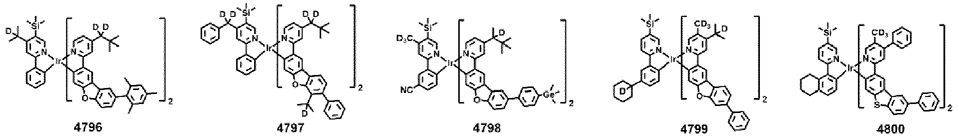

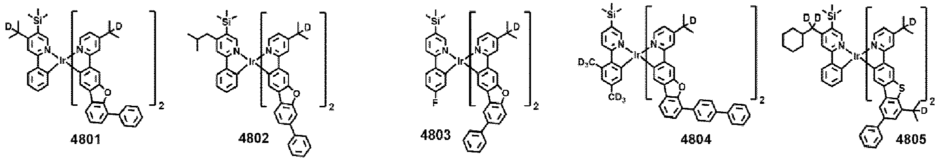

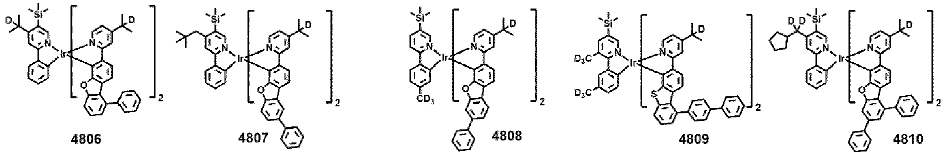

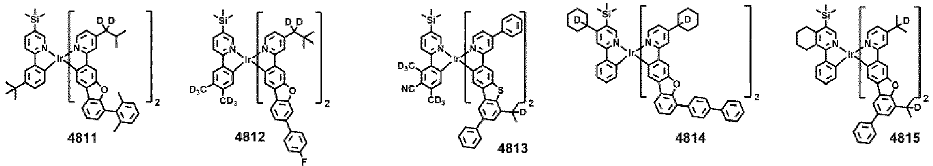

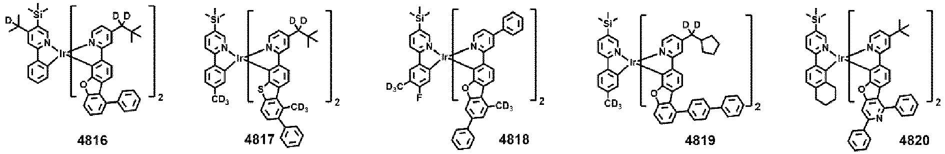

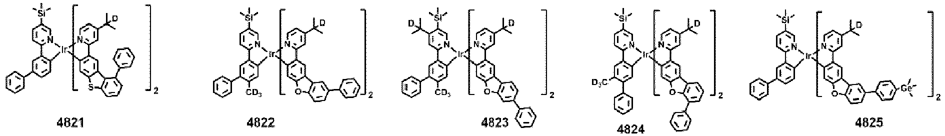

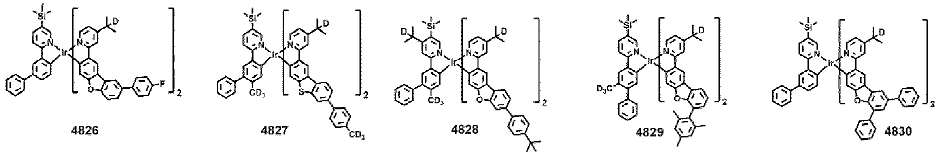

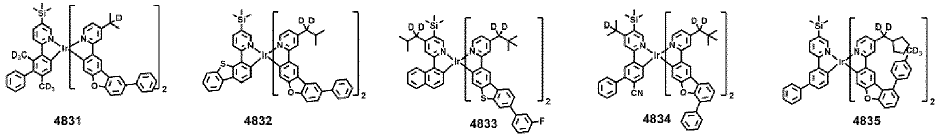

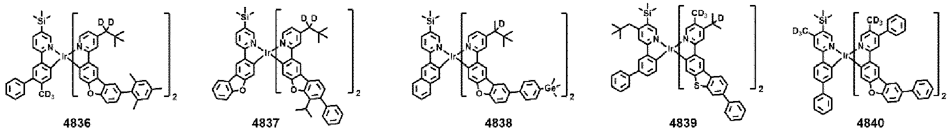

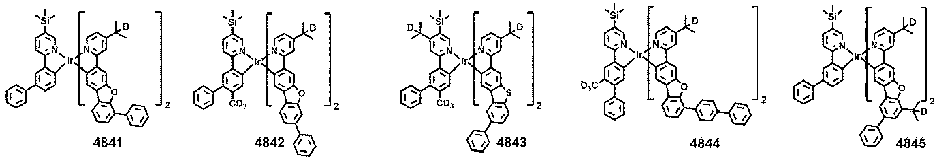

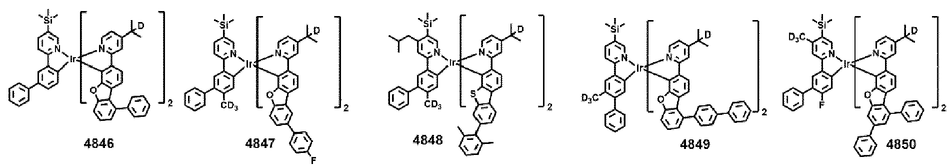

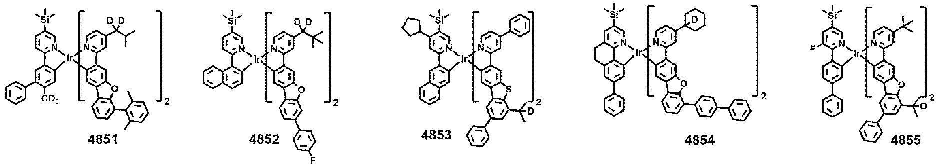

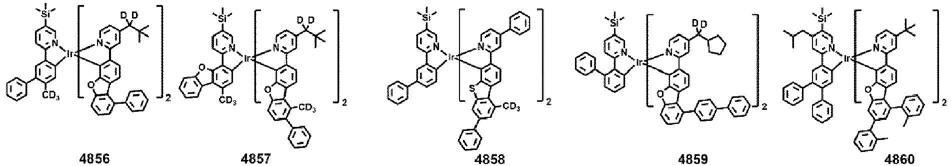

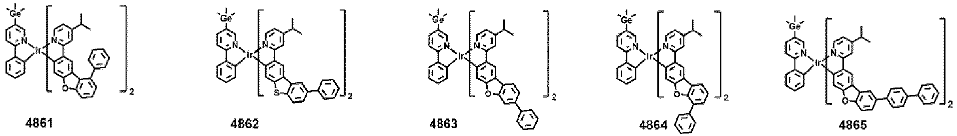

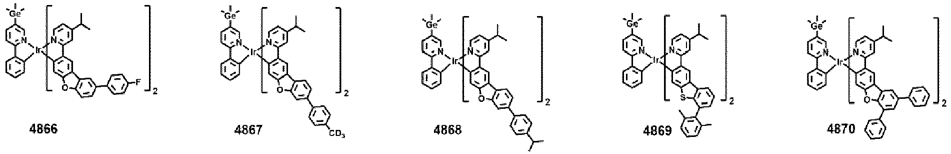

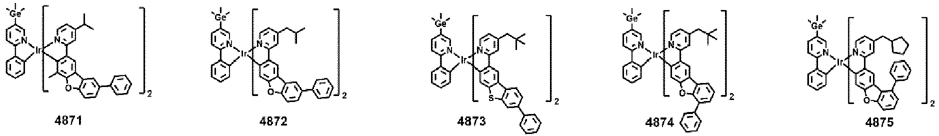

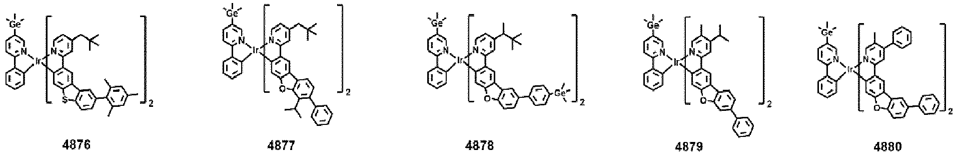

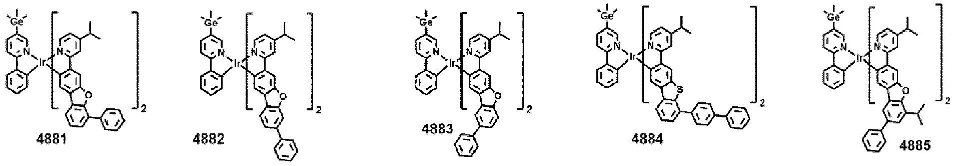

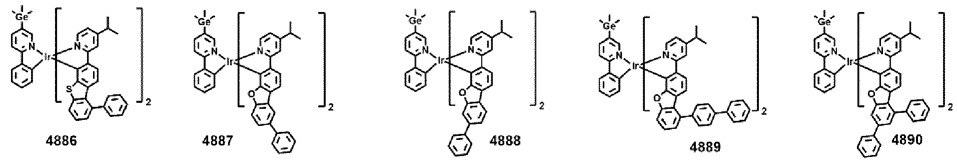

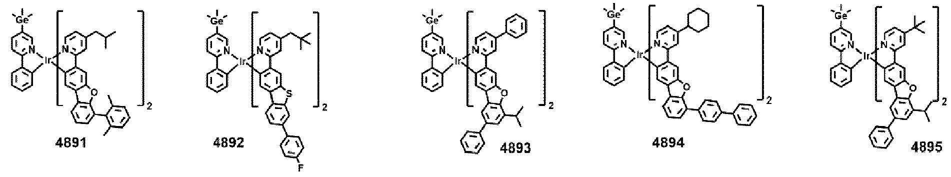

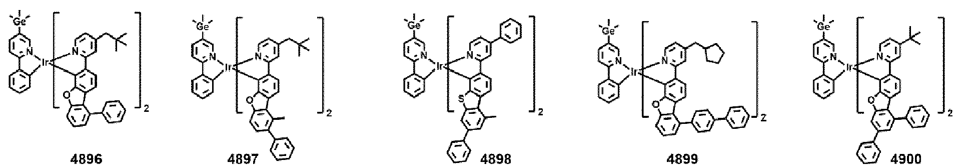

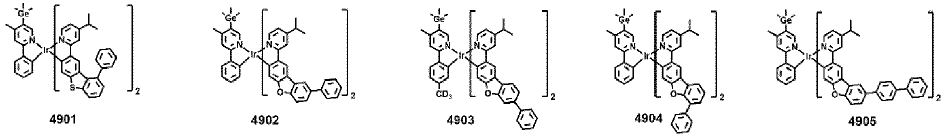

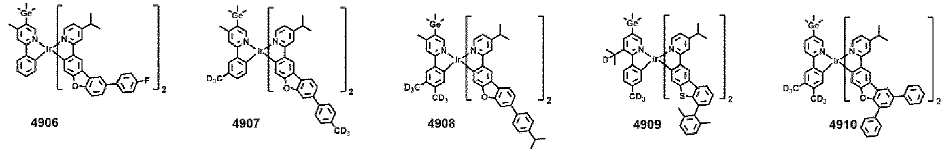

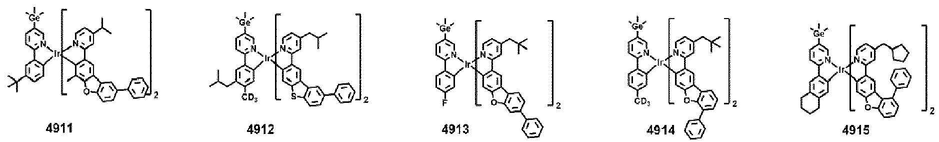

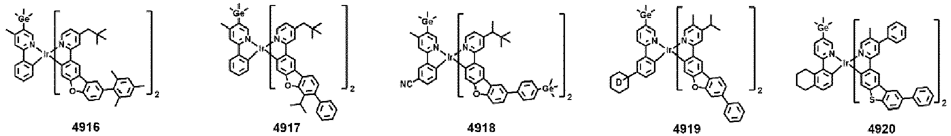

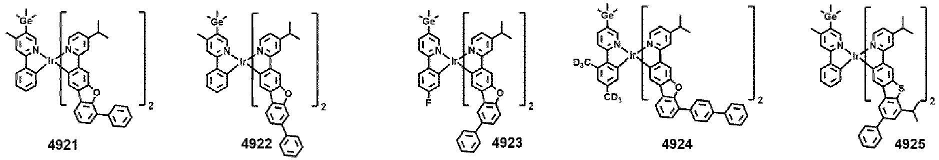

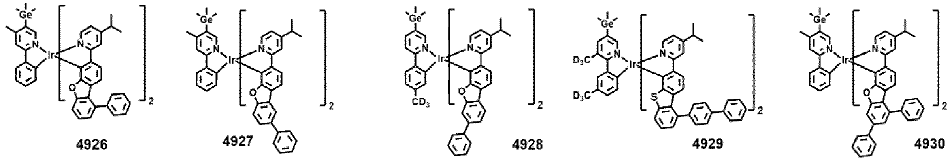

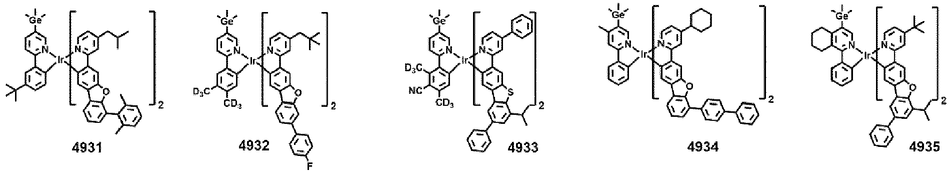

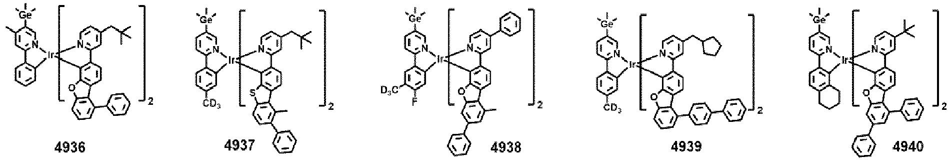

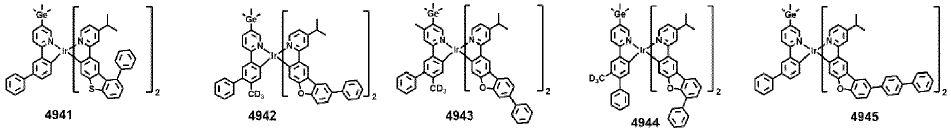

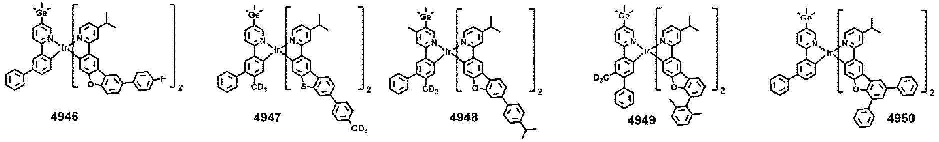

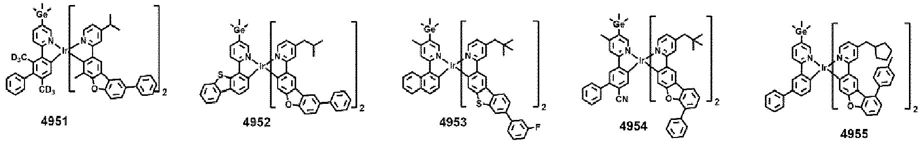

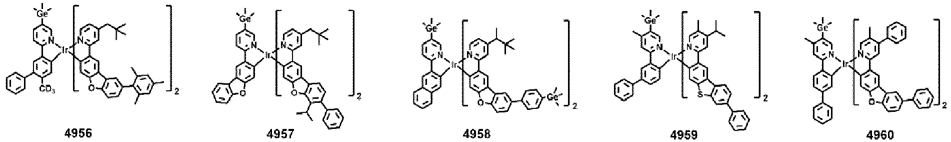

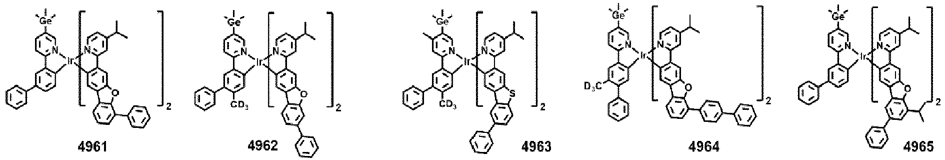

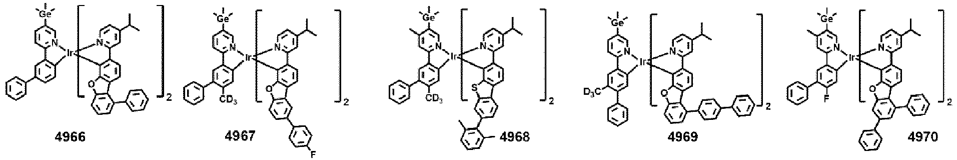

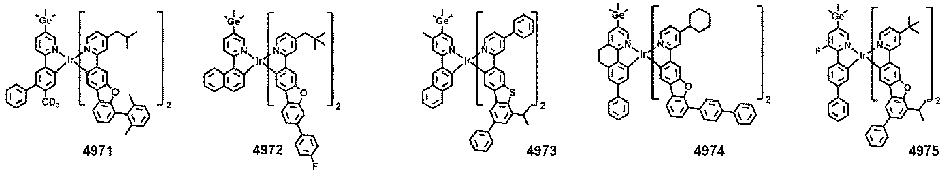

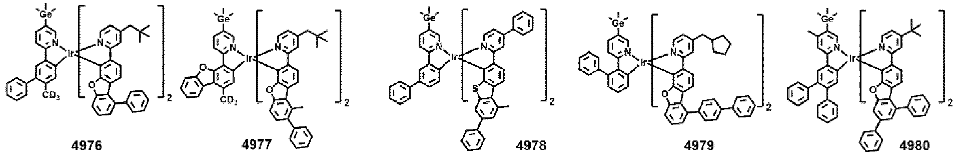

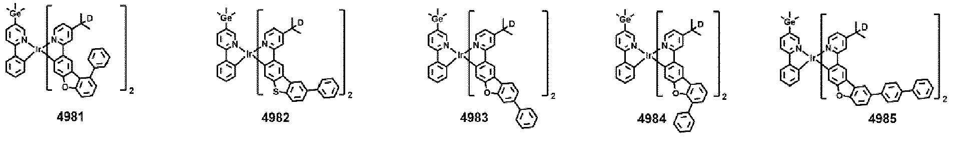

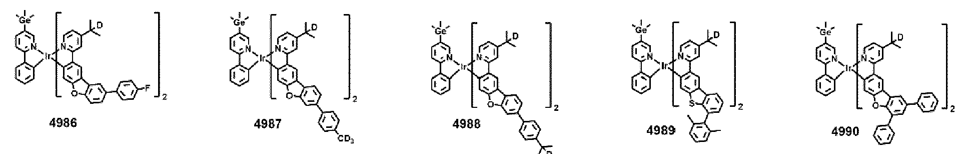

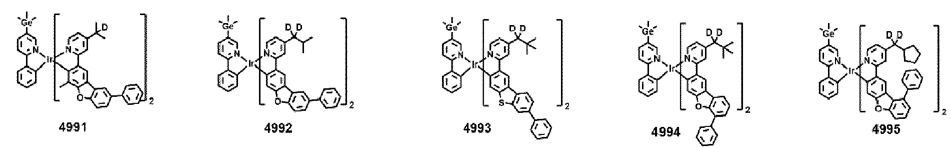

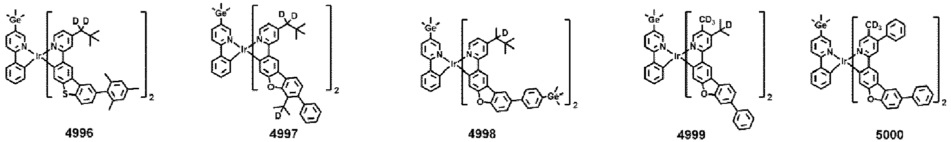

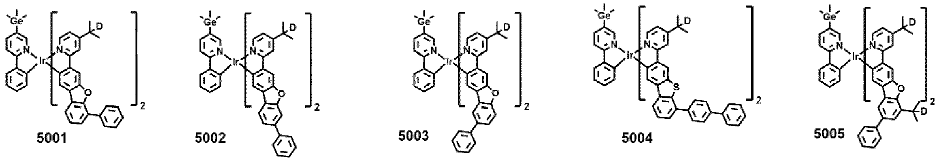

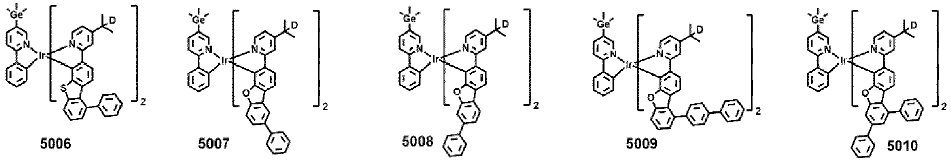

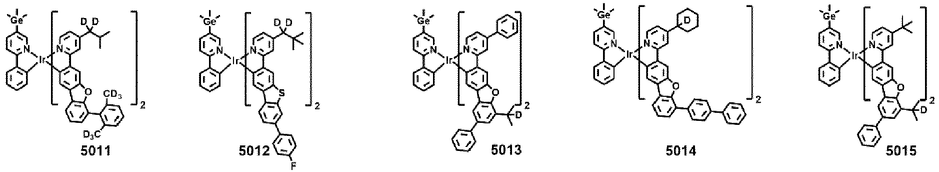

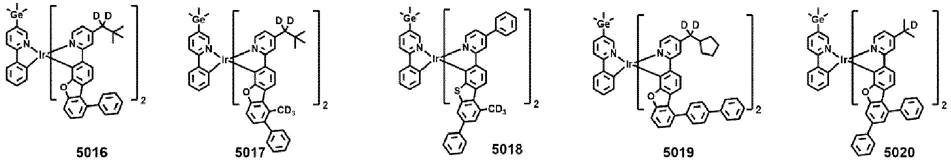

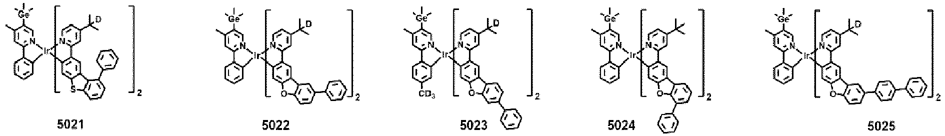

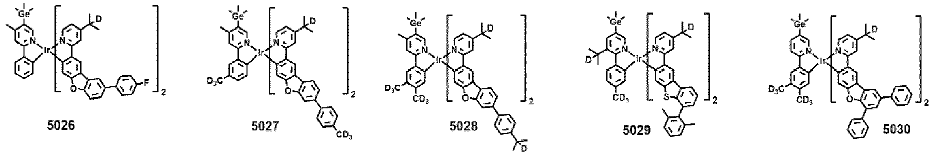

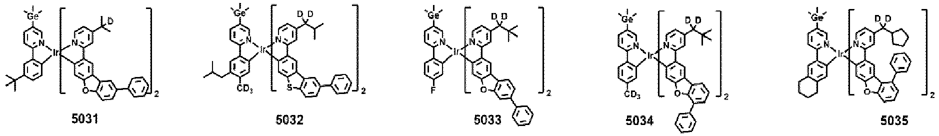

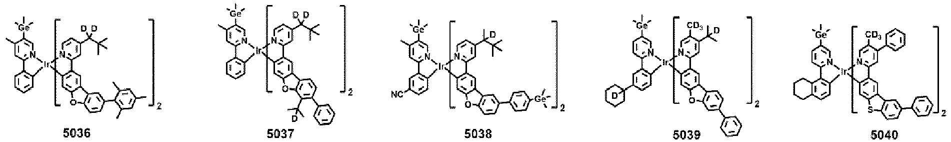

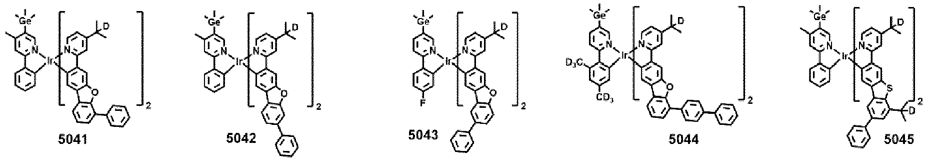

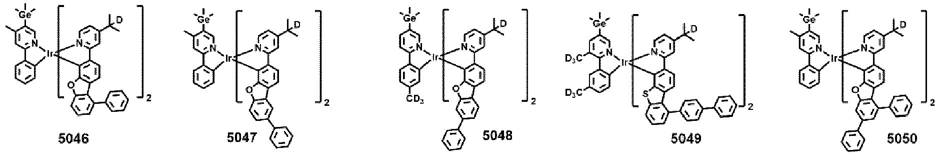

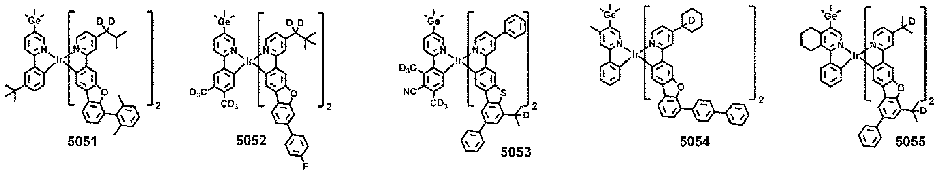

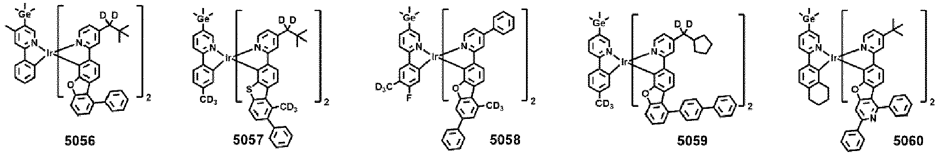

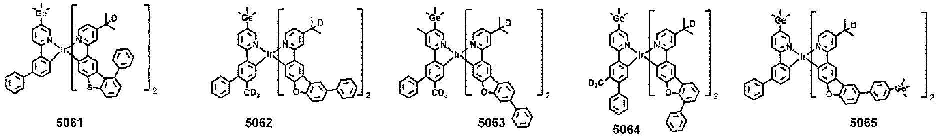

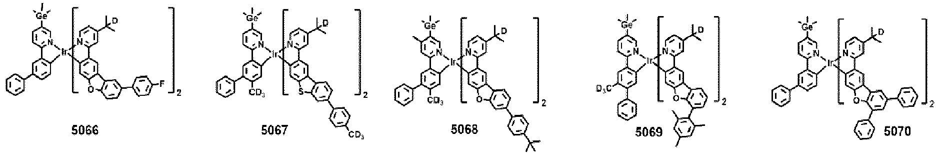

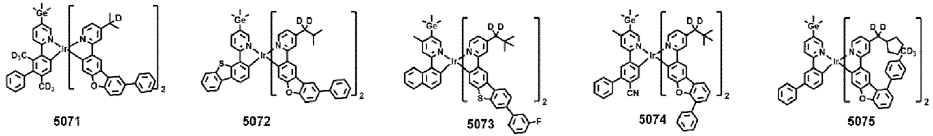

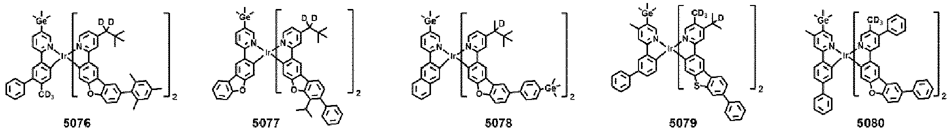

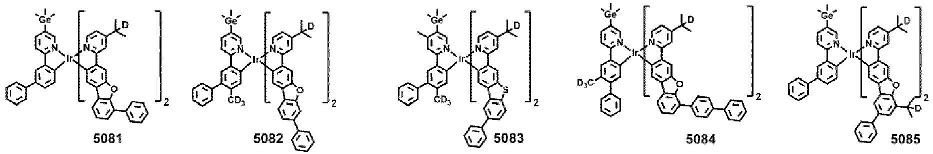

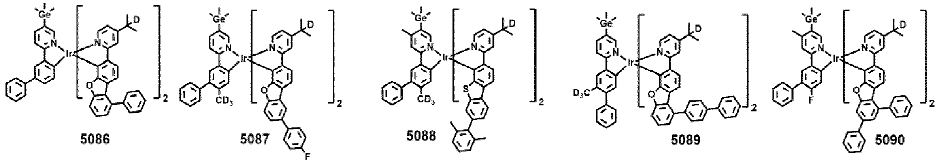

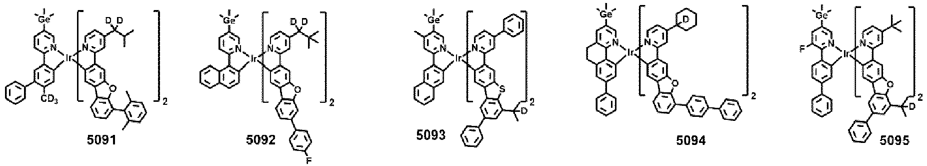

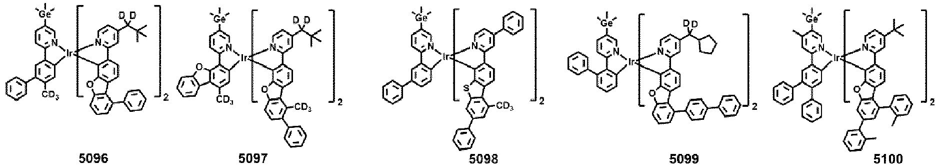

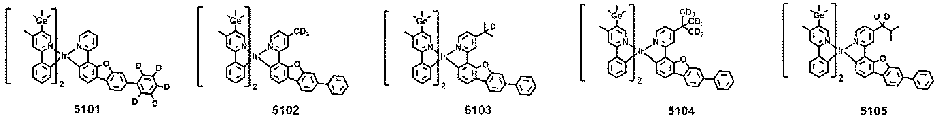

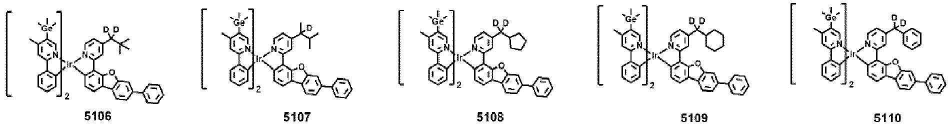

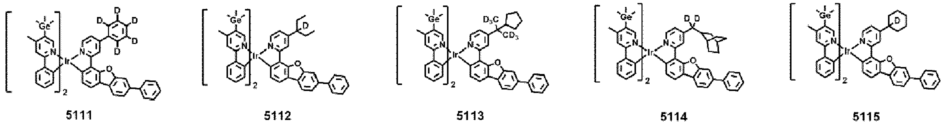

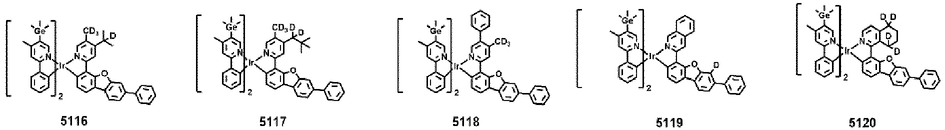

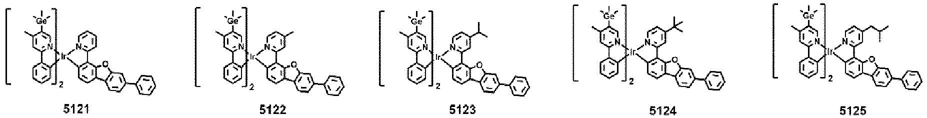

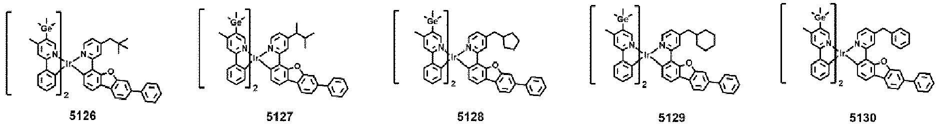

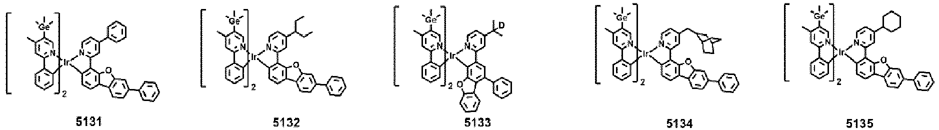

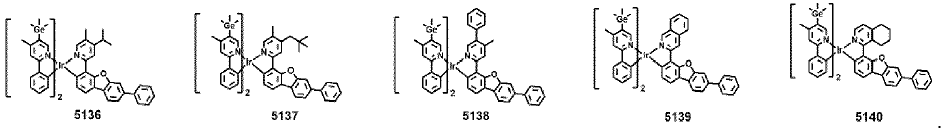

In the organometallic compound represented by Formula 1, L₁ may be a ligand represented by Formula 2A, n1, i.e., the number of L₁(s), may be 1 or 2, L₂ may be a ligand represented by Formula 2B, n2, i.e., the number of L₂(s) may be 1 or 2, and L₁ and L₂ may be different from each other. That is, the organometallic compound may be heteropeltic complex that may essentially include, as ligands bound to metal M, at least one ligand represented by Formula 2A and at least one ligand represented by Formula 2B.

In Formula 1, a group represented by *-X₁(R₂₁)(R₂₂)(R₂₃) may be bound to the 5'-position of a pyridine ring in the ligand represented by Formula 2B (see Formula 2B). Accordingly, the organometallic compound including the ligand represented by Formula 2B may have excellent heat resistance and decomposition resistance. Therefore, an electronic device, e.g., an organic light-emitting device, including the organometallic compound may have excellent stability and long lifespan upon manufacture, storage, and/or driving.

Ar₂ in Formula 2A of Formula 1 may be ring CY₂ unsubstituted or substituted with at least one Z₀, and ring CY₂ may be an unsaturated C₅-C₃₀ carbocyclic group or an unsaturated C₁-C₃₀ heterocyclic group, and d2, i.e., the number of Ar₂, may be an integer from 1 to 6. Thus, the organometallic compound represented by Formula 1 may have improved optical orientation characteristics, and the organometallic compound represented by Formula 1 may have a relatively narrow full width at half maximum (FWHM) of an emission spectrum or electroluminescence spectrum, and accordingly, an electronic device, e.g., an organic light-emitting device, including the organometallic compound may have improved emission efficiency.

In addition, the number of N(s) among T₁ to T₈ in Formula 2A of Formula 1 may be 0 or 1. Thus, the organometallic compound represented by Formula 1 may have stable highest occupied molecular orbital (HOMO) and lowest unoccupied molecular orbital (LUMO) energy levels, which lead to improved lifespan of an electronic device, e.g., an organic light-emitting device, including the organometallic compound.

The HOMO energy level, LUMO energy level, S₁ energy level, and T₁ energy level of some of the organometallic compounds represented by Formula 1 were evaluated by using Gaussian 09 that performs molecular structure optimizations according to density functional theory (DFT) at a degree of B3LYP. The results thereof are shown in Table 1.

**Table 1**

| Compound No. | HOMO (eV) | LUMO (eV) | S₁ (eV) | T₁ (eV) |
|---|---|---|---|---|
| 21 | -4.757 | -1.273 | 2.821 | 2.461 |
| 46 | -4.718 | -1.241 | 2.826 | 2.487 |
| 403 | -4.751 | -1.235 | 2.852 | 2.482 |
| 487 | -4.722 | -1.217 | 2.856 | 2.488 |
| 1657 | -4.799 | -1.222 | 2.928 | 2.516 |
| 2376 | -4.690 | -1.178 | 2.854 | 2.507 |
| 3272 | -4.793 | -1.217 | 2.890 | 2.525 |
| 3803 | -4.784 | -1.257 | 2.861 | 2.489 |

Referring to the results of Table 1, the organometallic compound represented by Formula 1 was found to have suitable electrical characteristics for use as a dopant in an electronic device, e.g., an organic light-emitting device.

A method of synthesizing the organometallic compound represented by Formula 1 may be apparent to one of ordinary skill in the art by referring to Synthesis Examples provided herein.

The organometallic compound represented by Formula 1 may be suitable for use in an organic layer of an organic light-emitting device, e.g., as a dopant in the organic layer. Thus, according to another aspect, there is provided an organic light-emitting device that may include a first electrode; a second electrode; and an organic layer located between the first electrode and the second electrode and including an emission layer, wherein the organic layer may include at least one organometallic compound represented by Formula 1.

Since the organic light-emitting device has an organic layer including the organometallic compound represented by Formula 1, the organic light-emitting device may have a high external quantum efficiency and high lifespan characteristics.

The organometallic compound represented by Formula 1 may be used in a pair of electrodes of an organic light-emitting device. For example, the organometallic compound represented by Formula 1 may be included in the emission layer. In this embodiment, the organometallic compound may serve as a dopant and the emission layer may further include a host (that is, an amount of the organometallic compound represented by Formula 1 may be smaller than that of the host). The emission layer, for example, may emit green light or blue light.

As used herein, the expression the "(organic layer) includes at least one organometallic compound" may be construed as meaning the "(organic layer) may include one organometallic compound of Formula 1 or two different organometallic compounds of Formula 1".

For example, Compound 1 may only be included in the organic layer as an organometallic compound. In this embodiment, Compound 1 may be included in the emission layer of the organic light-emitting device. In some embodiments, Compounds 1 and 2 may be included in the organic layer as organometallic compounds. In this embodiment, Compounds 1 and 2 may both be included in the same layer (for example, both Compounds 1 and 2 may be included in the emission layer).

The first electrode may be an anode, which is a hole injection electrode, and the second electrode may be a cathode, which is an electron injection electrode. In some embodiments, the first electrode may be a cathode, which is an electron injection electrode, and the second electrode may be an anode, which is a hole injection electrode.

For example, in the organic light-emitting device, the first electrode may be an anode, the second electrode may be a cathode, and the organic layer may further include a hole transport region between the first electrode and the emission layer and an electron transport region between the emission layer and the second electrode, wherein the hole transport region may include a hole injection layer, a hole transport layer, an electron blocking layer, a buffer layer, or a combination thereof, and the electron transport region may include a hole blocking layer, an electron transport layer, an electron injection layer, or a combination thereof.

The term "organic layer" as used herein refers to a single and/or a plurality of layers between the first electrode and the second electrode in an organic light-emitting device. The "organic layer" may include not only organic compounds but also organometallic complexes including metals.

FIG. 1 illustrates a schematic cross-sectional view of an organic light-emitting device 10 according to an embodiment. Hereinafter, a structure of an organic light-emitting device according to one or more embodiments and a method of manufacturing the organic light-emitting device will be described with reference to FIG. 1. The organic light-emitting device 10 may include a first electrode 11, an organic layer 15, and a second electrode 19, which may be sequentially layered in this stated order.

A substrate may be additionally disposed under the first electrode 11 or on the second electrode 19. The substrate may be a conventional substrate used in organic light-emitting devices, e.g., a glass substrate or a transparent plastic substrate, each having excellent mechanical strength, thermal stability, transparency, surface smoothness, ease of handling, and water repellency.

The first electrode 11 may be formed by depositing or sputtering, onto the substrate, a material for forming the first electrode 11. The first electrode 11 may be an anode. The material for forming the first electrode 11 may include a material with a high work function for easy hole injection. The first electrode 11 may be a reflective electrode, a semi-transmissive electrode, or a transmissive electrode. The material for forming the first electrode 11 may be indium tin oxide (ITO), indium zinc oxide (IZO), tin oxide (SnO₂), or zinc oxide (ZnO). In some embodiments, the material for forming the first electrode 110 may be a metal, such as magnesium (Mg), aluminum (Al), silver (Ag), aluminum-lithium (Al-Li), calcium (Ca), magnesium-indium (Mg-In), magnesium-silver (Mg-Ag), or the like.

The first electrode 11 may have a single-layered structure or a multi-layered structure including a plurality of layers. In some embodiments, the first electrode 11 may have a triple-layered structure of ITO/Ag/ITO.

The organic layer 15 may be on the first electrode 11.

The organic layer 15 may include a hole transport region, an emission layer, and an electron transport region.

The hole transport region may be between the first electrode 11 and the emission layer.

The hole transport region may include a hole injection layer, a hole transport layer, an electron blocking layer, a buffer layer, or a combination thereof.

The hole transport region may include a hole injection layer only or a hole transport layer only. In some embodiments, the hole transport region may include a hole injection layer and a hole transport layer which are sequentially stacked on the first electrode 11. In some embodiments, the hole transport region may include a hole injection layer, a hole transport layer, and an electron blocking layer, which are sequentially stacked on the first electrode 11.

When the hole transport region includes a hole injection layer, the hole injection layer may be formed on the first electrode 11 by using one or more suitable methods, such as vacuum deposition, spin coating, casting, and Langmuir-Blodgett (LB) deposition.

When a hole injection layer is formed by vacuum deposition, for example, the vacuum deposition may be performed at a deposition temperature in a range of about 100°C to about 500°C, at a vacuum degree in a range of about 10⁻⁸ torr to about 10⁻³ torr (1.3 × 10⁻⁶ Pa to 1.3 × 10⁻¹ Pa; 1 torr = 133 Pa) and at a deposition rate in a range of about 0.01 Angstroms per second (Å/sec) to about 100 Å/sec, though the conditions may vary depending on a compound that is used as a hole injection material and a structure and thermal properties of a desired hole injection layer.

When a hole injection layer is formed by spin coating, the spin coating may be performed at a coating rate in a range of about 2,000 revolutions per minute (rpm) to about 5,000 rpm, and at a temperature in a range of about 80°C to 200°C, to facilitate removal of a solvent after the spin coating, though the conditions may vary depending on a compound that is used as a hole injection material and a structure and thermal properties of a desired hole injection layer.

The conditions for forming a hole transport layer and an electron blocking layer may be inferred from the conditions for forming the hole injection layer.

The hole transport region may include m-MTDATA, TDATA, 2-TNATA, NPB, β-NPB, TPD, spiro-TPD, spiro-NPB, methylated-NPB, TAPC, HMTPD, 4,4',4"-tris(N-carbazolyl)triphenylamine (TCTA), polyaniline/dodecylbenzenesulfonic acid (PANI/DBSA), poly(3,4-ethylenedioxythiophene)/poly(4-styrenesulfonate) (PEDOT/PSS), polyaniline/camphor-sulfonic acid (PANI/CSA), polyaniline/poly(4-styrene sulfonate) (PANI/PSS), a compound represented by Formula 201, a compound represented by Formula 202, or any combination thereof: 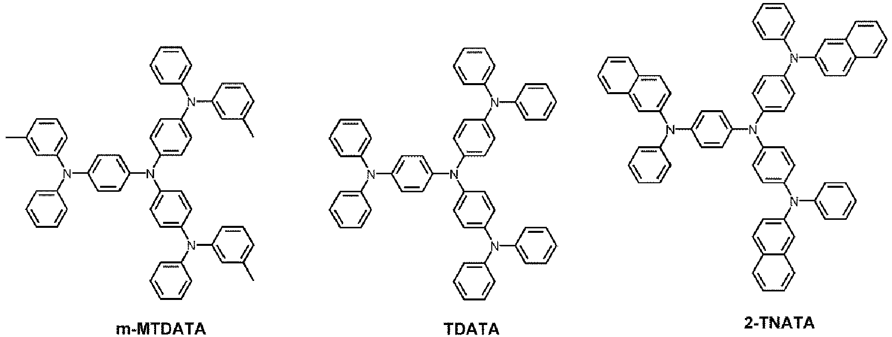 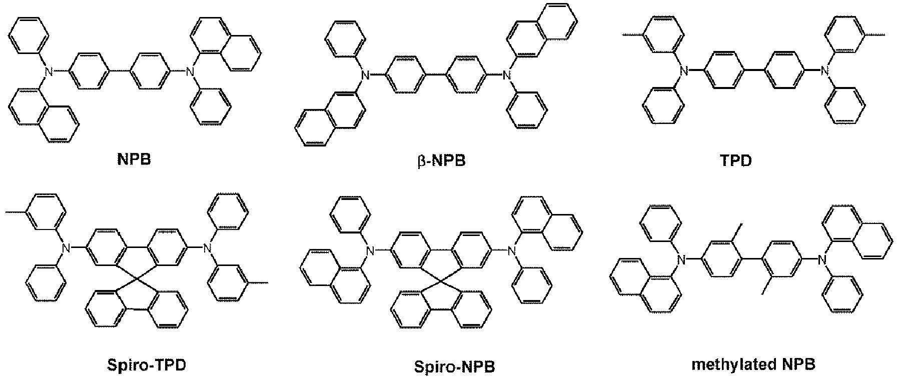 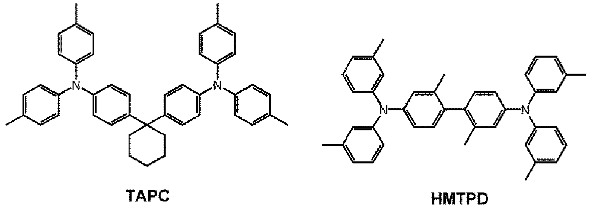 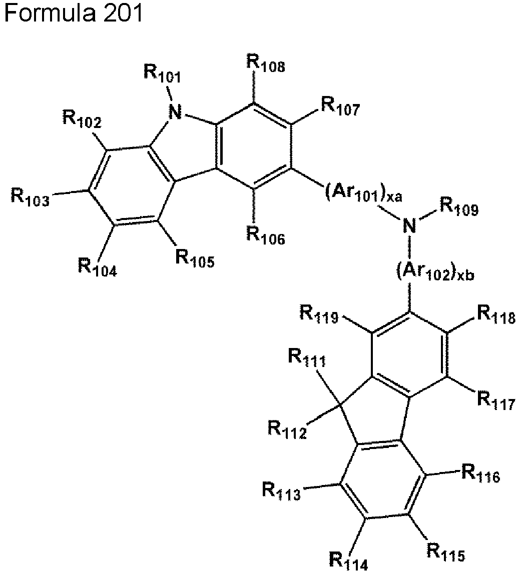 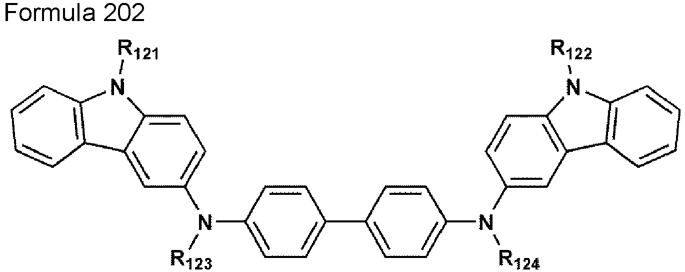 wherein, in Formula 201, Ar₁₀₁ and Ar₁₀₂ may each independently be a phenylene group, a pentalenylene group, an indenylene group, a naphthylene group, an azulenylene group, a heptalenylene group, an acenaphthylene group, a fluorenylene group, a phenalenylene group, a phenanthrenylene group, an anthracenylene group, a fluoranthenylene group, a triphenylenylene group, a pyrenylene group, a chrysenylenylene group, a naphthacenylene group, a picenylene group, a perylenylene group, or a pentacenylene group, each unsubstituted or substituted with deuterium, -F, -Cl, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₆₀ alkyl group, a C₂-C₆₀ alkenyl group, a C₂-C₆₀ alkynyl group, a C₁-C₆₀ alkoxy group, a C₃-C₁₀ cycloalkyl group, a C₃-C₁₀ cycloalkenyl group, a C₁-C₁₀ heterocycloalkyl group, a C₁-C₁₀ heterocycloalkenyl group, a C₆-C₆₀ aryl group, a C₆-C₆₀ aryloxy group, a C₆-C₆₀ arylthio group, a C₁-C₆₀ heteroaryl group, a monovalent non-aromatic condensed polycyclic group, a monovalent non-aromatic condensed heteropolycyclic group, or any combination thereof.

In Formula 201, xa and xb may each independently be an integer from 0 to 5. In some embodiments, xa and xb may each independently be an integer from 0 to 2. In some embodiments, xa may be 1, and xb may be 0.

In Formulae 201 and 202, R₁₀₁ to R₁₀₈, R₁₁₁ to R₁₁₉, and R₁₂₁ to R₁₂₄ may each independently be:
hydrogen, deuterium, -F, -Cl, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₁₀ alkyl group (e.g., a methyl group, an ethyl group, a propyl group, a butyl group, pentyl group, or a hexyl group), or a C₁-C₁₀ alkoxy group (e.g., a methoxy group, an ethoxy group, a propoxy group, a butoxy group, or a pentoxy group);
a C₁-C₁₀ alkyl group or a C₁-C₁₀ alkoxy group, each unsubstituted or substituted with deuterium, -F, -Cl, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, or any combination thereof; or
a phenyl group, a naphthyl group, an anthracenyl group, a fluorenyl group, or a pyrenyl group, each unsubstituted or substituted with deuterium, -F, -Cl, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₁₀ alkyl group, a C₁-C₁₀ alkoxy group, or any combination thereof.

In Formula 201, R₁₀₉ may be a phenyl group, a naphthyl group, an anthracenyl group, or a pyridinyl group, each unsubstituted or substituted with deuterium, -F, -Cl, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₂₀ alkyl group, a C₁-C₂₀ alkoxy group, a phenyl group, a naphthyl group, an anthracenyl group, a pyridinyl group, or any combination thereof.

In some embodiments, the compound represented by Formula 201 may be represented by Formula 201A: 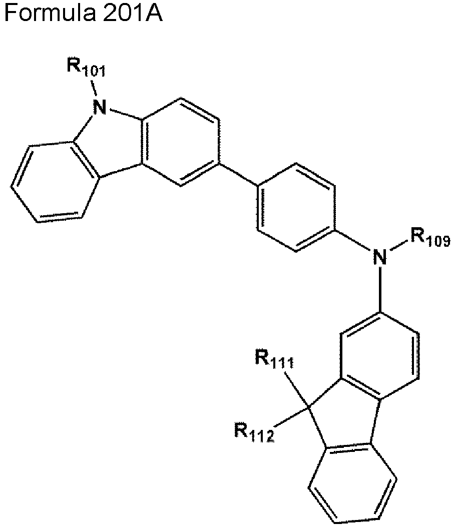 wherein, in Formula 201A, R₁₀₁, R₁₁₁, R₁₁₂, and R₁₀₉ may respectively be understood by referring to the descriptions of R₁₀₁, R₁₁₁, R₁₁₂, and R₁₀₉ provided herein.

In some embodiments, the hole transport region may include one of Compounds HT1 to HT20 or any combination thereof:

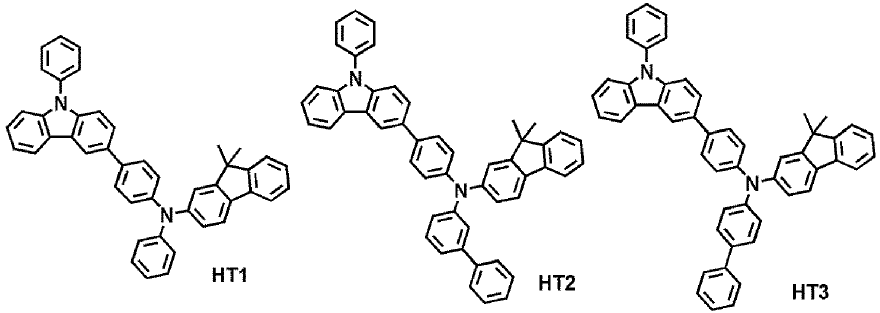

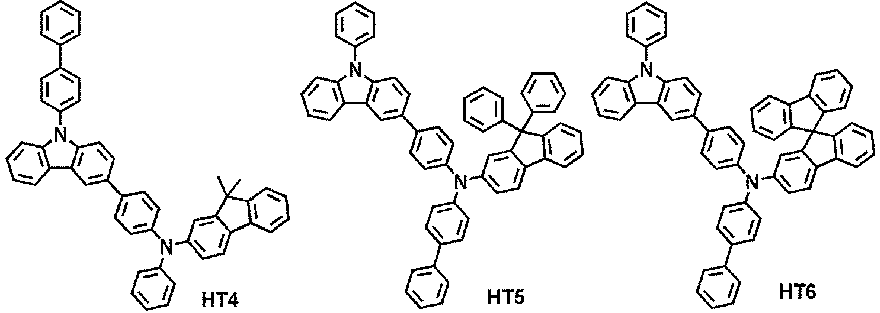

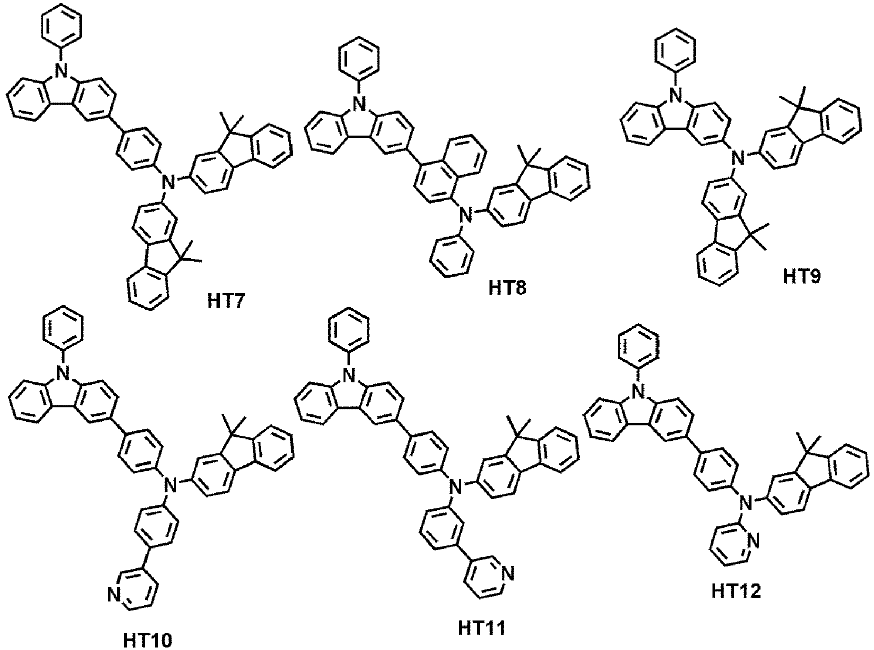

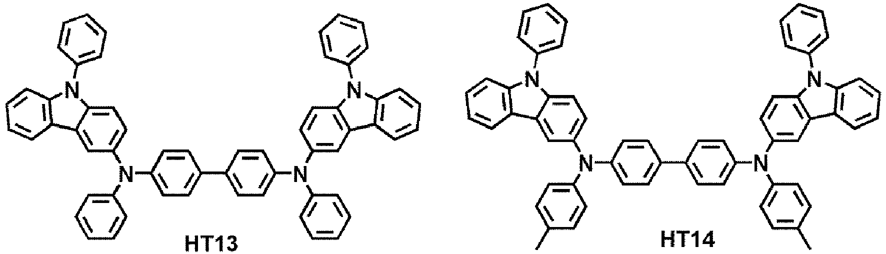

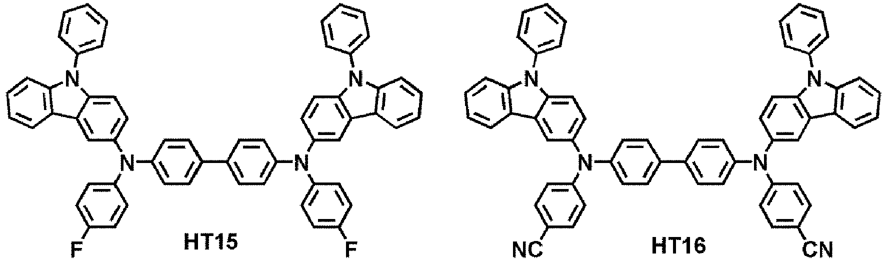

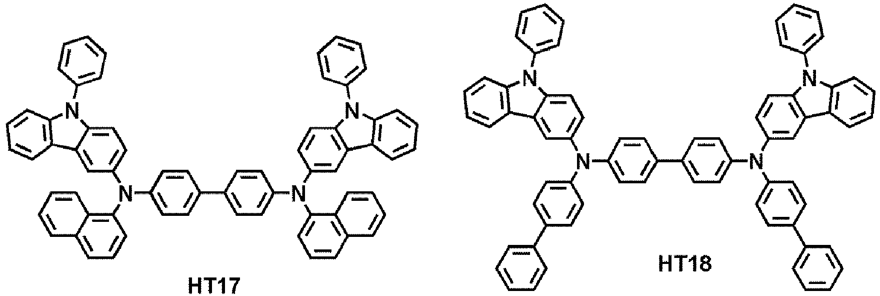

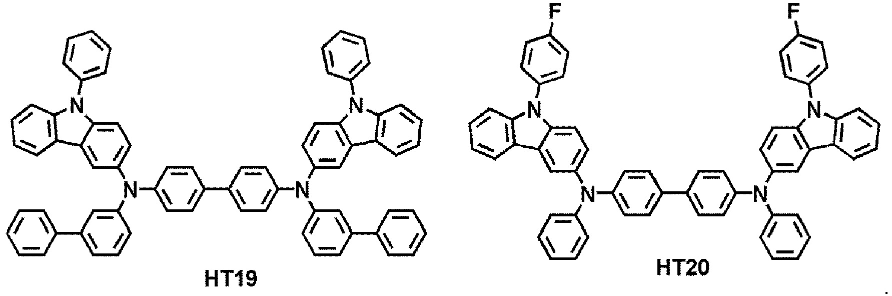

The thickness of the hole transport region may be in a range of about 100 (Angstroms) Å to about 10,000 Å, and in some embodiments, about 100 Å to about 1,000 Å. When the hole transport region includes a hole injection layer, a hole transport layer an electron blocking layer, or any combination thereof, the thickness of the hole injection layer may be in a range of about 100 Å to about 10,000 Å, and in some embodiments, about 100 Å to about 1,000 Å, and the thickness of the hole transport layer may be in a range of about 50 Å to about 2,000 Å, and in some embodiments, about 100 Å to about 1,500 Å. When the thicknesses of the hole transport region, the hole injection layer, and the hole transport layer are within any of these ranges, excellent hole transport characteristics may be obtained without a substantial increase in driving voltage.

The hole transport region may include a charge generating material as well as the aforementioned materials, to improve conductive properties of the hole transport region. The charge generating material may be substantially homogeneously or non-homogeneously dispersed in the hole transport region.

The charge generating material may include, for example, a p-dopant. The p-dopant may be a quinone derivative, a metal oxide, a compound containing a cyano group, or any combination thereof. In some embodiments, the p-dopant may be a quinone derivative, such as tetracyanoquinodimethane (TCNQ), a 2,3,5,6-tetrafluorotetracyano-1,4-benzoquinonedimethane (F4-TCNQ), or F6-TCNNQ; a metal oxide, such as a tungsten oxide or a molybdenum oxide; a compound containing a cyano group, such as Compound HT-D1; or any combination thereof:

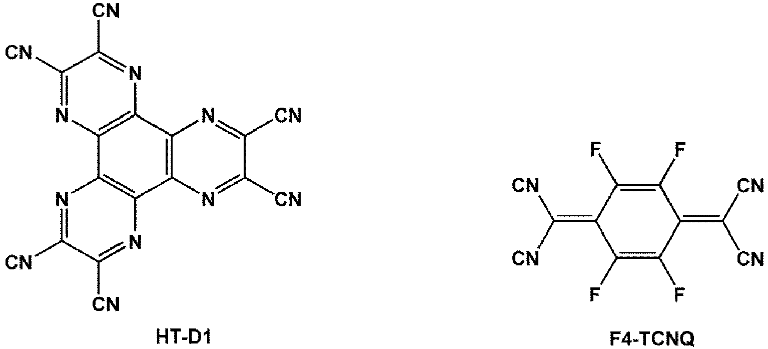

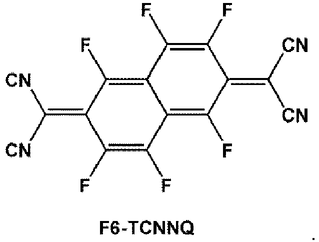

The hole transport region may further include a buffer layer.

The buffer layer may compensate for an optical resonance distance depending on a wavelength of light emitted from the emission layer to improve the efficiency of an organic light-emitting device.

When the hole transport region includes an electron blocking layer, a material for forming the electron blocking layer may include the material for forming a hole transport region, the host material described herein or any combination thereof. In some embodiments, when the hole transport region includes an electron blocking layer, mCP, Compound H-H1, etc. described herein or the like may be used for forming the electron blocking layer.

An emission layer may be formed on the hole transport region by using one or more suitable methods, such as vacuum deposition, spin coating, casting, or LB deposition. When the emission layer is formed by vacuum deposition or spin coating, vacuum deposition and coating conditions for forming the emission layer may be generally similar to those conditions for forming a hole injection layer, though the conditions may vary depending on a compound that is used.

The emission layer may include a host and a dopant, and the dopant may include the organometallic compound represented by Formula 1 described herein.

The host may include at least one selected from TPBi, TBADN, ADN (also known as "DNA"), CBP, CDBP, TCP, mCP, Compound H50, Compound H51, Compound H52, Compound H-H1, Compound H-E43, or any combination thereof:

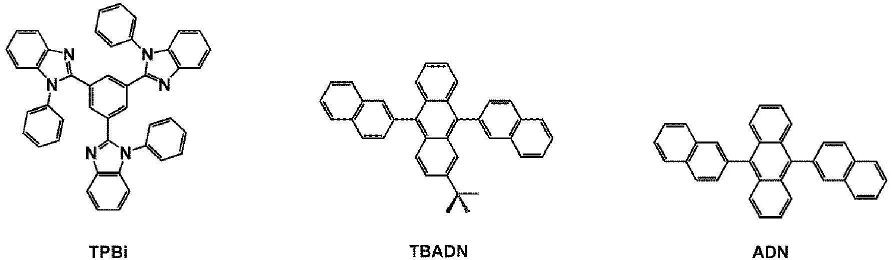

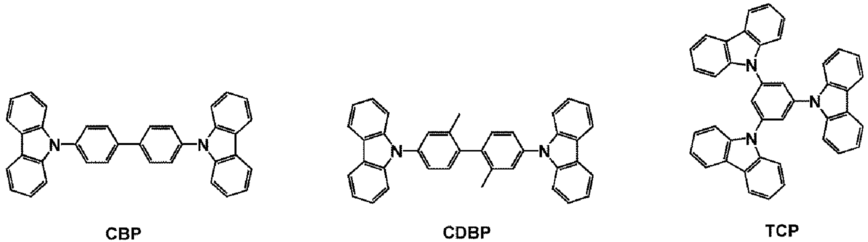

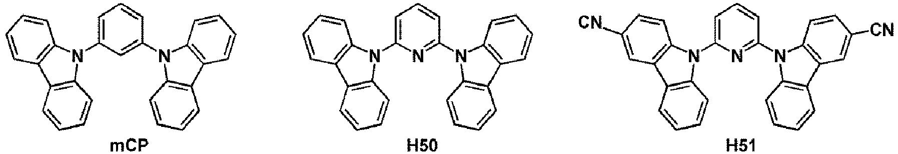

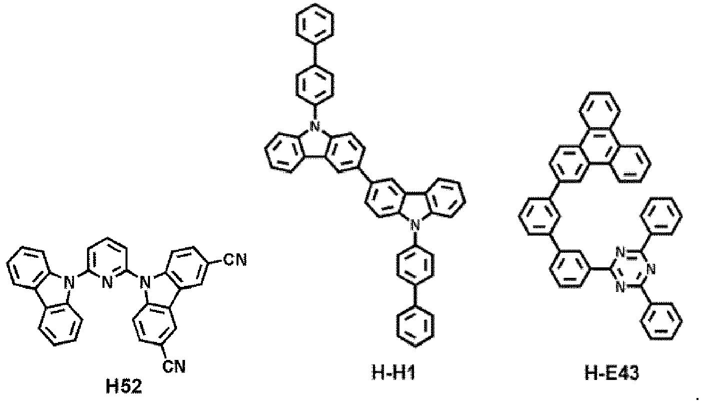

When the organic light-emitting device 10 is a full-color organic light-emitting device, the emission layer may be patterned into a red emission layer, a green emission layer, and/or a blue emission layer. In some embodiments, the emission layer may have a structure in which the red emission layer, the green emission layer, and/or the blue emission layer are layered to emit white light. In some embodiments, the structure of the emission layer may vary.

When the emission layer includes the host and the dopant, an amount of the dopant may be selected from a range of about 0.01 parts to about 15 parts by weight based on about 100 parts by weight of the host.

The thickness of the emission layer may be in a range of about 100 Å to about 1,000 Å, and in some embodiments, about 200 Å to about 600 Å. When the thickness of the emission layer is within any of these ranges, improved luminescence characteristics may be obtained without a substantial increase in driving voltage.

Next, an electron transport region may be formed on the emission layer.

The electron transport region may include a hole blocking layer, an electron transport layer, an electron injection layer, or a combination thereof.

In some embodiments, the electron transport region may have a hole blocking layer/an electron transport layer/an electron injection layer structure or an electron transport layer/an electron injection layer structure. The electron transport layer may have a single-layered structure or a multi-layered structure including two or more different materials.

The conditions for forming a hole blocking layer, an electron transport layer, and an electron injection layer may be inferred based on the conditions for forming the hole injection layer.

When the electron transport region includes a hole blocking layer, the hole blocking layer may include, for example, BCP, Bphen, BAlq, or any combination thereof:

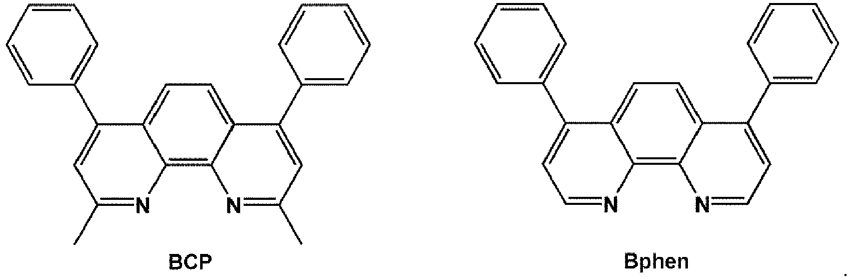

The thickness of the hole blocking layer may be in a range of about 20 Å to about 1,000 Å, and in some embodiments, about 30 Å to about 600 Å. When the thickness of the hole blocking layer is within any of these ranges, excellent hole blocking characteristics may be obtained without a substantial increase in driving voltage.

The electron transport layer may include BCP, Bphen, TPBi, Alq₃, BAlq, TAZ, NTAZ, or any combination thereof:

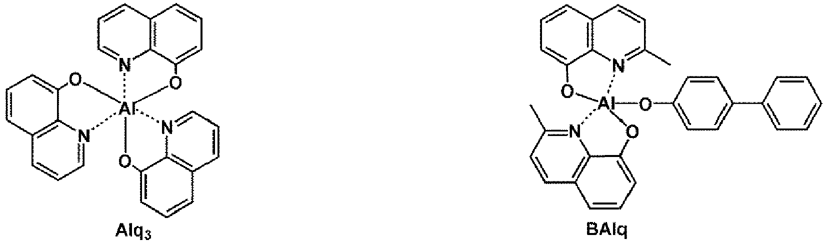

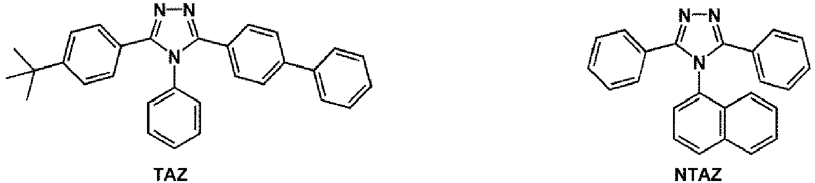

In some embodiments, the electron transport layer may include one of Compounds ET1 to ET25 or any combination thereof:

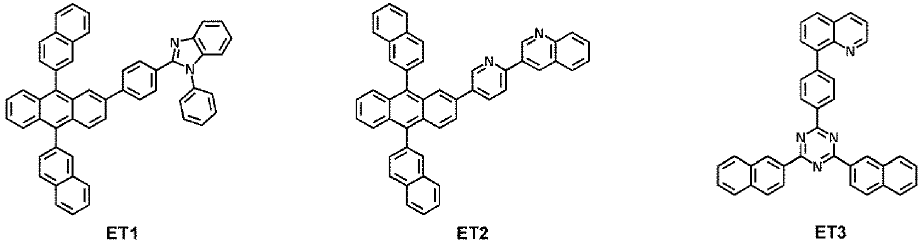

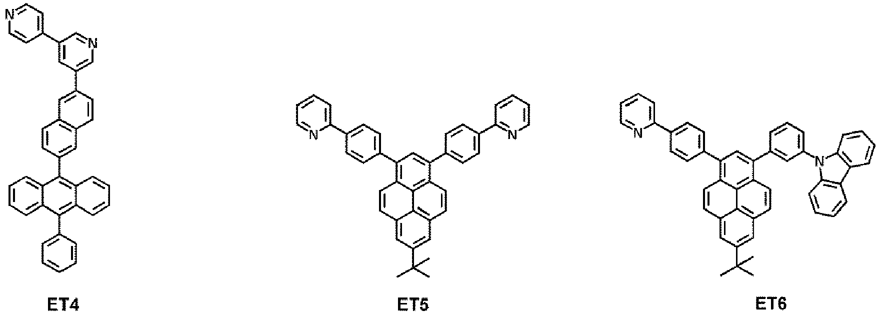

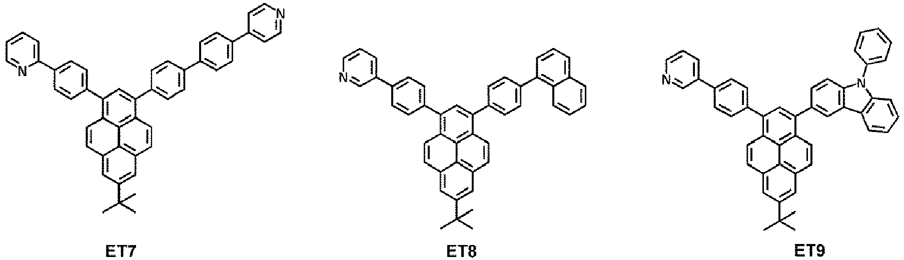

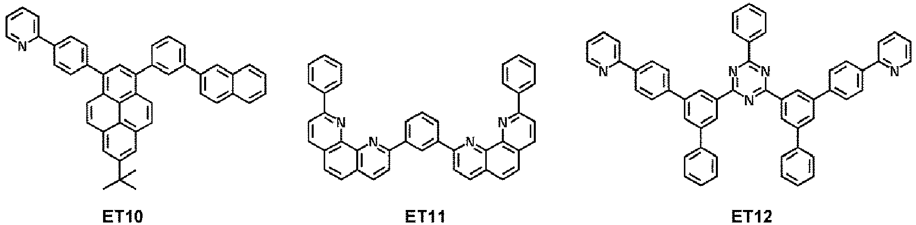

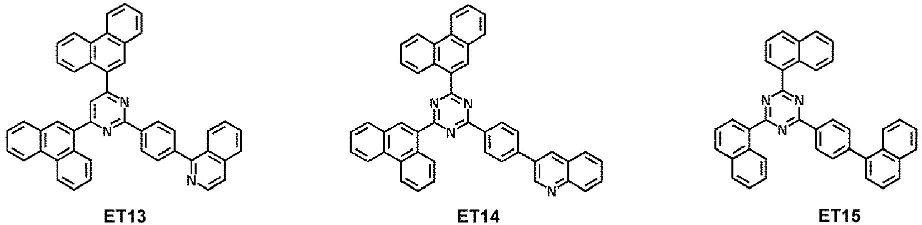

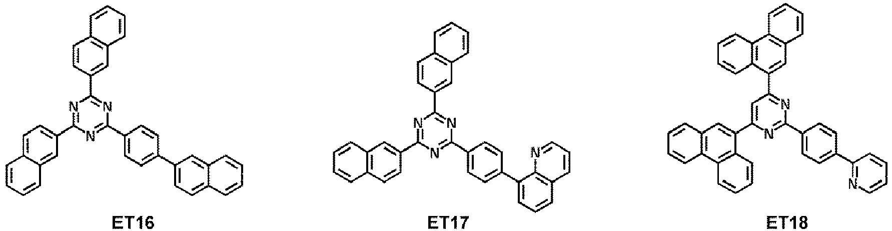

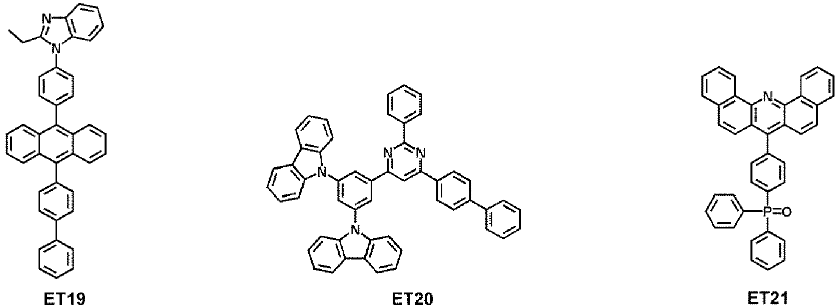

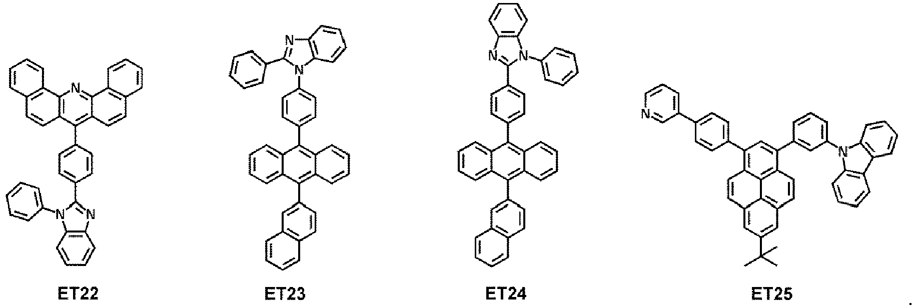

The thickness of the electron transport layer may be in a range of about 100 Å to about 1,000 Å, and in some embodiments, about 150 Å to about 500 Å. When the thickness of the electron transport layer is within any of these ranges, excellent electron transport characteristics may be obtained without a substantial increase in driving voltage.

The electron transport layer may further include a material containing metal, in addition to the materials described above.

The material containing metal may include a Li complex. The Li complex may include, e.g., Compound ET-D1 or Compound ET-D2:

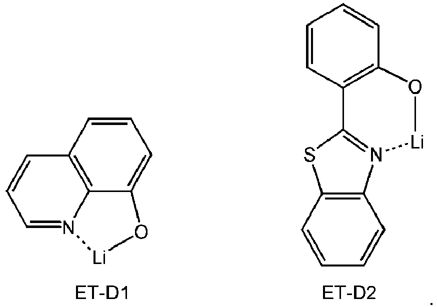

The electron transport region may include an electron injection layer that facilitates electron injection from the second electrode 19.

The electron injection layer may include LiF, NaCl, CsF, Li₂O, BaO, or any combination thereof.

The thickness of the electron injection layer may be in a range of about 1 Å to about 100 Å, for example, about 3 Å to about 90 Å. When the thickness of the electron injection layer is within any of these ranges, excellent electron injection characteristics may be obtained without a substantial increase in driving voltage.

The second electrode 19 may be on the organic layer 15. The second electrode 19 may be a cathode. A material for forming the second electrode 19 may be a material with a relatively low work function, such as a metal, an alloy, an electrically conductive compound, or any combination thereof. Examples of the material for forming the second electrode 19 may include lithium (Li), magnesium (Mg), aluminum (Al), aluminum-lithium (Al-Li), calcium (Ca), magnesium-indium (Mg-In), and magnesium-silver (Mg-Ag). In some embodiments, ITO or IZO may be used to form a transmissive second electrode 19 to manufacture a top emission light-emitting device. In some embodiments, the material for forming the second electrode 19 may vary.

Hereinbefore the organic light-emitting device 10 has been described with reference to FIG. 1, but embodiments are not limited thereto.

According to an aspect of another embodiment, an electronic apparatus may include the organic light-emitting device. Thus, an electronic apparatus including the organic light-emitting device may be provided. The electronic apparatus may include, for example, a display, lighting, a sensor, or the like.

According to an aspect of still another embodiment, a diagnostic composition may include at least one organometallic compound represented by Formula 1.

Since the organometallic compound represented by Formula 1 provides high luminescence efficiency, the diagnostic efficiency of the diagnostic composition that includes the organometallic compound represented by Formula 1 may be excellent.

The diagnostic composition may be applied in various ways, such as in a diagnostic kit, a diagnostic reagent, a biosensor, or a biomarker.

The term "C₁-C₆₀ alkyl group" as used herein refers to a linear or branched saturated aliphatic hydrocarbon monovalent group having 1 to 60 carbon atoms, and the term "C₁-C₆₀ alkylene group" as used herein refers to a divalent group having the same structure as the C₁-C₆₀ alkyl group.

Examples of the C₁-C₆₀ alkyl group, the C₁-C₂₀ alkyl group, and/or the C₁-C₁₀ alkyl group as used herein may include a methyl group, an ethyl group, an n-propyl group, an iso-propyl group, an n-butyl group, a sec-butyl group, an isobutyl group, a tert-butyl group, an n-pentyl group, a tert-pentyl group, a neopentyl group, an isopentyl group, a sec-pentyl group, a 3-pentyl group, a sec-isopentyl group, an n-hexyl group, an iso-hexyl group, a sec-hexyl group, a tert-hexyl group, an n-heptyl group, an iso-heptyl group, a sec-heptyl group, a tert-heptyl group, an n-octyl group, an iso-octyl group, a sec-octyl group, a tert-octyl group, an n-nonyl group, an iso-nonyl group, a sec-nonyl group, a tert-nonyl group, an n-decyl group, an iso-decyl group, a sec-decyl group or a tert-decyl group, each unsubstituted or substituted with a methyl group, an ethyl group, an n-propyl group, an iso-propyl group, an n-butyl group, a sec-butyl group, an isobutyl group, a tert-butyl group, an n-pentyl group, a tert-pentyl group, a neopentyl group, an isopentyl group, a sec-pentyl group, a 3-pentyl group, a sec-isopentyl group, an n-hexyl group, an iso-hexyl group, a sec-hexyl group, a tert-hexyl group, an n-heptyl group, an iso-heptyl group, a sec-heptyl group, a tert-heptyl group, an n-octyl group, an iso-octyl group, a sec-octyl group, a tert-octyl group, an n-nonyl group, an iso-nonyl group, a sec-nonyl group, a tert-nonyl group, an n-decyl group, an iso-decyl group, a sec-decyl group, a tert-decyl group, or any combination thereof. In some embodiments, Formula 9-33 may be a branched C₆ alkyl group. Formula 9-33 may be a tert-butyl group substituted with two methyl groups.

The term "C₁-C₆₀ alkoxy group" as used herein refers to a monovalent group represented by -OA₁₀₁ (wherein A₁₀₁ is a C₁-C₁ alkyl group). Examples thereof include a methoxy group, an ethoxy group, a propoxy group, a butoxy group, and a pentoxy group.

The term "C₂-C₆₀ alkenyl group" as used herein refers to a group formed by placing at least one carbon-carbon double bond in the middle or at the terminus of the C₂-C₆₀ alkyl group. Examples thereof include an ethenyl group, a propenyl group, and a butenyl group. The term "C₂-C₆₀ alkenylene group" as used herein refers to a divalent group having the same structure as the C₂-C₆₀ alkenyl group.

The term "C₂-C₆₀ alkynyl group" as used herein refers to a group formed by placing at least one carbon-carbon triple bond in the middle or at the terminus of the C₂-C₆₀ alkyl group. Examples thereof include an ethynyl group and a propynyl group. The term "C₂-C₆₀ alkynylene group" as used herein refers to a divalent group having the same structure as the C₂-C₆₀ alkynyl group.

The term "C₃-C₁₀ cycloalkyl group" as used herein refers to a monovalent saturated hydrocarbon cyclic group having 3 to 10 carbon atoms. The term "C₃-C₁₀ cycloalkylene group" as used herein refers to a divalent group having the same structure as the C₃-C₁₀ cycloalkyl group.

Examples of the C₃-C₁₀ cycloalkyl group as used herein include a cyclopropyl group, a cyclobutyl group, a cyclopentyl group, a cyclohexyl group, a cycloheptyl group, a cyclooctyl group, an adamantanyl group, a norbornanyl (bicyclo[2.2.1]heptyl) group, a bicyclo[1.1.1]pentyl group, a bicyclo[2.1.1]hexyl group, and a bicyclo[2.2.2]octyl group.

The term "C₁-C₁₀ heterocycloalkyl group" as used herein refers to a monovalent cyclic group having 1 to 10 carbon atoms and at least one heteroatom of N, O, P, Si, S, Se, Ge, and B as a ring-forming atom. The term "C₁-C₁₀ heterocycloalkylene group" as used herein refers to a divalent group having the same structure as the C₁-C₁₀ heterocycloalkyl group.

Examples of the C₁-C₁₀ heterocycloalkyl group as used herein may include a silolanyl group, a silinanyl group, a tetrahydrofuranyl group, a tetrahydro-2H-pyranyl group, or a tetrahydrothiophenyl group.

The term "C₃-C₁₀ cycloalkenyl group" as used herein refers to a monovalent cyclic group that has 3 to 10 carbon atoms and at least one carbon-carbon double bond in its ring, wherein the molecular structure as a whole is non-aromatic. Examples thereof include a cyclopentenyl group, a cyclohexenyl group, and a cycloheptenyl group. The term "C₃-C₁₀ cycloalkenylene group" as used herein refers to a divalent group having the same structure as the C₃-C₁₀ cycloalkenyl group.

The term "C₁-C₁₀ heterocycloalkenyl group" as used herein refers to a monovalent cyclic group including at least one heteroatom of N, O, P, Si, S, Se, Ge, and B as a ring-forming atom, 1 to 10 carbon atoms, and at least one double bond in its ring. Examples of the C₁-C₁₀ heterocycloalkenyl group include a 2,3-dihydrofuranyl group and a 2,3-dihydrothiophenyl group. The term "C₁-C₁₀ heterocycloalkylene group" as used herein refers to a divalent group having the same structure as the C₁-C₁₀ heterocycloalkyl group.

The term "C₆-C₆₀ aryl group" as used herein refers to a monovalent group having a carbocyclic aromatic system having 6 to 60 carbon atoms. The term "C₆-C₆₀ arylene group" as used herein refers to a divalent group having a carbocyclic aromatic system having 6 to 60 carbon atoms. Examples of the C₆-C₆₀ aryl group include a phenyl group, a naphthyl group, an anthracenyl group, a phenanthrenyl group, a pyrenyl group, and a chrysenyl group. When the C₆-C₆₀ aryl group and the C₆-C₆₀ arylene group each include a plurality of rings, the plurality of rings may be fused to each other.

The term "C₇₋C₆₀ alkyl aryl group" as used herein refers to a C₆-C₆₀ aryl group substituted with at least one C₁-C₆₀ alkyl group.

The term "C₁-C₆₀ heteroaryl group" as used herein refers to a monovalent group having a heterocyclic aromatic system having at least one heteroatom of N, O, P, Si, S, Se, Ge, and B as a ring-forming atom and 1 to 60 carbon atoms. The term "C₁-C₆₀ heteroarylene group" as used herein refers to a divalent group having a heterocyclic aromatic system having at least one heteroatom of N, O, P, Si, S, Se, Ge and B as a ring-forming atom and 1 to 60 carbon atoms. Examples of the C₁-C₆₀ heteroaryl group include a pyridinyl group, a pyrimidinyl group, a pyrazinyl group, a pyridazinyl group, a triazinyl group, a quinolinyl group, and an isoquinolinyl group. When the C₁-C₆₀ heteroaryl group and the C₁-C₆₀ heteroarylene group each include a plurality of rings, the plurality of rings may be fused to each other.

The term "C₂-C₆₀ alkyl heteroaryl group" as used herein refers to a C₁-C₆₀ heteroaryl group substituted with at least one C₁-C₆₀ alkyl group.

The term "C₆-C₆₀ aryloxy group" as used herein is represented by -OA₁₀₂ (wherein A₁₀₂ is the C₆-C₆₀ aryl group). The term "C₆-C₆₀ arylthio group" as used herein is represented by -SA₁₀₃ (wherein A₁₀₃ is the C₆-C₆₀ aryl group). The term "C₁-C₆₀ alkylthio group" as used herein is represented by -SA₁₀₄ (wherein A₁₀₄ is the C₁-C₆₀ alkyl group).

The term "monovalent non-aromatic condensed polycyclic group" as used herein refers to a monovalent group that has two or more condensed rings and only carbon atoms (e.g., the number of carbon atoms may be in a range of 8 to 60) as ring-forming atoms, wherein the molecular structure as a whole is non-aromatic. Examples of the monovalent non-aromatic condensed polycyclic group include a fluorenyl group. The term "divalent non-aromatic condensed polycyclic group" as used herein refers to a divalent group having substantially the same structure as the monovalent non-aromatic condensed polycyclic group.

The term "monovalent non-aromatic condensed heteropolycyclic group" as used herein refers to a monovalent group that has two or more condensed rings and a heteroatom selected from N, O, P, Si, S, Se, Ge, and B and carbon atoms (e.g., the number of carbon atoms may be in a range of 1 to 60) as ring-forming atoms, wherein the molecular structure as a whole is non-aromatic. Examples of the monovalent non-aromatic condensed heteropolycyclic group include a carbazolyl group. The term "divalent non-aromatic condensed heteropolycyclic group" as used herein refers to a divalent group having substantially the same structure as the monovalent non-aromatic condensed heteropolycyclic group.

The term "C₅-C₃₀ carbocyclic group" as used herein refers to a saturated or unsaturated cyclic group including 5 to 30 carbon atoms only as ring-forming atoms. The C₅-C₃₀ carbocyclic group may be a monocyclic group or a polycyclic group. The term "C₅-C₃₀ carbocyclic group (unsubstituted or substituted with at least one R₁₀ₐ (or at least one Z₀)" may include an adamantane group, a norbornene group, a bicyclo[1.1.1]pentane group, a bicyclo[2.1.1]hexane group, a bicyclo[2.2.1]heptane group (a norbornane group), a bicyclo[2.2.2]octane group, a cyclopentane group, a cyclohexane group, a cyclohexene group, a benzene group, a naphthalene group, an anthracene group, a phenanthrene group, a triphenylene group, a pyrene group, a chrysene group, a 1,2,3,4-tetrahydronaphthalene group, a cyclopentadiene group, or a fluorene group, each (unsubstituted or substituted with at least one R₁₀ₐ (or at least one Z₀)).

The term "C₁-C₃₀ heterocyclic group" as used herein refers to saturated or unsaturated cyclic group including 1 to 30 carbon atoms and at least one heteroatom selected from N, O, P, Si, S, Se, Ge, and B as ring-forming atoms. The C₁-C₃₀ heterocyclic group may be a monocyclic group or a polycyclic group. Examples of the "C₁-C₃₀ heterocyclic group (unsubstituted or substituted with at least one R₁₀ₐ (or at least one Z₀))" may include a thiophene group, a furan group, a pyrrole group, a silole group, a borole group, a phosphole group, a selenophene group, a germole group, a benzothiophene group, a benzofuran group, an indole group, a benzosilole group, a benzoborole group, a benzophosphole group, a benzoselenophene group, a benzogermole group, a dibenzothiophene group, a dibenzofuran group, a carbazole group, a dibenzosilole group, a dibenzoborole group, a dibenzophosphole group, a dibenzoselenophenegroup, a dibenzogermole group, a dibenzothiophene 5-oxide group, a 9H-fluorene-9-one group, a dibenzothiophene 5,5-dioxide group, an azabenzothiophene group, an azabenzofuran group, an azaindole group, an azaindene group, an azabenzosilole group, an azabenzoborole group, an azabenzophosphole group, an azabenzoselenophene group, an azabenzogermole group, an azadibenzothiophene group, an azadibenzofuran group, an azacarbazole group, an azafluorene group, an azadibenzosilole group, an azadibenzoborole group, an azadibenzophosphole group, an azadibenzoselenophene group, an azadibenzogermole group, an azadibenzothiophene 5-oxide group, an aza-9H-fluoren-9-one group, an azadibenzothiophene 5,5-dioxide group, a pyridine group, a pyrimidine group, a pyrazine group, a pyridazine group, a triazine group, a quinoline group, an isoquinoline group, a quinoxaline group, a quinazoline group, a phenanthroline group, a pyrazole group, an imidazole group, a triazole group, an oxazole group, an isooxazole group, a thiazole group, an isothiazole group, an oxadiazole group, a thiadiazole group, a benzopyrazole group, a benzimidazole group, a benzoxazole group, a benzothiazole group, a benzoxadiazole group, a benzothiadiazole group, a 5,6,7,8-tetrahydroisoquinoline group, or a 5,6,7,8-tetrahydroquinoline group, each unsubstituted or substituted with at least one R₁₀ₐ (or at least one Z₀)).

Examples of the "C₅-C₃₀ carbocyclic group" and the "C₁-C₃₀ heterocyclic group" as used herein include i) a first ring, ii) a second ring, iii) a condensed ring in which at least two first rings are condensed, iv) a condensed ring in which at least two second rings are condensed, or v) a condensed ring in which at least one first ring and at least one second ring are condensed,
the first ring may be a cyclopentane group, a cyclopentene group, a furan group, a thiophene group, a pyrrole group, a silole group, a borole group, a phosphole group, a germole group, a selenophene group, an oxazole group, an isoxazole group, an oxadiazole group, an oxatriazole group, a thiazole group, an isothiazole group, a thiadiazole group, a thiatriazole group, a pyrazole group, an imidazole group, a triazole group, a tetrazole group, an azasilole group, a diazasilole group, or a triazasilole group, and
the second ring may be an adamantane group, a norbornane group, a norbornene group, a cyclohexane group, a cyclohexene group, a benzene group, a pyridine group, a pyrimidine group, a pyrazine group, a pyridazine group, or a triazine group.

The "fluorinated C₁-C₆₀ alkyl group (or fluorinated C₁-C₂₀ alkyl group or the like)", "fluorinated C₃-C₁₀ cycloalkyl group", "fluorinated C₁-C₁₀ heterocycloalkyl group", and "fluorinated phenyl group" as used herein may respectively be a C₁-C₆₀ alkyl group (or C₁-C₂₀ alkyl group or the like), C₃-C₁₀ cycloalkyl group, a C₁-C₁₀ heterocycloalkyl group, and a phenyl group, each substituted with at least one fluoro group (-F). Examples of the "fluorinated C₁ alkyl group (i.e., a fluorinated methyl group)" may include -CF₃, -CF₂H, and -CFH₂. The "fluorinated C₁-C₆₀ alkyl group (or fluorinated C₁-C₂₀ alkyl group or the like)", "fluorinated C₃-C₁₀ cycloalkyl group", "fluorinated C₁-C₁₀ heterocycloalkyl group", or "fluorinated phenyl group" may respectively be: i) a fully fluorinated C₁-C₆₀ alkyl group (or fully fluorinated C₁-C₂₀ alkyl group or the like), fully fluorinated C₃-C₁₀ cycloalkyl group, fully fluorinated C₁-C₁₀ heterocycloalkyl group, or fully fluorinated phenyl group, in which all hydrogen atoms are substituted with fluoro groups; or ii) a partially fluorinated C₁-C₆₀ alkyl group (or partially fluorinated C₁-C₂₀ alkyl group or the like), partially fluorinated C₃-C₁₀ cycloalkyl group, partially fluorinated C₁-C₁₀ heterocycloalkyl group, or partially fluorinated phenyl group, in which some of hydrogen atoms are substituted with fluoro groups.

The "deuterated C₁-C₆₀ alkyl group (or deuterated C₁-C₂₀ alkyl group or the like)", "deuterated C₃-C₁₀ cycloalkyl group", "deuterated C₁-C₁₀ heterocycloalkyl group", and "deuterated phenyl group" as used herein may respectively be a C₁-C₆₀ alkyl group (or C₁-C₂₀ alkyl group or the like), C₃-C₁₀ cycloalkyl group, a C₁-C₁₀ heterocycloalkyl group, and a phenyl group, each substituted with at least one deuterium. Examples of the "deuterated C₁ alkyl group (i.e., a deuterated methyl group)" may include -CD₃, -CD₂H, and -CDH₂. Examples of the "deuterated C₃-C₁₀ cycloalkyl group" may include Formula 10-501. The "deuterated C₁-C₆₀ alkyl group (or deuterated C₁-C₂₀ alkyl group or the like)", "deuterated C₃-C₁₀ cycloalkyl group", "deuterated C₁-C₁₀ heterocycloalkyl group", or deuterated phenyl group may respectively be: i) a fully deuterated C₁-C₆₀ alkyl group (or fully deuterated C₁-C₂₀ alkyl group or the like), fully deuterated C₃-C₁₀ cycloalkyl group, fully deuterated C₁-C₁₀ heterocycloalkyl group, or fully deuterated phenyl group, in which all hydrogen atoms are substituted with deuterium atoms; or ii) a partially deuterated C₁-C₆₀ alkyl group (or partially deuterated C₁-C₂₀ alkyl group or the like), partially deuterated C₃-C₁₀ cycloalkyl group, partially deuterated C₁-C₁₀ heterocycloalkyl group, or partially deuterated phenyl group, in which some of hydrogen atoms are substituted with deuterium atoms.

The "(C₁-C₂₀ alkyl)'X' group" refers to a 'X' group substituted with at least one C₁-C₂₀ alkyl group. For example, The "(C₁-C₂₀ alkyl)C₃-C₁₀ cycloalkyl group" as used herein refers to a C₃-C₁₀ cycloalkyl group substituted with at least one C₁-C₂₀ alkyl group, and the "(C₁-C₂₀ alkyl)phenyl group" as used herein refers to a phenyl group substituted with at least one C₁-C₂₀ alkyl group. Examples of the (C₁ alkyl)phenyl group may include a toluyl group.

In the present specification, "an azaindole group, an azabenzoborole group, an azabenzophosphole group, an azaindene group, an azabenzosilole group, an azabenzogermole group, an azabenzothiophene group, an azabenzoselenophene group, an azabenzofuran group, an azacarbazole group, an azadibenzoborole group, an azadibenzophosphole group, an azafluorene group, an azadibenzosilole group, an azadibenzogermole group, an azadibenzothiophene group, an azadibenzoselenophene group, an azadibenzofuran group, an azadibenzothiophene 5-oxide group, an aza-9H-fluoren-9-one group, and an azadibenzothiophene 5,5-dioxide group" each refer to a hetero ring in which at least one ring-forming carbon atom is substituted with nitrogen atom and respectively having an identical backbone as "an indole group, a benzoborole group, a benzophosphole group, an indene group, a benzosilole group, a benzogermole group, a benzothiophene group, a benzoselenophene group, a benzofuran group, a carbazole group, a dibenzoborole group, a dibenzophosphole group, a fluorene group, a dibenzosilole group, a dibenzogermole group, a dibenzothiophene group, a dibenzoselenophene group, a dibenzofuran group, a dibenzothiophene 5-oxide group, a 9H-fluorene-9-one group, and a dibenzothiophene 5,5-dioxide group".

A substituent of the substituted C₅-C₃₀ carbocyclic group, the substituted C₂-C₃₀ heterocyclic group, the substituted C₁-C₆₀ alkyl group, the substituted C₂-C₆₀ alkenyl group, the substituted C₂-C₆₀ alkynyl group, the substituted C₁-C₆₀ alkoxy group, the substituted C₁-C₆₀alkylthio group, the substituted C₃-C₁₀ cycloalkyl group, the substituted C₁-C₁₀ heterocycloalkyl group, the substituted C₃-C₁₀ cycloalkenyl group, the substituted C₁-C₁₀ heterocycloalkenyl group, the substituted C₆-C₆₀ aryl group, the substituted C₇-C₆₀ alkyl aryl group, the substituted C₆-C₆₀ aryloxy group, the substituted C₆-C₆₀ arylthio group, the substituted C₁-C₆₀ heteroaryl group, the substituted C₂-C₆₀ alkyl heteroaryl group, the substituted monovalent non-aromatic condensed polycyclic group, and the substituted monovalent non-aromatic condensed heteropolycyclic group may each independently be:
deuterium, -F, -Cl, -Br, -I, -CD₃, -CD₂H, -CDH₂, -CF₃, -CF₂H, -CFH₂, a hydroxyl group, a cyano group, a nitro group, an amidino group, a hydrazine group, a hydrazone group, a carboxylic acid group or a salt thereof, a sulfonic acid group or a salt thereof, a phosphoric acid group or a salt thereof, a C₁-C₆₀ alkyl group, a C₂-C₆₀ alkenyl group, a C₂-C₆₀ alkynyl group, a C₁-C₆₀ alkoxy group, or a C₁-C₆₀ alkylthio group;
a C₁-C₆₀ alkyl group, a C₂-C₆₀ alkenyl group, a C₂-C₆₀ alkynyl group, a C₁-C₆₀ alkoxy group, or a C₁-C₆₀ alkylthio group, each substituted with deuterium, -F, -Cl, -Br, -I, -CD₃, -CD₂H, -CDH₂, -CF₃, -CF₂H, -CFH₂, a hydroxyl group, a cyano group, a nitro group, an amidino group, a hydrazine group, a hydrazone group, a carboxylic acid group or a salt thereof, a sulfonic acid group or a salt thereof, a phosphoric acid group or a salt thereof, a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₇-C₆₀ alkyl aryl group, a C₆-C₆₀ aryloxy group, a C₆-C₆₀ arylthio group, a C₁-C₆₀ heteroaryl group, a C₂-C₆₀ alkyl heteroaryl group, a monovalent non-aromatic condensed polycyclic group, a monovalent non-aromatic condensed heteropolycyclic group, - N(Q₁₁)(Q₁₂), -Si(Q₁₃)(Q₁₄)(Q₁₅), -B(Q₁₆)(Q₁₇), -P(=O)(Q₁₈)(Q₁₉), -P(Q₁₈)(Q₁₉), or any combination thereof;
a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₇-C₆₀ alkyl aryl group, a C₆-C₆₀ aryloxy group, a C₆-C₆₀ arylthio group, a C₁-C₆₀ heteroaryl group, a C₂-C₆₀ alkyl heteroaryl group, a monovalent non-aromatic condensed polycyclic group, or a monovalent non-aromatic condensed heteropolycyclic group, each unsubstituted or substituted with deuterium, -F, -Cl, -Br, -I, -CD₃, -CD₂H, -CDH₂, -CF₃, -CF₂H, -CFH₂, a hydroxyl group, a cyano group, a nitro group, an amidino group, a hydrazine group, a hydrazone group, a carboxylic acid group or a salt thereof, a sulfonic acid group or a salt thereof, a phosphoric acid group or a salt thereof, a C₁-C₆₀ alkyl group, a C₂-C₆₀ alkenyl group, a C₂-C₆₀ alkynyl group, a C₁-C₆₀ alkoxy group, a C₁-C₆₀ alkylthio group, a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₇-C₆₀ alkyl aryl group, a C₆-C₆₀ aryloxy group, a C₆-C₆₀ arylthio group, a C₁-C₆₀ heteroaryl group, a C₂-C₆₀ alkyl heteroaryl group, a monovalent non-aromatic condensed polycyclic group, a monovalent non-aromatic condensed heteropolycyclic group, -N(Q₂₁)(Q₂₂), -Si(Q₂₃)(Q₂₄)(Q₂₅), -B(Q₂₆)(Q₂₇), -P(=O)(Q₂₈)(Q₂₉), -P(Q₂₈)(Q₂₉), or any combination thereof;
-N(Q₃₁)(Q₃₂), -Si(Q₃₃)(Q₃₄)(Q₃₅), -B(Q₃₆)(Q₃₇), -P(=O)(Q₃₈)(Q₃₉), or - P(Q₃₈)(Q₃₉); or
any combination thereof.

In the present specification, Q₁ to Q₉, Q₁₁ to Q₁₉, Q₂₁ to Q₂₉, and Q₃₁ to Q₃₉ may each independently be: hydrogen; deuterium; -F; -Cl; -Br; -I; a hydroxyl group; a cyano group; a nitro group; an amidino group; a hydrazine group; a hydrazone group; a carboxylic acid group or a salt thereof; a sulfonic acid group or a salt thereof; a phosphoric acid group or a salt thereof; a C₁-C₆₀ alkyl group unsubstituted or substituted with deuterium, a C₁-C₆₀ alkyl group, a C₆-C₆₀ aryl group, or any combination thereof; a C₂-C₆₀ alkenyl group; a C₂-C₆₀ alkynyl group; a C₁-C₆₀ alkoxy group; a C₁-C₆₀ alkylthio group; a C₃-C₁₀ cycloalkyl group; a C₁-C₁₀ heterocycloalkyl group; a C₃-C₁₀ cycloalkenyl group; a C₁-C₁₀ heterocycloalkenyl group; a C₆-C₆₀ aryl group unsubstituted or substituted with deuterium, a C₁-C₆₀ alkyl group, a C₆-C₆₀ aryl group, or any combination thereof; a C₆-C₆₀ aryloxy group; a C₆-C₆₀ arylthio group; a C₁-C₆₀ heteroaryl group; a monovalent non-aromatic condensed polycyclic group; or a monovalent non-aromatic condensed heteropolycyclic group.

For example, Q₁ to Q₉, Q₁₁ to Q₁₉, Q₂₁ to Q₂₉, and Q₃₁ to Q₃₉ may each independently be:

-CH₃, -CD₃, -CD₂H, -CDH₂, -CH₂CH₃, -CH₂CD₃, -CH₂CD₂H, -CH₂CDH₂,-CHDCH₃, -CHDCD₂H, -CHDCDH₂, -CHDCD₃, -CD₂CD₃, -CD₂CD₂H, or -CD₂CDH₂;

an n-propyl group, an iso-propyl group, an n-butyl group, a sec-butyl group, an isobutyl group, a tert-butyl group, an n-pentyl group, a tert-pentyl group, a neopentyl group, an isopentyl group, a see-pentyl group, a 3-pentyl group, a see-isopentyl group, a phenyl group, a biphenyl group, or a naphthyl group, each unsubstituted or substituted with deuterium, a C₁-C₁₀ alkyl group, a phenyl group, or any combination thereof.

Hereinafter, a compound and an organic light-emitting device according to an embodiment will be described in detail with reference to Synthesis Examples and Examples, however, the present disclosure is not limited thereto. The wording "B was used instead of A" used in describing Synthesis Examples means that an amount of B used was identical to an amount of A used based on molar equivalence.

### Examples

### Synthesis Example 1 (Compound 65)

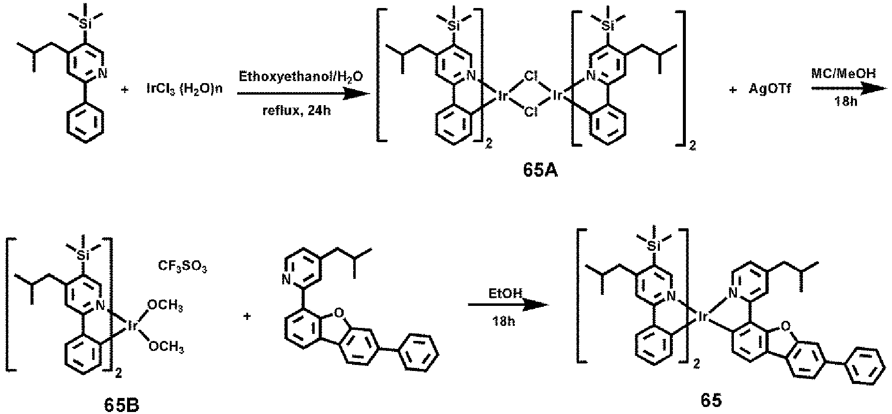

### Synthesis of Compound 65A

7.9 grams (g) (27.8 mmol) of 4-isobutyl-2-phenyl-5-(trimethylsilyl)pyridine and 4.4 g (12.6 mmol) of iridium chloride hydrate were mixed with 120 milliliters (mL) of ethoxyethanol and 40 mL of distilled water. Then, the mixture was stirred under reflux for 24 hours, and then the temperature was dropped to room temperature. A solid was formed therefrom, and then separated by filtration. The solid was sufficiently washed with water, methanol, and hexane in the stated order, and dried in a vacuum oven to thereby obtain 7.6 g of Compound 65A (yield: 76 %).

### Synthesis of Compound 65B

3.3 g (2.1 mmol) of Compound 65A was mixed with 90 mL of methylene chloride, and a solution, in which 1.1 g (4.1 mmol) of AgOTf is dissolved in 30 mL of methanol, was added thereto. Then, the mixture was stirred for 18 hours at room temperature while blocking light by using an aluminum foil. The resultant was celite-filtered to remove a solid formed therefrom and filtered under reduced pressure to thereby obtain a solid (Compound 65B). The solid was used in the following reaction without any further purification.

### Synthesis of Compound 65

4.0 g (4.1 mmol) of Compound 65B and 1.7 g (4.5 mmol) of 4-isobutyl-2-(7-phenyldibenzo[b,d]furan-4-yl)pyridine were mixed with 40 mL of ethanol and stirred under reflux for 18 hours, followed by lowering the temperature. The thus obtained mixture was under reduced pressure to obtain a solid which then was subjected to column chromatography (eluent: methylene chloride (MC) and hexane) to thereby obtain 1.8 g of Compound 65 (yield: 39 %). The resulting compound was identified by using mass spectroscopy and high-performance liquid chromatography (HPLC) analysis.

HRMS(MALDI) calcd for C₆₃H₇₀IrN₃OSi₂: m/z 1133.4687 Found: 1133.4681

### Synthesis Example 2 (Compound 206)

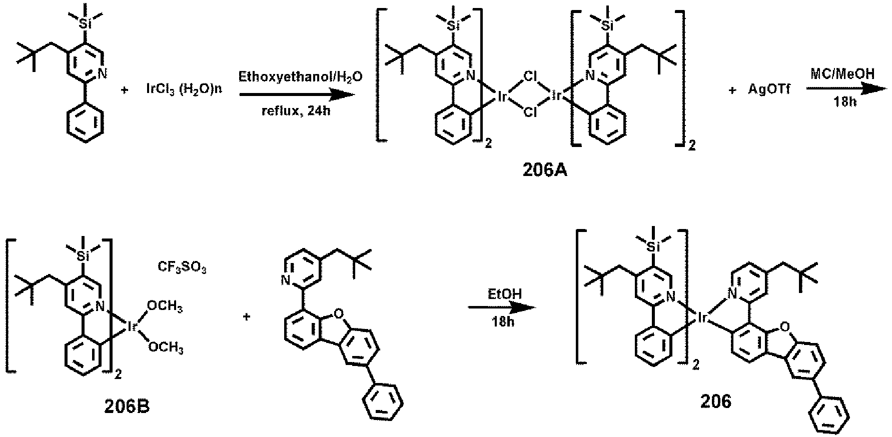

### Synthesis of Compound 206A

7.2 g of Compound 206A (yield: 72 %) was obtained in substantially the same manner as in Synthesis of Compound 65A in Synthesis Example 1, except that 4-neopentyl-2-phenyl-5-(trimethylsilyl)pyridine was used instead of 4-isobutyl-2-phenyl-5-(trimethylsilyl)pyridine.

### Synthesis of Compound 206B

Compound 206B was obtained in substantially the same manner as in Synthesis of Compound 65B in Synthesis Example 1, except that Compound 206A was used instead of Compound 65A. The resulting Compound 206B was used in the following reaction without any further purification.

### Synthesis of Compound 206

1.4 g of Compound 206 (yield: 33 %) was obtained in substantially the same manner as in Synthesis of Compound 65 in Synthesis Example 1, except that Compound 206B was used instead of Compound 65B, and 4-neopentyl-2-(8-phenyldibenzo[b,d]furan-4-yl)pyridine was used instead of 4-isobutyl-2-(7-phenyldibenzo[b,d]furan-4-yl)pyridine. The resulting compound was identified by using mass spectroscopy and HPLC analysis.

HRMS(MALDI) calcd for C₆₆H₇₆IrN₃OSi₂: m/z 1175.5156 Found: 1175.5162

### Synthesis Example 3 (Compound 363)

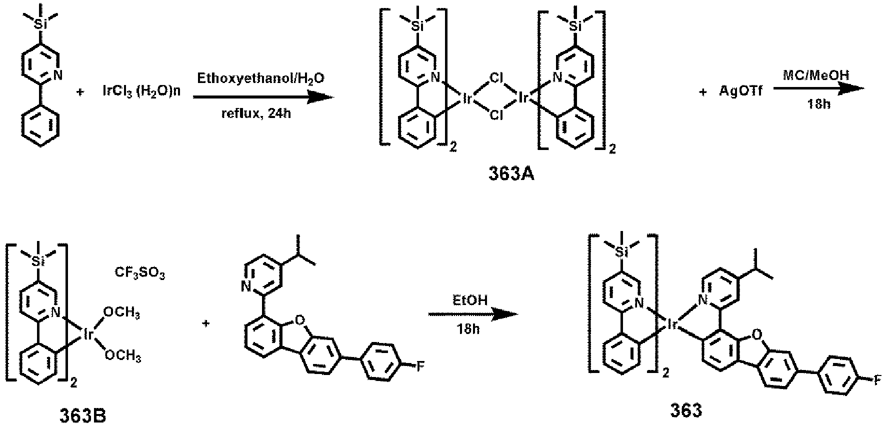

### Synthesis of Compound 363A

8.1 g of Compound 363A (yield: 81 %) was obtained in substantially the same manner as in Synthesis of Compound 65A in Synthesis Example 1, except that 2-phenyl-5-(trimethylsilyl)pyridine was used instead of 4-isobutyl-2-phenyl-5-(trimethylsilyl)pyridine.

### Synthesis of Compound 363B

Compound 363B was obtained in substantially the same manner as in Synthesis of Compound 65B in Synthesis Example 1, except that Compound 363A was used instead of Compound 65A. The resulting Compound 363B was used in the following reaction without any further purification.

### Synthesis of Compound 363

1.2 g of Compound 363 (yield: 29 %) was obtained in substantially the same manner as in Synthesis of Compound 65 in Synthesis Example 1, except that Compound 363B was used instead of Compound 65B, and 2-(7-(4-fluorophenyl)dibenzo[b,d]furan-4-yl)-4-isopropylpyridine was used instead of 4-isobutyl-2-(7-phenyldibenzo[b,d]furan-4-yl)pyridine. The resulting compound was identified by using mass spectroscopy and HPLC analysis.

HRMS(MALDI) calcd for C₅₄H₅₁FIrN₃OSi₂. m/z 1025.3184 Found: 1025.3189

### Synthesis Example 4 (Compound 556)

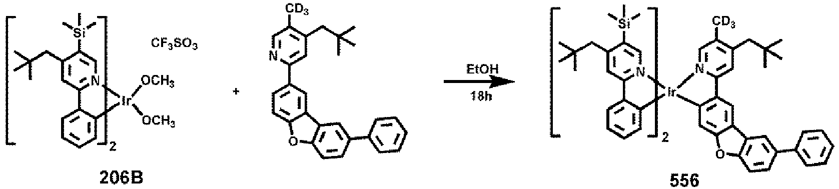

1.7 g of Compound 556 (yield: 36 %) was obtained in substantially the same manner as in Synthesis of Compound 65 in Synthesis Example 1, except that Compound 206B was used instead of Compound 65B, and 5-(methyl-d3)-4-neopentyl-2-(8-phenyldibenzo[b,d]furan-2-yl)pyridine was used instead of 4-isobutyl-2-(7-phenyldibenzo[b,d]furan-4-yl)pyridine. The resulting compound was identified by using mass spectroscopy and HPLC analysis.

HRMS(MALDI) calcd for C₆₇H₇₅D₃IrN₃OSi₂: m/z 1192.5501 Found: 1192.5496

### Synthesis Example 5 (Compound 749)

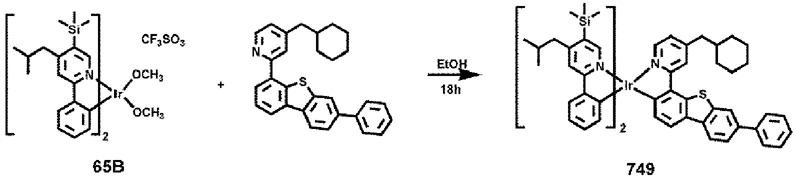

1.1 g of Compound 749 (yield: 27 %) was obtained in substantially the same manner as in Synthesis of Compound 65 in Synthesis Example 1, except that 4-(cyclohexylmethyl)-2-(7-phenyldibenzo[b,d]thiophen-4-yl)pyridine was used instead of 4-isobutyl-2-(7-phenyldibenzo[b,d]furan-4-yl)pyridine. The resulting compound was identified by using mass spectroscopy and HPLC analysis.

HRMS(MALDI) calcd for C₆₆H₇₄IrN₃SSi₂: m/z 1189.4771 Found: 1189.4763

### Synthesis Example 6 (Compound 2350)

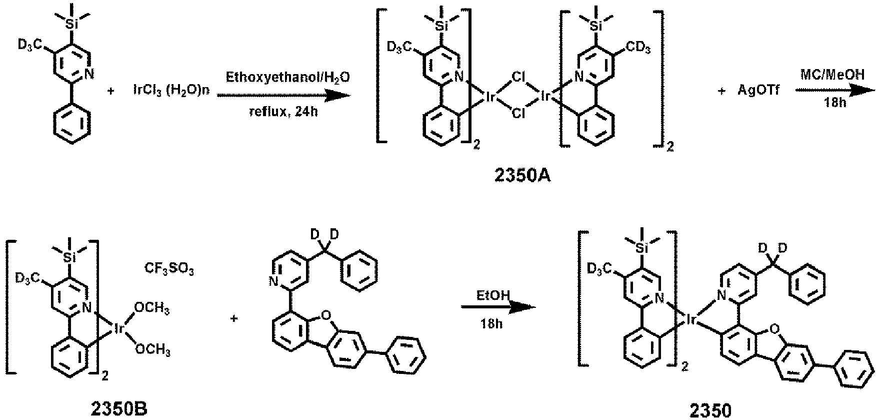

### Synthesis of Compound 2350A

8.8 g of Compound 2350A (yield: 88 %) was obtained in substantially the same manner as in Synthesis of Compound 65A in Synthesis Example 1, except that 4-(methyl-d3)-2-phenyl-5-(trimethylsilyl)pyridine was used instead of 4-isobutyl-2-phenyl-5-(trimethylsilyl)pyridine (yield: 88 %).

### Synthesis of Compound 2350B

Compound 2350B was obtained in substantially the same manner as in Synthesis of Compound 65B in Synthesis Example 1, except that Compound 2350A was used instead of Compound 65A. The resulting Compound 2350B was used in the following reaction without any further purification.

### Synthesis of Compound 2350

2.1 g of Compound 2350 (yield: 45 %) was obtained in substantially the same manner as in Synthesis of Compound 65 in Synthesis Example 1, except that Compound 2350B was used instead of Compound 65B, and 2-(7-phenyldibenzo[b,d]furan-4-yl)-4-(phenylmethyl-d2)pyridine was used instead of 2-isobutyl-2-(7-phenyldibenzo[b,d]furan-4-yl)pyridine. The resulting compound was identified by using mass spectroscopy and HPLC analysis.

HRMS(MALDI) calcd for C₆₀H₄₈D₈IrN₃OSi₂: m/z 1091.4093 Found: 1091.4090

### Synthesis Example 7 (Compound 2508)

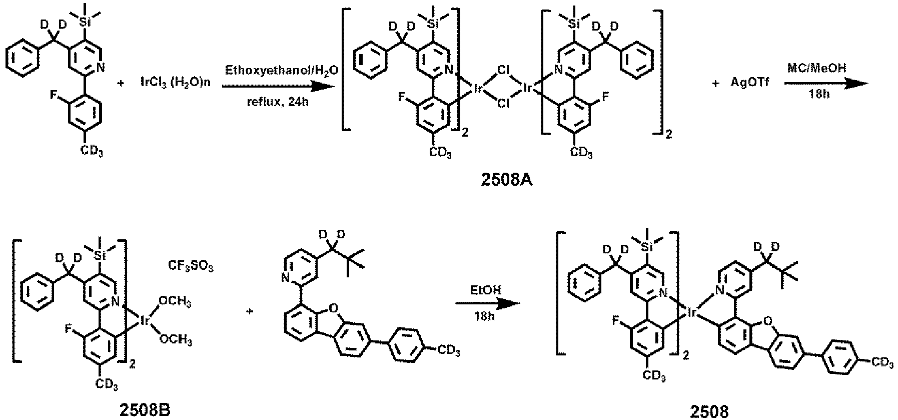

### Synthesis of Compound 2508A

6.7 g of Compound 2508A (yield: 67 %) was obtained in substantially the same manner as in Synthesis of Compound 65A in Synthesis Example 1, except that 2-(2-fluoro-4-(methyl-d3)phenyl)-4-(phenylmethyl-d2)-5-(trimethylsilyl)pyridine was used instead of 4-isobutyl-2-phenyl-5-(trimethylsilyl)pyridine.

### Synthesis of Compound 2508B

Compound 2508B was obtained in substantially the same manner as in Synthesis of Compound 65B in Synthesis Example 1, except that Compound 2508A was used instead of Compound 65A. The resulting Compound 2508B was used in the following reaction without any further purification.

### Synthesis of Compound 2508

1.3 g of Compound 2508 (yield: 26 %) was obtained in substantially the same manner as in Synthesis of Compound 65 in Synthesis Example 1, except that Compound 2508B was used instead of Compound 65B, and 4-(2,2-dimethylpropyl-1,1-d2)-2-(7-(4-(methyl-d3)phenyl)dibenzo[b,d]furan-4-yl)pyridine was used instead of 4-isobutyl-2-(7-phenyldibenzo[b,d]furan-4-yl)pyridine. The resulting compound was identified by using mass spectroscopy and HPLC analysis.

HRMS(MALDI) calcd for C₇₃H₅₇D₁₅F₂IrN₃OSi₂: m/z 1308.5753 Found: 1308.5760

### Synthesis Example 8 (Compound 2566)

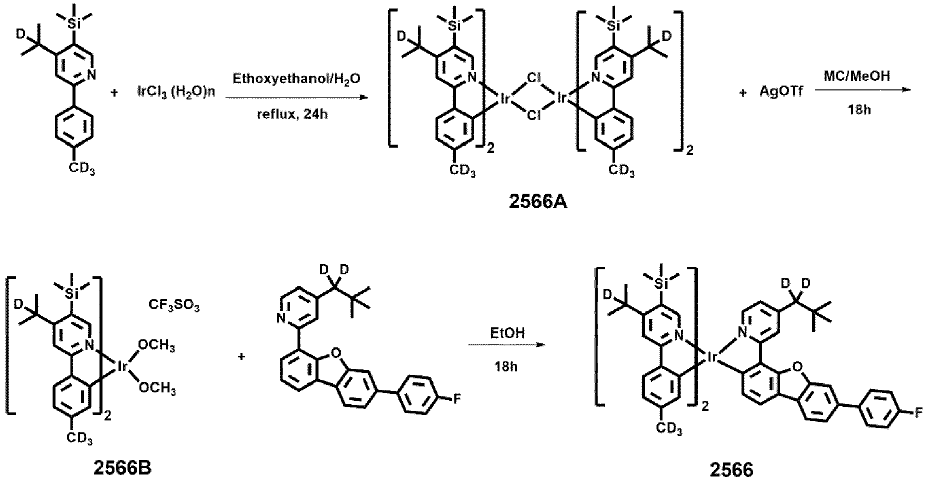

### Synthesis of Compound 2566A

8.3 g of Compound 2566A (yield: 83 %) was obtained in substantially the same manner as in Synthesis of Compound 65A in Synthesis Example 1, except that 2-(4-(methyl-d3)phenyl)-4-(propan-2-yl-2-d)-5-(trimethylsilyl)pyridine was used instead of 4-isobutyl-2-phenyl-5-(trimethylsilyl)pyridine.

### Synthesis of Compound 2566B

Compound 2566B was obtained in substantially the same manner as in Synthesis of Compound 65B in Synthesis Example 1, except that Compound 2566A was used instead of Compound 65A. The resulting Compound 2566B was used in the following reaction without any further purification.

### Synthesis of Compound 2566

1.5 g of Compound 2566 (yield: 34 %) was obtained in substantially the same manner as in Synthesis of Compound 65 in Synthesis Example 1, except that Compound 2566B was used instead of Compound 65B, and 4-(2,2-dimethylpropyl-1,1-d2)-2-(7-(4-fluorophenyl)dibenzo[b,d]furan-4-yl)pyridine was used instead of 4-isobutyl-2-(7-phenyldibenzo[b,d]furan-4-yl)pyridine. The resulting compound was identified by using mass spectroscopy and HPLC analysis.

HRMS(MALDI) calcd for C₆₄H₆₁D₁₀FIrN₃OSi₂: m/z 1175.5377 Found: 1175.5383

### Synthesis Example 9 (Compound 2579)

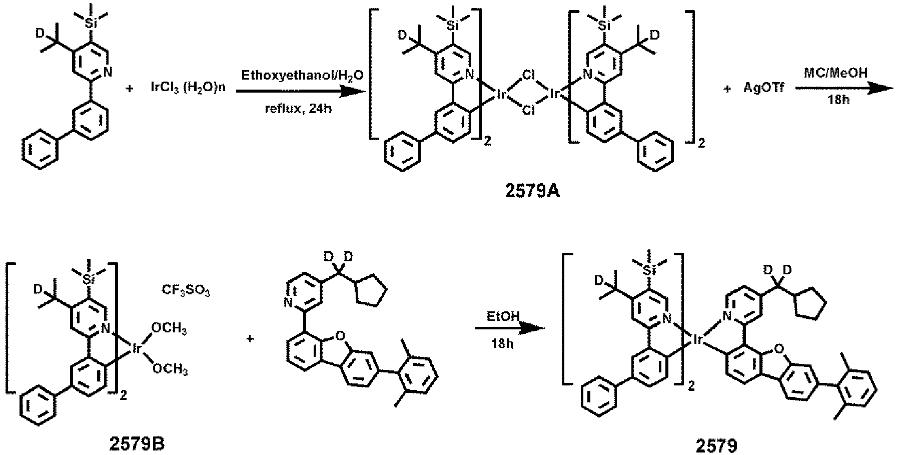

### Synthesis of Compound 2579A

8.4 g of Compound 2579A (yield: 84 %) was obtained in substantially the same manner as in Synthesis of Compound 65A in Synthesis Example 1, except that 2-([1,1'-biphenyl]-3-yl)-4-(propan-2-yl-2-d)-5-(trimethylsilyl)pyridine was used instead of 4-isobutyl-2-phenyl-5-(trimethylsilyl)pyridine.

### Synthesis of Compound 2579B

Compound 2579B was obtained in substantially the same manner as in Synthesis of Compound 65B in Synthesis Example 1, except that Compound 2579A was used instead of Compound 65A. The resulting Compound 2579B was used in the following reaction without any further purification.

### Synthesis of Compound 2579

1.1 g of Compound 2579 (yield: 25 %) was obtained in substantially the same manner as in Synthesis of Compound 65 in Synthesis Example 1, except that Compound 2579B was used instead of Compound 65B, and 4-(cyclopentylmethyl-d2)-2-(7-(2,6-dimethylphenyl)dibenzo[b,d]furan-4-yl)pyridine was used instead of 4-isobutyl-2-(7-phenyldibenzo[b,d]furan-4-yl)pyridine. The resulting compound was identified by using mass spectroscopy and HPLC analysis.

HRMS(MALDI) calcd for C₇₇H₇₆D₄IrN₃OSi₂: m/z 1315.5720 Found: 1315.5711

### Synthesis Example 10 (Compound 2758)

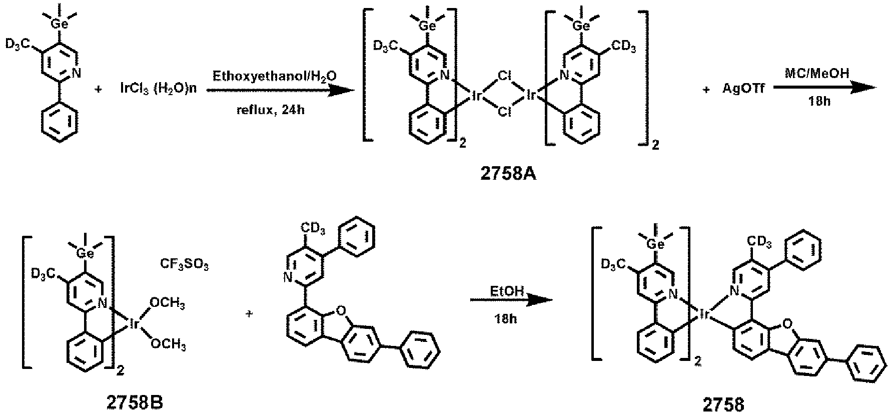

### Synthesis of Compound 2758A

7.2 g of Compound 2758A (yield: 72 %) was obtained in substantially the same manner as in Synthesis of Compound 65A in Synthesis Example 1, except that 4-(methyl-d3)-2-phenyl-5-(trimethylgermyl)pyridine was used instead of 4-isobutyl-2-phenyl-5-(trimethylsilyl)pyridine.

### Synthesis of Compound 2758B

Compound 2758B was obtained in substantially the same manner as in Synthesis of Compound 65B in Synthesis Example 1, except that Compound 2758A was used instead of Compound 65A. The resulting Compound 2758B was used in the following reaction without any further purification.

### Synthesis of Compound 2758

1.6 g of Compound 2758 (yield: 37 %) was obtained in substantially the same manner as in Synthesis of Compound 65 in Synthesis Example 1, except that Compound 2758B was used instead of Compound 65B, and 5-(methyl-d3)-4-phenyl-2-(7-phenyldibenzo[b,d]furan-4-yl)pyridine was used instead of 4-isobutyl-2-(7-phenyldibenzo[b,d]furan-4-yl)pyridine. The resulting compound was identified by using mass spectroscopy and HPLC analysis.

HRMS(MALDI) calcd for C₆₀H₄₇D₉Ge₂IrN₃O: m/z 1184.3041 Found: 1184.3033

### Synthesis Example 11 (Compound 485)

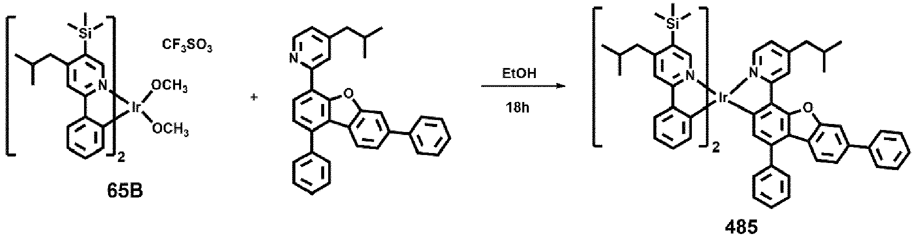

0.9 g of Compound 485 (yield: 27 %) was obtained in substantially the same manner as in Synthesis of Compound 65 in Synthesis Example 1, except that 2-(1,7-diphenyldibenzo[b,d]furan-4-yl)-4-isobutylpyridine was used instead of 4-isobutyl-2-(7-phenyldibenzo[b,d]furan-4-yl)pyridine. The resulting compound was identified by using mass spectroscopy and HPLC analysis.

HRMS(MALDI) calcd for C₆₉H₇₄IrN₃OSi₂: m/z 1209.5000 Found: 1209.4992

### Synthesis Example 12 (Compound 487)

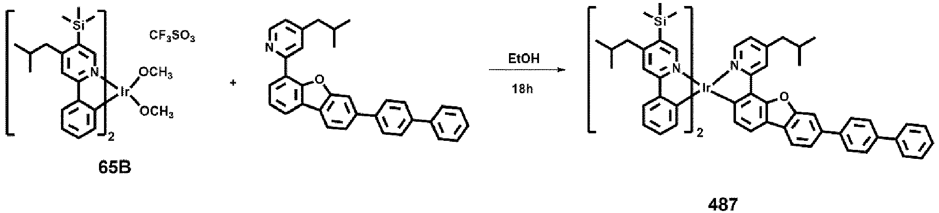

1.0 g of Compound 487 (yield: 32 %) was obtained in substantially the same manner as in Synthesis of Compound 65 in Synthesis Example 1, except that 2-(7-([1,1'-biphenyl]-4-yl)dibenzo[b,d]furan-4-yl)-4-isopropylpyridine was used instead of 4-isobutyl-2-(7-phenyldibenzo[b,d]furan-4-yl)pyridine. The resulting compound was identified by using mass spectroscopy and HPLC analysis.

HRMS(MALDI) calcd for C₆₈H₇₂IrN₃OSi₂: m/z 1195.4843 Found: 1195.4840

### Synthesis Example 13 (Compound 1703)

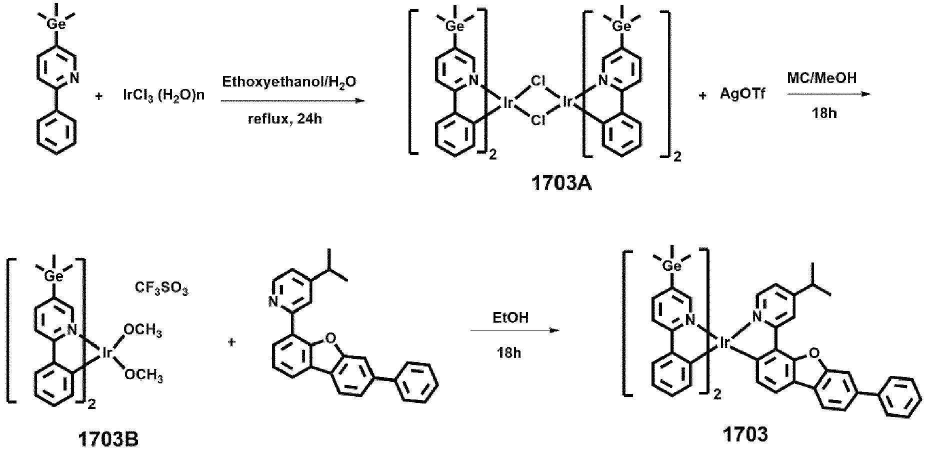

### Synthesis of Compound 1703A

6.5 g of Compound 1703A (yield: 65 %) was obtained in substantially the same manner as in Synthesis of Compound 65A in Synthesis Example 1, except that 2-phenyl-5-(trimethylgermyl)pyridine was used instead of 4-isobutyl-2-phenyl-5-(trimethylsilyl)pyridine.

### Synthesis of Compound 1703B

Compound 1703B was obtained in substantially the same manner as in Synthesis of Compound 65B in Synthesis Example 1, except that Compound 1703A was used instead of Compound 65A. The resulting Compound 1703B was used in the following reaction without any further purification.

### Synthesis of Compound 1703

2.1 g of Compound 1703 (yield: 45 %) was obtained in substantially the same manner as in Synthesis of Compound 65 in Synthesis Example 1, except that Compound 1703B was used instead of Compound 65B, and 4-isopropyl-2-(7-phenyldibenzo[b,d]furan-4-yl)pyridine was used instead of 4-isobutyl-2-(7-phenyldibenzo[b,d]furan-4-yl)pyridine. The resulting compound was identified by using mass spectroscopy and HPLC analysis.

HRMS(MALDI) calcd for C₅₄H₅₂Ge₂IrN₃O: m/z 1099.2163 Found: 1099.2156

### Synthesis Example 14 (Compound 2866)

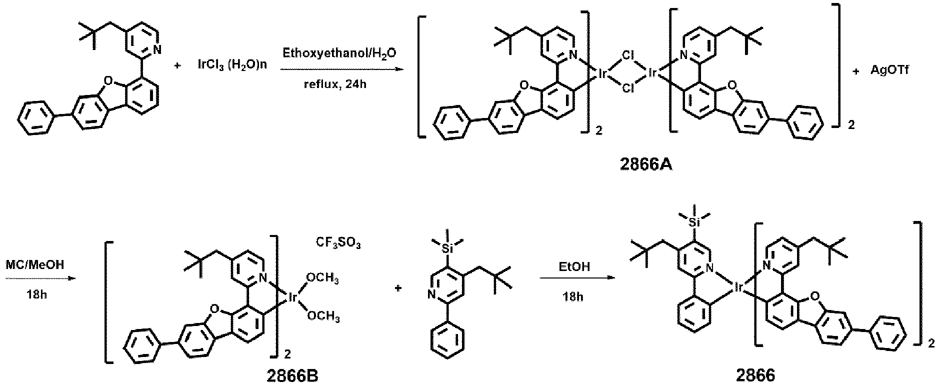

### Synthesis of Compound 2866A

3.6 g of Compound 2866A (yield: 72 %) was obtained in substantially the same manner as in Synthesis of Compound 65A in Synthesis Example 1, except that 4-neopentyl-2-(7-phenyldibenzo[b,d]furan-4-yl)pyridine was used instead of 4-isobutyl-2-phenyl-5-(trimethylsilyl)pyridine.

### Synthesis of Compound 2866B

Compound 2866B was obtained in substantially the same manner as in Synthesis of Compound 65B in Synthesis Example 1, except that Compound 2866A was used instead of Compound 65A. The resulting Compound 2866B was used in the following reaction without any further purification.

### Synthesis of Compound 2866

0.5 g of Compound 2866 (yield: 24 %) was obtained in substantially the same manner as in Synthesis of Compound 65 in Synthesis Example 1, except that Compound 2866B was used instead of Compound 65B, and 4-neopentyl-2-phenyl-5-(trimethylsilyl)pyridine was used instead of 4-isobutyl-2-(7-phenyldibenzo[b,d]furan-4-yl)pyridine. The resulting compound was identified by using mass spectroscopy and HPLC analysis.

HRMS(MALDI) calcd for C₇₅H₇₄IrN₃O₂Si. m/z 1269.5180 Found: 1269.5188

### Comparative Example 1 (Compound A1)

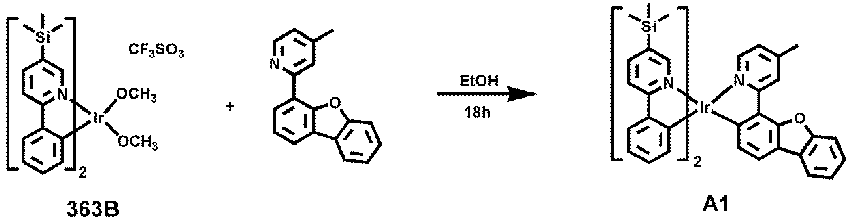

0.5 g of Compound A1 (yield: 42 %) was obtained in substantially the same manner as in Synthesis of Compound 65 in Synthesis Example 1, except that Compound 363B was used instead of Compound 65B, and 2-(dibenzo[b,d]furan-4-yl)-4-methylpyridine was used instead of 4-isobutyl-2-(7-phenyldibenzo[b,d]furan-4-yl)pyridine. The resulting compound was identified by using mass spectroscopy and HPLC analysis.

HRMS(MALDI) calcd for C₄₆H₄₄IrN₃OSi₂: m/z 903.2652 Found: 903.2645

### Comparative Example 2 (Compound A2)

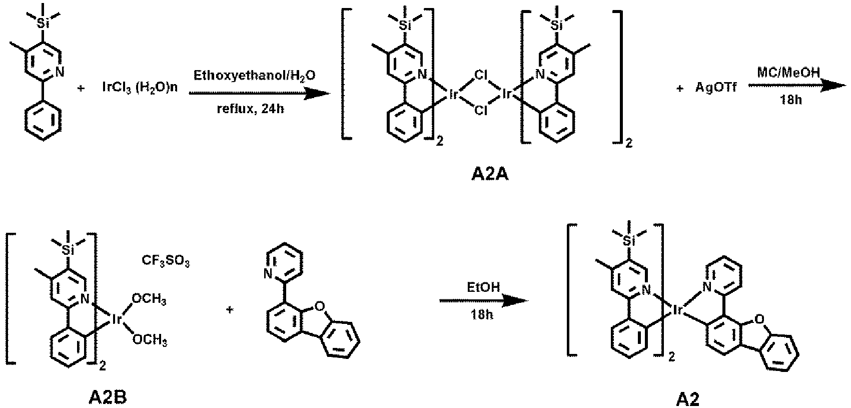

### Synthesis of Compound A2A

3.4 g of Compound A2A (yield: 86 %) was obtained in substantially the same manner as in Synthesis of Compound 65A in Synthesis Example 1, except that 4-methyl-2-phenyl-5-(trimethylsilyl)pyridine was used instead of 4-isobutyl-2-phenyl-5-(trimethylsilyl)pyridine.

### Synthesis of Compound A2B

Compound A2B was obtained in substantially the same manner as in Synthesis of Compound 65B in Synthesis Example 1, except that Compound A2A was used instead of Compound 65A. The resulting Compound A2B was used in the following reaction without any further purification.

### Synthesis of Compound A2

0.3 g of Compound A2 (yield: 41 %) was obtained in substantially the same manner as in Synthesis of Compound 65 in Synthesis Example 1, except that Compound A2B was used instead of Compound 65B, and 2-(dibenzo[b,d]furan-4-yl)pyridine was used instead of 4-isobutyl-2-(7-phenyldibenzo[b,d]furan-4-yl)pyridine. The resulting compound was identified by using mass spectroscopy and HPLC analysis.

HRMS(MALDI) calcd for C₄₇H₄₆IrN₃OSi₂: m/z 917.2809 Found: 917.2801

### Example 1

A glass substrate, on which an ITO as an anode was patterned, was cut to a size of 50 millimeters (mm) × 50 mm × 0.5 mm, sonicated in isopropyl alcohol and water for 5 minutes each, and cleaned by exposure to ultraviolet rays and ozone for 30 minutes. Subsequently, the glass substrate was mounted on a vacuum-deposition device.

Compound HT3 and F6-TCNNQ was vacuum-co-deposited on the anode at a weight ratio of 98:2 to form a hole injection layer having a thickness of 100 Å, Compound HT3 was vacuum-deposited on the hole injection layer to form a hole transport layer having a thickness of 1,350 Å, and Compound H-H1 was vacuum-deposited on the hole transport layer to form an electron blocking layer having a thickness of 300 Å.

Subsequently, Compound H-H1, Compound H-E43 and Compound 65 (dopant) were co-deposited on the electron blocking layer at a weight ratio of 57:38:5 to form an emission layer having a thickness of 400 Å.

Then, Compound ET3 and ET-D1 was codeposited on the emission layer at a volume ratio of 50:50 to form an electron transport layer having a thickness of 350 Å. ET-D1 was vacuum-deposited on the electron transport layer to form an electron injection layer having a thickness of 10 Å. AI was deposited on the electron injection layer to form a cathode having a thickness of 1000 Å, thereby completing the manufacture of an organic light-emitting device.

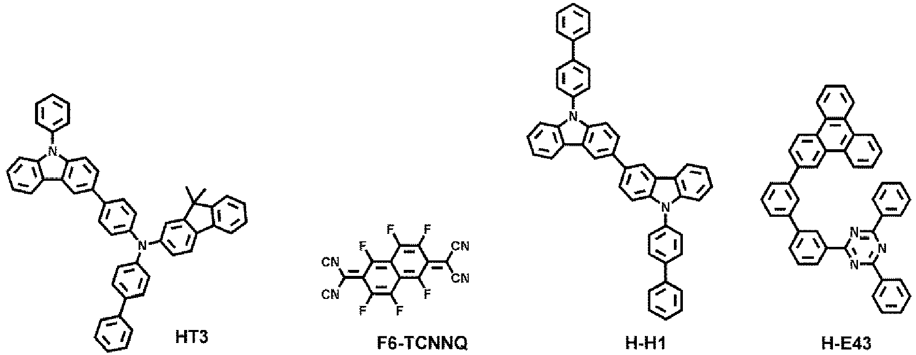

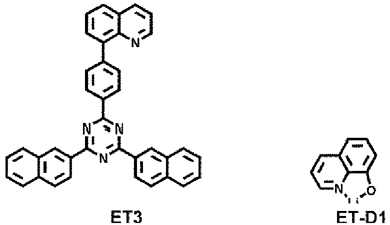

### Examples 2 to 14 and Comparative Examples A1 and A2

Organic light-emitting devices were manufactured in substantially the same manner as in Example 1, except that the compounds shown in Table 2 were used instead of Compound 65 as a dopant in the formation of an emission layer. Evaluation Example 1: Evaluation of characteristics of organic light-emitting device

The maximum value of external quantum efficiency (Max EQE, %), and lifespan (LT₉₇, hr) of each organic light-emitting device manufactured in Examples 1 to 14 and Comparative Examples A1 and A2 were evaluated. The results thereof are shown in Table 2. A Keithley 2400 current voltmeter and a luminance meter (Minolta Cs-1000A) were used in the evaluation. The lifespan (T₉₇) refers to time (hr) required for the initial luminance of 16,000 nit (1 nit = 1 cd/m²) of the organic light-emitting device to reduce by 97 % and is indicated in a relative value (%).

**Table 2**

| | Compound No. of dopant in emission layer | Max EQE (relative value, %) | LT₉₇ (relative value, %) (at 16,000 nit) |
|---|---|---|---|
| Example 1 | 65 | 96 % | 84 % |
| Example 2 | 206 | 92 % | 79 % |
| Example 3 | 363 | 91 % | 87 % |
| Example 4 | 556 | 90 % | 74 % |
| Example 5 | 749 | 98 % | 92 % |
| Example 6 | 2350 | 94 % | 77 % |
| Example 7 | 2508 | 100 % | 100 % |
| Example 8 | 2566 | 98 % | 95 % |
| Example 9 | 2579 | 92 % | 68 % |
| Example 10 | 2758 | 99 % | 77 % |
| Example 11 | 485 | 92% | 74% |
| Example 12 | 487 | 98% | 77% |
| Example 13 | 1703 | 92% | 75% |
| Example 14 | 2866 | 98% | 108% |
| Comparative Example A1 | A1 | 87 % | 47 % |
| Comparative Example A2 | A2 | 88 % | 40 % |

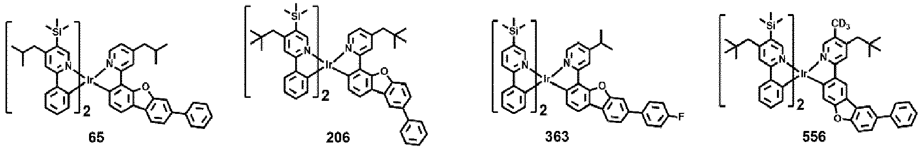

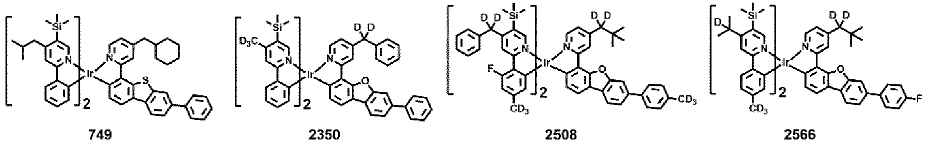

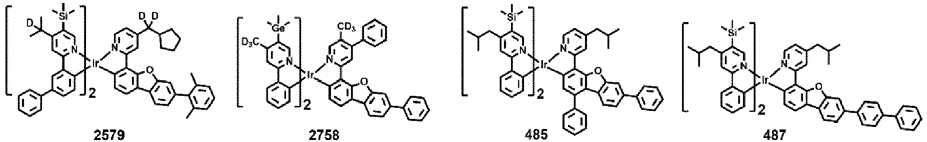

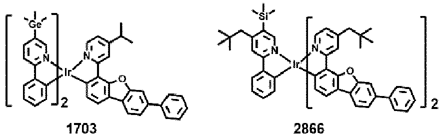

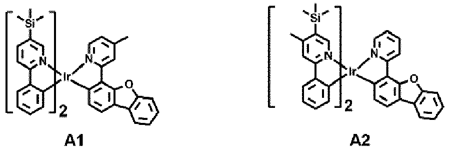

Referring to the results of Table 2, the organic light-emitting device of Examples 1 to 14 were found to have improved external quantum efficiency and lifespan, as compared with the organic light-emitting devices of Comparative Examples A1 and A2.

As apparent from the foregoing description, the organometallic compound may have excellent electrical characteristics and heat resistance, and thus, an electronic device, e.g., an organic light-emitting device, including the organometallic compound may have improved external quantum efficiency (EQE) and excellent lifespan characteristics. Accordingly, by using the organometallic compound, an organic light-emitting device with excellent quality and an electronic apparatus including the organic light-emitting device may be realized.

It should be understood that embodiments described herein should be considered in a descriptive sense only and not for purposes of limitation. Descriptions of features or aspects within each embodiment should typically be considered as available for other similar features or aspects in other embodiments. While one or more embodiments have been described with reference to the figures, it will be understood by those of ordinary skill in the art that various changes in form and details may be made therein without departing from the scope as defined by the following claims.

## Claims

1. An organometallic compound represented by Formula 1:
Formula 1 M(L₁)ₙ₁(L₂)ₙ₂
wherein, in Formula 1,
M is a transition metal,
L₁ is a ligand represented by Formula 2A,
L₂ is a ligand represented by Formula 2B,
n1 and n2 are each independently 1 or 2, when n1 is 2, two L₁(s) are identical to or different from each other, and when n2 is 2, two L₂(s) are identical to or different from each other,
the sum of n1 and n2 is 2 or 3,
L₁ is different from L₂, 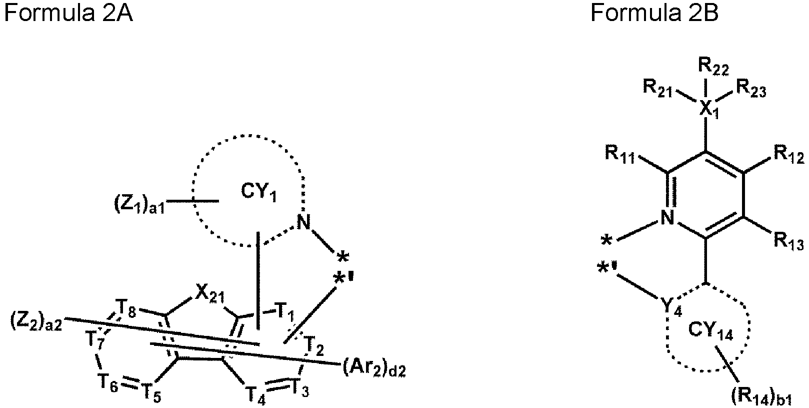
wherein, in Formulae 2A and 2B,
Y₄ is C or N,
X₁ is Si or Ge,
X₂₁ is O, S, S(=O), N(Z₂₉), C(Z₂₉)(Z₃₀), or Si(Z₂₉)(Z₃₀),
T₁ to T₄ are each independently C, N, a carbon atom bound to ring CY₁, or a carbon atom bound to M in Formula 1, one of T₁ to T₄ is a carbon atom bound to M in Formula 1, another one of T₁ to T₄, which is not bound to bound to M, is a carbon atom bound to ring CY₁,
T₅ to T₈ are each independently C or N,
the number of N(s) among T₁ to T₈ is 0 or 1,
ring CY₁ and ring CY₁₄ are each independently a C₅-C₃₀ carbocyclic group or a C₁-C₃₀ heterocyclic group,
Ar₂ is ring CY₂ unsubstituted or substituted with at least one Z₀, and ring CY₂ is an unsaturated C₅-C₃₀ carbocyclic group or an unsaturated C₁-C₃₀ heterocyclic group,
R₂₁ to R₂₃ are each independently a C₁-C₆₀ alkyl group or a C₆-C₆₀ aryl group, each unsubstituted or substituted with deuterium, -F, -Cl, -Br, -I, -CD₃, -CD₂H, -CDH₂, -CF₃, -CF₂H, -CFH₂, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₂₀ alkyl group, a C₃-C₁₀ cycloalkyl group, a phenyl group, or any combination thereof,
Z₀, Z₁, Z₂, Z₂₉, Z₃₀, and R₁₁ to R₁₄ are each independently hydrogen, deuterium, -F, -Cl, -Br, -I, -SF₅, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a substituted or unsubstituted C₁-C₆₀ alkyl group, a substituted or unsubstituted C₂-C₆₀ alkenyl group, a substituted or unsubstituted C₂-C₆₀ alkynyl group, a substituted or unsubstituted C₁-C₆₀ alkoxy group, a substituted or unsubstituted C₁-C₆₀ alkylthio group, a substituted or unsubstituted C₃-C₁₀ cycloalkyl group, a substituted or unsubstituted C₁-C₁₀ heterocycloalkyl group, a substituted or unsubstituted C₃-C₁₀ cycloalkenyl group, a substituted or unsubstituted C₁-C₁₀ heterocycloalkenyl group, a substituted or unsubstituted C₆-C₆₀ aryl group, a substituted or unsubstituted C₆-C₆₀ aryloxy group, a substituted or unsubstituted C₆-C₆o arylthio group, a substituted or unsubstituted C₁-C₆₀ heteroaryl group, a substituted or unsubstituted monovalent non-aromatic condensed polycyclic group, a substituted or unsubstituted monovalent non-aromatic condensed heteropolycyclic group, -N(Q₁)(Q₂), -Si(Q₃)(Q₄)(Q₅), -Ge(Q₃)(Q₄)(Q₅), -B(Q₆)(Q₇), -P(=O)(Q₈)(Q₉), or - P(Q₈)(Q₉),
d2 is an integer from 1 to 6, and when d2 is 2 or greater, at least two Ar₂(s) are identical to or different from each other,
a1 and b1 are each independently an integer from 0 to 20, when a1 is 2 or greater, at least two Z₁(s) are identical to or different from each other, and when b1 is 2 or greater, at least two R₁₄(s) are identical to or different from each other,
a2 is an integer from 0 to 5, and when a2 is 2 or greater, at least two Z₂(s) are identical to or different from each other,
Condition 1 or Condition 2 is satisfied:
Condition 1
wherein X₁ in Formula 2B is Si,
R₁₂ in Formula 2B is neither hydrogen nor a methyl group, and
the number of N(s) among T₁ to T₈ in Formula 2A is 0, and
Condition 2
wherein, in Formula 2B, R₁₂ is hydrogen, or the number of carbon atoms included in R₁₂ is 1,
at least two of R₂₁ to R₂₃ are optionally bound to each other to form a C₅-C₃₀ carbocyclic group unsubstituted or substituted with at least one R₁₀ₐ or a C₁-C₃₀ heterocyclic group unsubstituted or substituted with at least one R₁₀ₐ,
at least two of a plurality of Z₁(s) are optionally bound to each other to form a C₅-C₃₀ carbocyclic group unsubstituted or substituted with at least one R₁₀ₐ or a C₁-C₃₀ heterocyclic group unsubstituted or substituted with at least one R₁₀ₐ,
at least two of a plurality of Z₂(s) are optionally bound to each other to form a C₅-C₃₀ carbocyclic group unsubstituted or substituted with at least one R₁₀ₐ or a C₁-C₃₀ heterocyclic group unsubstituted or substituted with at least one R₁₀ₐ,
R₁₂ and R₁₃ are optionally bound to each other to form a C₅-C₃₀ carbocyclic group unsubstituted or substituted with at least one R₁₀ₐ or a C₁-C₃₀ heterocyclic group unsubstituted or substituted with at least one R₁₀ₐ,
at least two of a plurality of R₁₄(s) are optionally bound to each other to form a C₅-C₃₀ carbocyclic group unsubstituted or substituted with at least one R₁₀ₐ or a C₁-C₃₀ heterocyclic group unsubstituted or substituted with at least one R₁₀ₐ,
at least two of Z₀, Z₁, Z₂, Z₂₉, Z₃₀, and R₁₁ to R₁₄ are optionally bound to each other to form a C₅-C₃₀ carbocyclic group unsubstituted or substituted with at least one R₁₀ₐ or a C₁-C₃₀ heterocyclic group unsubstituted or substituted with at least one R₁₀ₐ,
R₁₀ₐ is understood by referring to the description of R₁₄ provided herein,
* and *' in Formulae 2A and 2B each indicate a binding site to M in Formula 1, and
a substituent of the substituted C₁-C₆₀ alkyl group, the substituted C₂-C₆₀ alkenyl group, the substituted C₂-C₆₀ alkynyl group, the substituted C₁-C₆₀ alkoxy group, the substituted C₁-C₆₀ alkylthio group, the substituted C₃-C₁₀ cycloalkyl group, the substituted C₁-C₁₀ heterocycloalkyl group, the substituted C₃-C₁₀ cycloalkenyl group, the substituted C₁-C₁₀ heterocycloalkenyl group, the substituted C₆-C₆₀ aryl group, the substituted C₆-C₆₀ aryloxy group, the substituted C₆-C₆₀ arylthio group, the substituted C₁-C₆₀ heteroaryl group, the substituted monovalent non-aromatic condensed polycyclic group, and the substituted monovalent non-aromatic condensed heteropolycyclic group is:
deuterium, -F, -Cl, -Br, -I, -CD₃, -CD₂H, -CDH₂, -CF₃, -CF₂H, -CFH₂, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₆₀ alkyl group, a C₂-C₆₀ alkenyl group, a C₂-C₆₀ alkynyl group, a C₁-C₆₀ alkoxy group, or a C₁-C₆₀ alkylthio group;
a C₁-C₆₀ alkyl group, a C₂-C₆₀ alkenyl group, a C₂-C₆₀ alkynyl group, a C₁-C₆₀ alkoxy group, or a C₁-C₆₀ alkylthio group, each substituted with deuterium, -F, -Cl, -Br, -I, -CD₃, -CD₂H, -CDH₂, -CF₃, -CF₂H, -CFH₂, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₆-C₆₀ aryloxy group, a C₆-C₆₀ arylthio group, a C₁-C₆₀ heteroaryl group, a monovalent non-aromatic condensed polycyclic group, a monovalent non-aromatic condensed heteropolycyclic group, -N(Q₁₁)(Q₁₂), - Si(Q₁₃)(Q₁₄)(Q₁₅), -Ge(Q₁₃)(Q₁₄)(Q₁₅), -B(Q₁₆)(Q₁₇), -P(=O)(Q₁₈)(Q₁₉), -P(Q₁₈)(Q₁₉), or any combination thereof;
a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₆-C₆₀ aryloxy group, a C₆-C₆₀ arylthio group, a C₁-C₆₀ heteroaryl group, a monovalent non-aromatic condensed polycyclic group, or a monovalent non-aromatic condensed heteropolycyclic group, each unsubstituted or substituted with deuterium, -F, -Cl, -Br, -I, -CD₃, -CD₂H, -CDH₂, -CF₃, -CF₂H, -CFH₂, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₆₀ alkyl group, a C₂-C₆₀ alkenyl group, a C₂-C₆₀ alkynyl group, a C₁-C₆₀ alkoxy group, a C₁-C₆₀ alkylthio group, a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₆-C₆₀ aryloxy group, a C₆-C₆₀ arylthio group, a C₁-C₆₀ heteroaryl group, a monovalent non-aromatic condensed polycyclic group, a monovalent non-aromatic condensed heteropolycyclic group, - N(Q₂₁)(Q₂₂), -Si(Q₂₃)(Q₂₄)(Q₂₅), -Ge(Q₂₃)(Q₂₄)(Q₂₅), -B(Q₂₆)(Q₂₇), -P(=O)(Q₂₈)(Q₂₉), - P(Q₂₈)(Q₂₉), or any combination thereof;
-N(Q₃₁)(Q₃₂), -Si(Q₃₃)(Q₃₄)(Q₃₅), -Ge(Q₃₃)(Q₃₄)(Q₃₅), -B(Q₃₆)(Q₃₇), - P(=O)(Q₃₈)(Q₃₉), or -P(Q₃₈)(Q₃₉); or
any combination thereof,
wherein Q₁ to Q₉, Q₁₁ to Q₁₉, Q₂₁ to Q₂₉, and Q₃₁ to Q₃₉ are each independently: hydrogen; deuterium; -F; -Cl; -Br; -I; a hydroxyl group; a cyano group; a nitro group; an amino group; an amidino group; a hydrazine group; a hydrazone group; a carboxylic acid group or a salt thereof; a sulfonic acid group or a salt thereof; a phosphoric acid group or a salt thereof; a C₁-C₆₀ alkyl group unsubstituted or substituted with deuterium, a C₁-C₆₀ alkyl group, a C₆-C₆₀ aryl group, or any combination thereof; a C₂-C₆₀ alkenyl group; a C₂-C₆₀ alkynyl group; a C₁-C₆₀ alkoxy group; a C₁-C₆₀ alkylthio group; a C₃-C₁₀ cycloalkyl group; a C₁-C₁₀ heterocycloalkyl group; a C₃-C₁₀ cycloalkenyl group; a C₁-C₁₀ heterocycloalkenyl group; a C₆-C₆₀ aryl group unsubstituted or substituted with deuterium, a C₁-C₆₀ alkyl group, a C₆-C₆₀ aryl group, or any combination thereof; a C₆-C₆₀ aryloxy group; a C₆-C₆₀ arylthio group; a C₁-C₆₀ heteroaryl group; a monovalent non-aromatic condensed polycyclic group; or a monovalent non-aromatic condensed heteropolycyclic group.

2. The organometallic compound of claim 1, wherein M in Formula 1 is Ir, and n1+n2=3, or M in Formula 1 is Pt, and n1+n2=2.

3. The organometallic compound of claims 1 or 2, wherein M in Formula 1 is Ir and i) n1 is 1 and n2 is 2; or ii) n1 is 2 and n2 is 1.

4. The organometallic compound of any of claims 1-3, wherein X₂₁ in Formula 2A is O or S; and/or
wherein ring CY₂ is a benzene group, a naphthalene group, an anthracene group, a phenanthrene group, a triphenylene group, a pyrene group, a chrysene group, a cyclopentadiene group, a 1,2,3,4-tetrahydronaphthalene group, a thiophene group, a furan group, a borole group, a phosphole group, a silole group, a germole group, a selenophene group, an indole group, a benzoborole group, a benzophosphole group, an indene group, a benzosilole group, a benzogermole group, a benzothiophene group, a benzoselenophene group, a benzofuran group, a carbazole group, a dibenzoborole group, a dibenzophosphole group, a fluorene group, a dibenzosilole group, a dibenzogermole group, a dibenzothiophene group, a dibenzoselenophenegroup, a dibenzofuran group, a dibenzothiophene 5-oxide group, a 9H-fluorene-9-one group, a dibenzothiophene 5,5-dioxide group, an azaindole group, an azabenzoborole group, an azabenzophosphole group, an azaindene group, an azabenzosilole group, an azabenzogermole group, an azabenzothiophene group, an azabenzoselenophene group, an azabenzofuran group, an azacarbazole group, an azadibenzoborole group, an azadibenzophosphole group, an azafluorene group, an azadibenzosilole group, an azadibenzogermole group, an azadibenzothiophene group, an azadibenzoselenophene group, an azadibenzofuran group, an azadibenzothiophene 5-oxide group, an aza-9H-fluoren-9-one group, an azadibenzothiophene 5,5-dioxide group, a pyridine group, a pyrimidine group, a pyrazine group, a pyridazine group, a triazine group, a quinoline group, an isoquinoline group, a quinoxaline group, a quinazoline group, a phenanthroline group, a pyrrole group, a pyrazole group, an imidazole group, a triazole group, an oxazole group, an isooxazole group, a thiazole group, an isothiazole group, an oxadiazole group, a thiadiazole group, a benzopyrazole group, a benzimidazole group, a benzoxazole group, a benzothiazole group, a benzoxadiazole group, a benzothiadiazole group, a 5,6,7,8-tetrahydroisoquinoline group, or a 5,6,7,8-tetrahydroquinoline group; and/or
wherein d2 in Formula 2A is 1 or 2.

5. The organometallic compound of any of claims 1-4, wherein Z₁ in Formula 2A and R₁₁ to R₁₃ in Formula 2B are each independently:
hydrogen or deuterium;
a C₁-C₂₀ alkyl group unsubstituted or substituted with deuterium, a C₃-C₁₀ cycloalkyl group, a deuterated C₃-C₁₀ cycloalkyl group, a (C₁-C₂₀ alkyl)C₃-C₁₀ cycloalkyl group, a C₁-C₁₀ heterocycloalkyl group, a deuterated C₁-C₁₀ heterocycloalkyl group, a (C₁-C₂₀ alkyl)C₁-C₁₀ heterocycloalkyl group, a phenyl group, a deuterated phenyl group, a (C₁-C₂₀ alkyl)phenyl group, a biphenyl group, a deuterated biphenyl group, a (C₁-C₂₀ alkyl)biphenyl group, or any combination thereof; or
a C₃-C₁₀ cycloalkyl group, a C₁-C₁₀ heterocycloalkyl group, a phenyl group, or a biphenyl group, each unsubstituted or substituted with deuterium, -F, a cyano group, a C₁-C₂₀ alkyl group, a deuterated C₁-C₂₀ alkyl group, a C₁-C₂₀ alkoxy group, a deuterated C₁-C₂₀ alkoxy group, a C₃-C₁₀ cycloalkyl group, a deuterated C₃-C₁₀ cycloalkyl group, a (C₁-C₂₀ alkyl)C₃-C₁₀ cycloalkyl group, a C₁-C₁₀ heterocycloalkyl group, a deuterated C₁-C₁₀ heterocycloalkyl group, a (C₁-C₂₀ alkyl)C₁-C₁₀ heterocycloalkyl group, a phenyl group, a deuterated phenyl group, a (C₁-C₂₀ alkyl)phenyl group, a biphenyl group, a deuterated biphenyl group, a (C₁-C₂₀ alkyl)biphenyl group, or any combination thereof.

6. The organometallic compound of any of claims 1-5, wherein Z₀ and Z₂ in Formula 2A and R₁₄ in Formula 2B are each independently:
hydrogen, deuterium, -F, or a cyano group;
a C₁-C₂₀ alkyl group unsubstituted or substituted with deuterium, -F, a cyano group, a C₃-C₁₀ cycloalkyl group, a deuterated C₃-C₁₀ cycloalkyl group, a fluorinated C₃-C₁₀ cycloalkyl group, a (C₁-C₂₀ alkyl)C₃-C₁₀ cycloalkyl group, a C₁-C₁₀ heterocycloalkyl group, a deuterated C₁-C₁₀ heterocycloalkyl group, a fluorinated C₁-C₁₀ heterocycloalkyl group, a (C₁-C₂₀ alkyl)C₁-C₁₀ heterocycloalkyl group, a phenyl group, a deuterated phenyl group, a fluorinated a phenyl group, a (C₁-C₂₀ alkyl)phenyl group, a biphenyl group, a deuterated biphenyl group, a fluorinated biphenyl group, a (C₁-C₂₀ alkyl)biphenyl group, or any combination thereof;
a C₃-C₁₀ cycloalkyl group, a C₁-C₁₀ heterocycloalkyl group, a phenyl group, or a biphenyl group, each unsubstituted or substituted with deuterium, -F, a cyano group, a C₁-C₂₀ alkyl group, a deuterated C₁-C₂₀ alkyl group, a fluorinated C₁-C₂₀ alkyl group, a C₁-C₂₀ alkoxy group, a deuterated C₁-C₂₀ alkoxy group, a fluorinated C₁-C₂₀ alkoxy group, a C₃-C₁₀ cycloalkyl group, a deuterated C₃-C₁₀ cycloalkyl group, a fluorinated C₃-C₁₀ cycloalkyl group, a (C₁-C₂₀ alkyl)C₃-C₁₀ cycloalkyl group, a C₁-C₁₀ heterocycloalkyl group, a deuterated C₁-C₁₀ heterocycloalkyl group, a fluorinated C₁-C₁₀ heterocycloalkyl group, a (C₁-C₂₀ alkyl)C₁-C₁₀ heterocycloalkyl group, a phenyl group, a deuterated phenyl group, a fluorinated a phenyl group, a (C₁-C₂₀ alkyl)phenyl group, a biphenyl group, a deuterated biphenyl group, a fluorinated a biphenyl group, a (C₁-C₂₀ alkyl)biphenyl group, or any combination thereof; or
-Si(Q₃)(Q₄)(Q₅), or -Ge(Q₃)(Q₄)(Q₅).

7. The organometallic compound of any of claims 1-6, wherein the organometallic compound satisfies at least one of Conditions A, B, and C:
Condition A
wherein, Z₁ in Formula 2A is not hydrogen, and a1 is not 0,
Condition B
wherein, Z₂ in Formula 2A is not hydrogen, and a2 is not 0, and
Condition C
R₁₄ in Formula 2B is not hydrogen, and b1 is not 0.

8. The organometallic compound of any of claims 1-7, wherein the organometallic compound represented by Formula 1 satisfies Condition 1 and the number of carbon atoms included in R₁₂ in Formula 2B is 2 or greater.

9. The organometallic compound of any of claims 1-8, wherein the organometallic compound represented by Formula 1 satisfies Condition 2; and/or
wherein the organometallic compound comprises at least one deuterium, at least one fluoro group (-F), at least one cyano group (-CN), or any combination thereof.

10. The organometallic compound of any of claims 1-9, wherein at least one of Conditions (1) to (6) is satisfied or Condition (7) is satisfied:
Condition (1)
wherein, in Formula 2A, a1 is not 0, and at least one of Z₁(s) in the number of a1 comprises deuterium,
Condition (2)
wherein, in Formula 2A, a2 is not 0, at least one of Z₂(s) in the number of a2 comprises deuterium, a fluoro group (-F), a cyano group, or any combination thereof,
Condition (3)
wherein, in Formula 2A, at least one of Ar₂(s) in the number of d2 comprises deuterium, a fluoro group (-F), a cyano group, or any combination thereof,
Condition (4)
wherein, in Formula 2B, at least one of R₂₁ to R₂₃ comprises deuterium,
Condition (5)
wherein, in Formula 2B, R₁₂ comprises at least one deuterium,
Condition (6)
wherein, in Formula 2B, b1 is not 0, at least one of R₁₄(s) in the number of b1 comprises deuterium, a fluoro group (-F), a cyano group, or any combination thereof, and
Condition (7)
wherein, Z₁, Z₂, and Ar₂ in Formula 2A and R₁₁ to R₁₄ and R₂₁ to R₂₃ in Formula 2B each consist of carbon and hydrogen.

11. The organometallic compound of any of claims 1-10, wherein a group represented by 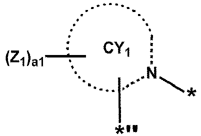 in Formula 2A is a group represented by one of Formulae CY1-1 to CY1-28: 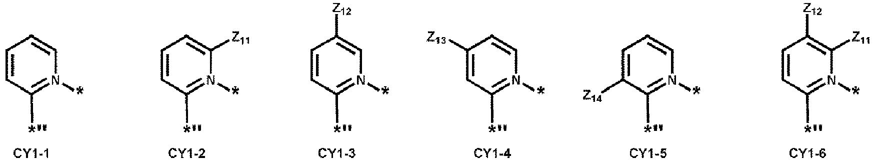 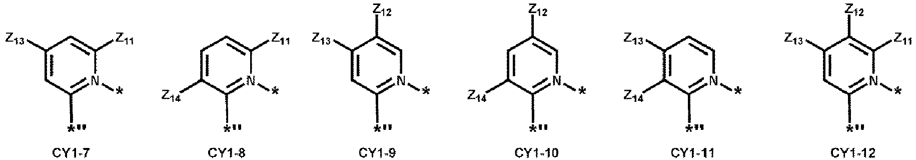 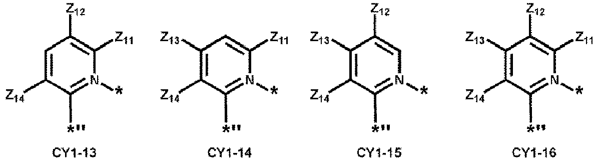 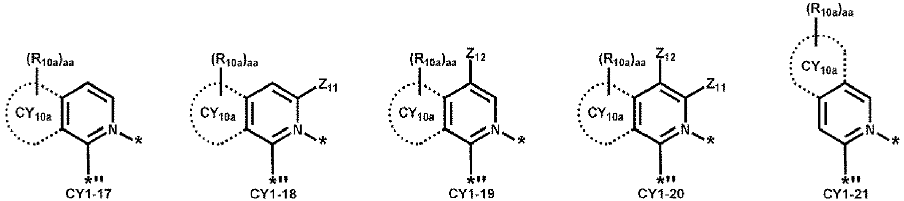 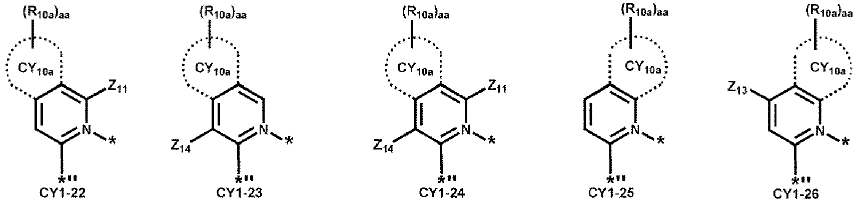 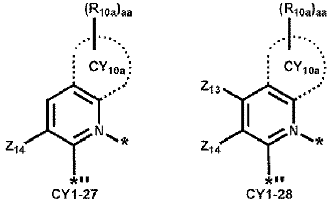
wherein, in Formulae CY1-1 to CY1-28,
Z₁₁ to Z₁₄ are each the same as described in connection with Z₁ in claim 1, wherein each of Z₁₁ to Z₁₄ are not hydrogen,
ring CY₁₀ₐ is a C₅-C₃₀ carbocyclic group or a C₁-C₃₀ heterocyclic group,
R₁₀ₐ is the same as described in claim 1,
aa is an integer from 0 to 10,
* indicates a binding site to M in Formula 1, and
*" indicates a binding site to one of T₁ to T₄ in Formula 2A.

12. The organometallic compound of any of claims 1-11, wherein a group represented by 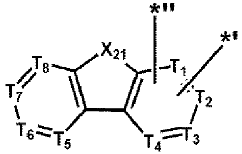 in Formula 2A is a group represented by one of Formulae CY2-1 to CY2-6: 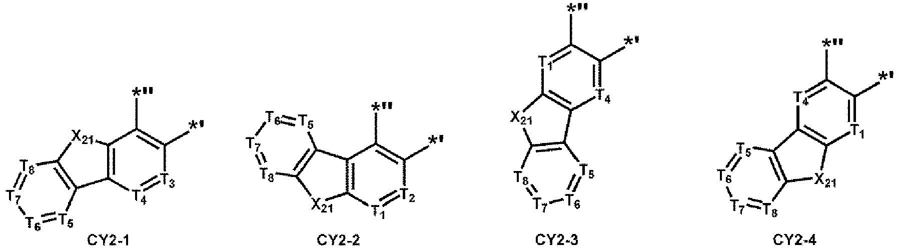 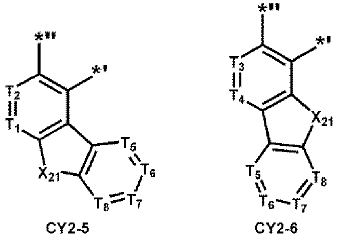
wherein, in Formulae CY2-1 to CY2-6,
T₁ to Ts are each independently C or N, the number of N(s) among T₃ to T₈ in Formulae CY2-1 and CY2-6 is 0 or 1, the number of N(s) among T₁, T₂, T₅, T₆, T₇, and T₈ in Formulae CY2-2 and CY2-5 is 0 or 1, the number of N(s) among T₁, T₄, T₅, T₆, T₇, and T₈ in Formulae CY2-3 and CY2-4 is 0 or 1,
X₂₁ is the same as described in claim 1,
*" indicates a binding site to ring CY₁ in Formula 2A, and
*' indicates a binding site to M in Formula 1.

13. An organic light-emitting device comprising:
a first electrode;
a second electrode; and
an organic layer located between the first electrode and the second electrode and comprising an emission layer and at least one of the organometallic compound of any of claims 1-12;
preferably wherein
the first electrode is an anode,
the second electrode is a cathode,
the organic layer further comprises a hole transport region between the first electrode and the emission layer and an electron transport region between the emission layer and the second electrode,
the hole transport region comprises a hole injection layer, a hole transport layer, an electron blocking layer, a buffer layer, or any combination thereof, and
the electron transport region comprises a hole blocking layer, an electron transport layer, an electron injection layer, or any combination thereof.

14. The organic light-emitting device of claim 13, wherein the emission layer comprises the organometallic compound;
preferably wherein the emission layer further comprises a host in an amount greater than an amount of the organometallic compound.

15. An electronic apparatus comprising the organic light-emitting device of claims 13 or 14.

## Patentansprüche

1. Organometallische Verbindung, dargestellt durch Formel 1:
Formel 1 M(L₁)ₙ₁(L₂)ₙ₂, wobei in Formel 1
M ein Übergangsmetall ist,
L₁ ein Ligand ist, dargestellt durch Formel 2A,
L₂ ein Ligand ist, dargestellt durch Formel 2B,
n1 und n2 jeweils unabhängig 1 oder 2 sind, wenn n1 2 ist, sind zwei L₁(s) identisch oder voneinander unterschiedlich, und wenn n2 2 ist, sind zwei L₂(s) identisch oder voneinander unterschiedlich,
die Summe von n1 und n2 2 oder 3 ist,
L₁ unterschiedlich ist von L₂, 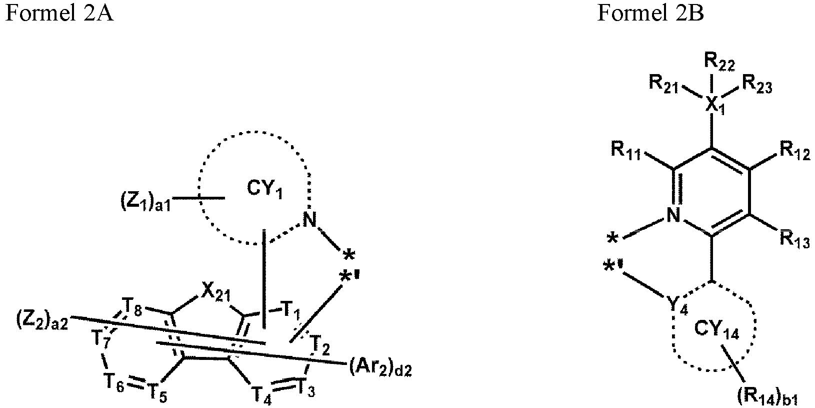
wobei in den Formel 2A und 2B
Y₄ C oder N ist,
X₁ Si oder Ge ist,
X₂₁ O, S, S(=O), N(Z₂₉), C(Z₂₉)(Z₃₀) oder Si(Z₂₉)(Z₃₀) ist,
T₁ bis T₄ jeweils unabhängig C, N, ein an Ring CY₁ gebundenes Kohlenstoffatom oder ein an M in Formel 1 gebundenes Kohlenstoffatom sind, eines von T₁ bis T₄ ein an M in Formel 1 gebundenes Kohlenstoffatom ist, ein weiteres von T₁ bis T₄, welches nicht gebunden ist, an M gebunden zu sein, ein an Ring CY₁ gebundenes Kohlenstoffatom ist,
T₅ bis T₈ jeweils unabhängig C oder N sind,
die Anzahl von N(s) unter T₁ bis T₈ 0 oder 1 ist,
Ring CY₁ und Ring CY₁₄ jeweils unabhängig eine carbocyclische C₅-C₃₀-Gruppe oder eine heterocyclische C₁-C₃₀-Gruppe sind,
Ar₂ Ring CY₂ ist, der unsubstituiert oder mit zumindest einem Z₀ substituiert ist, und Ring CY₂ eine ungesättigte carbocyclische C₅-C₃₀-Gruppe oder eine ungesättigte heterocyclische C₁-C₃₀-Gruppe ist,
R₂₁ bis R₂₃ jeweils unabhängig eine C₁-C₆₀-Alkylgruppe oder eine C₆-C₆₀-Arylgruppe, die jeweils unsubstituiert oder substituiert ist mit Deuterium, -F, -Cl, -Br, -I, -CD₃, -CD₂H, -CDH₂, - CF₃, -CF₂H, -CFH₂, eine Hydroxylgruppe, eine Cyanogruppe, eine Nitrogruppe, eine Aminogruppe, eine Amidinogruppe, eine Hydrazingruppe, eine Hydrazongruppe, eine Carboxylsäuregruppe oder ein Salz davon, eine Sulfonsäuregruppe oder ein Salz davon, eine Phosphorsäuregruppe oder ein Salz davon, eine C₁-C₂₀-Alkylgruppe, eine C₃-C₁₀-Cycloalkylgruppe, eine Phenylgruppe oder eine beliebige Kombination davon sind,
Z₀, Z₁, Z₂, Z₂₉, Z₃₀ und R₁₁ bis R₁₄ jeweils unabhängig Wasserstoff, Deuterium, -F, -Cl, - Br, -I, -SF₅, eine Hydroxylgruppe, eine Cyanogruppe, eine Nitrogruppe, eine Aminogruppe, eine Amidinogruppe, eine Hydrazingruppe, eine Hydrazongruppe, eine Carboxylsäuregruppe oder ein Salz davon, eine Sulfonsäuregruppe oder ein Salz davon, eine Phosphorsäuregruppe oder ein Salz davon, eine substituierte oder unsubstituierte C₁-C₆₀-Alkylgruppe, eine substituierte oder unsubstituierte C₂-C₆₀-Alkenylgruppe, eine substituierte oder unsubstituierte C₂-C₆₀-Alkinylgruppe, eine substituierte oder unsubstituierte C₁-C₆₀-Alkoxygruppe, eine substituierte oder unsubstituierte C₁-C₆₀-Alkylthiogruppe, eine substituierte oder unsubstituierte C₃-C₁₀-Cycloalkylgruppe, eine substituierte oder unsubstituierte C₁-C₁₀-Heterocycloalkylgruppe, eine substituierte oder unsubstituierte C₃-C₁₀-Cycloalkenylgruppe, eine substituierte oder unsubstituierte C₁-C₁₀-Heterocycloalkenylgruppe, eine substituierte oder unsubstituierte C₆-C₆₀-Arylgruppe, eine substituierte oder unsubstituierte C₆-C₆₀-Aryloxygruppe, eine substituierte oder unsubstituierte C₆-C₆₀-Arylthiogruppe, eine substituierte oder unsubstituierte C₁-C₆₀-Heteroarylgruppe, eine substituierte oder unsubstituierte monovalente nicht-aromatische kondensierte polycyclische Gruppe, eine substituierte oder unsubstituierte monovalente nicht-aromatische kondensierte heteropolycyclische Gruppe, -N(Q₁)(Q₂), -Si(Q₃)(Q₄)(Q₅), - Ge(Q₃)(Q₄)(Q₅), -B(Q₆)(Q₇), -P(=O)(Q₈)(Q₉) oder -P(Q₈)(Q₉) sind,
d2 eine ganze Zahl von 1 bis 6 ist, und wenn d2 2 oder größer ist, sind zumindest zwei Ar₂(s) identisch oder voneinander unterschiedlich,
a1 und b1 jeweils unabhängig voneinander eine ganze Zahl von 0 bis 20 sind, wenn a1 2 oder größer ist, sind zumindest zwei Z₁(s) identisch oder voneinander unterschiedlich, und wenn b1 2 oder größer ist, sind zumindest zwei R₁₄(s) identisch oder voneinander unterschiedlich,
a2 eine ganze Zahl von 0 bis 5 ist, und wenn a2 2 oder größer ist, sind zumindest zwei Z₂(s) identisch oder voneinander unterschiedlich,
Bedingung 1 oder Bedingung 2 erfüllt ist:
Bedingung 1
wobei X₁ in Formel 2B Si ist,
R₁₂ in Formel 2B weder Wasserstoff noch eine Methylgruppe ist und
die Anzahl von N(s) unter T₁ bis T₈ in Formel 2A 0 ist, und
Bedingung 2
wobei in Formel 2B R₁₂ Wasserstoff ist oder die Anzahl von in R₁₂ enthaltenen Kohlenstoffatomen 1 ist,
zumindest zwei von R₂₁ bis R₂₃ gegebenenfalls aneinander gebunden sind, um eine carbocyclische C₅-C₃₀-Gruppe, die unsubstituiert oder mit zumindest einem R₁₀ₐ substituiert ist, oder eine heterocyclische C₁-C₃₀-Gruppe zu bilden, die unsubstituiert oder mit zumindest einem R₁₀ₐ substituiert ist,
zumindest zwei einer Vielzahl von Z₁(s) gegebenenfalls aneinander gebunden sind, um eine carbocyclische C₅-C₃₀-Gruppe, die unsubstituiert oder mit zumindest einem R₁₀ₐ substituiert ist, oder eine heterocyclische C₁-C₃₀-Gruppe zu bilden, die unsubstituiert oder mit zumindest einem R₁₀ₐ substituiert ist,
zumindest zwei einer Vielzahl von Z₂(s) gegebenenfalls aneinander gebunden sind, um eine carbocyclische C₅-C₃₀-Gruppe, die unsubstituiert oder mit zumindest einem R₁₀ₐ substituiert ist, oder eine heterocyclische C₁-C₃₀-Gruppe zu bilden, die unsubstituiert oder mit zumindest einem R₁₀ₐ substituiert ist,
R₁₂ und R₁₃ gegebenenfalls aneinander gebunden sind, um eine carbocyclische C₅-C₃₀-Gruppe, die unsubstituiert oder mit zumindest einem R₁₀ₐ substituiert ist, oder eine heterocyclische C₁-C₃₀-Gruppe zu bilden, die unsubstituiert oder mit zumindest einem R₁₀ₐ substituiert ist,
zumindest zwei einer Vielzahl von R₁₄(s) gegebenenfalls aneinander gebunden sind, um eine carbocyclische C₅-C₃₀-Gruppe, die unsubstituiert oder mit zumindest einem R₁₀ₐ substituiert ist, oder eine heterocyclische C₁-C₃₀-Gruppe zu bilden, die unsubstituiert oder mit zumindest einem R₁₀ₐ substituiert ist,
zumindest zwei von Z₀, Z₁, Z₂, Z₂₉, Z₃₀ und R₁₁ bis R₁₄ gegebenenfalls aneinander gebunden sind, um eine carbocyclische C₅-C₅₀-Gruppe, die unsubstituiert oder mit zumindest einem R₁₀ₐ substituiert ist, oder eine heterocyclische C₁-C₃₀-Gruppe zu bilden, die unsubstituiert oder mit zumindest einem R₁₀ₐ substituiert ist,
wobei R₁₀ₐ unter Bezugnahme auf die hierin bereitgestellte Beschreibung von R₁₄ verstanden wird,
* und *' in den Formeln 2A und 2B jeweils eine Bindungsstelle an M in Formel 1 angeben, und
ein Substituent der substituierten C₁-C₆₀-Alkylgruppe, der substituierten C₂-C₆₀-Alkenylgruppe, der substituierten C₂-C₆₀-Alkinylgruppe, der substituierten C₁-C₆₀-Alkoxygruppe, der substituierten C₁-C₆₀-Alkylthiogruppe, der substituierten C₃-C₁₀-Cycloalkylgruppe, der substituierten C₁-C₁₀-Heterocycloalkylgruppe, der substituierten C₃-C₁₀-Cycloalkenylgruppe, der substituierten C₁-C₁₀-Heterocycloalkenylgruppe, der substituierten C₆-C₆₀-Arylgruppe, der substituierten C₆-C₆₀-Aryloxygruppe, der substituierten C₆-C₆₀-Arylthiogruppe, der substituierten C₁-C₆₀-Heteroarylgruppe, der substituierten monovalenten nicht-aromatischen kondensierten polycyclischen Gruppe und der substituierten monovalenten nicht-aromatischen kondensierten heteropolycyclischen Gruppe Folgendes ist:
Deuterium, -F, -Cl, -Br, -I, -CD₃, -CD₂H, -CDH₂, -CF₃, -CF₂H, -CFH₂, eine Hydroxylgruppe, eine Cyanogruppe, eine Nitrogruppe, eine Aminogruppe, eine Amidinogruppe, eine Hydrazingruppe, eine Hydrazongruppe, eine Carboxylsäuregruppe oder ein Salz davon, eine Sulfonsäuregruppe oder ein Salz davon, eine Phosphorsäuregruppe oder ein Salz davon, eine C₁-C₆₀-Alkylgruppe, eine C₂-C₆₀-Alkenylgruppe, eine C₂-C₆₀-Alkinylgruppe, eine C₁-C₆₀-Alkoxygruppe oder eine C₁-C₆₀-Alkylthiogruppe;
eine C₁-C₆₀-Alkylgruppe, eine C₂-C₆₀-Alkenylgruppe, eine C₂-C₆₀-Alkinylgruppe, eine C₁-C₆₀-Alkoxygruppe oder eine C₁-C₆₀-Alkylthiogruppe, die jeweils substituiert ist mit Deuterium, - F, -Cl, -Br, -I, -CD₃, -CD₂H, -CDH₂, -CF₃, -CF₂H, -CFH₂, eine Hydroxylgruppe, eine Cyanogruppe, eine Nitrogruppe, eine Aminogruppe, eine Amidinogruppe, eine Hydrazingruppe, eine Hydrazongruppe, eine Carboxylsäuregruppe oder ein Salz davon, eine Sulfonsäuregruppe oder ein Salz davon, eine Phosphorsäuregruppe oder ein Salz davon, eine C₃-C₁₀-Cycloalkylgruppe, eine C₁-C₁₀-Heterocycloalkylgruppe, eine C₃-C₁₀-Cycloalkenylgruppe, eine C₁-C₁₀-Heterocycloalkenylgruppe, eine C₆-C₆₀-Arylgruppe, eine C₆-C₆₀-Aryloxygruppe, eine C₆-C₆₀-Arylthiogruppe, eine C₁-C₆₀-Heteroarylgruppe, eine monovalente nicht-aromatische kondensierte polycyclische Gruppe, eine monovalente nicht-aromatische kondensierte heteropolycyclische Gruppe, -N(Q₁₁)(Q₁₂), -Si(Q₁₃)(Q₁₄)(Q₁₅), -Ge(Q₁₃)(Q₁₄)(Q₁₅), -B(Q₁₆)(Q₁₇), -P(=O)(Q₁₈)(Q₁₉), -P(Q₁₈)(Q₁₉) oder eine beliebige Kombination davon;
eine C₃-C₁₀-Cycloalkylgruppe, eine C₁-C₁₀-Heterocycloalkylgruppe, eine C₃-C₁₀-Cycloalkenylgruppe, eine C₁-C₁₀-Heterocycloalkenylgruppe, eine C₆-C₆₀-Arylgruppe, eine C₆-C₆₀-Aryloxygruppe, eine C₆-C₆₀-Arylthiogruppe, eine C₁-C₆₀-Heteroarylgruppe, eine monovalente nicht-aromatische kondensierte polycyclische Gruppe oder eine monovalente nicht-aromatische kondensierte heteropolycyclische Gruppe, die jeweils unsubstituiert oder substituiert ist mit Deuterium, -F, -Cl, -Br, -I, -CD₃, -CD₂H, -CDH₂, -CF₃, -CF₂H, -CFH₂, eine Hydroxylgruppe, eine Cyanogruppe, eine Nitrogruppe, eine Aminogruppe, eine Amidinogruppe, eine Hydrazingruppe, eine Hydrazongruppe, eine Carboxylsäuregruppe oder ein Salz davon, eine Sulfonsäuregruppe oder ein Salz davon, eine Phosphorsäuregruppe oder ein Salz davon, eine C₁-C₆₀-Alkylgruppe, eine C₂-C₆₀-Alkenylgruppe, eine C₂-C₆₀-Alkinylgruppe, eine C₁-C₆₀-Alkoxygruppe, eine C₁-C₆₀-Alkylthiogruppe, eine C₃-C₁₀-Cycloalkylgruppe, eine C₁-C₁₀-Heterocycloalkylgruppe, eine C₃-C₁₀-Cycloalkenylgruppe, eine C₁-C₁₀-Heterocycloalkenylgruppe, eine C₆-C₆₀-Arylgruppe, eine C₆-C₆₀-Aryloxygruppe, eine C₆-C₆₀-Arylthiogruppe, eine C₁-C₆₀-Heteroarylgruppe, eine monovalente nicht-aromatische kondensierte polycyclische Gruppe, eine monovalente nicht-aromatische kondensierte heteropolycyclische Gruppe, -N(Q₂₁)(Q₂₂), -Si(Q₂₃)(Q₂₄)(Q₂₅), -Ge(Q₂₃)(Q₂₄)(Q₂₅), -B(Q₂₆)(Q₂₇), -P(=O)(Q₂₈)(Q₂₉), - P(Q₂₈)(Q₂₉) oder eine beliebige Kombination davon;
-N(Q₃₁)(Q₃₂), -Si(Q₃₃)(Q₃₄)(Q₃₅), -Ge(Q₃₃)(Q₃₄)(Q₃₅), -B(Q₃₆)(Q₃₇), -P(=O)(Q₃₈)(Q₃₉) oder -P(Q₃₈)(Q₃₉); oder
eine beliebige Kombination davon,
wobei Q₁ bis Q₉, Q₁₁ bis Q₁₉, Q₂₁ bis Q₂₉ und Q₃₁ bis Q₃₉ jeweils unabhängig voneinander Folgendes sind: Wasserstoff; Deuterium; -F; -Cl; -Br; -I; eine Hydroxylgruppe; eine Cyanogruppe; eine Nitrogruppe; eine Aminogruppe; eine Amidinogruppe; eine Hydrazingruppe; eine Hydrazongruppe; eine Carboxylsäuregruppe oder ein Salz davon; eine Sulfonsäuregruppe oder ein Salz davon; eine Phosphorsäuregruppe oder ein Salz davon; eine C₁-C₆₀-Alkylgruppe, die unsubstituiert oder mit Deuterium substituiert ist, eine C₁-C₆₀-Alkylgruppe, eine C₆-C₆₀-Arylgruppe oder eine beliebige Kombination davon; eine C₂-C₆₀-Alkenylgruppe; eine C₂-C₆₀-Alkinylgruppe; eine C₁-C₆₀-Alkoxygruppe, eine C₁-C₆₀-Alkylthiogruppe; eine C₃-C₁₀-Cycloalkylgruppe; eine C₁-C₁₀-Heterocycloalkylgruppe; eine C₃-C₁₀-Cycloalkenylgruppe, eine C₁-C₁₀-Heterocycloalkenylgruppe, eine C₆-C₆₀-Arylgruppe, die unsubstituiert oder mit Deuterium substituiert ist, eine C₁-C₆₀-Alkylgruppe, eine C₆-C₆₀-Arylgruppe oder eine beliebige Kombination davon; eine C₆-C₆₀-Aryloxygruppe, eine C₆-C₆₀-Arylthiogruppe; eine C₁-C₆₀-Heteroarylgruppe; eine monovalente nicht-aromatische kondensierte polycyclische Gruppe; oder eine monovalente nicht-aromatische kondensierte heteropolycyclische Gruppe.

2. Organometallische Verbindung nach Anspruch 1, wobei M in Formel 1 Ir und n1+n2=3 ist, oder M in Formel 1 Pt und n1+n2=2 ist.

3. Organometallische Verbindung nach Anspruch 1 oder 2, wobei M in Formel 1 Ir ist und i) n1 1 ist und n2 2 ist; oder ii) n1 2 ist und n2 1 ist.

4. Organometallische Verbindung nach einem beliebigen der Ansprüche 1-3, wobei X₂₁ in Formel 2A O oder S ist; und/oder
wobei Ring CY₂ eine Benzolgruppe, eine Naphthalingruppe, eine Anthracengruppe, eine Phenanthrengruppe, eine Triphenylengruppe, eine Pyrengruppe, eine Chrysengruppe, eine Cyclopentadiengruppe, eine 1,2,3,4-Tetrahydronaphthalingruppe, eine Thiophengruppe, eine Furangruppe, eine Borolgruppe, eine Phospholgruppe, eine Silolgruppe, eine Germolgruppe, eine Selenophengruppe, eine Indolgruppe, eine Benzoborolgruppe, eine Benzophospholgruppe, eine Indengruppe, eine Benzosilolgruppe, eine Benzogermolgruppe, eine Benzothiophengruppe, eine Benzoselenophengruppe, eine Benzofurangruppe, eine Carbazolgruppe, eine Dibenzoborolgruppe, eine Dibenzophospholgruppe, eine Fluorengruppe, eine Dibenzosilolgruppe, eine Dibenzogermolgruppe, eine Dibenzothiophengruppe, eine Dibenzoselenophengruppe, eine Dibenzofurangruppe, eine Dibenzothiophen-5-oxidgruppe, eine 9H-Fluoren-9-ongruppe, eine Dibenzothiophen-5,5-dioxidgruppe, eine Azaindolgruppe, eine Azabenzoborolgruppe, eine Azabenzophospholgruppe, eine Azaindengruppe, eine Azabenzosilolgruppe, eine Azabenzogermolgruppe, eine Azabenzothiophengruppe, eine Azabenzoselenophengruppe, eine Azabenzofurangruppe, eine Azacarbazolgruppe, eine Azadibenzoborolgruppe, eine Azadibenzophospholgruppe, eine Azafluorengruppe, eine Azadibenzosilolgruppe, eine Azadibenzogermolgruppe, eine Azadibenzothiophengruppe, eine Azadibenzoselenophengruppe, eine Azadibenzofurangruppe, eine Azadibenzothiophen-5-oxidgruppe, eine Aza-9H-Fluoren-9-ongruppe, eine Azadibenzothiophen-5,5-dioxidgruppe, eine Pyridingruppe, eine Pyrimidingruppe, eine Pyrazingruppe, eine Pyridazingruppe, eine Triazingruppe, eine Chinolingruppe, eine Isochinolingruppe, eine Chinoxalingruppe, eine Chinazolingruppe, eine Phenanthrolingruppe, eine Pyrrolgruppe, eine Pyrazolgruppe, eine Imidazolgruppe, eine Triazolgruppe, eine Oxazolgruppe, eine Isooxazolgruppe, eine Thiazolgruppe, eine Isothiazolgruppe, eine Oxadiazolgruppe, eine Thiadiazolgruppe, eine Benzopyrazolgruppe, eine Benzimidazolgruppe, eine Benzoxazolgruppe, eine Benzothiazolgruppe, eine Benzoxadiazolgruppe, eine Benzothiadiazolgruppe, eine 5,6,7,8-Tetrahydroisochinolingruppe oder eine 5,6,7,8-Tetrahydrochinolingruppe ist; und/oder
wobei d2 in Formel 2A 1 oder 2 ist.

5. Organometallische Verbindung nach einem beliebigen der Ansprüche 1-4, wobei Z₁ in Formel 2A und R₁₁ bis R₁₃ in Formel 2B jeweils unabhängig voneinander Folgendes sind:
Wasserstoff oder Deuterium;
eine C₁-C₂₀-Alkylgruppe, die unsubstituiert oder mit Deuterium substituiert ist, eine C₃-C₁₀-Cycloalkylgruppe, eine deuterierte C₃-C₁₀-Cycloalkylgruppe, eine (C₁-C₂₀-Alkyl-)C₃-C₁₀-Cycloalkylgruppe, eine C₁-C₁₀-Heterocycloalkylgruppe, eine deuterierte C₁-C₁₀-Heterocycloalkylgruppe, eine (C₁-C₂₀-Alkyl-)C₁-C₁₀-Heterocycloalkylgruppe, eine Phenylgruppe, eine deuterierte Phenylgruppe, eine (C₁-C₂₀-Alkyl-)Phenylgruppe, eine Biphenylgruppe, eine deuterierte Biphenylgruppe, eine (C₁-C₂₀-Alkyl-)Biphenylgruppe oder eine beliebige Kombination davon; oder
eine C₃-C₁₀-Cycloalkylgruppe, eine C₁-C₁₀-Heterocycloalkylgruppe, eine Phenylgruppe oder eine Biphenylgruppe, die jeweils unsubstituiert oder substituiert ist mit Deuterium, -F, eine Cyanogruppe, eine C₁-C₂₀-Alkylgruppe, eine deuterierte C₁-C₂₀-Alkylgruppe, eine C₁-C₂₀-Alkoxygruppe, eine deuterierte C₁-C₂₀-Alkoxygruppe, eine C₃-C₁₀-Cycloalkylgruppe, eine deuterierte C₃-C₁₀-Cycloalkylgruppe, eine (C₁-C₂₀-Alkyl-)C₃-C₁₀-Cycloalkylgruppe, eine C₁-C₁₀-Heterocycloalkylgruppe, eine deuterierte C₁-C₁₀-Heterocycloalkylgruppe, eine (C₁-C₂₀-Alkyl-)C₁-C₁₀-Heterocycloalkylgruppe, eine Phenylgruppe, eine deuterierte Phenylgruppe, eine (C₁-C₂₀-Alkyl-)Phenylgruppe, eine Biphenylgruppe, eine deuterierte Biphenylgruppe, eine (C₁-C₂₀-Alkyl-)Biphenylgruppe oder eine beliebige Kombination davon.

6. Organometallische Verbindung nach einem beliebigen der Ansprüche 1-5, wobei Z₀ und Z₂ in Formel 2A und R₁₄ in Formel 2B jeweils unabhängig voneinander Folgendes sind:
Wasserstoff, Deuterium, -F oder eine Cyanogruppe;
eine C₁-C₂₀-Alkylgruppe, die unsubstituiert oder substituiert ist mit Deuterium, -F, eine Cyanogruppe, eine C₃-C₁₀-Cycloalkylgruppe, eine deuterierte C₃-C₁₀-Cycloalkylgruppe, eine fluorierte C₃-C₁₀-Cycloalkylgruppe, eine (C₁-C₂₀-Alkyl-)C₃-C₁₀-Cycloalkylgruppe, eine C₁-C₁₀-Heterocycloalkylgruppe, eine deuterierte C₁-C₁₀-Heterocycloalkylgruppe, eine fluorierte C₁-C₁₀-Heterocycloalkylgruppe, eine (C₁-C₂₀-Alkyl-)C₁-C₁₀-Heterocycloalkylgruppe, eine Phenylgruppe, eine deuterierte Phenylgruppe, eine fluorierte Phenylgruppe, eine (C₁-C₂₀-Alkyl-)Phenylgruppe, eine Biphenylgruppe, eine deuterierte Biphenylgruppe, eine fluorierte Biphenylgruppe, eine (C₁-C₂₀-Alkyl-)Biphenylgruppe oder eine beliebige Kombination davon;
eine C₃-C₁₀-Cycloalkylgruppe, eine C₁-C₁₀-Heterocycloalkylgruppe, eine Phenylgruppe oder eine Biphenylgruppe, die jeweils unsubstituiert oder substituiert ist mit Deuterium, -F, eine Cyanogruppe, eine C₁-C₂₀-Alkylgruppe, eine deuterierte C₁-C₂₀-Alkylgruppe, eine fluorierte C₁-C₂₀-Alkylgruppe, eine C₁-C₂₀-Alkoxygruppe, eine deuterierte C₁-C₂₀-Alkoxygruppe, eine fluorierte C₁-C₂₀-Alkoxygruppe, eine C₃-C₁₀-Cycloalkylgruppe, eine deuterierte C₃-C₁₀-Cycloalkylgruppe, eine fluorierte C₃-C₁₀-Cycloalkylgruppe, eine (C₁-C₂₀-Alkyl-)C₃-C₁₀-Cycloalkylgruppe, eine C₁-C₁₀-Heterocycloalkylgruppe, eine deuterierte C₁-C₁₀-Heterocycloalkylgruppe, eine fluorierte C₁-C₁₀-Heterocycloalkylgruppe, eine (C₁-C₂₀-Alkyl-)C₁-C₁₀-Heterocycloalkylgruppe, eine Phenylgruppe, eine deuterierte Phenylgruppe, eine fluorierte eine Phenylgruppe, eine (C₁-C₂₀-Alkyl-)Phenylgruppe, eine Biphenylgruppe, eine deuterierte Biphenylgruppe, eine fluorierte eine Biphenylgruppe, eine (C₁-C₂₀-Alkyl-)Biphenylgruppe oder eine beliebige Kombination davon; oder
-Si(Q₃)(Q₄)(Q₅) oder -Ge(Q₃)(Q₄)(Q₅).

7. Organometallische Verbindung nach einem beliebigen der Ansprüche 1-6, wobei die organometallische Verbindung zumindest eine der Bedingungen A, B und C erfüllt:
Bedingung A,
wobei Z₁ in Formel 2A nicht Wasserstoff ist und a1 nicht 0 ist,
Bedingung B,
wobei Z₂ in Formel 2A nicht Wasserstoff ist und a2 nicht 0 ist, und
Bedingung C,
R₁₄ in Formel 2B nicht Wasserstoff ist und b 1 nicht 0 ist.

8. Organometallische Verbindung nach einem beliebigen der Ansprüche 1-7, wobei die durch Formel 1 dargestellte organometallische Verbindung Bedingung 1 erfüllt und die Anzahl von in R₁₂ in Formel 2B enthaltenen Kohlenstoffatome 2 oder größer ist.

9. Organometallische Verbindung nach einem beliebigen der Ansprüche 1-8, wobei die durch Formel 1 dargestellte organometallische Verbindung Bedingung 2 erfüllt; und/oder
wobei die organometallische Verbindung zumindest ein Deuterium, zumindest eine Fluorgruppe (-F), zumindest eine Cyanogruppe (-CN) oder eine beliebige Kombination davon umfasst.

10. Organometallische Verbindung nach einem beliebigen der Ansprüche 1-9, wobei zumindest eine der Bedingungen (1) bis (6) erfüllt ist oder Bedingung (7) erfüllt ist:
Bedingung (1),
wobei in Formel 2A a1 nicht 0 ist und zumindest eines von Z₁(s) in der Anzahl von a1 Deuterium umfasst,
Bedingung (2),
wobei in Formel 2A a2 nicht 0 ist, zumindest eines von Z₂(s) in der Anzahl von a2 Deuterium, eine Fluorgruppe (-F), eine Cyanogruppe oder eine beliebige Kombination davon umfasst,
Bedingung (3),
wobei in Formel 2A zumindest eines von Ar₂(s) in der Anzahl von d2 Deuterium, eine Fluorgruppe (-F), eine Cyanogruppe oder eine beliebige Kombination davon umfasst,
Bedingung (4),
wobei in Formel 2B zumindest eines von R₂₁ bis R₂₃ Deuterium umfasst,
Bedingung (5), wobei in Formel 2B R₁₂ zumindest ein Deuterium umfasst,
Bedingung (6), wobei in Formel 2B b1 nicht 0 ist, zumindest eines von R₁₄(s) in der Anzahl von b1 Deuterium, eine Fluorgruppe (-F), eine Cyanogruppe oder eine beliebige Kombination davon umfasst, und
Bedingung (7), wobei Z₁, Z₂ und Ar₂ in Formel 2A und R₁₁ bis R₁₄ und R₂₁ bis R₂₃ in Formel 2B jeweils aus Kohlenstoff und Wasserstoff bestehen.

11. Organometallische Verbindung nach einem beliebigen der Ansprüche 1-10, wobei eine durch 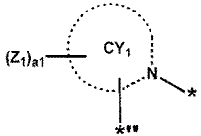 in Formel 2A dargestellte Gruppe eine Gruppe ist, die durch eine der Formeln CY1-1 bis CY1-28 dargestellt wird: 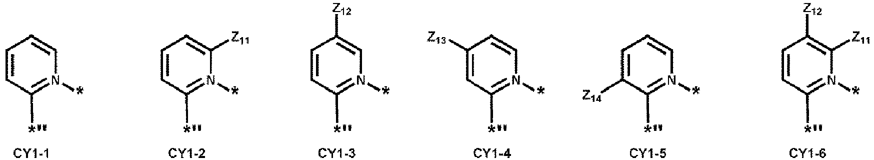 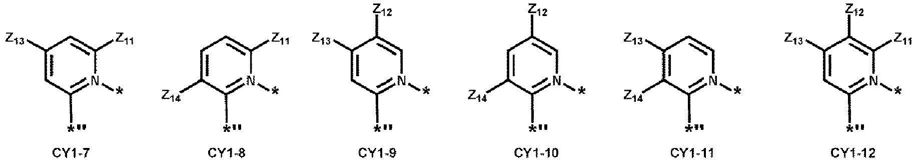 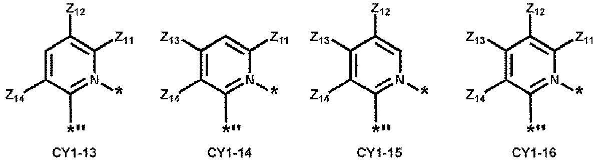 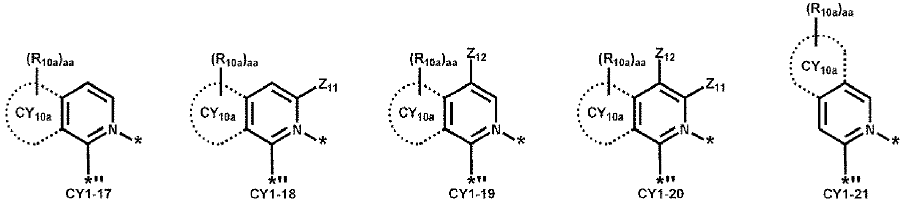 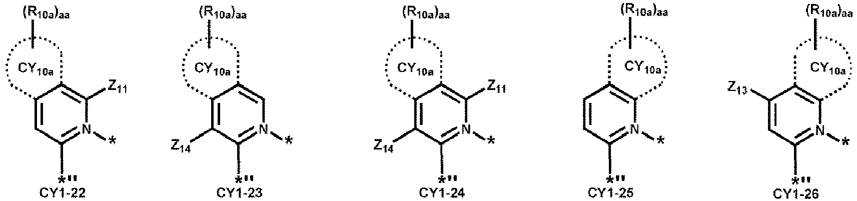 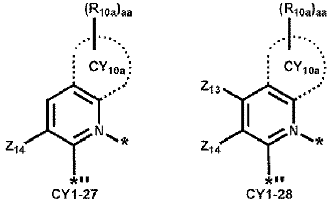
wobei in den Formeln CY1-1 bis CY1-28
Z₁₁ bis Z₁₄ jeweils die gleichen wie im Zusammenhang mit Z₁ in Anspruch 1 beschrieben sind, wobei Z₁₁ bis Z₁₄ jeweils nicht Wasserstoff sind,
Ring CY₁₀ₐ eine carbocyclische C₅-C₃₀-Gruppe oder eine heterocyclische C₁-C₃₀-Gruppe ist,
R₁₀ₐ das gleiche wie in Anspruch 1 beschrieben ist,
aa eine ganze Zahl von 0 bis 10 ist,
* eine Bindungsstelle an M in Formel 1 angibt und
*" eine Bindungsstelle an eines von T₁ bis T₄ in Formel 2A angibt.

12. Organometallische Verbindung nach einem beliebigen der Ansprüche 1-11, wobei eine durch 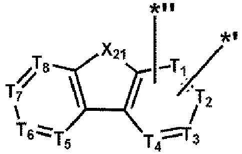 in Formel 2A dargestellte Gruppe eine Gruppe ist, die durch eine der Formeln CY2-1 bis CY2-6 dargestellt wird: 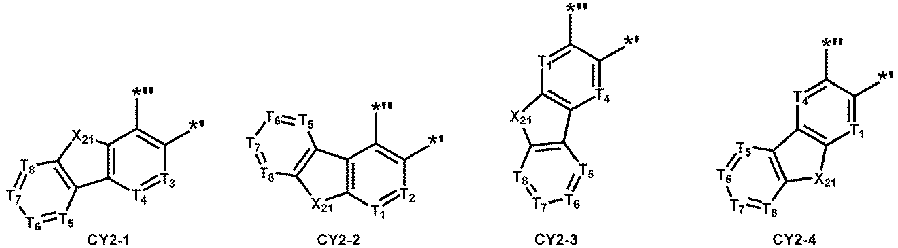 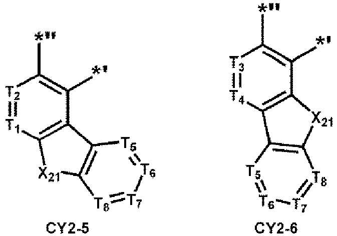
wobei in den Formeln CY2-1 bis CY2-6
T₁ bis T₈ jeweils unabhängig C oder N sind, die Anzahl von N(s) unter T₃ bis T₈ in den Formeln CY2-1 und CY2-6 0 oder 1 ist, die Anzahl von N(s) unter T₁, T₂, T₅, T₆, T₇ und T₈ in den Formeln CY2-2 und CY2-5 0 oder 1 ist, die Anzahl von N(s) in T₁, T₄, T₅, T₆, T₇ und T₈ in den Formeln CY2-3 und CY2-4 0 oder 1 ist,
X₂₁ das gleiche wie in Anspruch 1 beschrieben ist,
*" eine Bindungsstelle an Ring CY₁ in Formel 2A angibt und
*' eine Bindungsstelle an M in Formel 1 anzeigt.

13. Organische lichtemittierende Vorrichtung, umfassend:
eine erste Elektrode;
eine zweite Elektrode; und
eine zwischen der ersten Elektrode und der zweiten Elektrode befindliche organische Schicht und eine Emissionsschicht und zumindest eine der organometallischen Verbindung nach einem beliebigen der Ansprüche 1-12 umfassend;
wobei bevorzugt
die erste Elektrode eine Anode ist,
die zweite Elektrode eine Kathode ist,
die organische Schicht ferner einen Lochtransportbereich zwischen der ersten Elektrode und der Emissionsschicht und einen Elektronentransportbereich zwischen der Emissionsschicht und der zweiten Elektrode umfasst,
der Lochtransportbereich eine Lochinjektionsschicht, eine Lochtransportschicht, eine Elektronenblockierschicht, eine Pufferschicht oder eine beliebige Kombination davon umfasst, und
der Elektronentransportbereich eine Lochblockierschicht, eine Elektronentransportschicht, eine Elektroneninjektionsschicht oder eine beliebige Kombination davon umfasst.

14. Organische lichtemittierende Vorrichtung nach Anspruch 13, wobei die Emissionsschicht die organometallische Verbindung umfasst;
wobei die Emissionsschicht bevorzugt ferner einen Wirt in einer Menge größer als eine Menge der organometallischen Verbindung umfasst.

15. Elektronisches Gerät, die organische lichtemittierende Vorrichtung nach Anspruch 13 oder 14 umfassend.

## Revendications

1. Composé organométallique représenté par la Formule 1 :
Formule 1 M(L₁)n₁(L₂)n₂
où, dans la Formule 1,
M est un métal de transition,
L₁ est un ligand représenté par la Formule 2A,
L₂ est un ligand représenté par la Formule 2B,
n1 et n2 sont chacun indépendamment 1 ou 2, quand n1 est 2, deux L₁(s) sont identiques ou différents l'un de l'autre, et quand n2 est 2, deux L₂(s) sont identiques ou différents l'un de l'autre,
la somme de n1 et n2 est 2 ou 3,
L₁ est différent de L₂, 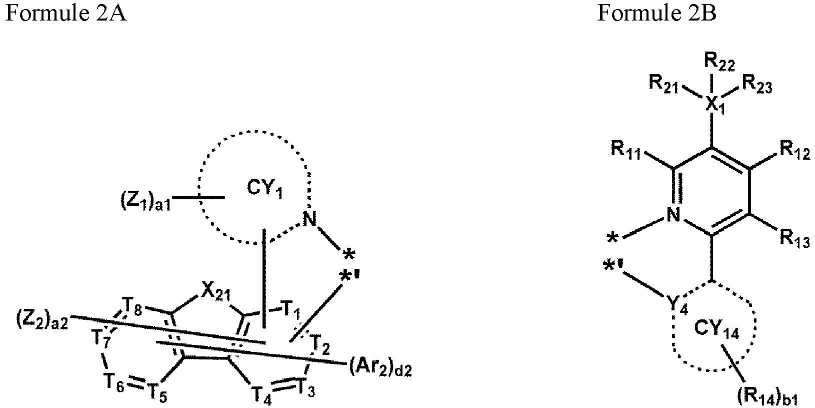
où, dans les Formules 2A et 2B,
Y₄ est C ou N,
X₁ est Si ou Ge,
X₂₁ est O, S, S(=O), N(Z₂₉), C(Z₂₉)(Z₃₀), ou Si(Z₂₉)(Z₃₀),
T₁ à T₄ sont chacun indépendamment C, N, un atome de carbone lié à l'anneau CY₁, ou un atome de carbone lié à M dans la Formule 1, l'un de T₁ à T₄ est un atome de carbone lié à M dans la Formule 1, un autre de T₁ à T₄, qui n'est pas lié à M, est un atome de carbone lié à l'anneau CY₁,
T₅ à T₈ sont chacun indépendamment C ou N,
le nombre de N(s) parmi T₁ à T₈ est 0 ou 1,
l'anneau CY₁ et l'anneau CY₁₄ sont chacun indépendamment un groupe C₅-C₃₀ carbocyclique ou un groupe C₁-C₃₀ hétérocyclique,
Ar₂ est un anneau CY₂ non substitué ou substitué par au moins un Z₀, et l'anneau CY₂ est un groupe C₅-C₃₀ carbocyclique non saturé ou un groupe C₁-C₃₀ hétérocyclique non saturé,
R₂₁ à R₂₃ sont chacun indépendamment un groupe C₁-C₆₀ alkyle ou un groupe C₆-C₆₀ aryle, chacun non substitué ou substitué par deutérium, -F, -Cl, -Br, -I, -CD₃, -CD₂H, -CDH₂, -CF₃, - CF₂H, -CFH₂, un groupe hydroxyle, un groupe cyano, un groupe nitro, un groupe amino, un groupe amidino, un groupe hydrazine, un groupe hydrazone, un groupe acide carboxylique ou un sel de celui-ci, un groupe acide sulfonique ou un sel de celui-ci, un groupe acide phosphorique ou un sel de celui-ci, un groupe C₁-C₂₀ alkyle, un groupe C₃-C₁₀ cycloalkyle, un groupe phényle, ou toute combinaison de ceux-ci,
Z₀, Z₁, Z₂, Z₂₉, Z₃₀, et R₁₁ à R₁₄ sont chacun indépendamment hydrogène, deutérium, -F, - Cl, -Br, -I, -SF₅, un groupe hydroxyle, un groupe cyano, un groupe nitro, un groupe amino, un groupe amidino, un groupe hydrazine, un groupe hydrazone, un groupe acide carboxylique ou un sel de celui-ci, un groupe acide sulfonique ou un sel de celui-ci, un groupe acide phosphorique ou un sel de celui-ci, un groupe C₁-C₆₀ alkyle substitué ou non substitué, un groupe C₂-C₆₀ alkényle substitué ou non substitué, un groupe C₂-C₆₀ alkynyle substitué ou non substitué, un groupe C₁-C₆₀ alkoxy substitué ou non substitué, un groupe C₁-C₆₀ alkylthio substitué ou non substitué, un groupe C₃-C₁₀ cycloalkyle substitué ou non substitué, un groupe C₁-C₁₀ hétérocycloalkyle substitué ou non substitué, un groupe C₃-C₁₀ cycloalkényle substitué ou non substitué, un groupe C₁-C₁₀ hétérocycloalkényle substitué ou non substitué, un groupe C₆-C₆₀ aryle substitué ou non substitué, un groupe C₆-C₆₀ aryloxy substitué ou non substitué, un groupe C₆-C₆₀ arylthio substitué ou non substitué, un groupe C₁-C₆₀ hétéroaryle substitué ou non substitué, un groupe polycyclique condensé non aromatique monovalent substitué ou non substitué, un groupe hétéropolycyclique condensé non aromatique monovalent substitué ou non substitué, -N(Q₁)(Q₂), -Si(Q₃)(Q₄)(Q₅), - Ge(Q₃)(Q₄)(Q₅), -B(Q₆)(Q₇), -P(=O)(Q₈)(Q₉), ou -P(Q₈)(Q₉),
d2 est un nombre entier de 1 à 6, et quand d2 est 2 ou plus, au moins deux Ar₂(s) sont identiques ou différents l'un de l'autre,
a1 et b1 sont chacun indépendamment un nombre entier de 0 à 20, quand a1 est 2 ou plus, au moins deux Z₁(s) sont identiques ou différents l'un de l'autre, et quand b1 est 2 ou plus, au moins deux R₁₄(s) sont identiques ou différents l'un de l'autre,
a2 est un nombre entier de 0 à 5, et quand a2 est 2 ou plus, au moins deux Z₂(s) sont identiques ou différents l'un de l'autre,
Condition 1 ou Condition 2 est satisfaite :
Condition 1
où X₁ dans la Formule 2B est Si,
R12 dans la Formule 2B n'est ni hydrogène ni un groupe méthyle, et
le nombre de N(s) parmi T₁ à T₈ dans la Formule 2A est 0, et
Condition 2
où, dans la Formule 2B, R₁₂ est hydrogène, ou le nombre d'atomes de carbone inclus dans R₁₂ est 1,
au moins deux de R₂₁ à R₂₃ sont optionnellement liés l'un à l'autre pour former un groupe C₅-C₃₀ carbocyclique non substitué ou substitué par au moins un R₁₀ₐ ou un groupe C₁-C₃₀ hétérocyclique non substitué ou substitué par au moins un R₁₀ₐ,
au moins deux d'une pluralité de Z₁(s) sont optionnellement liés l'un à l'autre pour former un groupe C₅-C₃₀ carbocyclique non substitué ou substitué par au moins un R₁₀ₐ ou un groupe C₁-C₃₀ hétérocyclique non substitué ou substitué par au moins un R₁₀ₐ,
au moins deux d'une pluralité de Z₂(s) sont optionnellement liés l'un à l'autre pour former un groupe C₅-C₃₀ carbocyclique non substitué ou substitué par au moins un R₁₀ₐ ou un groupe C₁-C₃₀ hétérocyclique non substitué ou substitué par au moins un R₁₀ₐ,
R₁₂ et R₁₃ sont optionnellement liés l'un à l'autre pour former un groupe C₅-C₃₀ carbocyclique non substitué ou substitué par au moins un R₁₀ₐ ou un groupe C₁-C₃₀ hétérocyclique non substitué ou substitué par au moins un R₁₀ₐ,
au moins deux d'une pluralité de R₁₄(s) sont optionnellement liés l'un à l'autre pour former un groupe C₅-C₃₀ carbocyclique non substitué ou substitué par au moins un R₁₀ₐ ou un groupe C₁-C₃₀ hétérocyclique non substitué ou substitué par au moins un R₁₀ₐ,
au moins deux de Z₀, Z₁, Z₂, Z₂₉, Z₃₀, et R₁₁ à R₁₄ sont optionnellement liés l'un à l'autre pour former un groupe C₅-C₃₀ carbocyclique non substitué ou substitué par au moins un R₁₀ₐ ou un groupe C₁-C₃₀ hétérocyclique non substitué ou substitué par au moins un R₁₀ₐ,
R₁₀ₐ est compris par référence à la description de R₁₄ fournie ici,
* et *' dans les Formules 2A and 2B indiquent chacun un site de liaison à M dans la Formule 1, et
un substituant du groupe C₁-C₆₀ alkyle substitué, du groupe C₂-C₆₀ alkényle substitué, du groupe C₂-C₆₀ alkynyle substitué, du groupe C₁-C₆₀ alkoxy substitué, du groupe C₁-C₆₀ alkylthio substitué, du groupe C₃-C₁₀ cycloalkyle substitué, du groupe C₁-C₁₀ hétérocycloalkyle substitué, du groupe C₃-C₁₀ cycloalkényle substitué, du groupe C₁-C₁₀ hétérocycloalkényle substitué, du groupe C₆-C₆₀ aryle substitué, du groupe C₆-C₆₀ aryloxy substitué, du groupe C₆-C₆₀ arylthio substitué, du groupe C₁-C₆₀ hétéroaryle substitué, du groupe polycyclique condensé non aromatique monovalent substitué, et du groupe hétéropolycyclique condensé non aromatique monovalent substitué est :
deutérium, -F, -Cl, -Br, -I, -CD₃, -CD₂H, -CDH₂, -CF₃, -CF₂H, -CFH₂, un groupe hydroxyle, un groupe cyano, un groupe nitro, un groupe amino, un groupe amidino, un groupe hydrazine, un groupe hydrazone, un groupe acide carboxylique ou un sel de celui-ci, un groupe acide sulfonique ou un sel de celui-ci, un groupe acide phosphorique ou un sel de celui-ci, un groupe C₁-C₆₀ alkyle, un groupe C₂-C₆₀ alkényle, un groupe C₂-C₆₀ alkynyle, un groupe C₁-C₆₀ alkoxy, ou un groupe C₁-C₆₀ alkylthio ;
un groupe C₁-C₆₀ alkyle, un groupe C₂-C₆₀ alkényle, un groupe C₂-C₆₀ alkynyle, un groupe C₁-C₆₀ alkoxy, ou un groupe C₁-C₆₀ alkylthio, chacun substitué par deutérium, -F, -Cl, -Br, -I, - CD₃, -CD₂H, -CDH₂, -CF₃, -CF₂H, -CFH₂, un groupe hydroxyle, un groupe cyano, un groupe nitro, un groupe amino, un groupe amidino, un groupe hydrazine, un groupe hydrazone, un groupe acide carboxylique ou un sel de celui-ci, un groupe acide sulfonique ou un sel de celui-ci, un groupe acide phosphorique ou un sel de celui-ci, un groupe C₃-C₁₀ cycloalkyle, un groupe C₁-C₁₀ hétérocycloalkyle, un groupe C₃-C₁₀ cycloalkényle, un groupe C₁-C₁₀ hétérocycloalkényle, un groupe C₆-C₆₀ aryle, un groupe C₆-C₆₀ aryloxy, un groupe C₆-C₆₀ arylthio, un groupe C₁-C₆₀ hétéroaryle, un groupe polycyclique condensé non aromatique monovalent, un groupe hétéropolycyclique condensé non aromatique monovalent, -N(Q₁₁)(Q₁₂), -Si(Q₁₃)(Q₁₄)(Q₁₅), - Ge(Q₁₃)(Q₁₄)(Q₁₅), -B(Q_{I6})(Q₁₇), -P(=O)(Q₁₈)(Q₁₉), -P(Q₁₈)(Q₁₉), ou toute combinaison de ceux-ci ;
un groupe C₃-C₁₀ cycloalkyle, un groupe C₁-C₁₀ hétérocycloalkyle, un groupe C₃-C₁₀ cycloalkényle, un groupe C₁-C₁₀ hétérocycloalkényle, un groupe C₆-C₆₀ aryle, un groupe C₆-C₆₀ aryloxy, un groupe C₆-C₆₀ arylthio, un groupe C₁-C₆₀ hétéroaryle, un groupe polycyclique condensé non aromatique monovalent, ou un groupe hétéropolycyclique condensé non aromatique monovalent, chacun non substitué ou substitué par deutérium, -F, -Cl, -Br, -I, -CD₃, -CD₂H, - CDH₂, -CF₃, -CF₂H, -CFH₂, un groupe hydroxyle, un groupe cyano, un groupe nitro, un groupe amino, un groupe amidino, un groupe hydrazine, un groupe hydrazone, un groupe acide carboxylique ou un sel de celui-ci, un groupe acide sulfonique ou un sel de celui-ci, un groupe acide phosphorique ou un sel de celui-ci, un groupe C₁-C₆₀ alkyle, un groupe C₂-C₆₀ alkényle, un groupe C₂-C₆₀ alkynyle, un groupe C₁-C₆₀ alkoxy, un groupe C₁-C₆₀ alkylthio, un groupe C₃-C₁₀ cycloalkyle, un groupe C₁-C₁₀ hétérocycloalkyle, un groupe C₃-C₁₀ cycloalkényle, un groupe C₁-C₁₀ hétérocycloalkényle, un groupe C₆-C₆₀ aryle, un groupe C₆-C₆₀ aryloxy, un groupe C₆-C₆₀ arylthio, un groupe C₁-C₆₀ hétéroaryle, un groupe polycyclique condensé non aromatique monovalent, un groupe hétéropolycyclique condensé non aromatique monovalent, -N(Q₂₁)(Q₂₂), - Si(Q₂₃)(Q₂₄)(Q₂₅), -Ge(Q₂₃)(Q₂₄)(Q₂₅), -B(Q₂₆)(Q₂₇), -P( = O)(Q₂₈)(Q₂₉), - P(Q₂₈)(Q₂₉), ou toute combinaison de ceux-ci ;
-N(Q₃₁)(Q₃₂), -Si(Q₃₃)(Q₃₄)(Q₃₅), -Ge(Q₃₃)(Q₃₄)(Q₃₅), -B(Q₃₆)(Q₃₇), -P(=O)(Q₃₈)(Q₃₉), ou -P(Q₃₈)(Q₃₉) ; ou
toute combinaison de ceux-ci,
où Q₁ à Q₉, Q₁₁ à Q₁₉, Q₂₁ à Q₂₉, et Q₃₁ à Q₃₉ sont chacun indépendamment : hydrogène ; deutérium ; -F ; -Cl ; -Br ; -I ; un groupe hydroxyle ; un groupe cyano ; un groupe nitro ; un groupe amino ; un groupe amidino ; un groupe hydrazine ; un groupe hydrazone ; un groupe acide carboxylique ou un sel de celui-ci ; un groupe acide sulfonique ou un sel de celui-ci ; un groupe acide phosphorique ou un sel de celui-ci ; un groupe C₁-C₆₀ alkyle non substitué ou substitué par deutérium, un groupe C₁-C₆₀ alkyle, un groupe C₆-C₆₀ aryle, ou toute combinaison de ceux-ci ; un groupe C₂-C₆₀ alkényle ; un groupe C₂-C₆₀ alkynyle ; un groupe C₁-C₆₀ alkoxy ; un groupe C₁-C₆₀ alkylthio ; un groupe C₃-C₁₀ cycloalkyle ; un groupe C₁-C₁₀ hétérocycloalkyle ; un groupe C₃-C₁₀ cycloalkényle ; un groupe C₁-C₁₀ hétérocycloalkényle ; un groupe C₆-C₆₀ aryle non substitué ou substitué par deutérium, un groupe C₁-C₆₀ alkyle, un groupe C₆-C₆₀ aryle, ou toute combinaison de ceux-ci ; un groupe C₆-C₆₀ aryloxy ; un groupe C₆-C₆₀ arylthio ; un groupe C₁-C₆₀ hétéroaryle ; un groupe polycyclique condensé non aromatique monovalent ; ou un groupe hétéropolycyclique condensé non aromatique monovalent.

2. Composé organométallique selon la revendication 1, où M dans la Formule 1 est Ir, et n1+n2=3, ou M dans la Formule 1 est Pt, et n1+n2=2.

3. Composé organométallique selon la revendication 1 ou 2, où M dans la Formule 1 est Ir et i) n1 est 1 et n2 est 2 ; ou ii) n1 est 2 et n2 est 1.

4. Composé organométallique selon l'une quelconque des revendications 1-3, où X₂₁ dans la Formule 2A est O ou S ; et/ou
où l'anneau CY₂ est un groupe benzène, un groupe naphtalène, un groupe anthracène, un groupe phénanthrène, un groupe triphénylène, un groupe pyrène, un groupe chrysène, un groupe cyclopentadiène, un groupe 1,2,3,4-tétrahydronaphtalène, un groupe thiophène, un groupe furane, un groupe borole, un groupe phosphole, un groupe silole, un groupe germole, un groupe sélénophène, un groupe indole, un groupe benzoborole, un groupe benzophosphole, un groupe indène, un groupe benzosilole, un groupe benzogermole, un groupe benzothiophène, un groupe benzosélénophène, un groupe benzofurane, un groupe carbazole, un groupe dibenzoborole, un groupe dibenzophosphole, un groupe fluorène, un groupe dibenzosilole, un groupe dibenzogermole, un groupe dibenzothiophène, un groupe dibenzosélénophène, un groupe dibenzofurane, un groupe dibenzothiophène 5-oxyde, un groupe 9H-fluorène-9-one, un groupe dibenzothiophène 5,5-dioxyde, un groupe azaindole, un groupe azabenzoborole, un groupe azabenzophosphole, un groupe azaindène, un groupe azabenzosilole, un groupe azabenzogermole, un groupe azabenzothiophène, un groupe azabenzosélénophène, un groupe azabenzofurane, un groupe azacarbazole, un groupe azadibenzoborole, un groupe azadibenzophosphole, un groupe azafluorène, un groupe azadibenzosilole, un groupe azadibenzogermole, un groupe azadibenzothiophène, un groupe azadibenzosélénophène, un groupe azadibenzofurane, un groupe azadibenzothiophène 5-oxyde, un groupe aza-9H-fluoren-9-one, un groupe azadibenzothiophène 5,5-dioxyde, un groupe pyridine, un groupe pyrimidine, un groupe pyrazine, un groupe pyridazine, un groupe triazine, un groupe quinoline, un groupe isoquinoline, un groupe quinoxaline, un groupe quinazoline, un groupe phénanthroline, un groupe pyrrole, un groupe pyrazole, un groupe imidazole, un groupe triazole, un groupe oxazole, un groupe isooxazole, un groupe thiazole, un groupe isothiazole, un groupe oxadiazole, un groupe thiadiazole, un groupe benzopyrazole, un groupe benzimidazole, un groupe benzoxazole, un groupe benzothiazole, un groupe benzoxadiazole, un groupe benzothiadiazole, un groupe 5,6,7,8-tétrahydroisoquinoline, ou un groupe 5,6,7,8-tétrahydroquinoline ; et/ou
où d2 dans la Formule 2A est 1 ou 2.

5. Composé organométallique selon l'une quelconque des revendications 1-4, où Z₁ dans la Formule 2A et R₁₁ à R₁₃ dans la Formule 2B sont chacun indépendamment :
hydrogène ou deutérium ;
un groupe C₁-C₂₀ alkyle non substitué ou substitué par deutérium, un groupe C₃-C₁₀ cycloalkyle, un groupe C₃-C₁₀ cycloalkyle deutéré, un groupe (C₁-C₂₀ alkyl)C₃-C₁₀ cycloalkyle, un groupe C₁-C₁₀ hétérocycloalkyle, un groupe C₁-C₁₀ hétérocycloalkyle deutéré, un groupe (C₁-C₂₀ alkyl)C₁-C₁₀ hétérocycloalkyle, un groupe phényle, un groupe phényle deutéré, un groupe (C₁-C₂₀ alkyl)phényle, un groupe biphényle, un groupe biphényle deutéré, un groupe (C₁-C₂₀ alkyl)biphényle, ou toute combinaison de ceux-ci ; ou
un groupe C₃-C₁₀ cycloalkyle, un groupe C₁-C₁₀ hétérocycloalkyle, un groupe phényle, ou un groupe biphényle, chacun non substitué ou substitué par deutérium, -F, un groupe cyano, un groupe C₁-C₂₀ alkyle, un groupe C₁-C₂₀ alkyle deutéré, un groupe C₁-C₂₀ alkoxy, un groupe C₁-C₂₀ alkoxy deutéré, un groupe C₃-C₁₀ cycloalkyle, un groupe C₃-C₁₀ cycloalkyle deutéré, un groupe (C₁-C₂₀ alkyl)C₃-C₁₀ cycloalkyle, un groupe C₁-C₁₀ hétérocycloalkyle, un groupe C₁-C₁₀ hétérocycloalkyle deutéré, un groupe (C₁-C₂₀ alkyl)C₁-C₁₀ hétérocycloalkyle, un groupe phényle, un groupe phényle deutéré, un groupe (C₁-C₂₀ alkyl)phényle, un groupe biphényle, un groupe biphényle deutéré, un groupe (C₁-C₂₀ alkyl)biphényle, ou toute combinaison de ceux-ci.

6. Composé organométallique selon l'une quelconque des revendications 1-5, où Z₀ et Z₂ dans la Formule 2A et R₁₄ dans la Formule 2B sont chacun indépendamment :
hydrogène, deutérium, -F, ou un groupe cyano ;
un groupe C₁-C₂₀ alkyle non substitué ou substitué par deutérium, -F, un groupe cyano, un groupe C₃-C₁₀ cycloalkyle, un groupe C₃-C₁₀ cycloalkyle deutéré, un groupe C₃-C₁₀ cycloalkyle fluoré, un groupe (C₁-C₂₀ alkyl)C₃-C₁₀ cycloalkyle, un groupe C₁-C₁₀ hétérocycloalkyle, un groupe C₁-C₁₀ hétérocycloalkyle deutéré, un groupe C₁-C₁₀ hétérocycloalkyle fluoré, un groupe (C₁-C₂₀ alkyl)C₁-C₁₀ hétérocycloalkyle, un groupe phényle, un groupe phényle deutéré, un groupe phényle fluoré, un groupe (C₁-C₂₀ alkyl)phényle, un groupe biphényle, un groupe biphényle deutéré, un groupe biphényle fluoré, un groupe (C₁-C₂₀ alkyl)biphényle, ou toute combinaison de ceux-ci ;
un groupe C₃-C₁₀ cycloalkyle, un groupe C₁-C₁₀ hétérocycloalkyle, un groupe phényle, ou un groupe biphényle, chacun non substitué ou substitué par deutérium, -F, un groupe cyano, un groupe C₁-C₂₀ alkyle, un groupe C₁-C₂₀ alkyle deutéré, un groupe C₁-C₂₀ alkyle fluoré, un groupe C₁-C₂₀ alkoxy, un groupe C₁-C₂₀ alkoxy deutéré, un groupe C₁-C₂₀ alkoxy fluoré, un groupe C₃-C₁₀ cycloalkyle, un groupe C₃-C₁₀ cycloalkyle deutéré, un groupe C₃-C₁₀ cycloalkyle fluoré, un groupe (C₁-C₂₀ alkyl)C₃-C₁₀ cycloalkyle, un groupe C₁-C₁₀ hétérocycloalkyle, un groupe C₁-C₁₀ hétérocycloalkyle deutéré, un groupe C₁-C₁₀ hétérocycloalkyle fluoré, un groupe (C₁-C₂₀ alkyl)C₁-C₁₀ hétérocycloalkyle, un groupe phényle, un groupe phényle deutéré, un groupe phényle un fluoré, un groupe (C₁-C₂₀ alkyl)phényle, un groupe biphényle, un groupe biphényle deutéré, un groupe biphényle un fluoré, un groupe (C₁-C₂₀ alkyl)biphényle, ou toute combinaison de ceux-ci ; ou
-Si(Q₃)(Q₄)(Q₅), ou -Ge(Q₃)(Q₄)(Q₅).

7. Composé organométallique selon l'une quelconque des revendications 1-6, le composé organométallique satisfaisant au moins une des Conditions A, B et C :
Condition A
où, Z₁ dans la Formule 2A n'est pas hydrogène, et a1 n'est pas 0,
Condition B
où, Z₂ dans la Formule 2A n'est pas hydrogène, et a2 n'est pas 0, et
Condition C
R₁₄ dans la Formule 2B n'est pas hydrogène, et b1 n'est pas 0.

8. Composé organométallique selon l'une quelconque des revendications 1-7, où le composé organométallique représenté par la Formule 1 satisfait la Condition 1 et le nombre d'atomes de carbone inclus dans R₁₂ dans la Formule 2B est 2 ou plus.

9. Composé organométallique selon l'une quelconque des revendications 1-8, où le composé organométallique représenté par la Formule 1 satisfait la Condition 2 ; et/ou
où le composé organométallique comprend au moins un deutérium, au moins un groupe fluoro (-F), au moins un groupe cyano (-CN), ou toute combinaison de ceux-ci.

10. Composé organométallique selon l'une quelconque des revendications 1-9, où au moins une des Conditions (1) à (6) est satisfaite ou la Condition (7) est satisfaite :
Condition (1)
où, dans la Formule 2A, a1 n'est pas 0, et au moins un de Z₁(s) dans le nombre de a1 comprend deutérium,
Condition (2)
où, dans la Formule 2A, a2 n'est pas 0, au moins un de Z₂(s) dans le nombre de a2 comprend deutérium, un groupe fluoro (-F), un groupe cyano, ou toute combinaison de ceux-ci,
Condition (3)
où, dans la Formule 2A, au moins un de Ar₂(s) dans le nombre de d2 comprend deutérium, un groupe fluoro (-F), un groupe cyano, ou toute combinaison de ceux-ci,
Condition (4)
où, dans la Formule 2B, au moins un de R₂₁ à R₂₃ comprend deutérium,
Condition (5)
où, dans la Formule 2B, R₁₂ comprend au moins un deutérium,
Condition (6)
où, dans la Formule 2B, b1 n'est pas 0, au moins un de R₁₄(s) dans le nombre de b1 comprend deutérium, un groupe fluoro (-F), un groupe cyano, ou toute combinaison de ceux-ci, et
Condition (7)
où Z₁, Z₂ et Ar₂ dans la Formule 2A, et R₁₁ à R₁₄ et R₂₁ à R₂₃ dans la Formule 2B sont chacun constitués de carbone et hydrogène.

11. Composé organométallique selon l'une quelconque des revendications 1-10, où un groupe représenté par 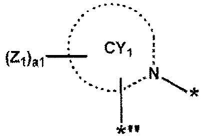 dans la Formule 2A est un groupe représenté par l'une des formules CY1-1 à CY1-28 : 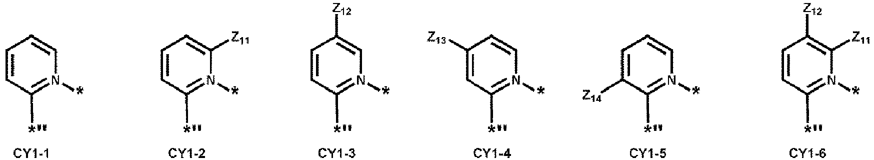 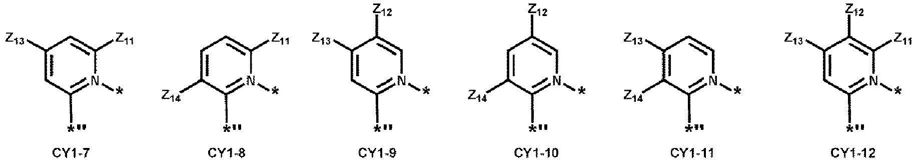 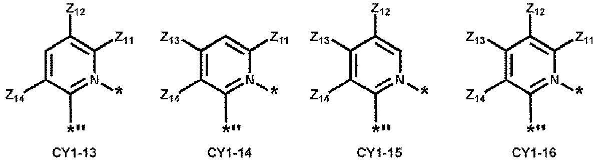 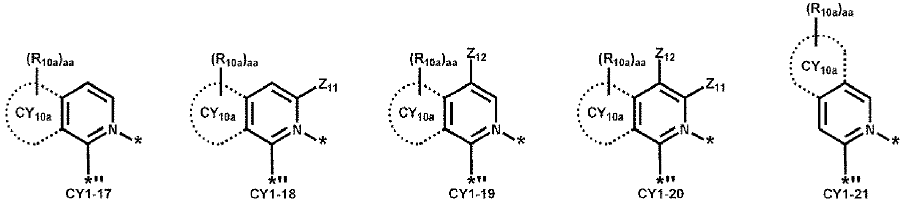 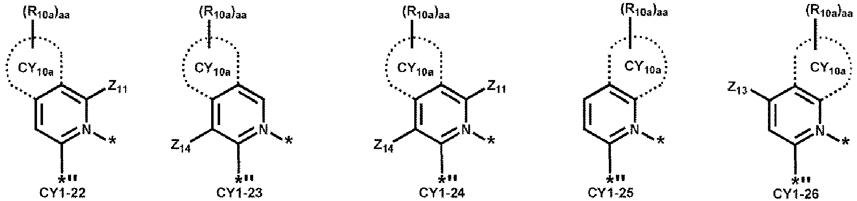 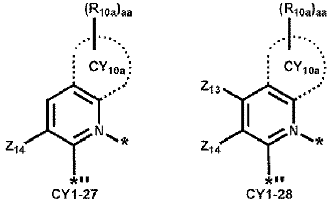
où, dans les Formules CY1-1 à CY1-28,
Z₁₁ à Z₁₄ sont chacun identiques à la description relative à Z₁ dans la revendication 1, où chacun de Z₁₁ à Z₁₄ n'est pas hydrogène,
l'anneau CY₁₀ₐ est un groupe C₅-C₃₀ carbocyclique ou un groupe C₁-C₃₀ hétérocyclique,
R₁₀ₐ est identique à la description de la revendication 1,
aa est un nombre entier de 0 à 10,
^{∗} indique un site de liaison à M dans la Formule 1, et
^{∗}" indique un site de liaison à l'un de T₁ à T₄ dans la Formule 2A.

12. Composé organométallique selon l'une quelconque des revendications 1-11, où un groupe représenté par 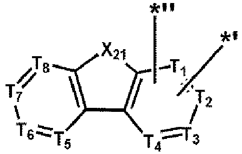 dans la Formule 2A est un groupe représenté par l'une des Formules CY2-1 à CY2-6 : 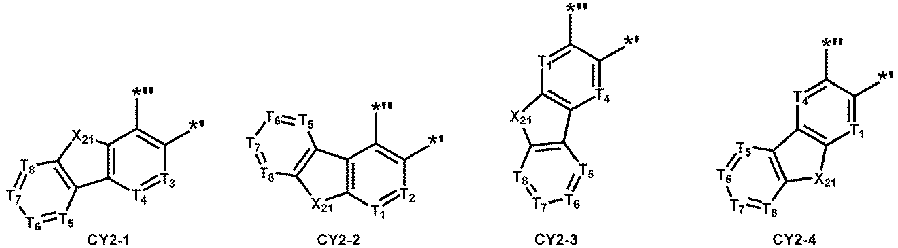 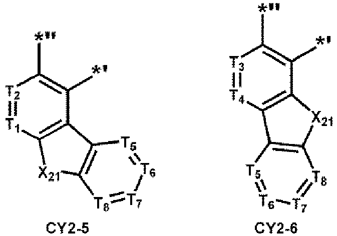
où, dans les Formules CY2-1 à CY2-6,
T₁ à T₈ sont chacun indépendamment C ou N, le nombre de N(s) parmi T₃ à T₈ dans les Formules CY2-1 et CY2-6 est 0 ou 1, le nombre de N(s) parmi T₁, T₂, T₅, T₆, T₇, et T₈ dans les Formules CY2-2 et CY2-5 est 0 ou 1, le nombre de N(s) parmi T₁, T₄, T₅, T₆, T₇, et T₈ dans les Formules CY2-3 et CY2-4 est 0 ou 1,
X₂₁ est identique à la description selon la revendication 1,
^{∗}" indique un site de liaison à l'anneau CY₁ dans la Formule 2A, et
^{∗}' indique un site de liaison à M dans la Formule 1.

13. Dispositif électroluminescent organique comprenant :
une première électrode ;
une deuxième électrode ; et
une couche organique située entre la première électrode et la deuxième électrode et comprenant une couche émettrice et au moins un du composé organométallique selon l'une quelconque des revendications 1-12 ;
de préférence où
la première électrode est une anode,
la deuxième électrode est une cathode,
la couche organique comprend en outre une zone de transport de trous entre la première électrode et la couche émettrice et une zone de transport d'électrons entre la couche émettrice et la deuxième électrode,
la zone de transport de trous comprend une couche d'injection de trous, une couche de transport de trous, une couche de blocage d'électrons, une couche tampon, ou toute combinaison de celles-ci, et
la zone de transport d'électrons comprend une couche de blocage de trous, une couche de transport d'électrons, une couche d'injection d'électrons, ou toute combinaison de celles-ci.

14. Dispositif électroluminescent organique selon la revendication 13, où la couche émettrice comprend le composé organométallique ;
de préférence où la couche émettrice comprend en outre un hôte en quantité supérieure à une quantité du composé organométallique.

15. Appareil électronique comprenant le dispositif électroluminescent organique selon la revendication 13 ou 14.
